# EUROPEAN PATENT APPLICATION

(11) **EP 4 624 510 A1**
(43) Date of publication of application: **01.10.2025**
(21) Application number: 25165986.8
(22) Date of filing: 25.03.2025
(51) Int. Cl.: C08G 61/02, C08G 61/12

(54) **COPOLYMER, COMPOSITION, LIQUID COMPOSITION, AND ELECTROLUMINSECNT DEVICE INCLUDING THE COPOLYMER**

(30) Priority: 26.03.2024 JP 2024049460; 17.02.2025 KR 20250019974
(71) Applicant: Samsung Electronics Co., Ltd., Suwon-si, Gyeonggi-do 16677 (KR)
(72) Inventor: FUJIYAMA, Takahiro, 16678 Suwon-si (KR); ISHII, Norihito, 16678 Suwon-si (KR); KATO, Fumiaki, 16678 Suwon-si (KR); TSUTSUMI, Kiyohiko, 16678 Suwon-si (KR); TSUJI, Masashi, 16678 Suwon-si (KR); SUGANUMA, Naotoshi, 16678 Suwon-si (KR); KONISHI, Yusaku, 16678 Suwon-si (KR); KWON, Ha Il, 16678 Suwon-si (KR); YOON, Won Sik, 16678 Suwon-si (KR)
(74) Representative: Elkington and Fife LLP

(57) **Abstract**

A copolymer including a structural unit represented by Chemical Formula 1, and a structural unit represented by Chemical Formula 2:

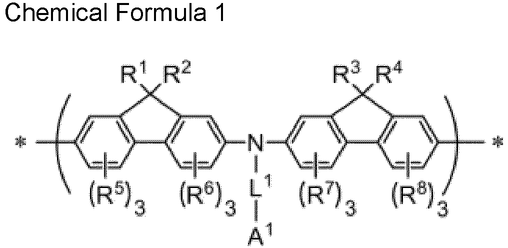

Chemical Formula 2 * ² - A⁴ - * ²

wherein in Chemical Formula 1 and Chemical Formula 2, R¹, R², R³, R⁴, R⁵, R⁶, R⁷ , R⁸ , L¹, A¹, A⁴ , *, and *² are the same as defined herein.

## Description

### FIELD OF THE INVENTION

A copolymer, a composition, a liquid composition, and an electroluminescent device including the copolymer are disclosed.

### BACKGROUND OF THE INVENTION

Research and development on electroluminescent devices (EL devices) are actively underway. In particular, EL devices are expected to have promising applications as inexpensive, large-area, solid-state light-emitting full-color display devices or recording light source arrays. The EL devices are light emitting devices having a thin film that is several nanometers to several hundred nanometers thick, that is disposed between an anode and a cathode. In addition, the EL device typically further includes a hole transport layer, a light emitting layer, an electron transport layer, or the like.

Among these, the materials for the light emitting layer include fluorescent light emitting materials and phosphorescent light emitting materials. Phosphorescent materials are expected to have higher luminous efficiency than fluorescent materials. Additionally, in order to cover a wide color gamut, RGB light sources are typically required to have an emission spectrum having a narrow full width at half maximum (FWHM). In particular, deep blue is required for blue light emission, but a device that can also satisfy the requirements of long life-span and high color purity has yet to be developed.

As a method for solving these problems, a light emitting device that uses "quantum dots," which are inorganic light emitting materials, is known (Japanese Patent Publication No. 2016-084370). Quantum dots (QDs) are semiconductor materials with a crystal structure measuring several nanometers in size and composed of hundreds to thousands of atoms. Since quantum dots have a particle size equivalent to the de Broglie wavelength of an atom, they exhibit effects such as quantum confinement. Due to the quantum confinement effect, the emission wavelength of quantum dots can be controlled by simply adjusting their size. QDs are also desirable because they have characteristics such as excellent color purity and high PL (photoluminescence) luminous efficiency. Quantum dot light emitting diodes (QD LEDs) have a three-layer structure as their basic device, which includes a hole transport layer (HTL) and an electron transport layer (ETL) on opposite sides of an emitting layer that includes a plurality of QDs.

### SUMMARY OF THE INVENTION

Recently, from the perspectives of larger screens, improved manufacturing process efficiency, and lower costs, attempts are being made to manufacture EL devices using a coating method. Meanwhile, in a stacked structure composed of a lower layer (e.g., a hole transport layer) and an upper layer (e.g., a light emitting layer), when the lower layer is formed by a coating method, a material for the lower layer should have low solubility (solvent resistance) in the solvent used when forming the upper layer.

However, there is a problem in that the hole transport material described in Patent Document 1 does not have such characteristics.

Accordingly, the present disclosure aims to provide a hole transport material that can be formed as a film using a coating method, which has excellent resistance to solvents used in forming an adjacent layer, and can realize an electroluminescent device having a high luminous efficiency and a long life-span.

An aspect provides a copolymer including a structural unit represented by Chemical Formula 1, and a structural unit represented by Chemical Formula 2: 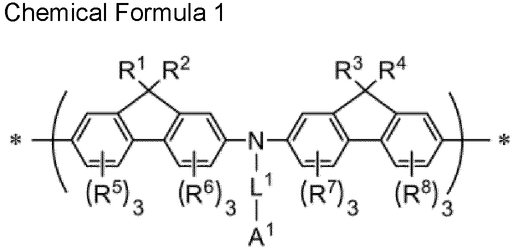 In Chemical Formula 1,
A¹ is a substituted or unsubstituted aromatic ring group having 6 to 60 ring-forming atoms, a substituted or unsubstituted heteroaromatic ring group having 3 to 60 ring-forming atoms, or a group represented by Chemical Formula 3,
L¹ is a single bond, or a substituted or unsubstituted aromatic ring group having 6 to 60 ring-forming atoms,
R¹ to R⁴ are each independently a substituted or unsubstituted aromatic ring group having 6 to 30 ring-forming atoms, a substituted or unsubstituted alkyl group having 1 to 30 carbon atoms, or a substituted or unsubstituted ethylene glycol group or oligoethylene glycol group having 2 to 30 carbon atoms,
wherein, R¹ and R² are optionally bonded with each other to form a ring, or R³ and R⁴ are optionally bonded with each other to form a ring,
R⁵ to R⁸ are each independently a hydrogen atom, or a substituted or unsubstituted alkyl group having 1 to 30 carbon atoms, and
* is a bonding position with another atom, 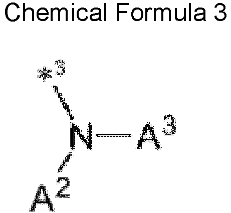
wherein, in Chemical Formula 3,
A² and A³ are each independently a substituted or unsubstituted aromatic ring group having 6 to 30 ring-forming atoms, or a substituted or unsubstituted heteroaromatic ring group having 3 to 30 ring-forming atoms, and
*³ is a bonding position with another atom,

   Chemical Formula 2 *²-A⁴-*²
wherein, in Chemical Formula 2,
A⁴ is a substituted or unsubstituted aromatic ring group having 6 to 60 ring-forming atoms, or a substituted or unsubstituted heteroaromatic ring group having 3 to 60 ring-forming atoms, and
*² is a bonding position with another atom.

According to an embodiment, provided is a hole transport material that can be readily formed into a film by a coating method, has excellent resistance to solvents used in forming an adjacent layer, and can be used to provide an electroluminescent device with a high luminous efficiency and a long life-span.

According to another aspect, provided is a composition including the copolymer described herein, and at least one material that is a hole transporting material, an electron transporting material, or a light emitting material.

In still another aspect, provided is a composition including the copolymer described herein, and at least one solvent.

Also provided is an electroluminescent device including a pair of electrodes, and at least one organic layer including the copolymer described herein, wherein the organic layer is disposed between the pair of electrodes.

Yet another aspect provides an electroluminescent device including a pair of electrodes and at least one organic layer including the composition including the copolymer composition described herein that is disposed between the pair of electrodes.

### BRIEF DESCRIPTION OF THE DRAWINGS

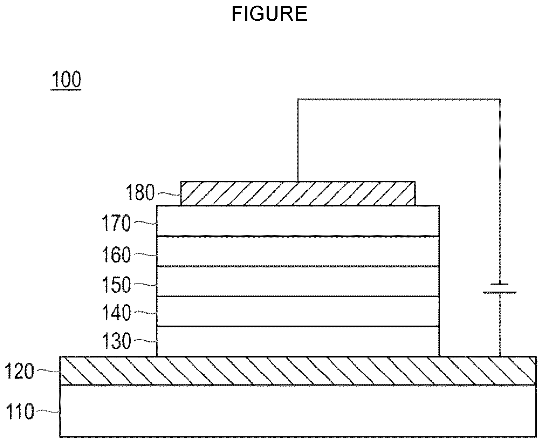

The above and other aspects, features, and advantages of certain embodiments will be more apparent from the following description taken in conjunction with the accompanying drawing, in which the FIGURE is a schematic view showing an electroluminescent device according to an embodiment.

### DETAILED DESCRIPTION OF THE EMBODIMENTS

An aspect provides a copolymer including a structural unit represented by Chemical Formula 1, and a structural unit represented by Chemical Formula 2: 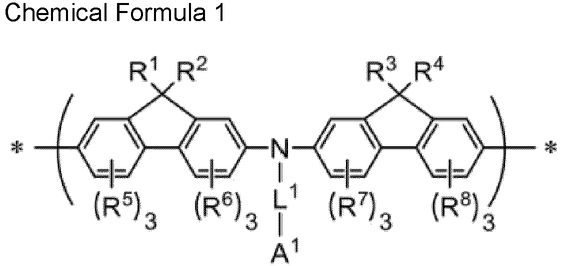 In Chemical Formula 1,
A¹ is a substituted or unsubstituted aromatic ring group having 6 to 60 ring-forming atoms, a substituted or unsubstituted heteroaromatic ring group having 3 to 60 ring-forming atoms, or a group represented by Chemical Formula 3,
L¹ is a single bond, or a substituted or unsubstituted aromatic ring group having 6 to 60 ring-forming atoms,
R¹ to R⁴ are each independently a substituted or unsubstituted aromatic ring group having 6 to 30 ring-forming atoms, a substituted or unsubstituted alkyl group having 1 to 30 carbon atoms, or a substituted or unsubstituted ethylene glycol group or oligoethylene glycol group having 2 to 30 carbon atoms,
wherein, R¹ and R² are optionally bonded with each other to form a ring, or R³ and R⁴ are optionally bonded with each other to form a ring,
R⁵ to R⁸ are each independently a hydrogen atom, or a substituted or unsubstituted alkyl group having 1 to 30 carbon atoms, and
* is a bonding position with another atom, 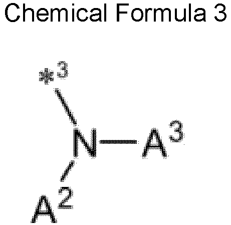
wherein, in Chemical Formula 3,
A² and A³ are each independently a substituted or unsubstituted aromatic ring group having 6 to 30 ring-forming atoms, or a substituted or unsubstituted heteroaromatic ring group having 3 to 30 ring-forming atoms, and
*³ is a bonding position with another atom,

   Chemical Formula 2 *²-A⁴-*²
wherein, in Chemical Formula 2,
A⁴ is a substituted or unsubstituted aromatic ring group having 6 to 60 ring-forming atoms, or a substituted or unsubstituted heteroaromatic ring group having 3 to 60 ring-forming atoms, and
*² is a bonding position with another atom.

As used herein, the term "structural unit represented by Chemical Formula 1" is also referred to as "structural unit (1)" or "structural unit (1)" according to an embodiment."

In addition, as used herein, the term "structural unit represented by Chemical Formula 2" is also referred to as "structural unit (2)" or "structural unit (2)" according to an embodiment."

Another aspect provides a composition including the copolymer according to an embodiment, and at least one material that is a hole transport material, an electron transport material, or a light emitting material.

Another aspect provides a composition including the copolymer according to an embodiment, and at least one solvent.

Another aspect provides an electroluminescent device including a pair of electrodes, and at least one organic layer that includes a composition including the copolymer according to an embodiment, wherein the organic layer is disposed between the pair of electrodes. As used herein, the electroluminescent device may also be referred to as "LED."

As used herein, the quantum dot electroluminescent device may also be referred to as "QLED."

As used herein, the organic electroluminescent device may also be referred to as "OLED."

An electroluminescent device can be manufactured by sequentially stacking a hole transport layer, a light emitting layer, an electron transport layer, or the like. As a method for forming such a stacked structure, a deposition method using low-molecular materials or a wet method using polymer materials may be used. Among these, wet methods can be used from the perspectives of large screens, efficiency, and low cost, and recently, it is expected that coating processes using a coating method will be adopted because they can manufacture higher-precision devices. However, designing materials capable of forming stacked structures has become a challenge.

Since the copolymer according to an embodiment has the above-described properties, i.e., a high resistance to solvents used in forming an adjacent layer, it becomes possible to manufacture an electroluminescent device by a coating method. Without wishing to be limited to theory, the mechanism of exerting the above-mentioned effect by the configuration of an embodiment is presumed to be as follows.

The fluorene ring has two aromatic rings on the same plane, and thus, has rigid molecular structure. The structural unit represented by Chemical Formula 1 has multiple fluorene rings in the structure, and further includes the structural unit represented by Chemical Formula 2, which is an aromatic ring group or a heteroaromatic ring group. Therefore, it is thought that a packing structure is formed in which molecules are densely arranged (stacked) within a layer by a highly planar molecular structure or π-π stacking interaction. For this reason, once the film is formed, when it comes into contact with another solvent (for example, when an upper layer ink is applied over the film), it is difficult for the other solvent to enter the gap between the copolymers, and it has excellent resistance to the solvent used in forming the adjacent layer. Without being limited to theory, the copolymer having the structural unit represented by Chemical Formula 1 and the structural unit represented by Chemical Formula 2 has excellent solvent resistance (high film retention rate) when another layer is formed on the surface of the layer by a wet method. The above characteristics can be particularly exhibited when the copolymer according to an embodiment is used in a hole transport layer.

Therefore, by using the copolymer according to an embodiment, it becomes possible to manufacture an electroluminescent device by a coating method.

In addition, by applying the copolymer according to an embodiment to an electroluminescent device (e.g., a hole transport layer of an electroluminescent device), a higher luminous efficiency can be exhibited compared to when other known materials are used. In addition, by applying the copolymer according to an embodiment to an electroluminescent device (e.g., a hole transport layer of an electroluminescent device), the durability (luminescence life-span) can be improved compared to when other known materials are used. Without wishing to be bound to theory, the mechanism of exerting the above-mentioned effect by the configuration of an embodiment is presumed to be as follows. According to the copolymer having the structural unit represented by Chemical Formula 1 and the structural unit represented by Chemical Formula 2, since it has a molecular structure with a large π conjugated system, the hole transport property may be improved. In addition, the copolymer having the structural unit represented by Chemical Formula 1 and the structural unit represented by Chemical Formula 2 may have a HOMO level suitable for hole injection into a light emitting layer (e.g., a quantum dot light emitting layer). Accordingly, a high luminous efficiency can be exhibited in electroluminescent devices (e.g., quantum dot electroluminescent devices or the like). In addition, the durability (luminescence life-span) of the electroluminescent device can be improved by a dense film.

In addition, since the copolymer according to an embodiment has a large π conjugated system, a dissociation energy of the bond linking the nitrogen atom and the fluorene structure is greater than a bond dissociation energy of the nitrogen atom and the benzene structure. Therefore, deterioration of the polymer material is suppressed, and the durability (luminescence life-span) of the electroluminescent device can be improved.

Also, typically, in order to have a higher film retention rate, the molecular weight should be larger to reduce the copolymer solubility in the solvent, but compounds with large molecular weights tend to have higher viscosity in the solution. The copolymer according to an embodiment can have excellent solvent resistance (higher film retention) even at a lower molecular weight due to its structure, and therefore can suppress an increase in viscosity when made into a solution. Due to these properties, it may be possible to manufacture an electroluminescent device by a coating method (particularly, an inkjet printing method) using the copolymer according to an embodiment.

The above mechanisms are speculative, and embodiments are not limited thereto.

Hereinafter, exemplary embodiments are described in further detail. However, the present disclosure is not limited to the following embodiments. In addition, each drawing is exaggerated for convenience of explanation, and the dimensional ratio of each component in each drawing may differ from the actual size. In addition, when an embodiment is described with reference to drawings, the same elements in the description of the drawings are given the same reference numerals and redundant descriptions are omitted. Accordingly, the exemplary embodiments are described below, by referring to the figure, to explain one or more aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." **It** will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

**It** will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (*i.e*., the limitations of the measurement system). For example, "about" can mean within one or more standard deviations, or within ± 30%, 20%, 10%, 5% of the stated value.

Unless otherwise specified, measurements of operation and physical properties, etc. are made at room temperature (20°C or higher and 25°C or lower) and relative humidity (RH) of 40% or higher and 50% or lower.

In this specification, "x and y are each independently" means that x and y may be the same or different.

In the present specification, the term "group derived from "Compound z" refers to a group in which, when "Compound z" is a cyclic compound, it represents a group with a free atom valence by excluding the hydrogen atoms directly bonded to the ring-forming atoms by the valence from that ring structure.

In this specification, "structural unit" may refer to a structure that is a repeating unit of a copolymer. In other words, the copolymer according to an embodiment may include a repeating unit represented by Chemical Formula 1 and a repeating unit represented by Chemical Formula 2. In other embodiments, the copolymer may include a repeating unit that includes a structural unit represented by Chemical Formula 1 and a structural unit represented by Chemical Formula 2.

In the present specification, the number of ring-forming atoms refers to the number of atoms forming the ring itself of a compound (e.g., a monocyclic compound, a condensed ring compound, a bridged compound, a carbocyclic compound, and a heterocyclic compound) having a structure in which atoms are bonded in a ring (e.g., a monocyclic ring, a condensed ring, and a ring assembly). Atoms that do not form a ring (e.g., hydrogen atoms terminating bonds of atoms forming a ring) or atoms included in a substituent when the ring is substituted by a substituent group are not included in the number of ring-forming atoms. The number of ring-forming atoms described below is the same unless otherwise stated.

For example, the benzene ring has 6 ring-forming atoms, the naphthalene ring has 10 ring-forming atoms, the pyridine ring has 6 ring-forming atoms, and the furan ring has 5 ring-forming atoms.

When a benzene ring is substituted with, for example, an alkyl group, the number of carbon atoms of the alkyl group is not included in the number of ring-forming atoms of the benzene ring. For this reason, the number of ring-forming atoms in the benzene ring substituted by the alkyl group is 6. In addition, when an alkyl group, for example, is substituted as a substituent on the naphthalene ring, the number of atoms of the alkyl group is not included in the number of ring-forming atoms of the naphthalene ring. For this reason, the number of ring-forming atoms of the naphthalene ring substituted by the alkyl group is 10.

For example, the number of hydrogen atoms bonded to a pyridine ring or atoms forming a substituent is not included in the number of ring-forming atoms of the pyridine ring. For this reason, the number of ring-forming atoms in the pyridine ring to which hydrogen atoms or substituents are bonded is 6.

In the present specification, unless specifically defined, "substituted" means substitution with a halogen atom, an alkyl group, a cycloalkyl group, a hydroxyalkyl group, a haloalkyl group, an alkoxyalkyl group, an alkoxy group, a cycloalkoxy group, an alkenyl group, an alkynyl group, an amino group, an aryl group, an aryloxy group, an alkylthio group, a cycloalkylthio group, an arylthio group, an alkoxycarbonyl group, an aryloxycarbonyl group, a hydroxy group (-OH), a carboxyl group (-COOH), a thiol group (-SH), a cyano group (-CN), a diarylamino group, an arylheteroarylamino group, or a combination thereof. In some cases, the substituent that exists is not identical to the group being substituted. For example, an alkyl group is not substituted with another alkyl group. However, in some cases, when a different substituent is inserted, this is not limited, and for example, when alkyl group is substituted with an aromatic ring group, the aromatic hydrocarbon group may be substituted with alkyl group.

Here, the alkyl group as a substituent may be either linear or branched, but examples thereof include a linear alkyl group having 1 to 30, 1 to 10, or 1 to 5 carbon atoms, and a branched alkyl group having 3 to 30, 3 to 10, or 3 to 5 carbon atoms. Specifically, non-limiting examples of the alkyl group include a methyl group, an ethyl group, a n-propyl group, an isopropyl group, a n-butyl group, an isobutyl group, a sec-butyl group, a tert-butyl group, a n-pentyl group, an isopentyl group, a tert-pentyl group, a neopentyl group, a 1,2-dimethylpropyl group, a n-hexyl group, an isohexyl group, a 1,3-dimethylbutyl group, a 1-isopropylpropyl group, a 1,2-dimethylbutyl group, a n-heptyl group, a 1,4-dimethylpentyl group, a 3-ethylpentyl group, a 2-methyl-1-isopropylpropyl group, a 1-ethyl-3-methylbutyl group, a n-octyl group, a 2-ethylhexyl group, a 3-methyl-1-isopropylbutyl group, a 2-methyl-1-isopropylbutyl group, a 1-tert-butyl-2-methylpropyl group, a n-nonyl group, a 3,5,5-trimethylhexyl group, a n-decyl group, an isodecyl group, a n-undecyl group, a 1-methyldecyl group, a n-dodecyl group, a n-tridecyl group, a n-tetradecyl group, a n-pentadecyl group, a n-hexadecyl group, a n-heptadecyl group, a n-octadecyl group, a n-nonadecyl group, a n-icosyl group, or the like.

Non-limiting examples of the cycloalkyl group as a substituent may have 3 to 20, 4 to 10, or 5 to 8 carbon atoms, and include a cyclopropyl group, a cyclobutyl group, a cyclopentyl group, a cyclohexyl group, or the like.

Non-limiting examples of the haloalkyl group as a substituent include a fluoromethyl group, a difluoromethyl group, a trifluoromethyl group, a bromomethyl group, a dibromomethyl group, a tribromomethyl group, an iodomethyl group, a diiodomethyl group, a triiodomethyl group, or the like.

As a hydroxyalkyl group, non-limiting examples thereof include those in which the alkyl group is substituted with 1 or more and 3 or less (for example, 1 or more and 2 or less, particularly for example, 1 hydroxyl groups (for example, a hydroxymethyl group, a hydroxyethyl group, or the like).

As an alkoxyalkyl group as a substituent, for example, the alkyl group may be substituted with 1 or more and 3 or less (for example, 1 or more and 2 or less, particularly for example, 1) alkoxy groups as described in detail below.

The alkoxy group as a substituent may be either linear or branched, but examples thereof include a linear alkoxy group having 1 to 30 carbon atoms, and a branched alkoxy group having 3 to 30 carbon atoms. Non-limiting examples thereof include a methoxy group, an ethoxy group, a propoxy group, an isopropoxy group, a butoxy group, a pentyloxy group, a hexyloxy group, a heptyloxy group, an octyloxy group, a nonyloxy group, a decyloxy group, an undecyloxy group, a dodecyloxy group, a tridecyloxy group, a tetradecyloxy group, a pentadecyloxy group, a hexadecyloxy group, a heptadecyloxy group, an octadecyloxy group, a 2-ethylhexyloxy group, a 3-ethylpentyloxy group, or the like.

Non-limiting examples of the cycloalkoxy group as a substituent include a cyclopropoxy group, a cyclobutoxy group, a cyclopentoxy group, a cyclohexyloxy group, or the like.

Non-limiting examples of the alkenyl group may have 2 to 20, 2 to 10, or 2 to 5 carbon atoms, and include a vinyl group, an allyl group, a 1-propenyl group, an isopropenyl group, a 1-butenyl group, a 2-butenyl group, a 3-butenyl group, a 1-pentenyl group, a 2-pentenyl group, a 3-pentenyl group, a 1-hexenyl group, a 2-hexenyl group, a 3-hexenyl group, a 1-heptenyl group, a 2-heptenyl group, a 5-heptenyl group, a 1-octenyl group, a 3-octenyl group, a 5-octenyl group, or the like.

Non-limiting examples of the alkynyl group as a substituent may have 2 to 20, 2 to 10, or 2 to 5 carbon atoms, and include an acetylenyl group, a 1-propynyl group, a 2-propynyl group, a 1-butynyl group, a 2-butynyl group, a 3-butynyl group, a 1-pentynyl group, a 2-pentynyl group, a 3-pentynyl group, a 1-hexynyl group, a 2-hexynyl group, a 3-hexynyl group, a 1-heptynyl group, a 2-heptynyl group, a 5-heptynyl group, a 1-octynyl group, a 3-octynyl group, a 5-octynyl group, or the like.

As an aromatic ring group (also referred to as an "aryl group" in the present specification) as a substituent, an aromatic ring group having 6 to 30, 6 to 20, or 6 to 10 carbon atoms may be exemplified. Non-limiting examples include a phenyl group, a naphthyl group, a benzocyclobutenyl group, a biphenyl group, a fluorenyl group, a spiro-bifluorenyl group, anthryl group, a pyrenyl group, an azulenyl group, an acenaphthylenyl group, a terphenyl group, a phenanthryl group, or the like.

Non-limiting examples of the aryloxy group as a substituent include a phenoxy group, a naphthoxy group, or the like.

Non-limiting examples of the alkylthio group as a substituent include a methylthio group, an ethylthio group, a propylthio group, a pentylthio group, a hexylthio group, an octylthio group, a dodecylthio group, or the like.

Non-limiting examples of the cycloalkylthio group as a substituent include a cyclopentylthio group, a cyclohexylthio group, or the like.

Non-limiting examples of the arylthio group as a substituent include a phenylthio group, a naphthylthio group, or the like.

Non-limiting examples of the alkoxycarbonyl group as a substituent include a methoxycarbonyl group, an ethoxycarbonyl group, a butoxycarbonyl group, an octoxycarbonyl group, a dodecyloxycarbonyl group, or the like.

Non-limiting examples of the aryloxycarbonyl group as a substituent include a phenoxycarbonyl group, a naphthoxycarbonyl group, or the like.

Non-limiting examples of the diarylamino group as a substituent include an N,N-diphenylamino group, an N-naphthyl-N-phenylamino group, an N-biphenylyl-N-phenylamino group, an N-fluorenyl-N-phenylamino group, an N-phenyl-N-spirobifluorenylamino group, an N-naphthyl-N-spirobifluorenylamino group, an N-biphenylyl-N-spirobifluorenylamino group, an N-fluorenyl-N-spirobifluorenylamino group, an N-naphthylphenyl-N-spirobifluorenylamino group, an N-fluorenylphenyl-N-spirobifluorenylamino group, or the like.

Non-limiting examples of the arylheteroarylamino group as a substituent include an N-dibenzofuranyl-N-phenylamino group, an N-dibenzothienyl-N-phenylamino group, an N-dibenzofuranyl-N-spirobifluorenylamino group, an N-dibenzothienyl-N-spirobifluorenylamino group, or the like.

In addition, as used herein, an "heteroaromatic ring group" is a substituent derived from an aromatic ring compound having one or more heteroatoms (e.g., nitrogen atom (N), oxygen atom (O), phosphorus atom (P), sulfur atom (S), silicon atom (Si), selenium atom (Se), etc.) as ring-forming atoms, and the remaining ring-forming atoms are carbon atoms (C). Non-limiting examples of the heteroaromatic ring group having 3 to 60 ring-forming atoms are not particularly limited, and non-limiting examples thereof include a group derived from a heteroaromatic ring compound such as, for example, pyridine, pyrazine, pyridazine, pyrimidine, triazine, quinoline, isoquinoline, quinoxaline, quinazoline, naphthyridine, acridine, phenazine, benzoquinoline, benzoisoquinoline, phenanthridine, phenanthroline, coumarin, furan, thiophene, benzofuran, benzothiophene, dibenzofuran, dibenzothiophene, pyrrole, indole, carbazole, imidazole, benzimidazole, pyrazole, indazole, oxazole, isoxazole, benzoxazole, benzoisoxazole, thiazole, isothiazole, benzothiazole, benzoisothiazole, imidazolinone, benzimidazolinone, imidazopyridine, imidazopyrimidine, azadibenzofuran, azacarbazole, azadibenzothiophene, diazadibenzofuran, diazacarbazole, diazadibenzothiophene, xanthone, thioxanthone, or the like.

As used herein, the "ethylene glycol group or oligoethylene glycol group" may be, for example, a group represented by Chemical Formula A:

Chemical Formula A *^{a1}-(CH₂-CH₂-O)ₙ-R

In Chemical Formula A,
R may be a hydrogen atom, or an alkyl group having 1 to 6 carbon atoms, n may be an integer of 1 to 10, and *^{a1} may be a bonding position with another atom.

Non-limiting examples of the ethylene glycol group or oligoethylene glycol group as a substituent include a 2-methoxyethyl group, a 2-(2-methoxyethoxy)ethyl group, a 2-[2-(2-methoxyethoxy)ethoxy]ethyl group, or the like.

As used herein, unless otherwise stated, substituents may include possible positional isomers. For example, the naphthyl group may be a 1-naphthyl group and/or a 2-naphthyl group, and the biphenylyl group may be at least one of a (1,1'-biphenyl)-2-yl group, a (1,1'-biphenyl)-3-yl group, or a (1,1'-biphenyl)-4-yl group.

In the chemical formulas as used herein, unless otherwise defined, if a chemical bond is not drawn at a position where a chemical bond should be drawn, it means that a hydrogen atom is bonded at that position.

In this specification, "the substituent is a hydrogen atom" means unsubstituted. For example, if all four R⁹ groups in Chemical Formula 5 are hydrogen atoms, the group represented by Chemical Formula 5 is an unsubstituted phenylene group.

In the present specification, symbols accompanying "*" in the text or chemical formula, for example, *, *² to *⁷, *', *²', and *^{a1} to *^{a6}, each indicate a bonding position with another atom.

### Copolymer

The copolymer according to an embodiment includes a structural unit represented by Chemical Formula 1 and a structural unit represented by Chemical Formula 2. The copolymer having this structure can achieve both improvement in resistance to a solvent used in forming an adjacent layer (so-called film retention rate) and suppression of high viscosity. In addition, the current efficiency and luminescence life-span of an electroluminescent device including the copolymer can be improved. According to an embodiment, a copolymer may include one type of structural unit (structural unit (1)) of Chemical Formula 1, or may include two or more types of structural units (1), and may include one type of structural unit (structural unit (2)) of Chemical Formula 2, or may include two or more types of structural units (2). The plurality of structural units (1) may exist in a block type, a random type, or an alternating type of copolymer. Likewise, a plurality of structural units (2) may exist in a block type, a random type, or an alternating type of copolymer. In addition, the arrangement of the structural unit (1) and the structural unit (2) is not particularly limited, and may be block type (block copolymer), random type (random copolymer), or alternating type (alternating copolymer).

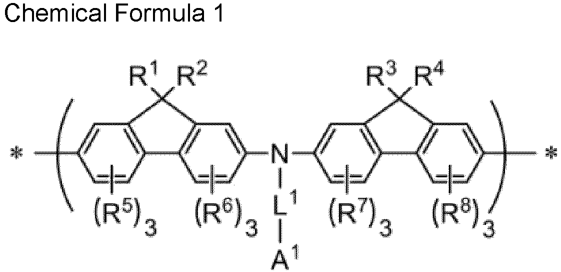

In Chemical Formula 1,
A¹ is a substituted or unsubstituted aromatic ring group having 6 to 60 ring-forming atoms, a substituted or unsubstituted heteroaromatic ring group having 3 to 60 ring-forming atoms, or a group represented by Chemical Formula 3, and
* is a bonding position with another atom.

The aromatic ring group having 6 to 60 ring-forming atoms is not particularly limited, but may be, for example, a group having 1 to 5 aromatic rings. Non-limiting examples thereof include a phenyl group, a pentalenyl group, an indenyl group, a naphthyl group, anthranyl group, an azulenyl group, a heptalenyl group, an acenaphthenyl group, a phenalenyl group, a fluorenyl group, a phenanthryl group, a biphenylyl group, a terphenyl group, a quaterphenyl group, a quinquephenyl group, a pyrenyl group, a 9,9-diphenylfluorenyl group, a 9,9'-spirobi[fluoren]-yl group, a 9,9-dialkylfluorenyl group, a bicyclo[4.2.0]octa-1,3,5-trienyl group, or the like. The heteroaromatic ring group having 3 to 60 ring-forming atoms is not particularly limited, but may be, for example, a group having 1 to 5 ring structures. Non-limiting examples thereof include an acridinyl group, a phenazinyl group, a benzoquinolyl group, a benzoisoquinolyl group, a phenanthridinyl group, a phenanthrolinyl group, an anthraquinonyl group, a fluorenonyl group, a dibenzofuranyl group, a dibenzothiophenyl group, a carbazolyl group, an imidazophenanthridinyl group, a benzimidazophenanthridinyl group, an azadibenzofuranyl group, a 9-phenylcarbazolyl group, an azacarbazolyl group, an azadibenzothiophenyl group, a diazadibenzofuranyl group, a diazacarbazolyl group, a diazadibenzothiophenyl group, a xanthonyl group, a thioxanthonyl group, a pyridinyl group, a quinolinyl group, an anthraquinolinyl group, or the like.

In some embodiments, A¹ in Chemical Formula 1 may be a group represented by Chemical Formula 7. In a case of such a structure, the copolymer according to an embodiment can suppress high viscosity when made into a solution, and can also have excellent solvent resistance (a high film retention rate).

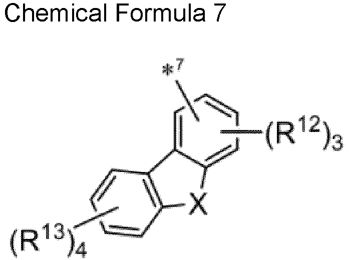

In Chemical Formula 7,
R¹² and R¹³ may each independently be a hydrogen atom, a substituted or unsubstituted aromatic ring group having 6 to 30 ring-forming atoms, or a substituted or unsubstituted alkyl group having 1 to 30 carbon atoms, and
*⁷ is a bonding position with another atom.

In Chemical Formula 7, R¹² is a substituent on the benzene ring that is bonded to L¹ of Chemical Formula 1, and R¹³ is a substituent on the other benzene ring that is not bonded to L¹. Each R¹² and R¹³ may be the same or different. Additionally, when there are a plurality of R¹² groups, they may be the same or different, and when there are a plurality of R¹³ groups, they may be the same or different. The aromatic ring group having 6 to 30 ring-forming atoms is not particularly limited, but may be a group having 1 to 5 aromatic hydrocarbon rings. Non-limiting examples thereof include a phenyl group, a pentalenyl group, an indenyl group, a naphthyl group, anthranyl group, an azulenyl group, a heptalenyl group, an acenaphthenyl group, a phenalenyl group, a fluorenyl group, a phenanthryl group, a biphenylyl group, a terphenyl group, a quaterphenyl group, a quinquephenyl group, a pyrenyl group, or the like. As the alkyl group having 1 to 30 carbon atoms, the same alkyl groups listed in the above "substituent" can be exemplified. Additionally, the alkyl group may be linear or branched, but may be for example linear.

In addition, when the substitution positions are 1st, 2nd, 3rd, and 4th in a clockwise direction from the substitution position on the lower right of the benzene ring bonded to L¹ of Chemical Formula 1 of Chemical Formula 7, R¹² may be introduced at any substitution position except the position bonded to L¹. When the substitution positions are 8th, 7th, 6th, and 5th counterclockwise from the substitution positions on the lower right of the benzene ring that is not bonded to L¹ in Chemical Formula 7, R¹³ may be introduced at any substitution position. For example, the substitution position of R¹³ may be at 6th position and/or 7th position, or may be at 6th position.

In Chemical Formula 7, X represents *'-C(R¹⁴)(R¹⁵)-*', *'-N(R¹⁶)-*', *'-O-*', or *'-S-*', and *' represents a bonding position with another atom. X may include a heteroatom in its structure, a heteroaromatic ring group, an ether structure, an amine structure, or a sulfide structure. X may include a nitrogen atom in its structure, or may include a nitrogen-containing heteroaromatic ring group or an amine structure.

When X is *'-C(R¹⁴)(R¹⁵)-*', R¹⁴ and R¹⁵ may each independently be a substituted or unsubstituted aromatic ring group having 6 to 30 carbon atoms, or a substituted or unsubstituted alkyl group having 1 to 30 carbon atoms, and R¹⁴ and R¹⁵ may be bonded to each other to form a ring structure together with the carbon atoms to which each is bonded. As an aromatic ring group having 6 to 30 carbon atoms, the same aromatic ring groups listed in the above "substituent" may be exemplified. As the alkyl group having 1 to 30 carbon atoms, the same alkyl groups listed in the above "substituent" may be exemplified.

When X is *'-N(R¹⁶)-*', R¹⁶ may be a substituted or unsubstituted aromatic ring group having 6 to 30 ring-forming atoms, a substituted or unsubstituted heteroaromatic ring group having 3 to 30 ring-forming atoms, or a substituted or unsubstituted alkyl group having 1 to 30 carbon atoms. The aromatic ring group having 6 to 30 carbon atoms is not particularly limited, and may be a group having 1 to 5 aromatic hydrocarbon rings. Non-limiting examples thereof may include a phenyl group, a pentalenyl group, an indenyl group, a naphthyl group, anthranyl group, an azulenyl group, a heptalenyl group, an acenaphthenyl group, a phenalenyl group, a fluorenyl group, a phenanthryl group, a biphenyl group, a terphenyl group, a quaterphenyl group, a quinquephenyl group, a pyrenyl group, or the like. As the heteroaromatic ring group having 3 to 30 ring-forming atoms, the same heteroaromatic ring groups listed in the above "substituent" may be exemplified. As the alkyl group having 1 to 30 carbon atoms, the same alkyl groups listed in the above "substituent" may be exemplified. In some embodiments, R¹⁶ may be a substituted or unsubstituted aromatic ring group having 6 to 30 ring-forming atoms, or a substituted or unsubstituted heteroaromatic ring group having 3 to 30 ring-forming atoms.

When X is *'-N(R¹⁶)-*', the structure represented by Chemical Formula 7 may be a structure represented by one of Group 1.

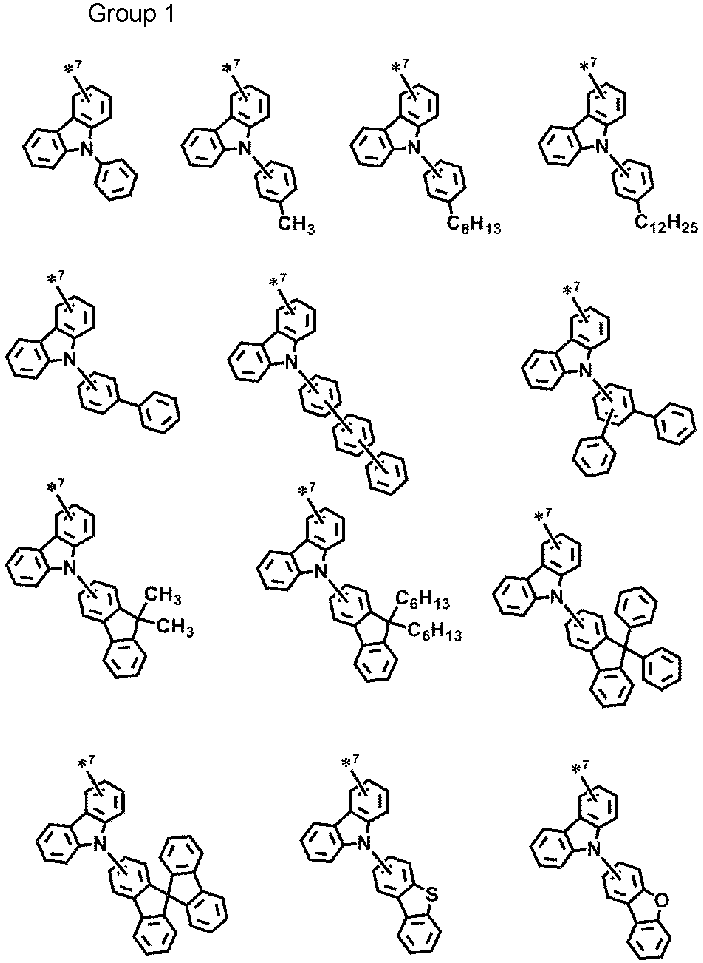

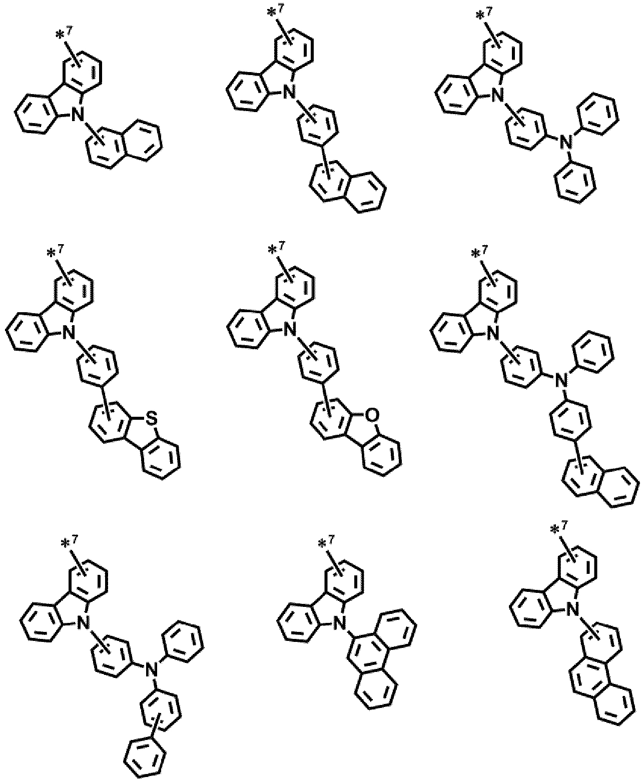

In Chemical Formula 7, *⁷ is a bonding position with another atom. In Chemical Formula 7, *⁷ may bind to L¹ of Chemical Formula 1. In Chemical Formula 7, *⁷ is substituted at one of the 1st, 2nd, 3rd, or 4th positions according to the numbering of the substitution positions defined above. Among them, for example, it may be substituted at 2nd position or 3rd position.

In addition, in an embodiment, A¹ in Chemical Formula 1 may have a structure represented by Chemical Formula 3. In the case of such a structure, the copolymer according to the present embodiment may suppress high viscosity when made into a solution, and may also have excellent solvent resistance (a high film retention rate).

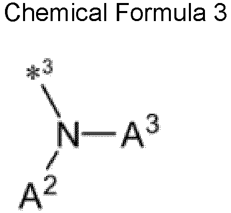

**In** Chemical Formula 3, A² and A³ are each independently a substituted or unsubstituted aromatic ring group having 6 to 30 ring-forming atoms or a substituted or unsubstituted heteroaromatic ring group having 3 to 30 ring-forming atoms. A² and A³ may be the same or different. As the aromatic ring group having 6 to 30 ring-forming atoms, the same aromatic ring groups as those listed in the above "substituent" may be exemplified. As the heteroaromatic ring group having 3 to 30 ring-forming atoms, the same heteroaromatic ring groups listed in the above "substituent" may be exemplified.

**In** Chemical Formula 3, *³ is a bonding position with another atom.

**In** chemical formula 1, L¹ is a single bond or a substituted or unsubstituted aromatic ring group having 6 to 60 ring-forming atoms. As the aromatic ring group having 6 to 60 ring-forming atoms, the same aromatic ring groups as those listed in A¹ of Chemical Formula 1 may be exemplified. **In** an embodiment, the substituted or unsubstituted aromatic ring group having 6 to 60 ring-forming atoms of L¹ may be a group represented by Chemical Formula 5 or Chemical Formula 6:

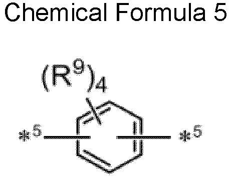

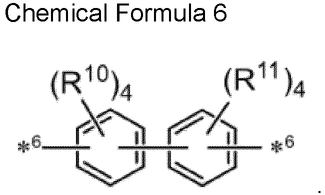

In Chemical Formula 5 and Chemical Formula 6, R⁹ to R¹¹ may each independently be a hydrogen atom, a substituted or unsubstituted aromatic ring group having 6 to 30 ring-forming atoms, or a substituted or unsubstituted alkyl group having 1 to 30 carbon atoms. As the aromatic ring group having 6 to 30 ring-forming atoms, the same aromatic ring groups as those listed in the above "substituent" may be exemplified. As the alkyl group having 1 to 30 carbon atoms, the same alkyl groups listed in the above "substituent" may be exemplified.

In Chemical Formula 5 and Chemical Formula 6, *⁵ and *⁶ are each a bonding position with another atom.

The structure of Chemical Formula 5 and/or Chemical Formula 6 may be a structure selected from the structures shown in Group 2. In the structures below, *⁵ and *⁶ are a bonding position with another atom, respectively.

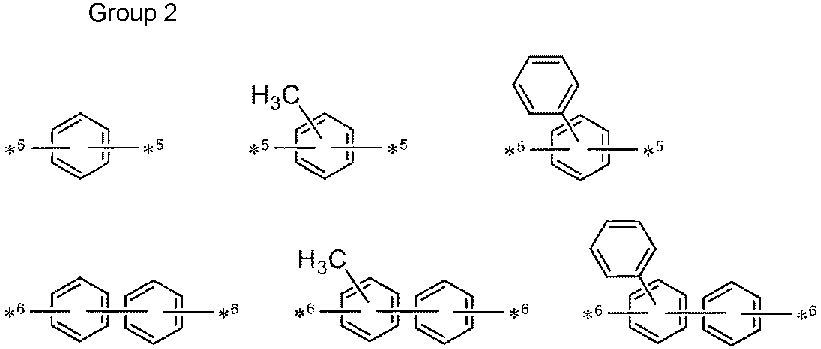

In some embodiments, in Chemical Formula 1, when A¹ is a group represented by Chemical Formula 7, L¹ of Chemical Formula 1 may be a group represented by Chemical Formula 5. In some embodiments, in Chemical Formula 1, when A¹ is the group represented by Chemical Formula 3, L¹ of Chemical Formula 1 may be a group represented by Chemical Formula 6.

In Chemical Formula 1, R¹ to R⁴ are each independently a substituted or unsubstituted aromatic ring group having 6 to 30 ring-forming atoms, a substituted or unsubstituted alkyl group having 1 to 30 carbon atoms, or a substituted or unsubstituted ethylene glycol group or oligoethylene glycol group having 2 to 30 carbon atoms. R¹ and R² are optionally bonded with each other to form a ring, or R³ and R⁴ are optionally bonded with each other to form a ring. As the aromatic ring group having 6 to 30 ring-forming atoms, the same aromatic ring groups as those listed in the above "substituent" may be exemplified. As the alkyl group having 1 to 30 carbon atoms, the same alkyl groups listed in the above "substituent" may be exemplified. As the ethylene glycol group or oligoethylene glycol group having 2 to 30 carbon atoms, non-limiting examples thereof include a group represented by Chemical Formula A shown in the above "substituent", or the same ethylene glycol group or oligoethylene glycol groups as those listed in the above "substituent".

In some embodiments, R¹ to R⁴ may each independently be a methyl group, a butyl group, a phenyl group, a p-hexylphenyl group, or a methoxyethoxyethyl group (*^{a2}-CH₂-CH₂-O-CH₂-CH₂-O-CH³, where *^{a2} is a bonding position with another atom), and substituents on the same carbon atom (i.e., corresponding to R¹ and R² and/or R³ and R⁴) may be bonded to form a ring.

In Chemical Formula 1, R⁵ to R⁸ are each independently a hydrogen atom, or a substituted or unsubstituted alkyl group having 1 to 30 carbon atoms. At this time, if there are a plurality of non-hydrogen R⁵ to R⁸, they may be the same or different. Additionally, each R⁵ to each R⁸ may be the same or different. As the alkyl group having 1 to 30 carbon atoms, the same alkyl groups listed in the above "substituent" may be exemplified. For example, in an embodiment, R⁵ to R⁸ may all be hydrogen atoms.

A specific example of the structural unit (1) of a copolymer according to an embodiment is shown in Group 3. In the structure below, * is a bonding position with another atom. That is, * is a binding site that forms the main chain.

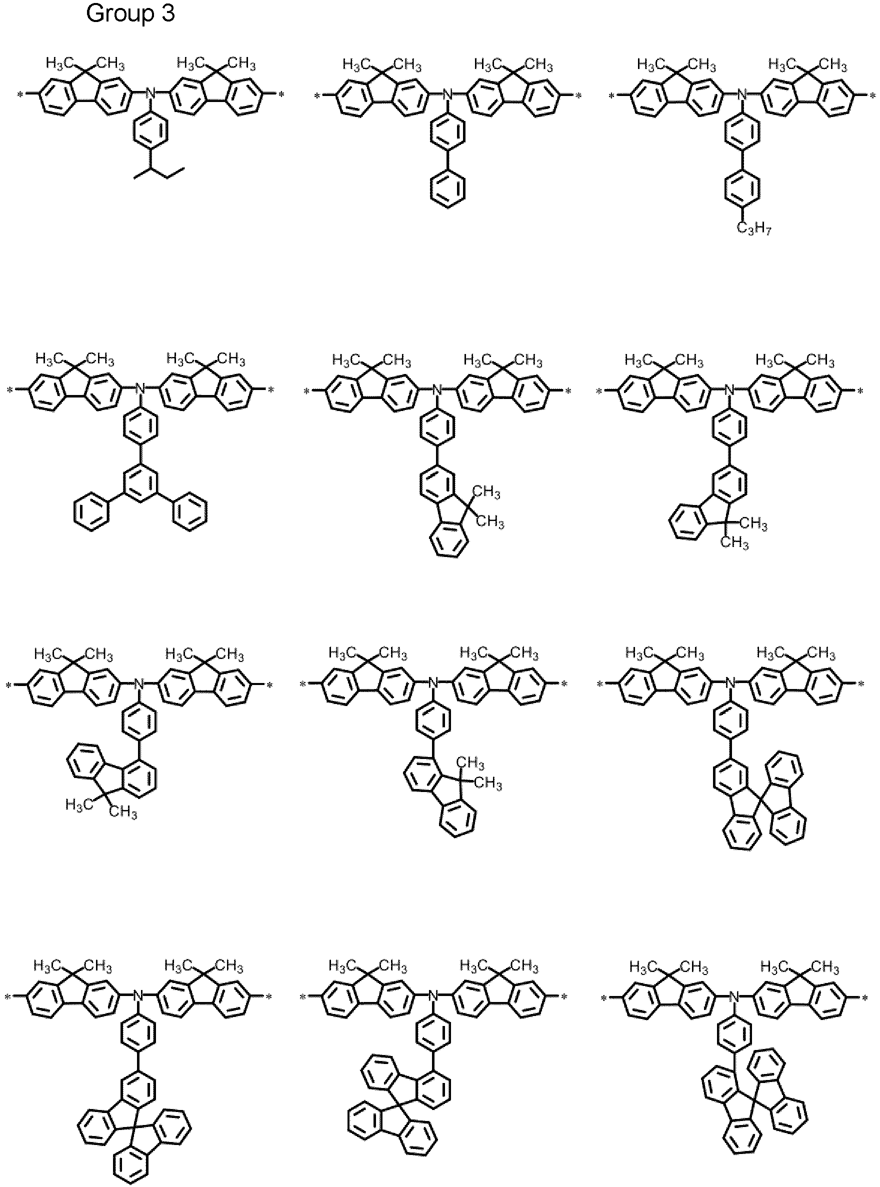

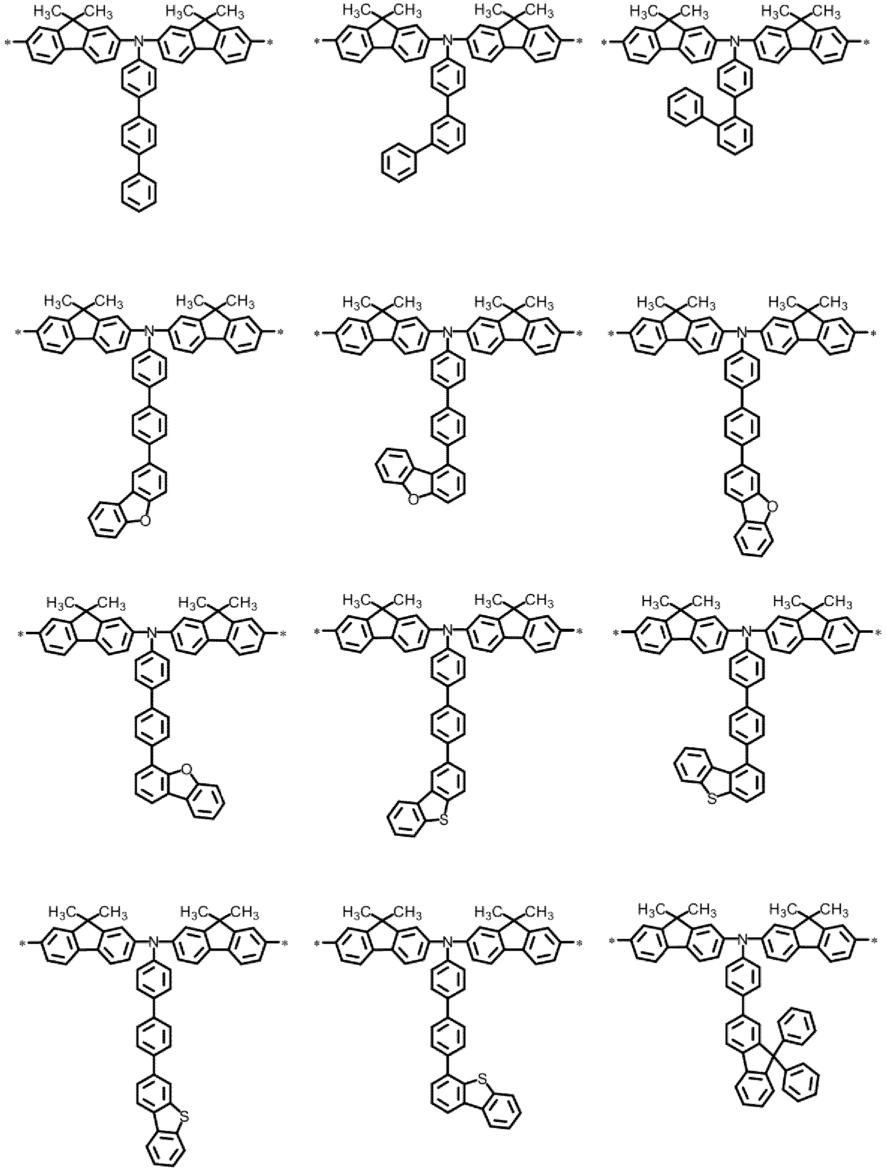

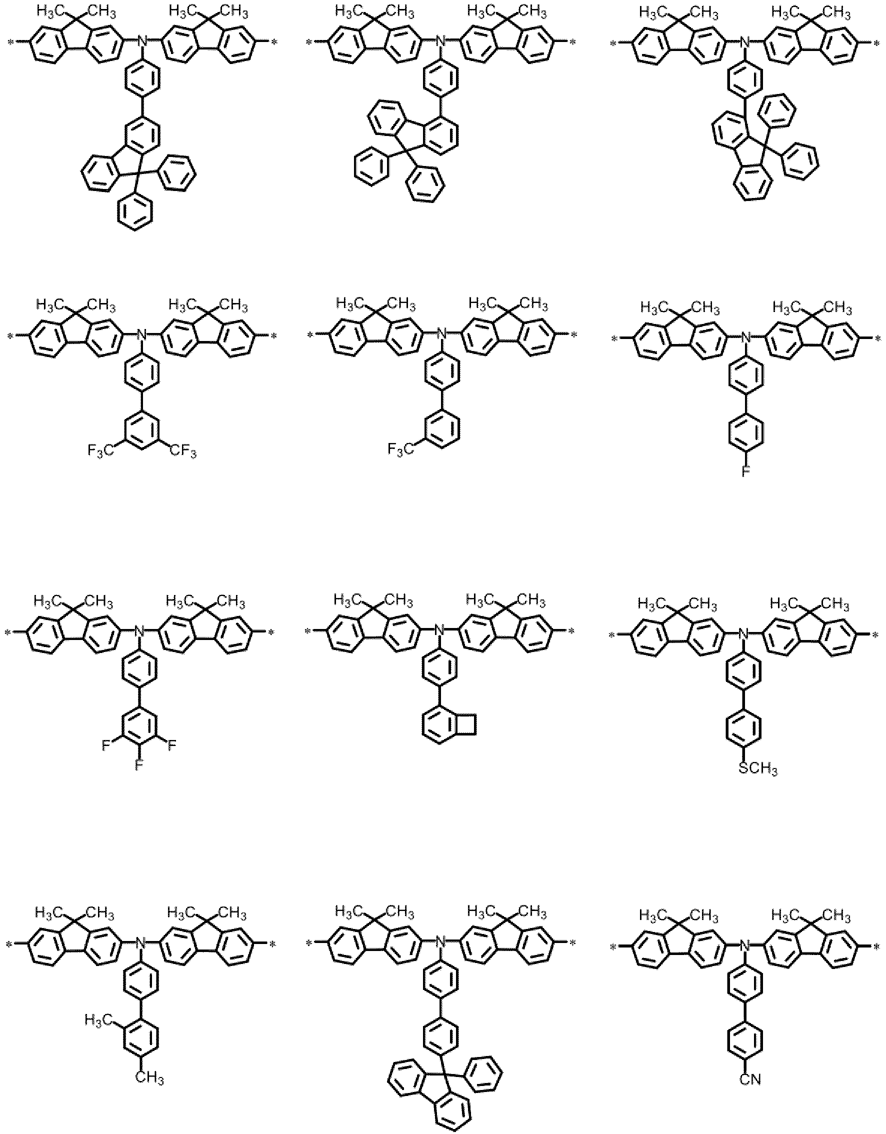

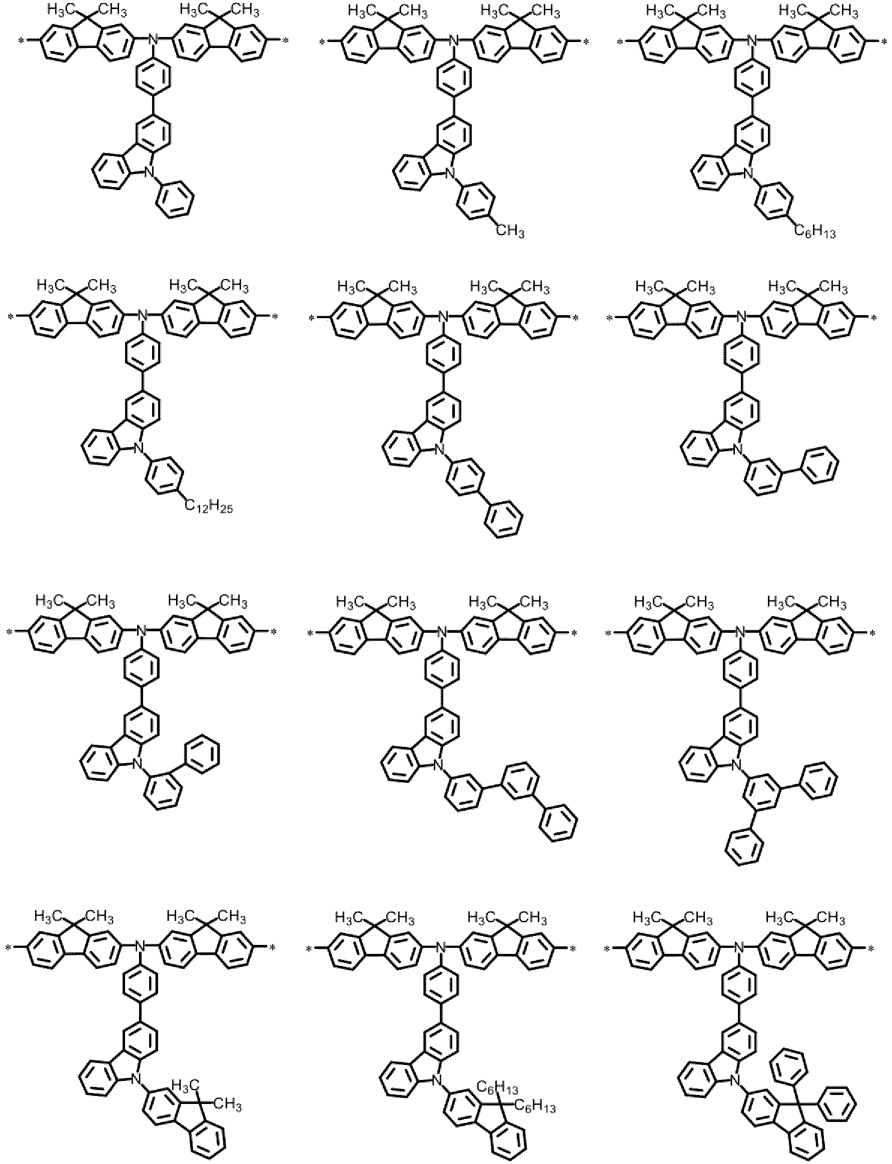

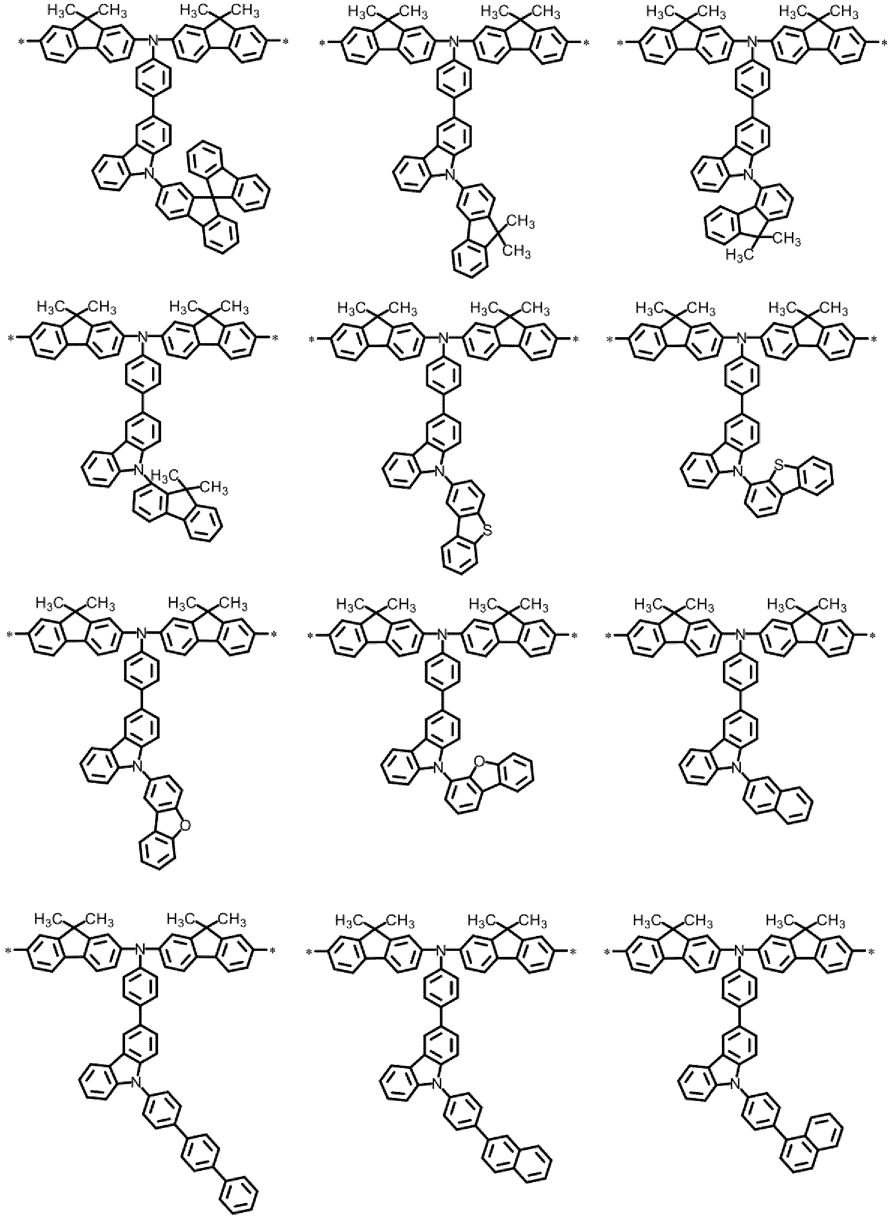

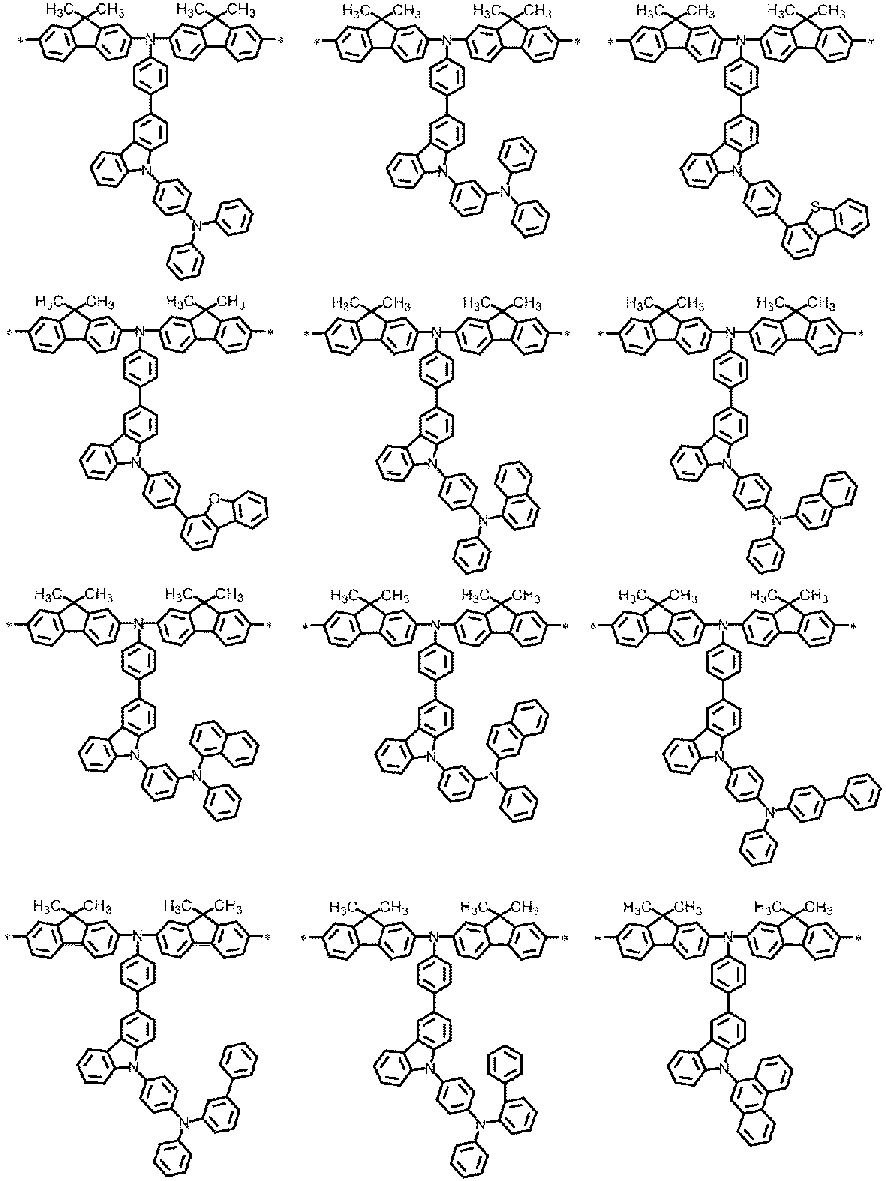

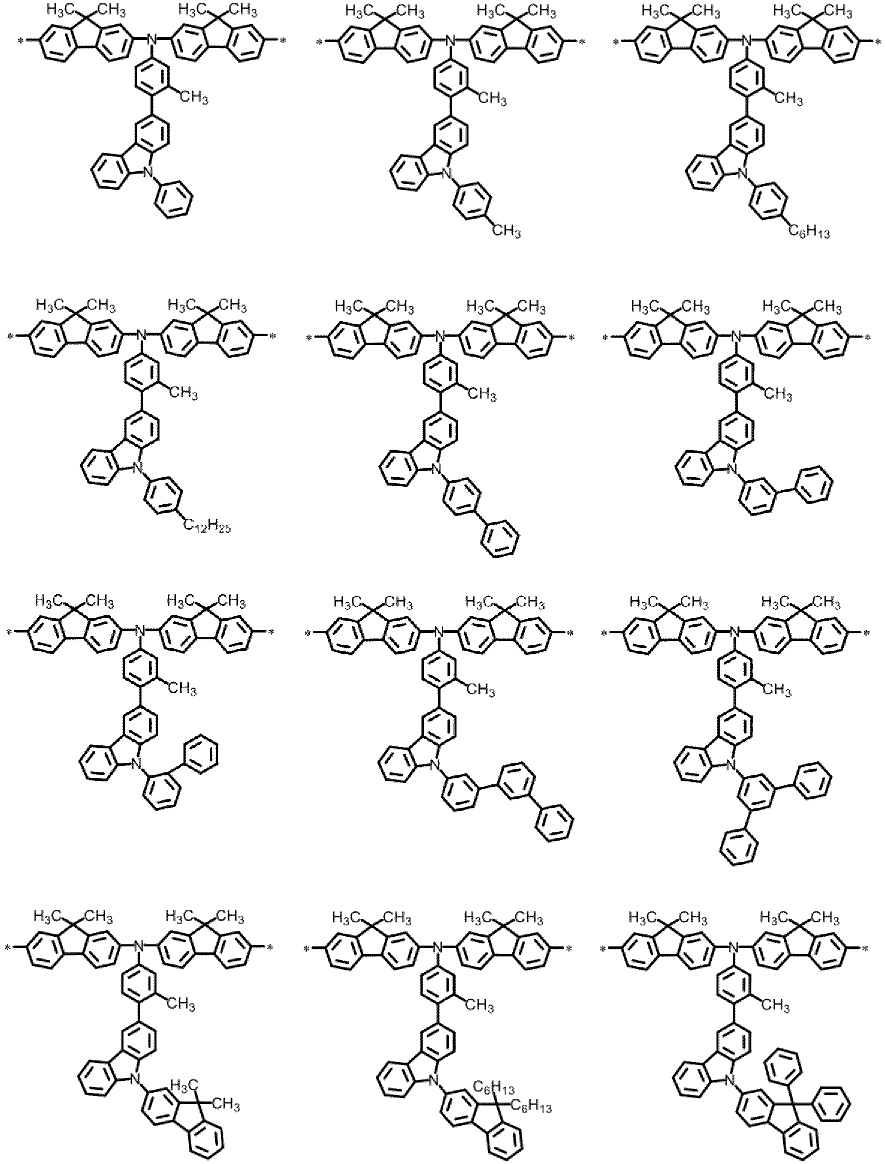

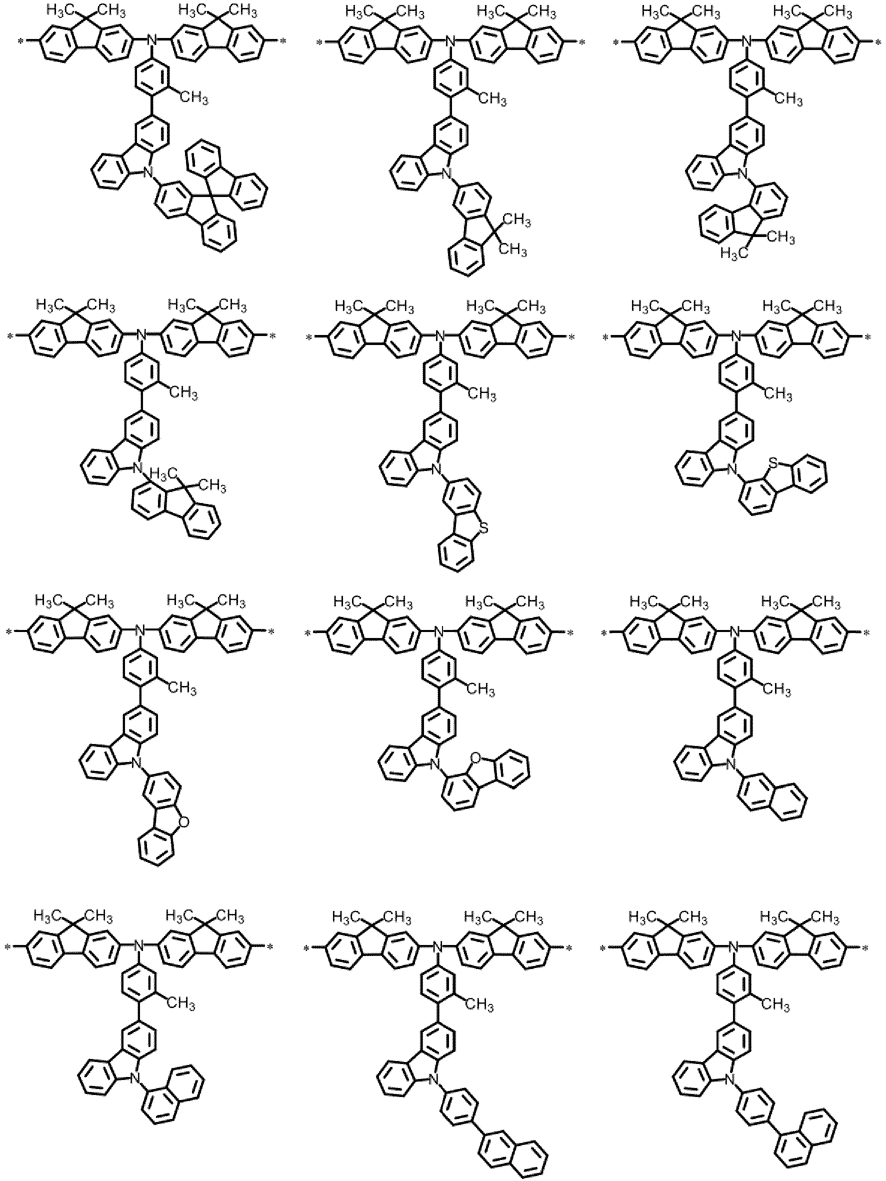

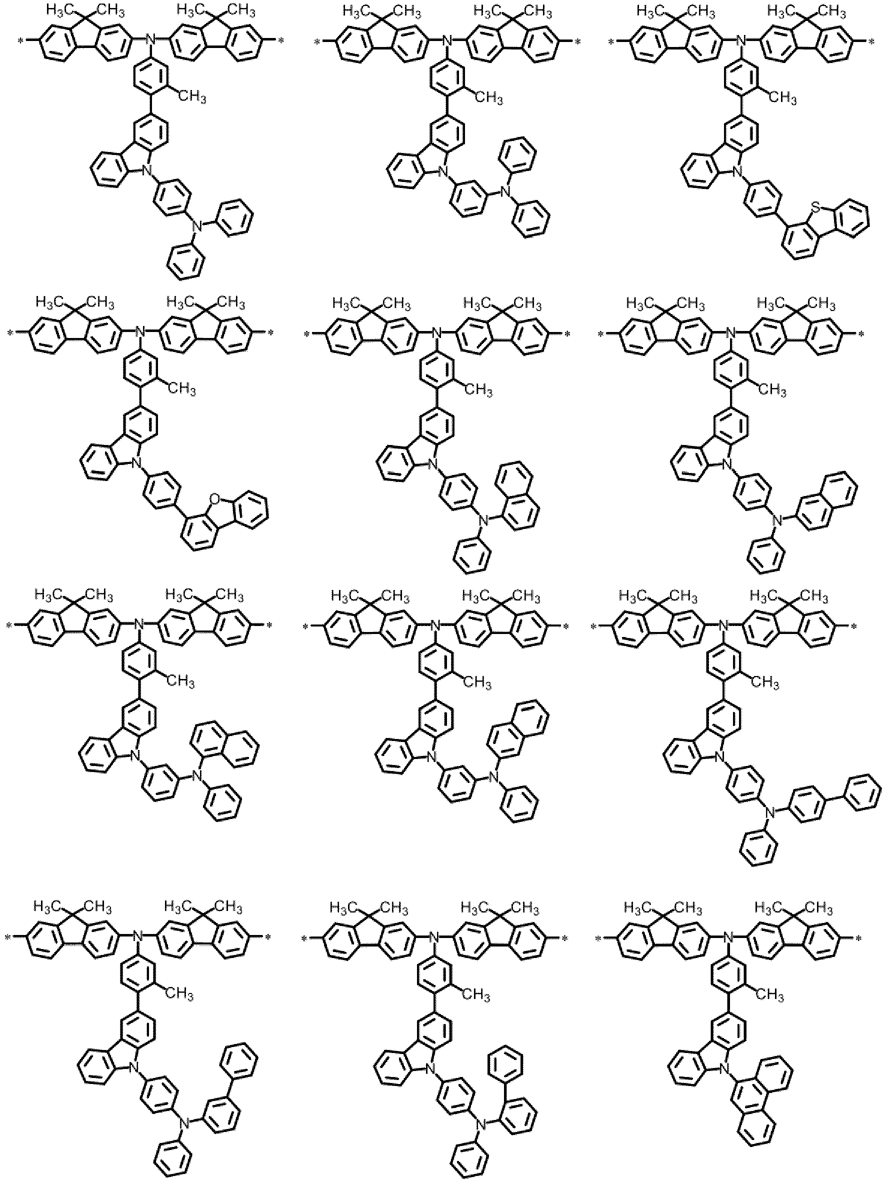

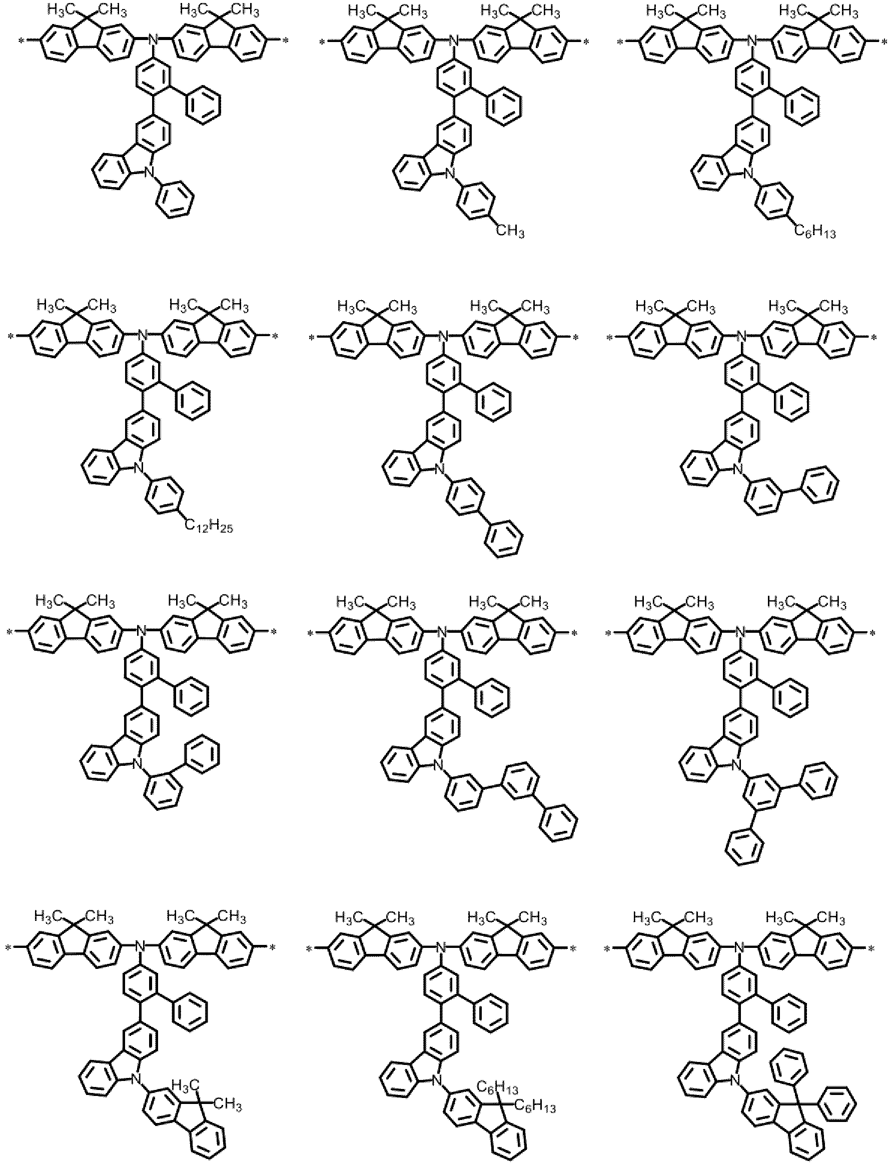

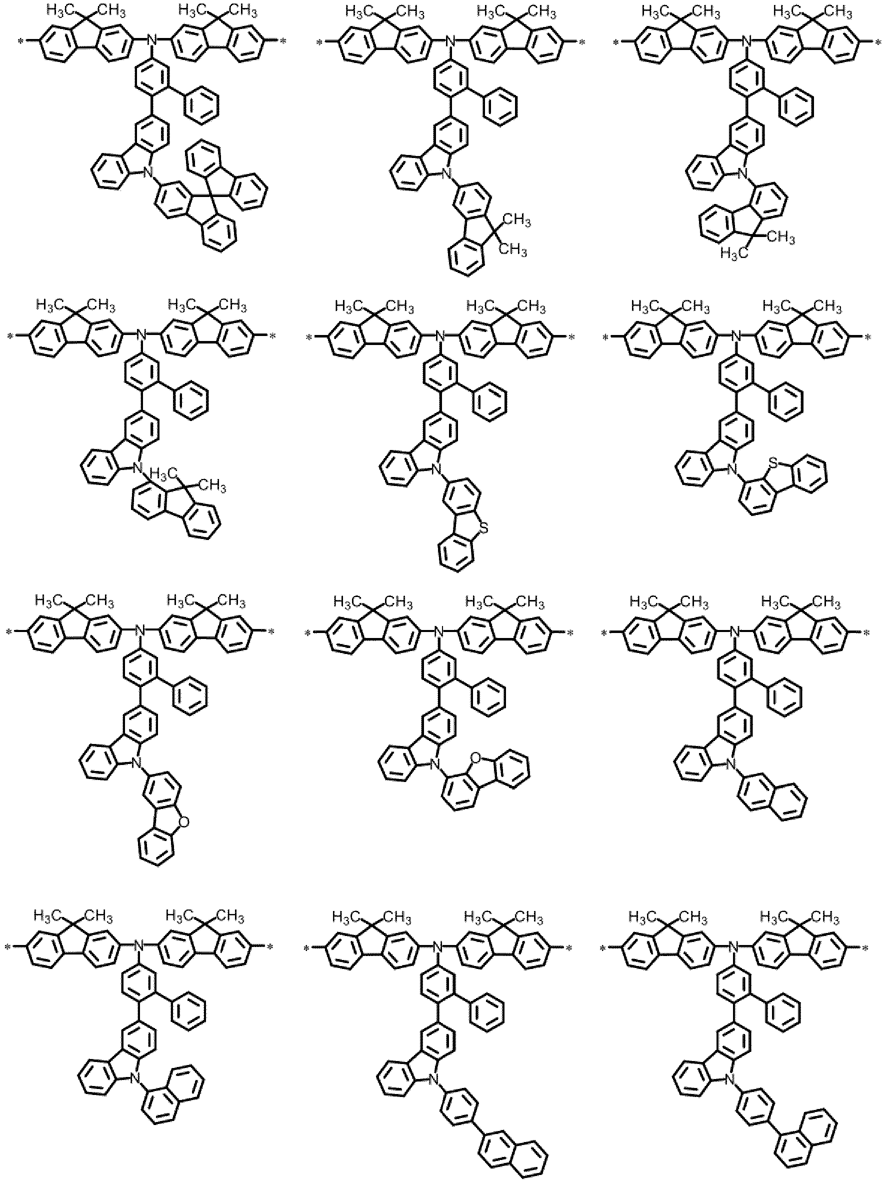

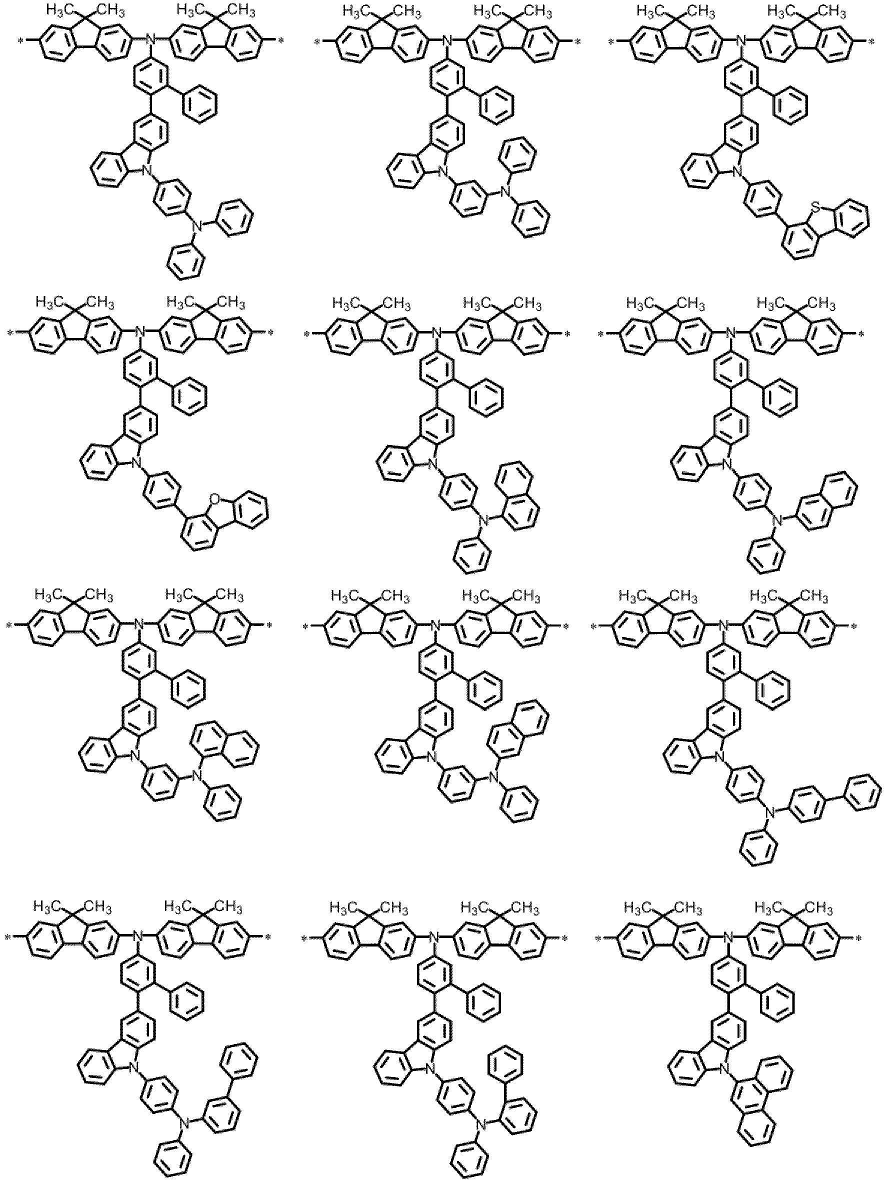

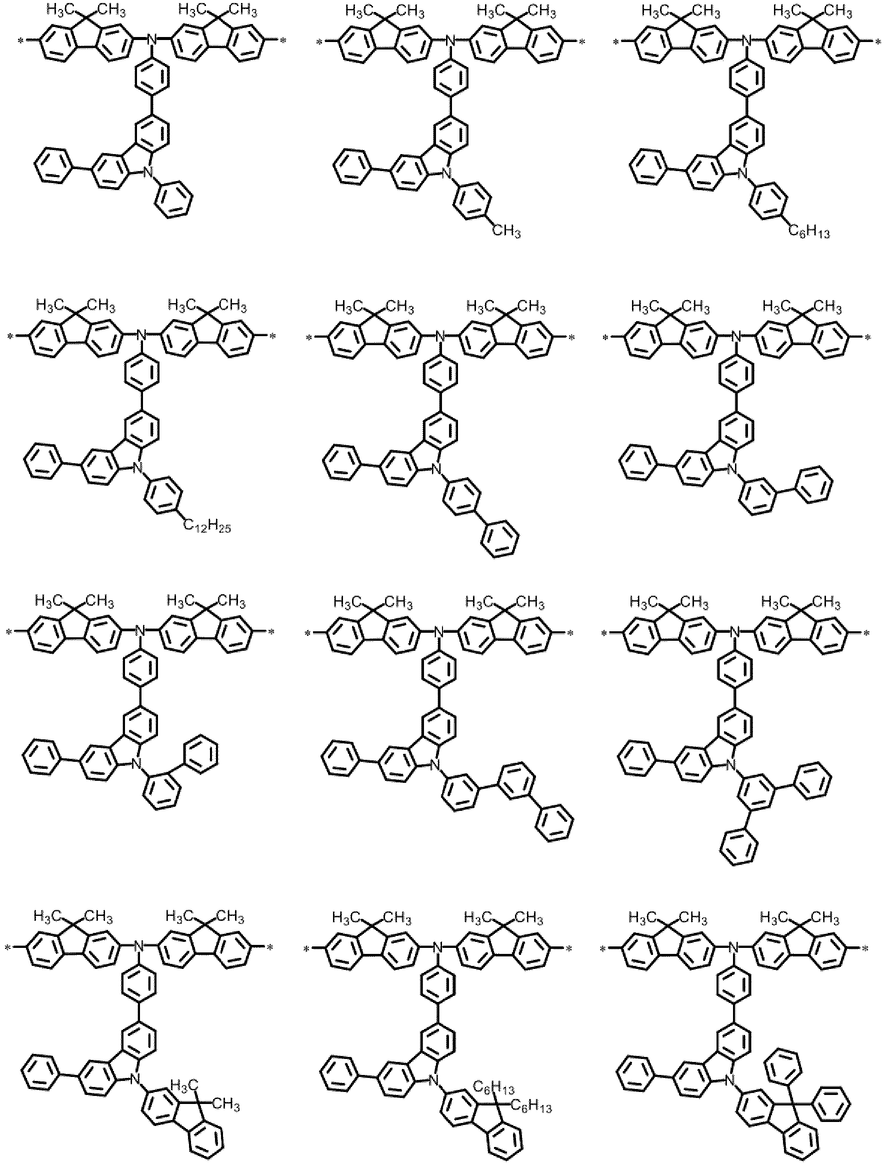

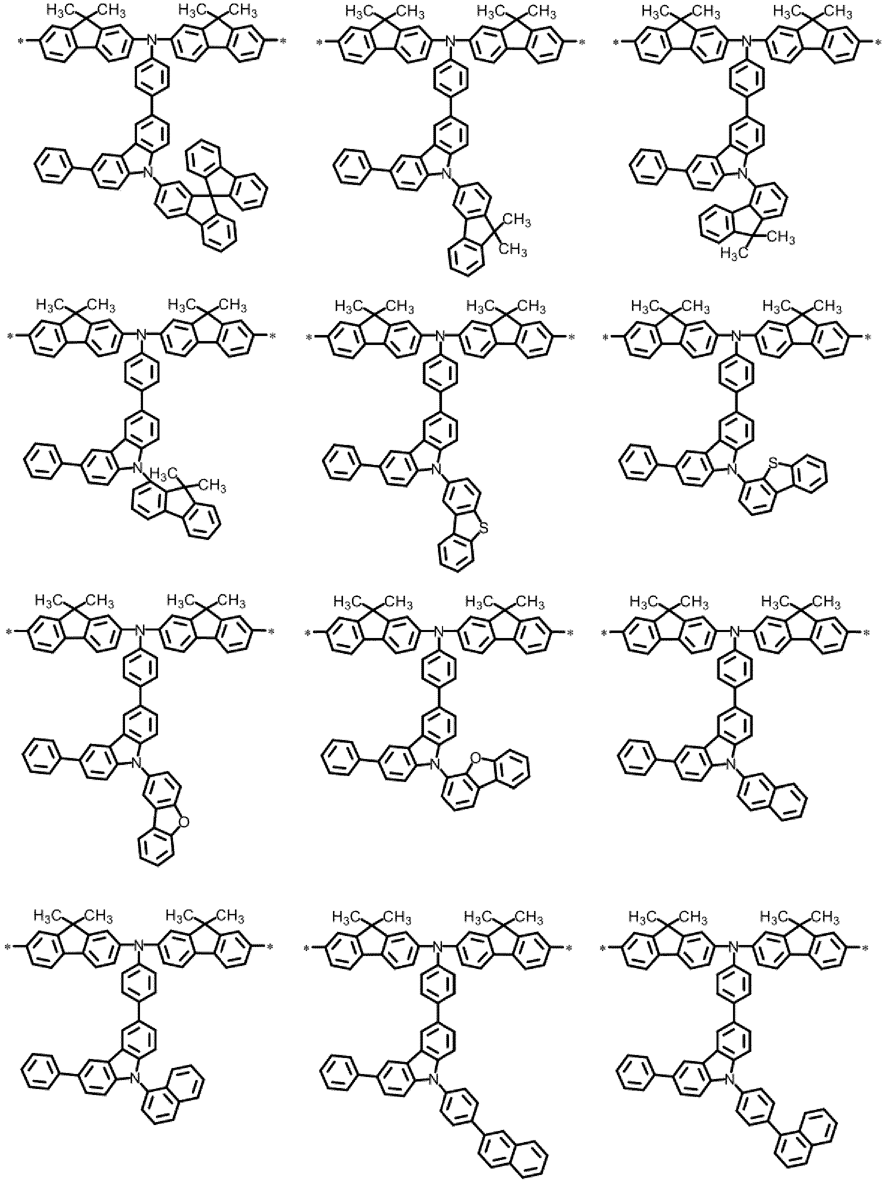

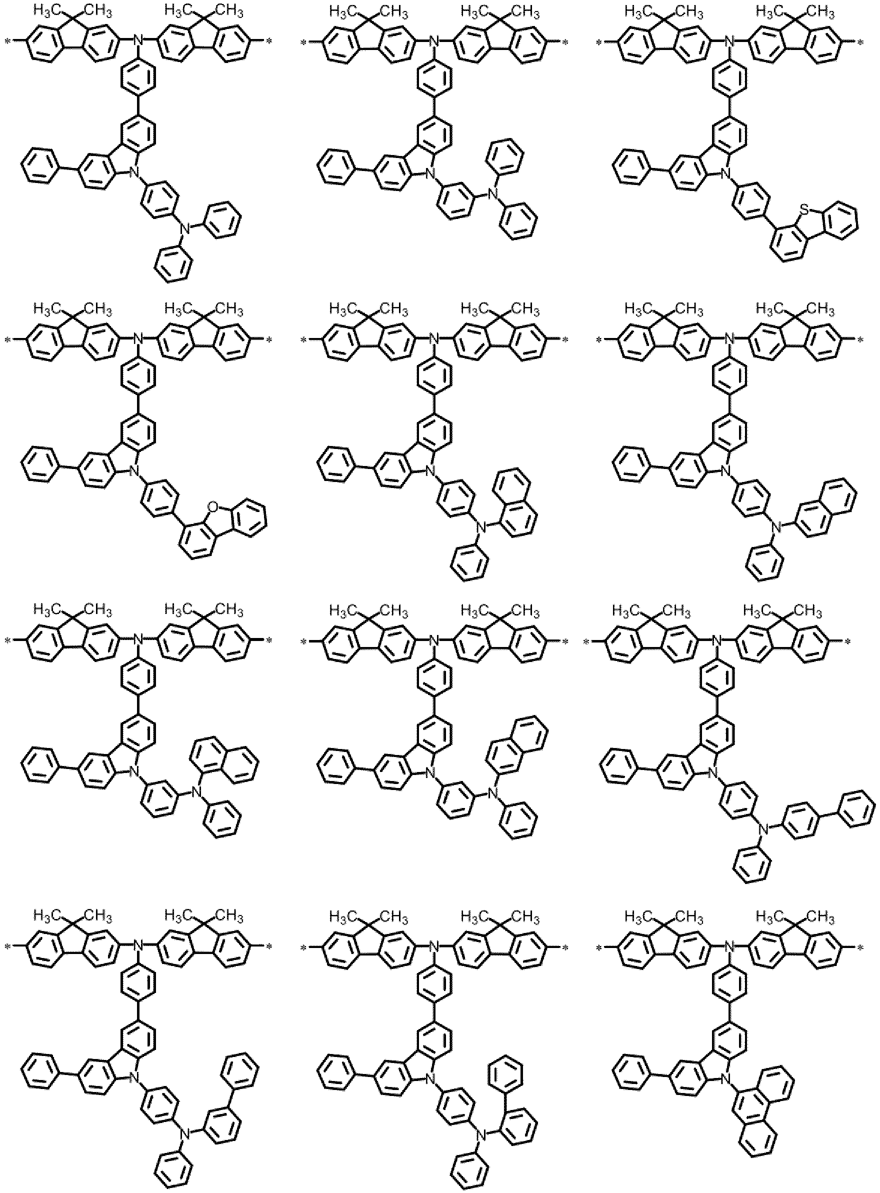

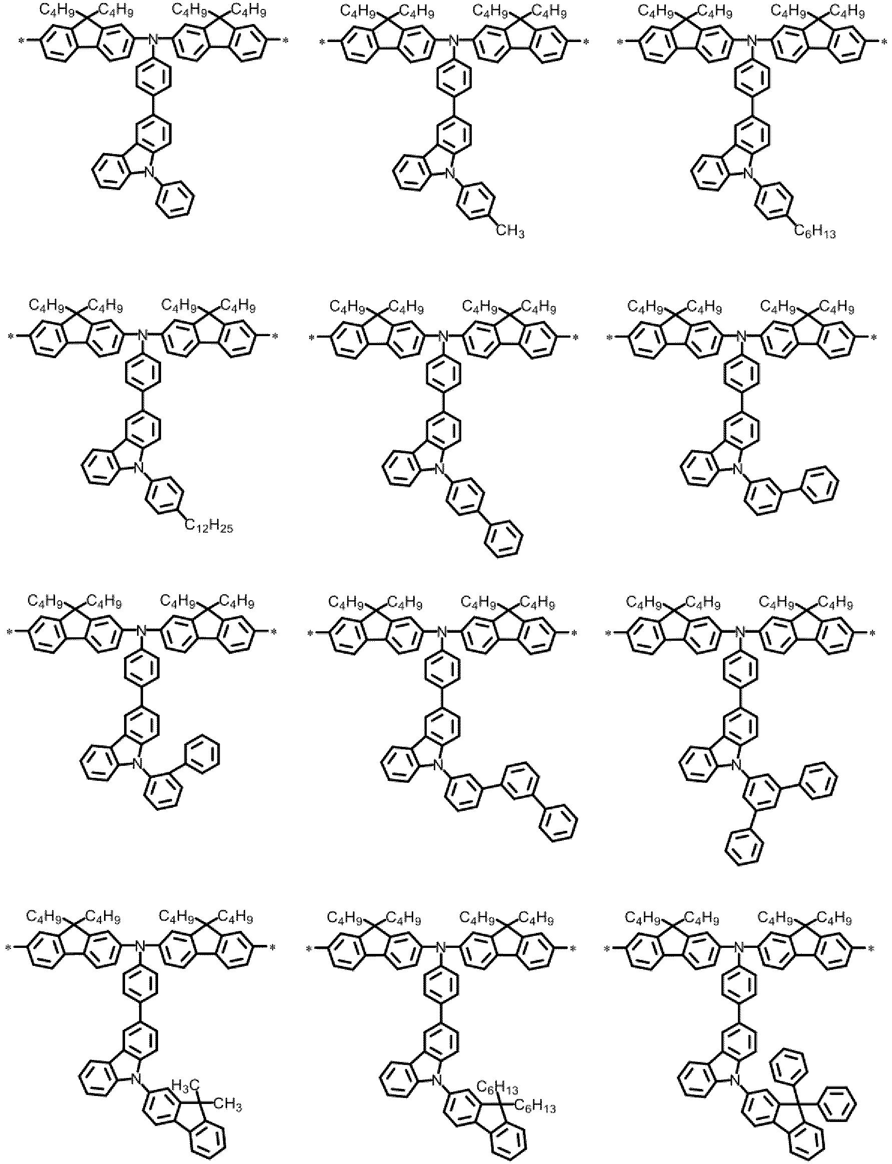

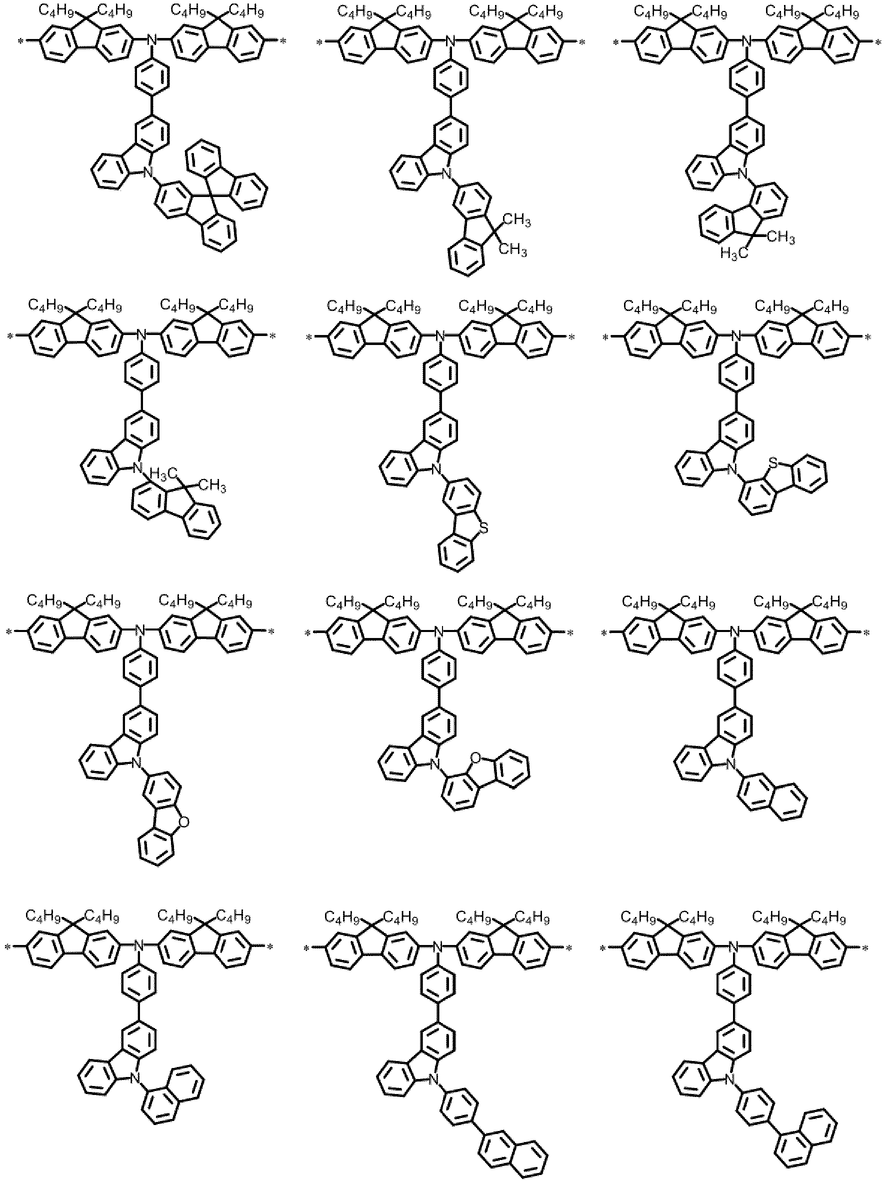

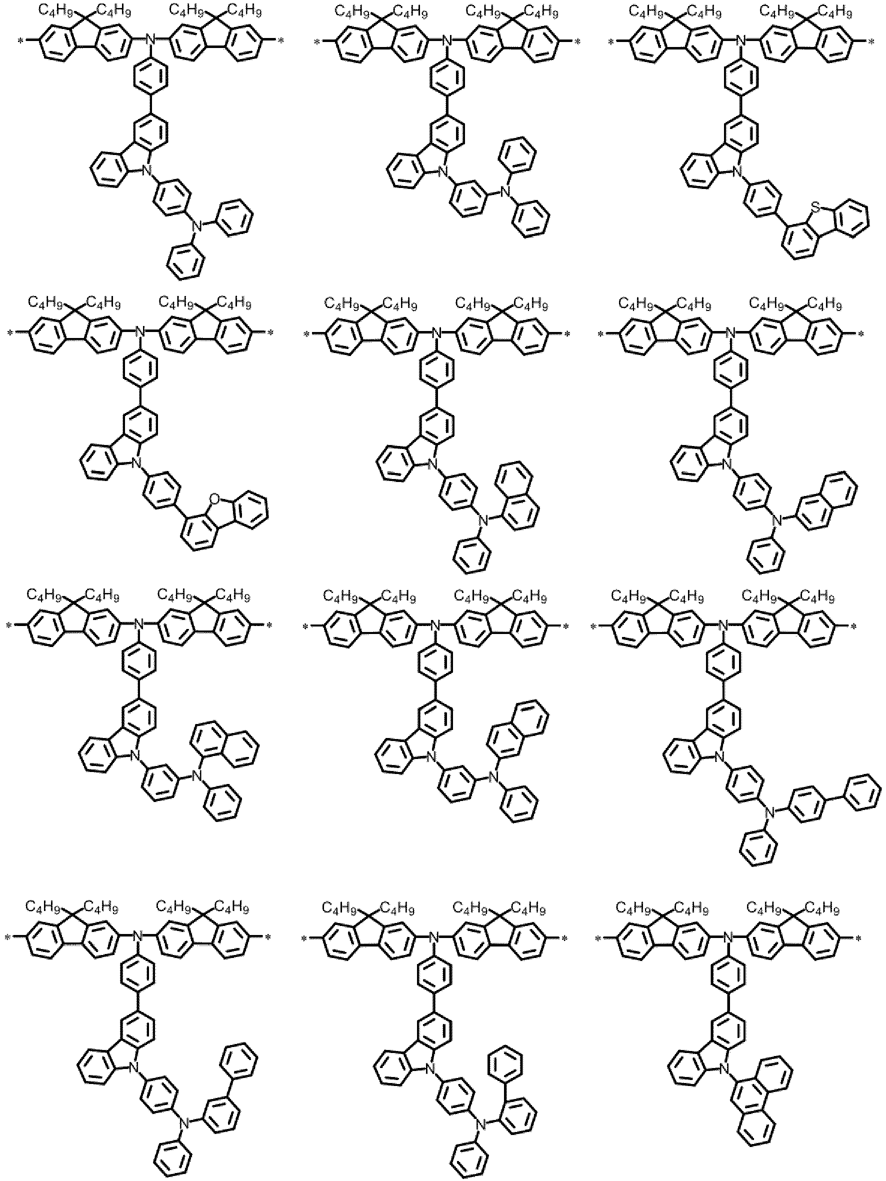

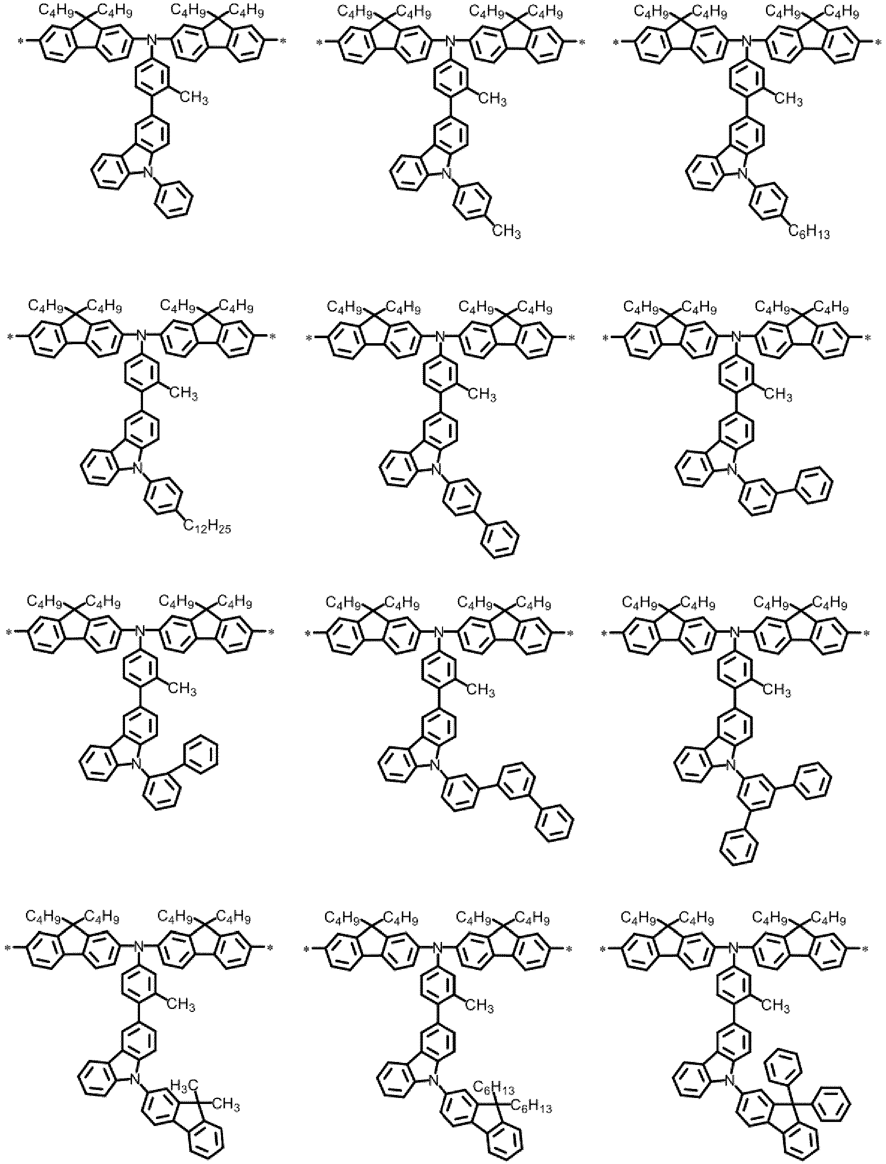

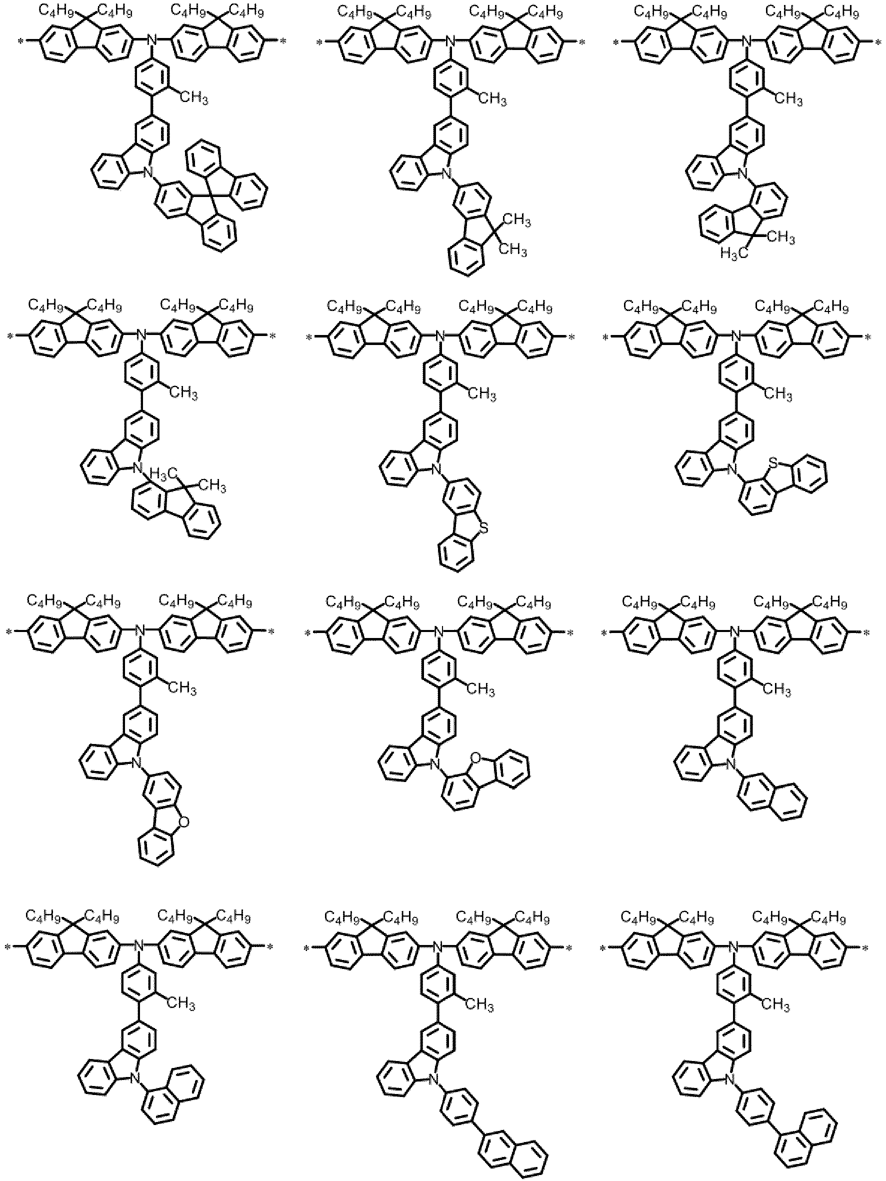

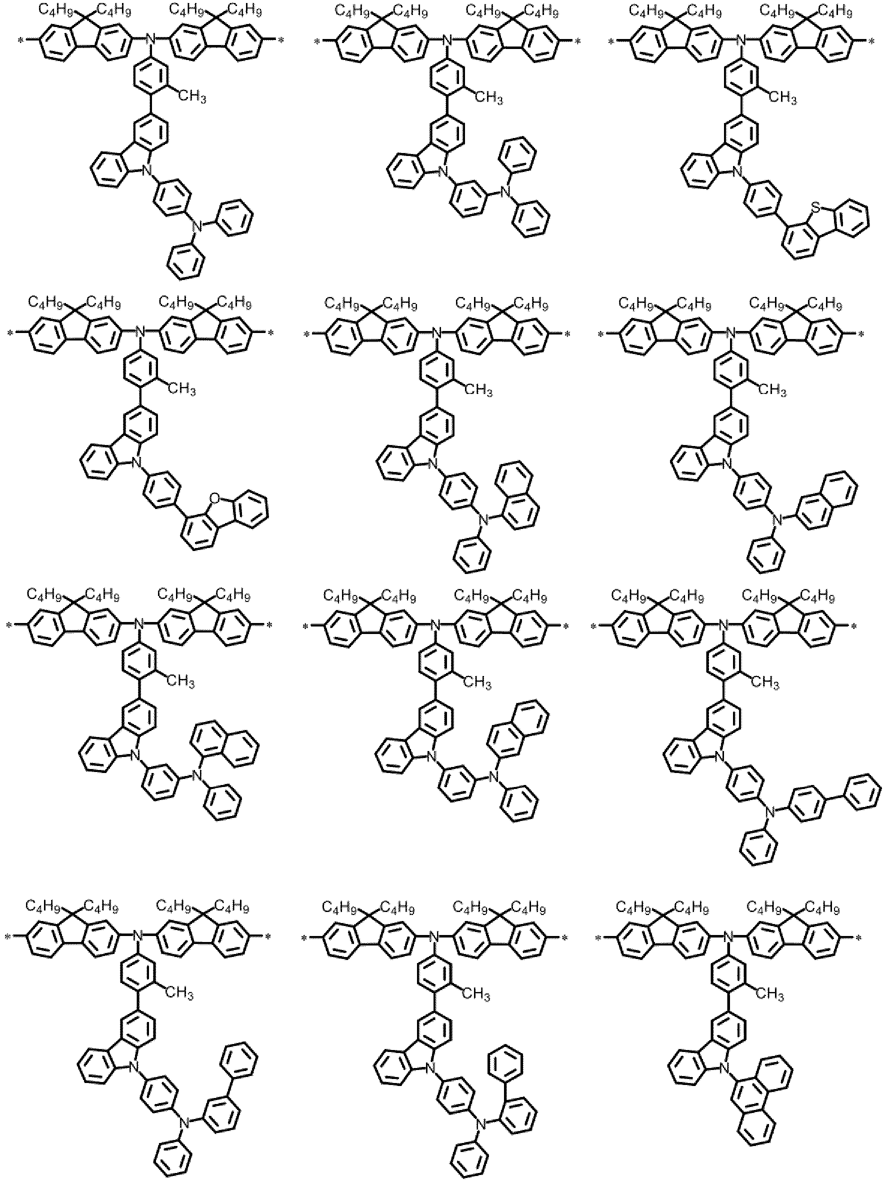

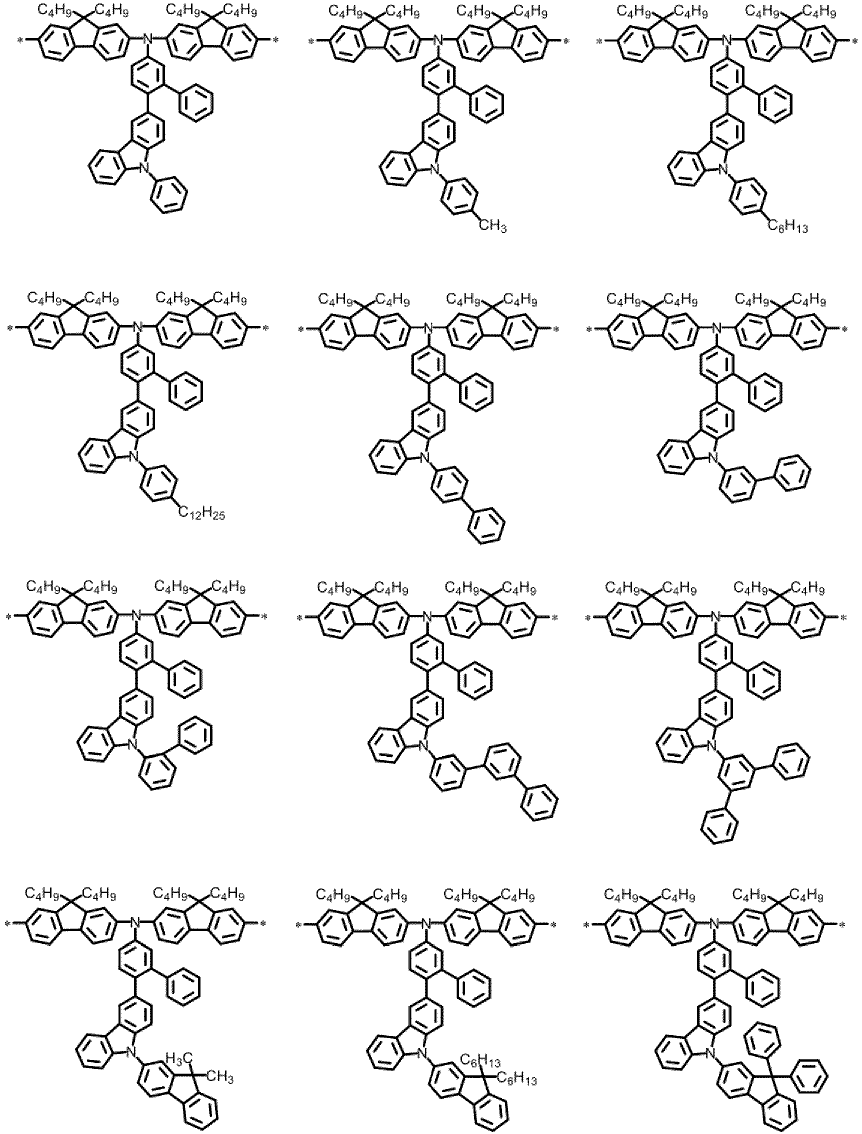

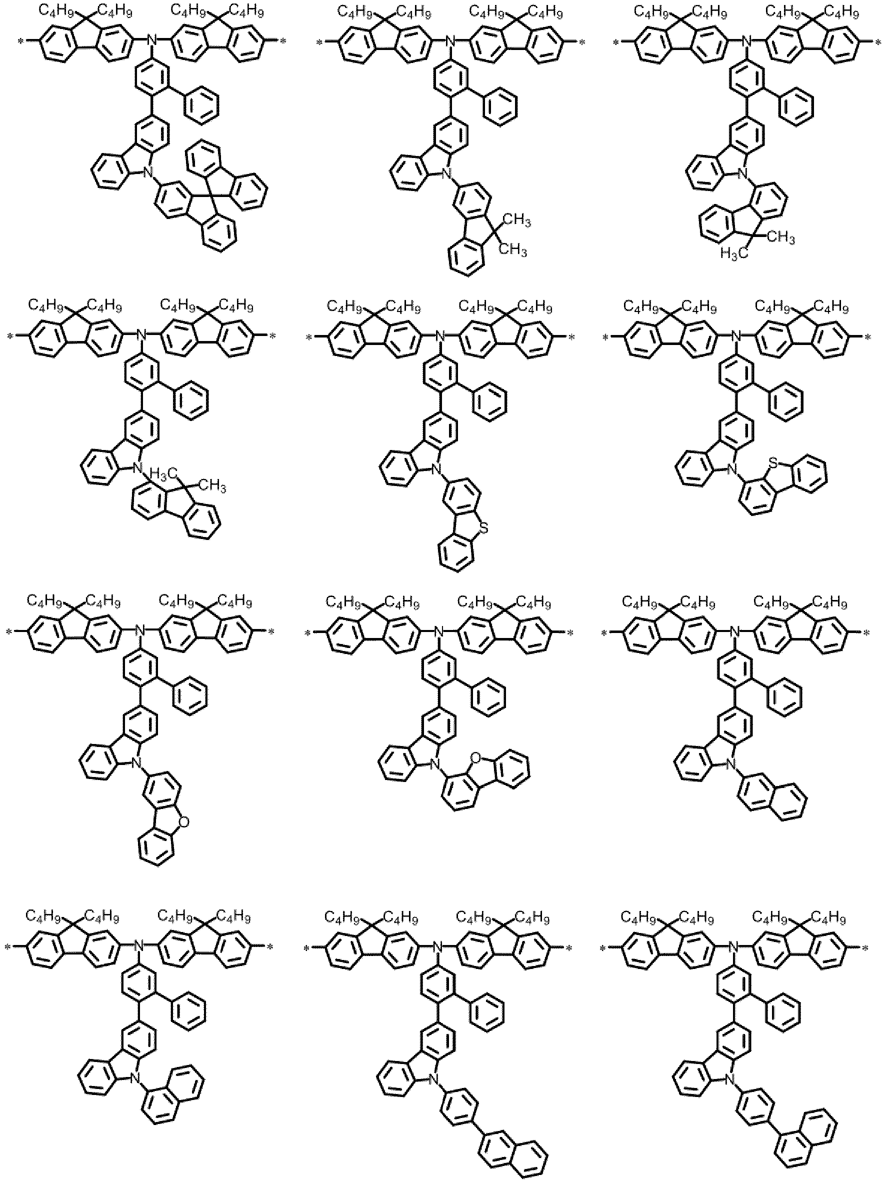

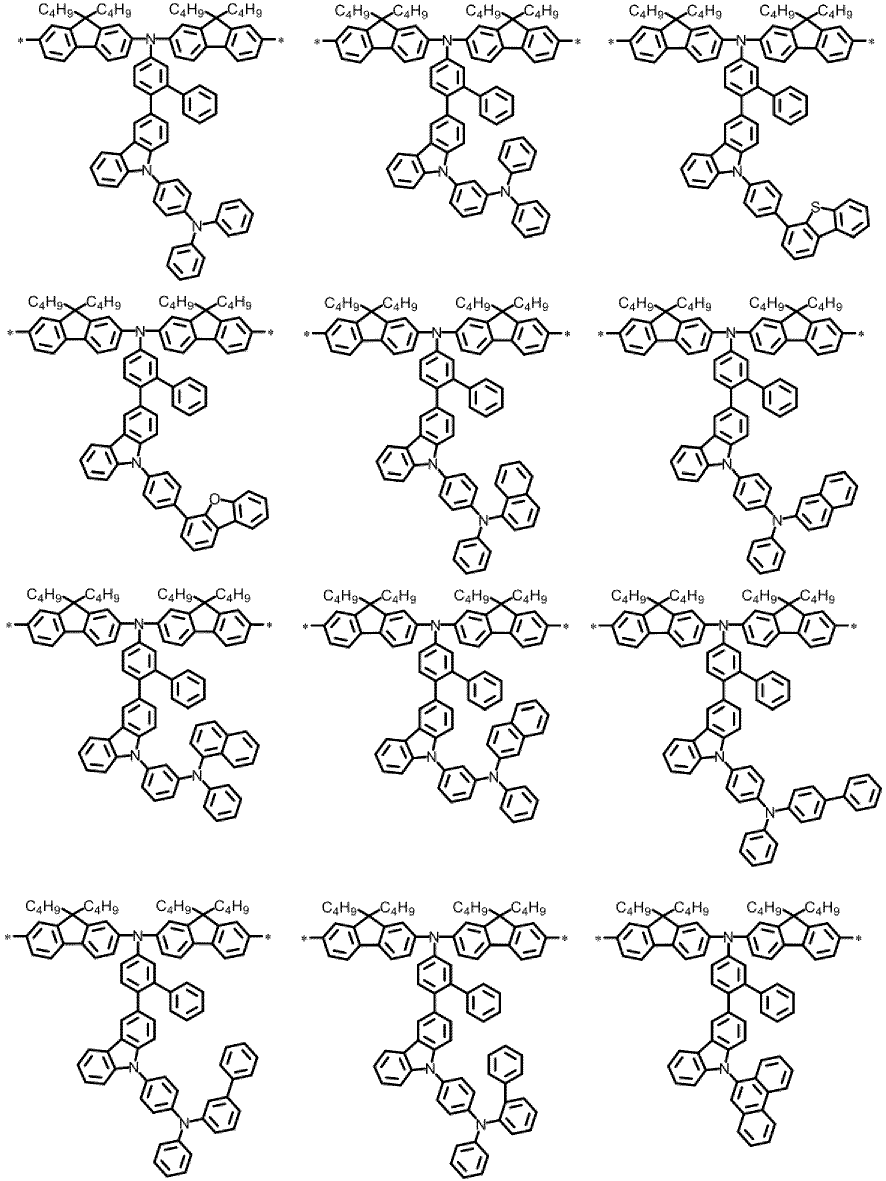

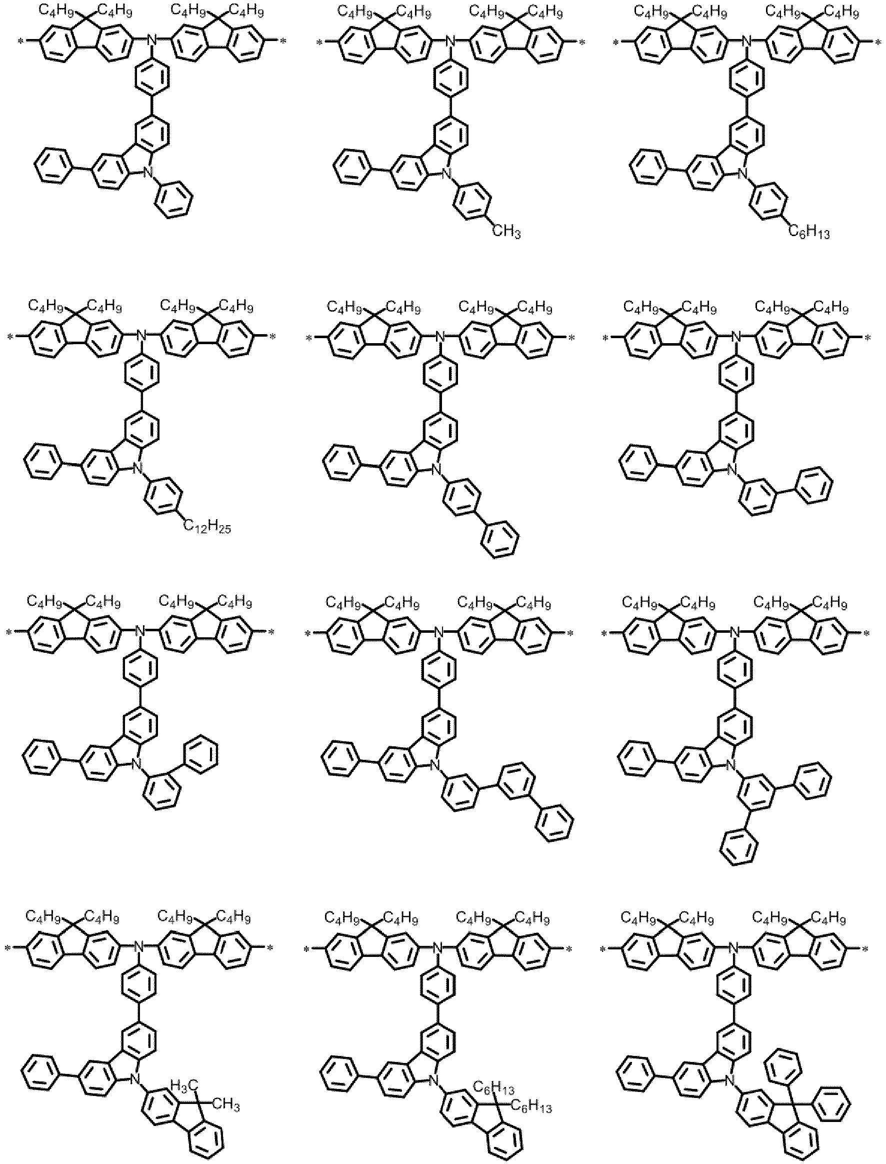

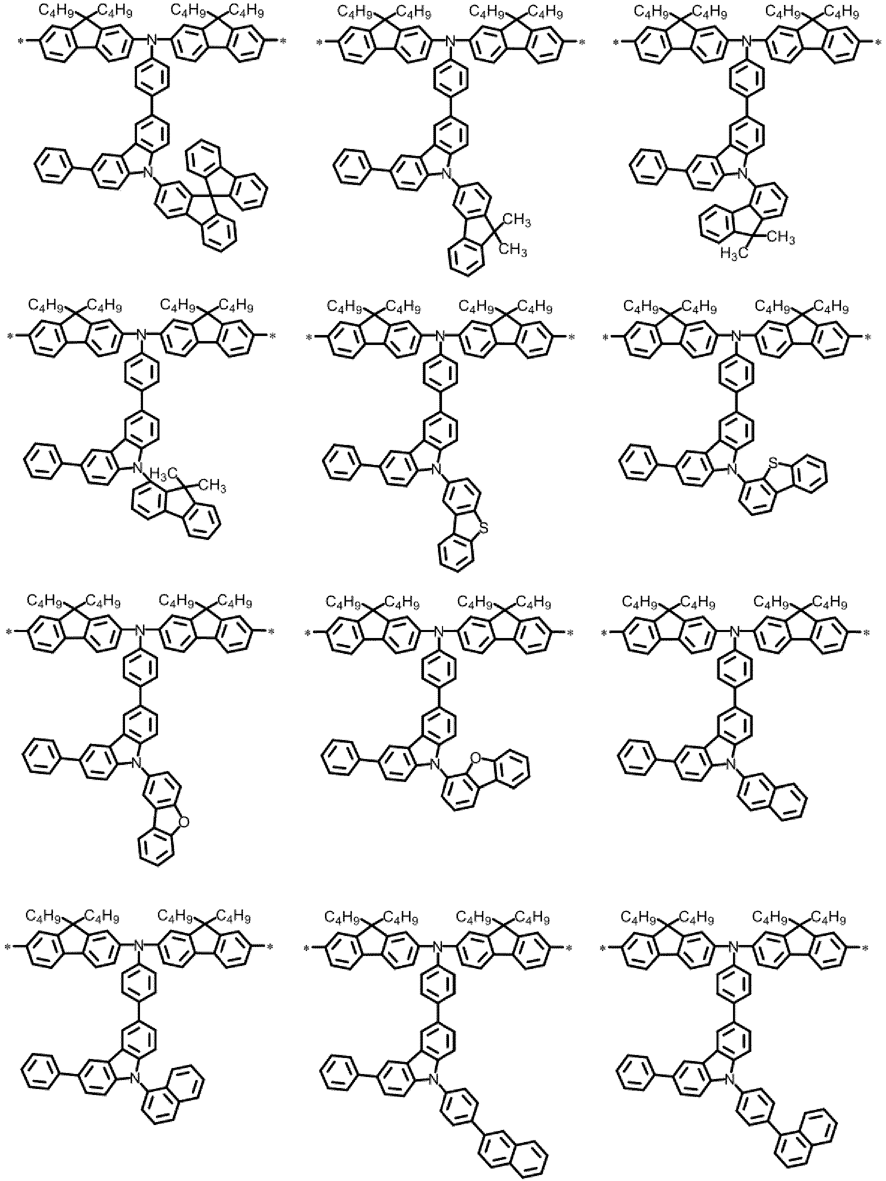

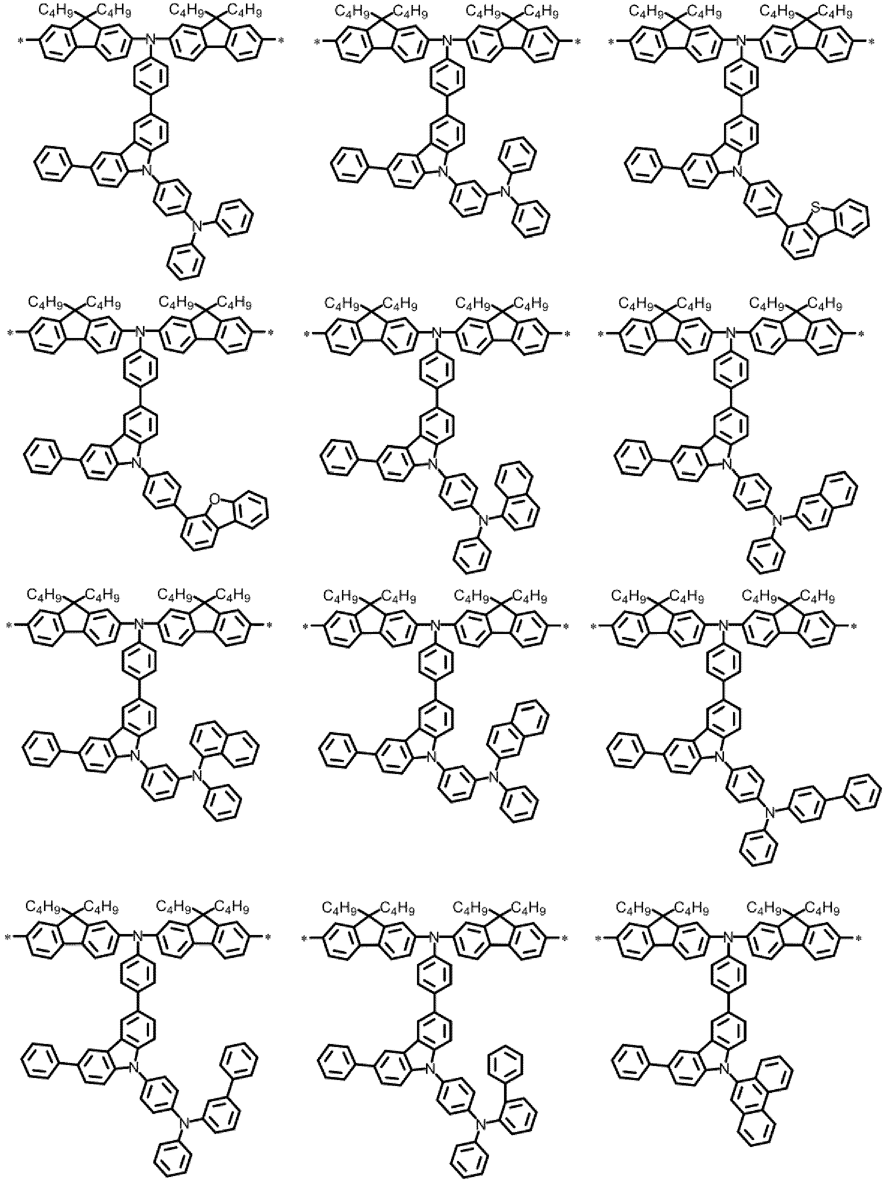

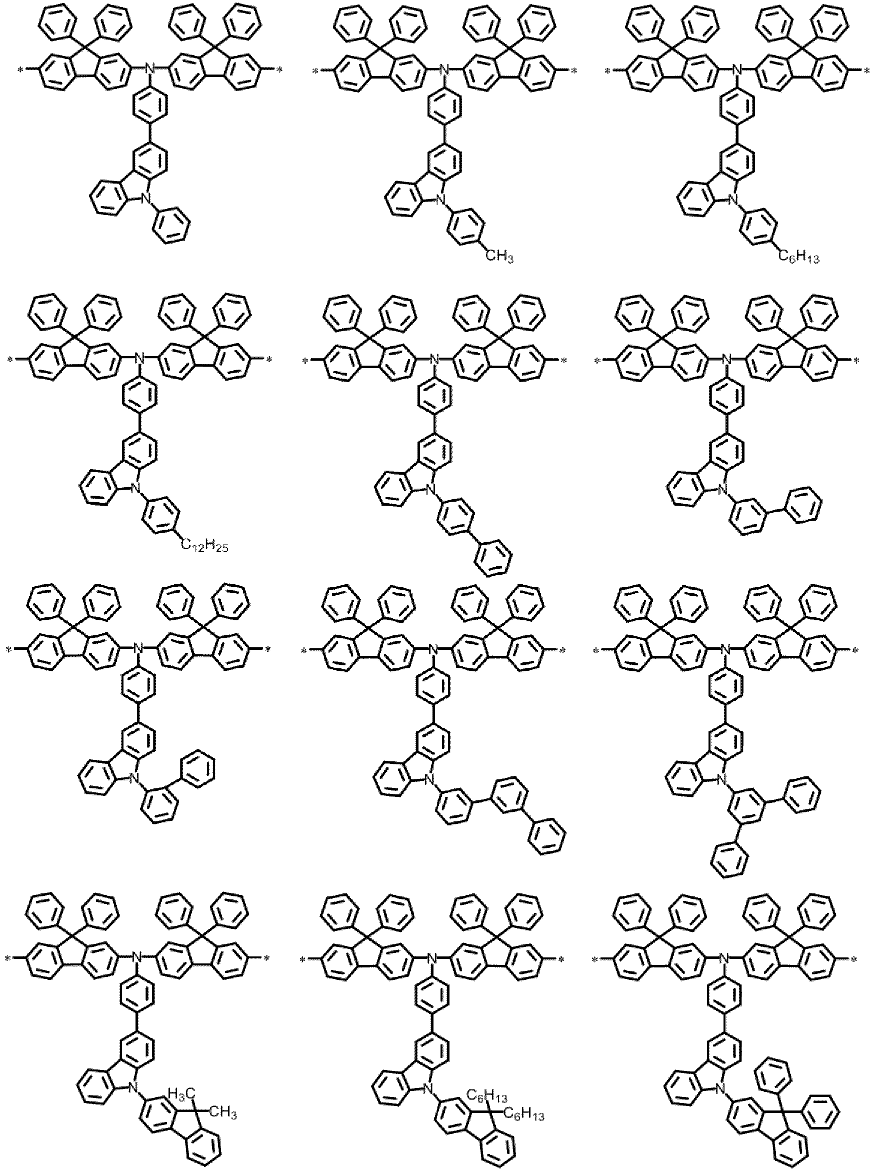

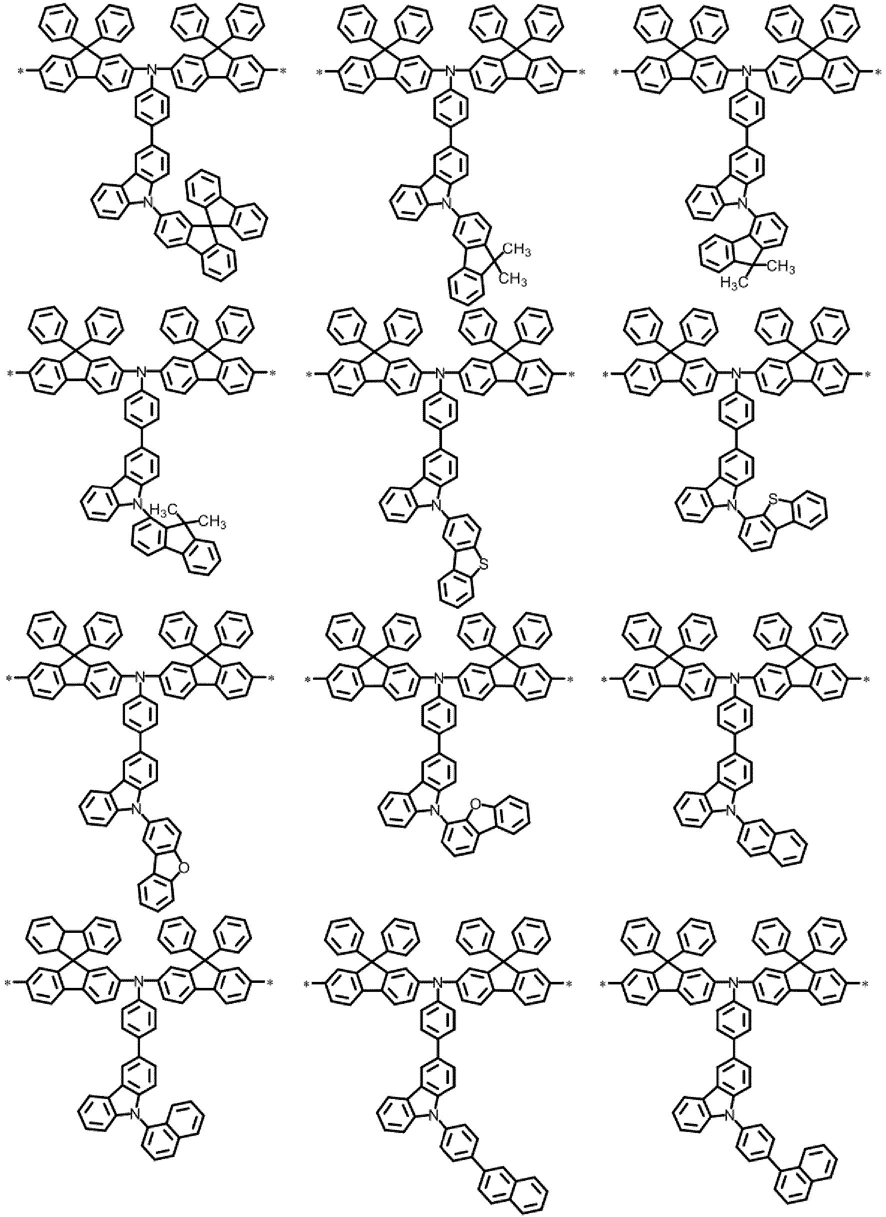

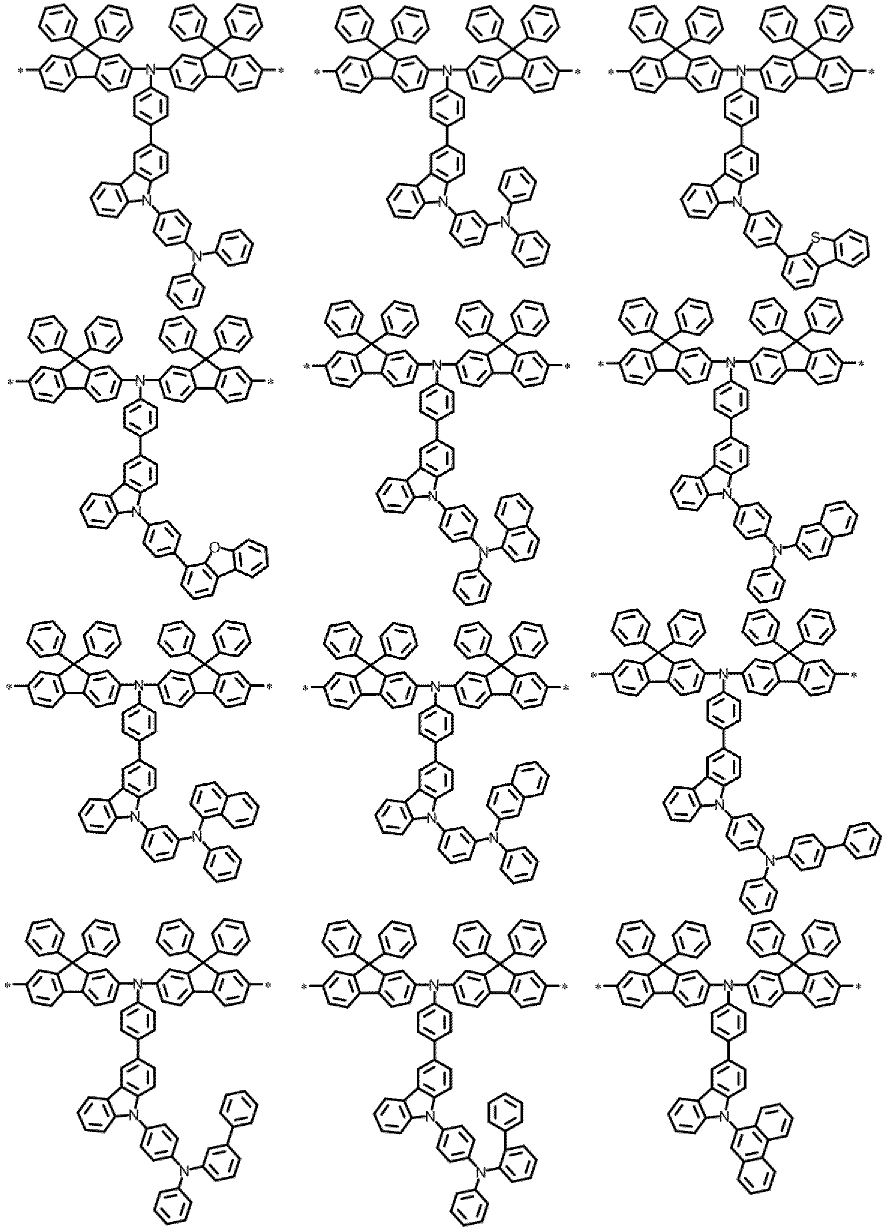

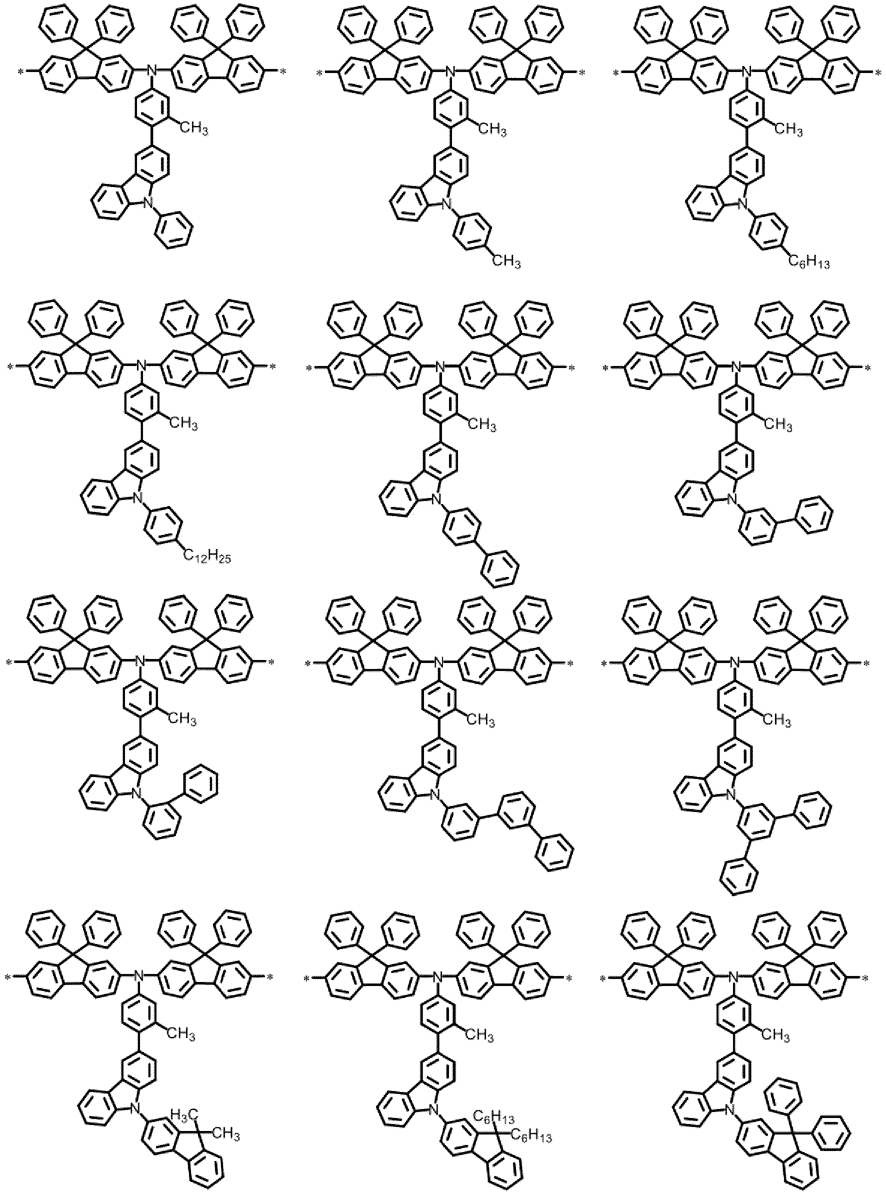

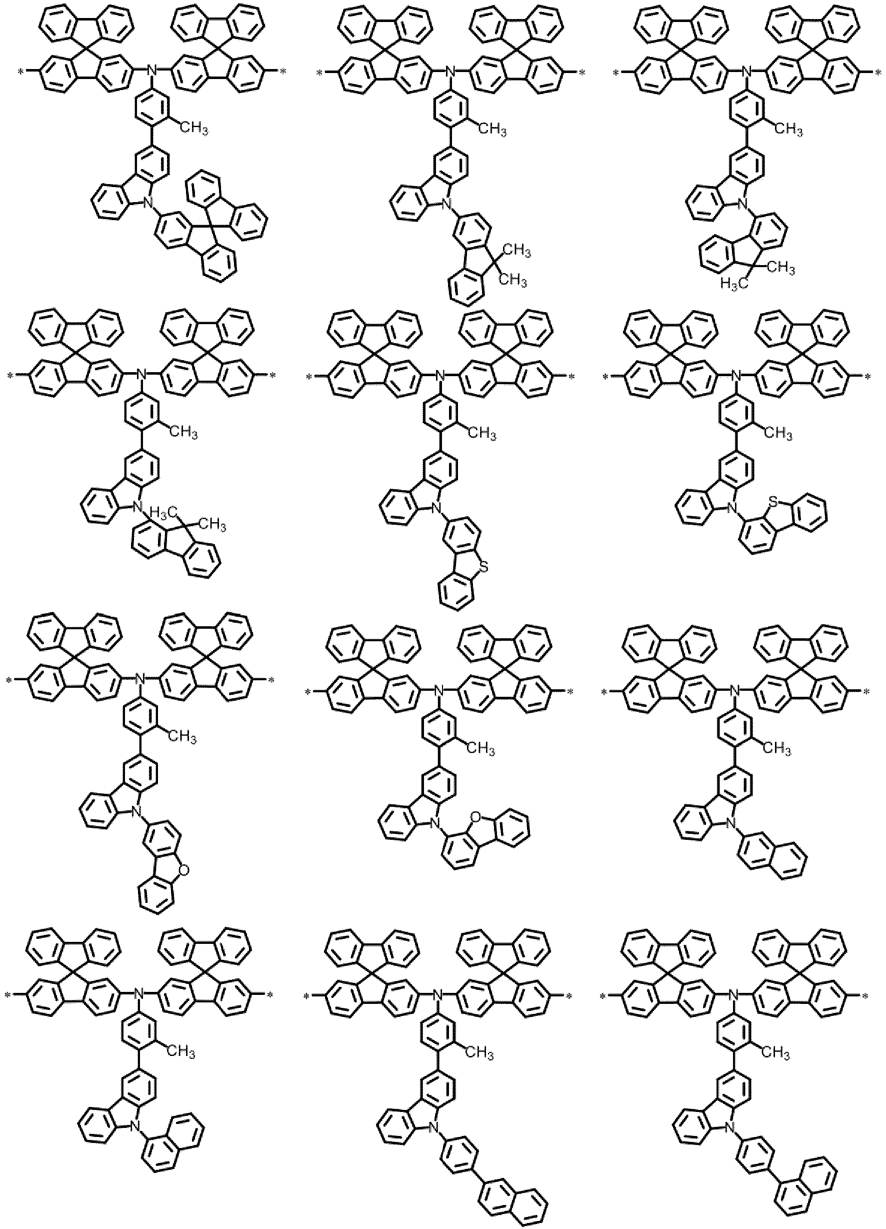

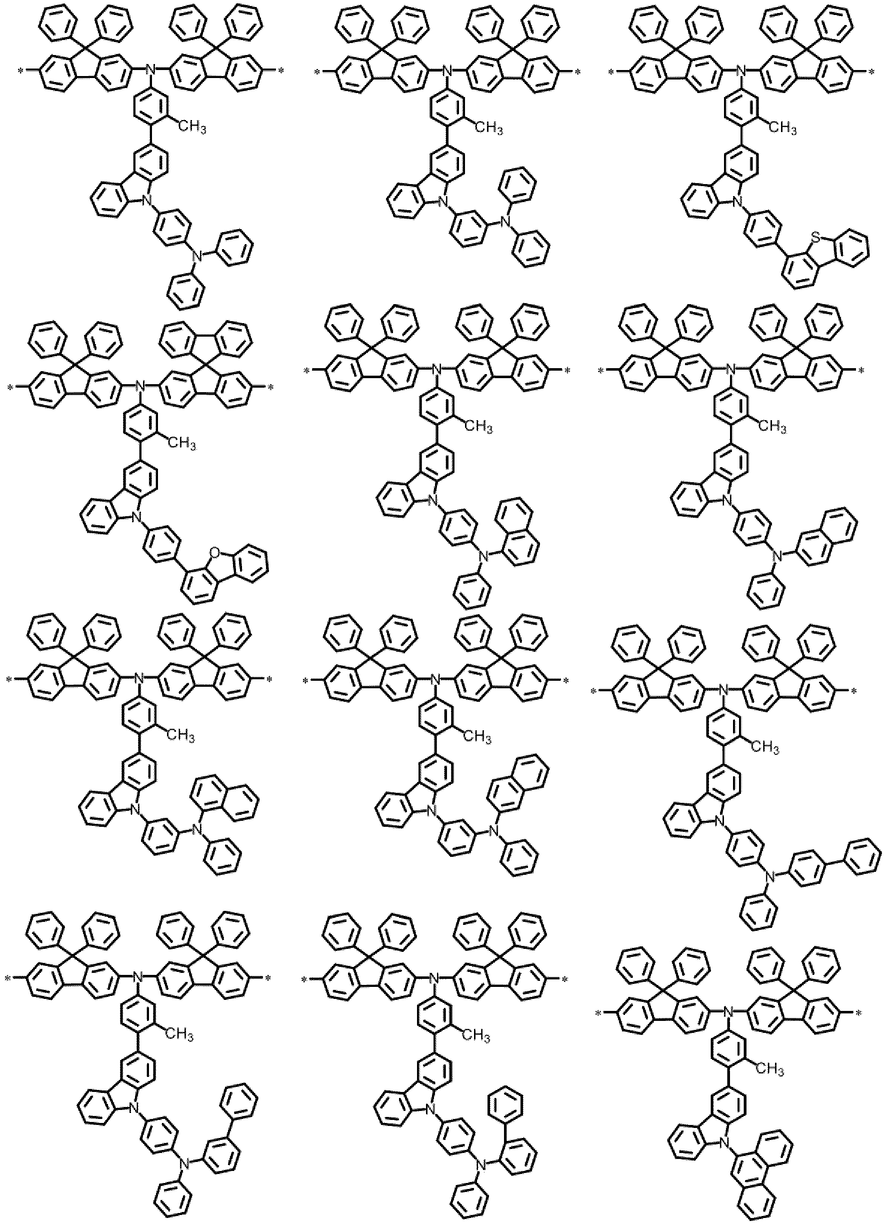

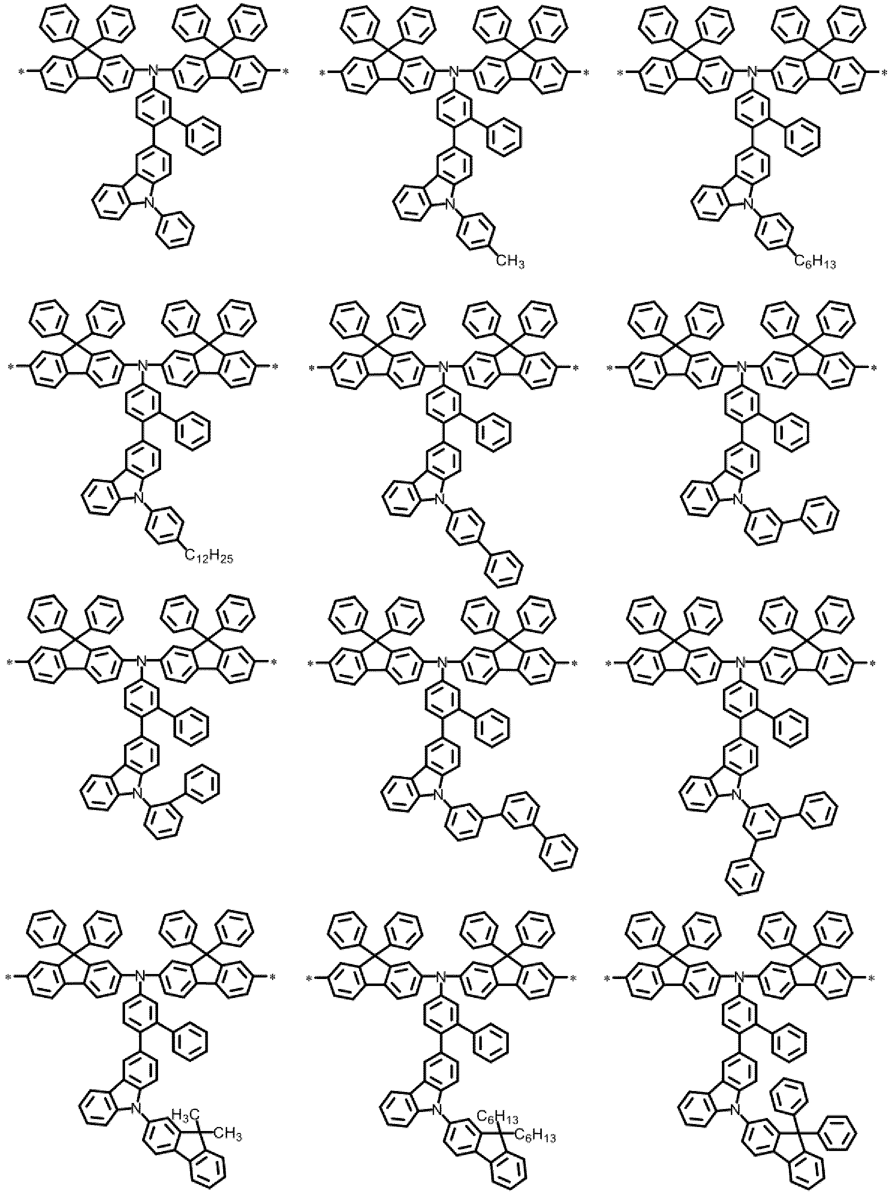

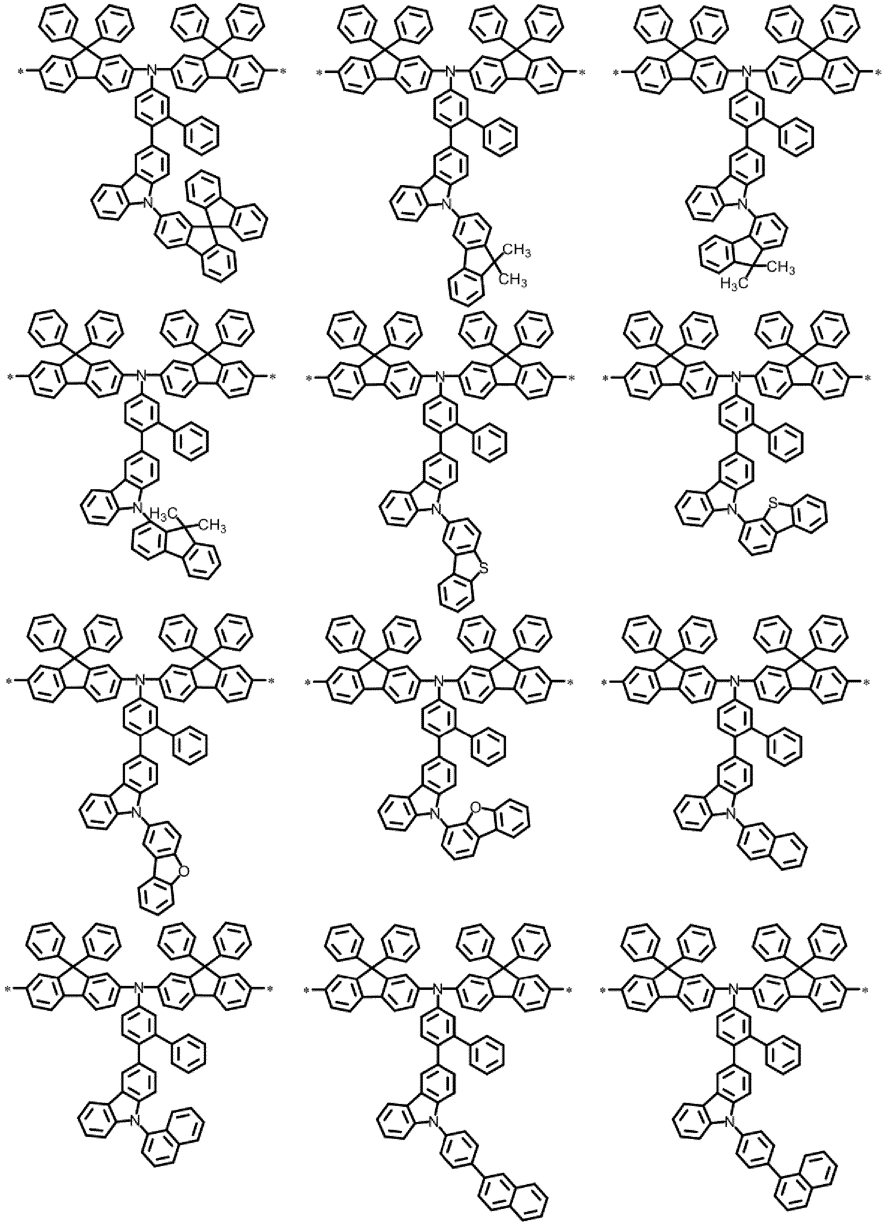

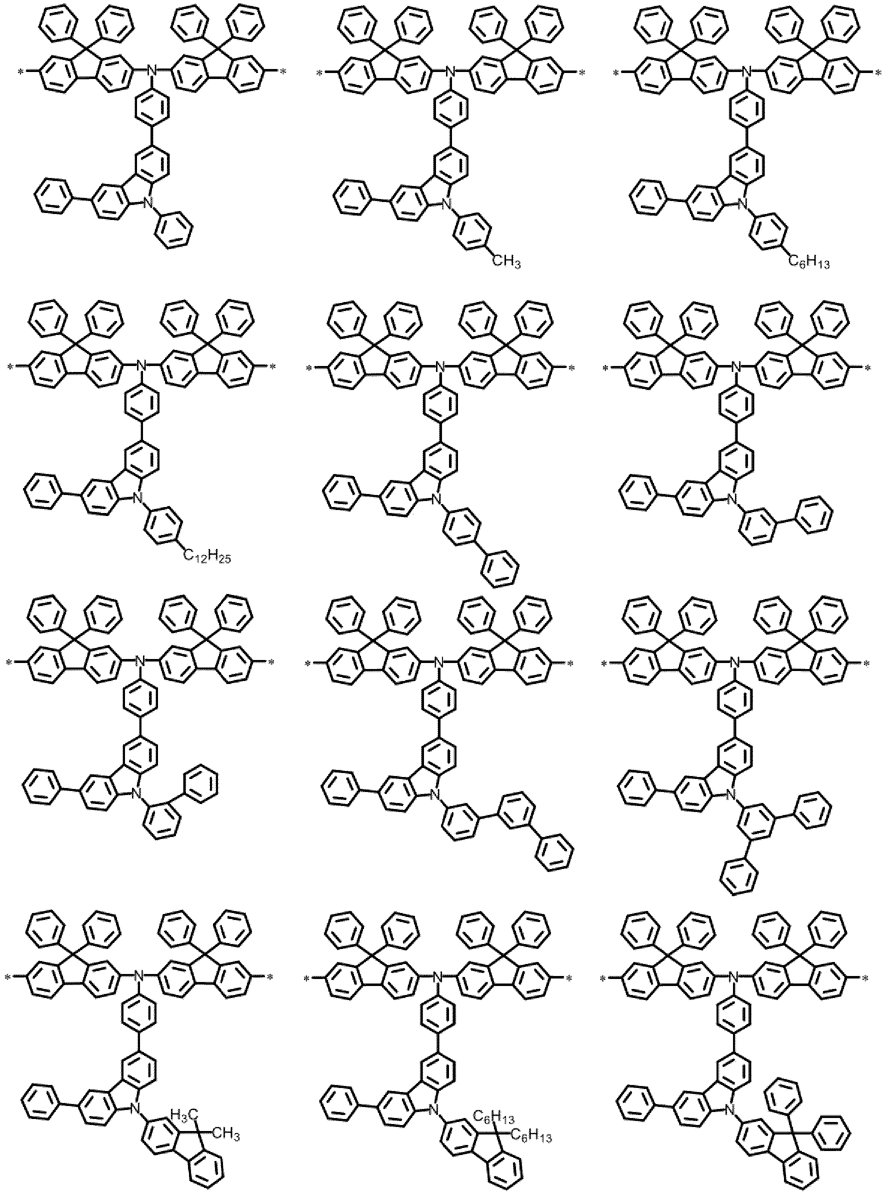

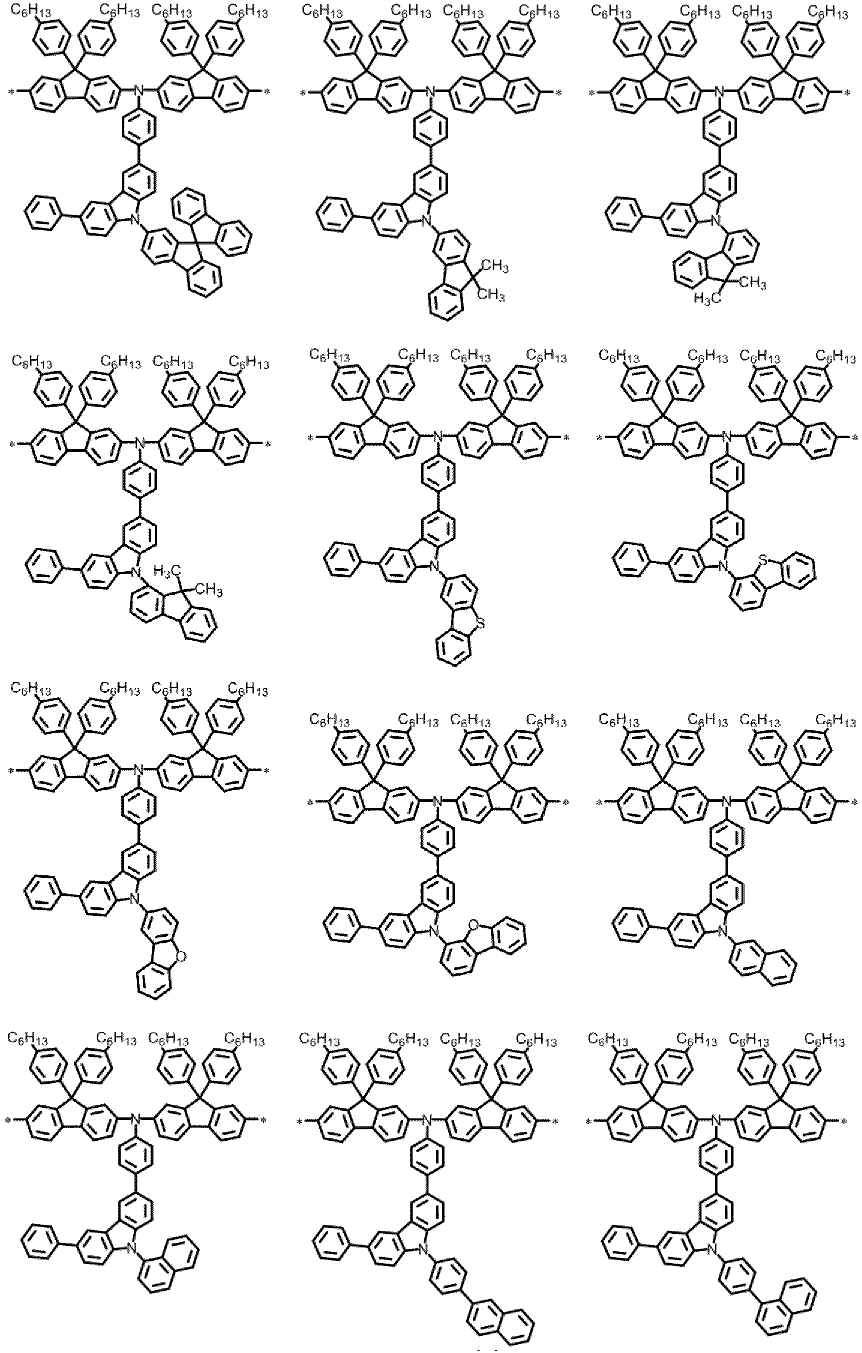

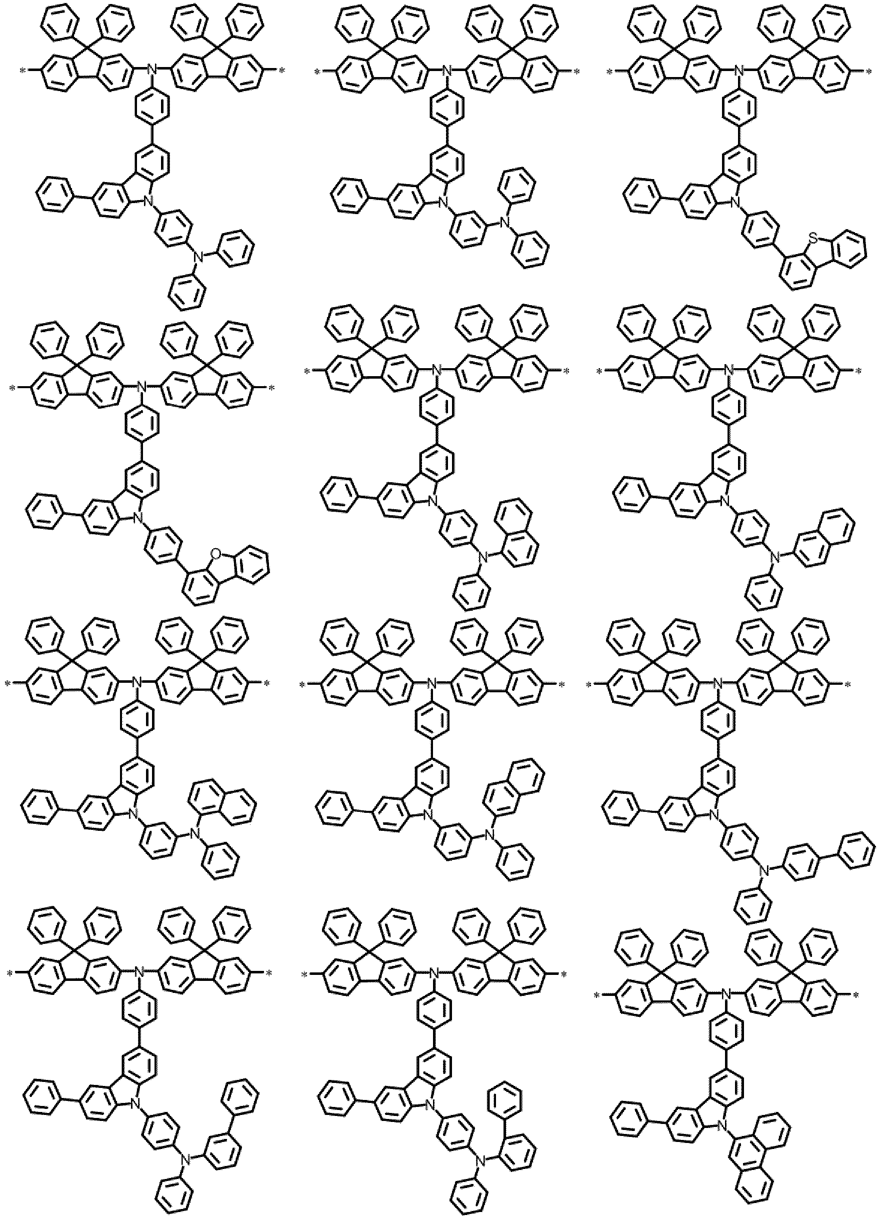

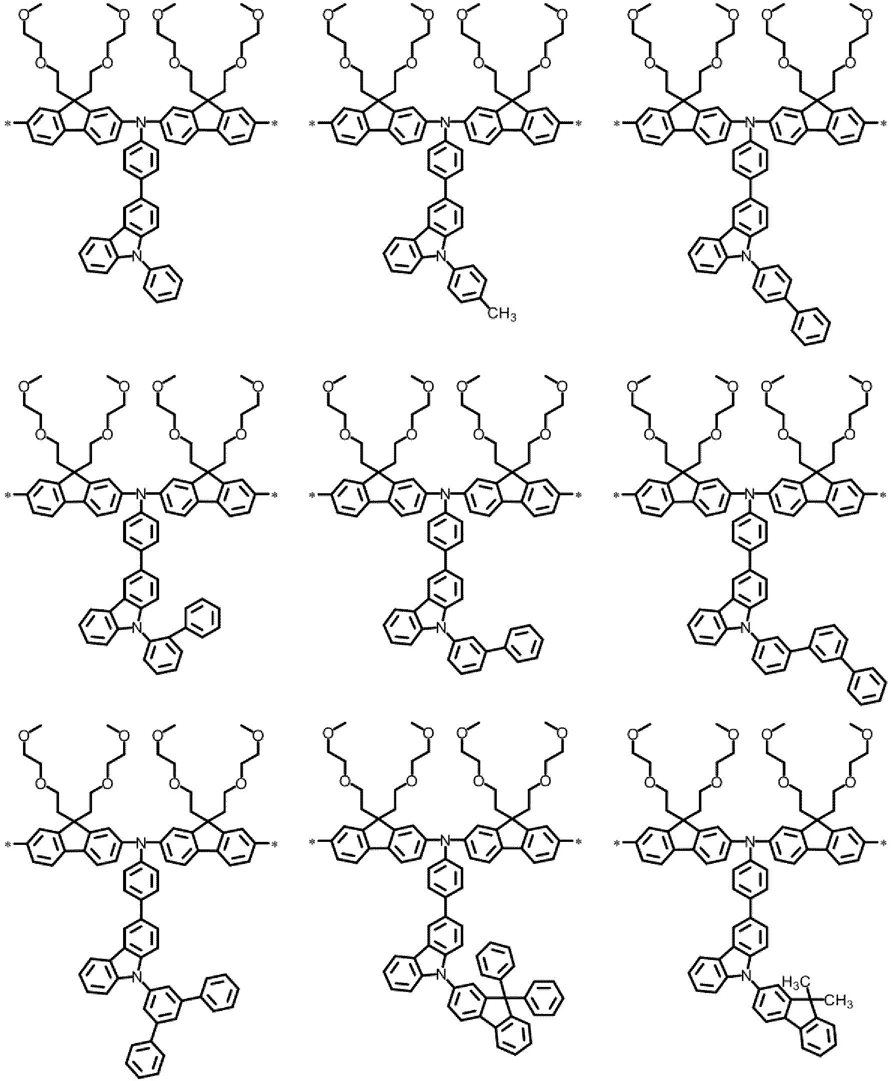

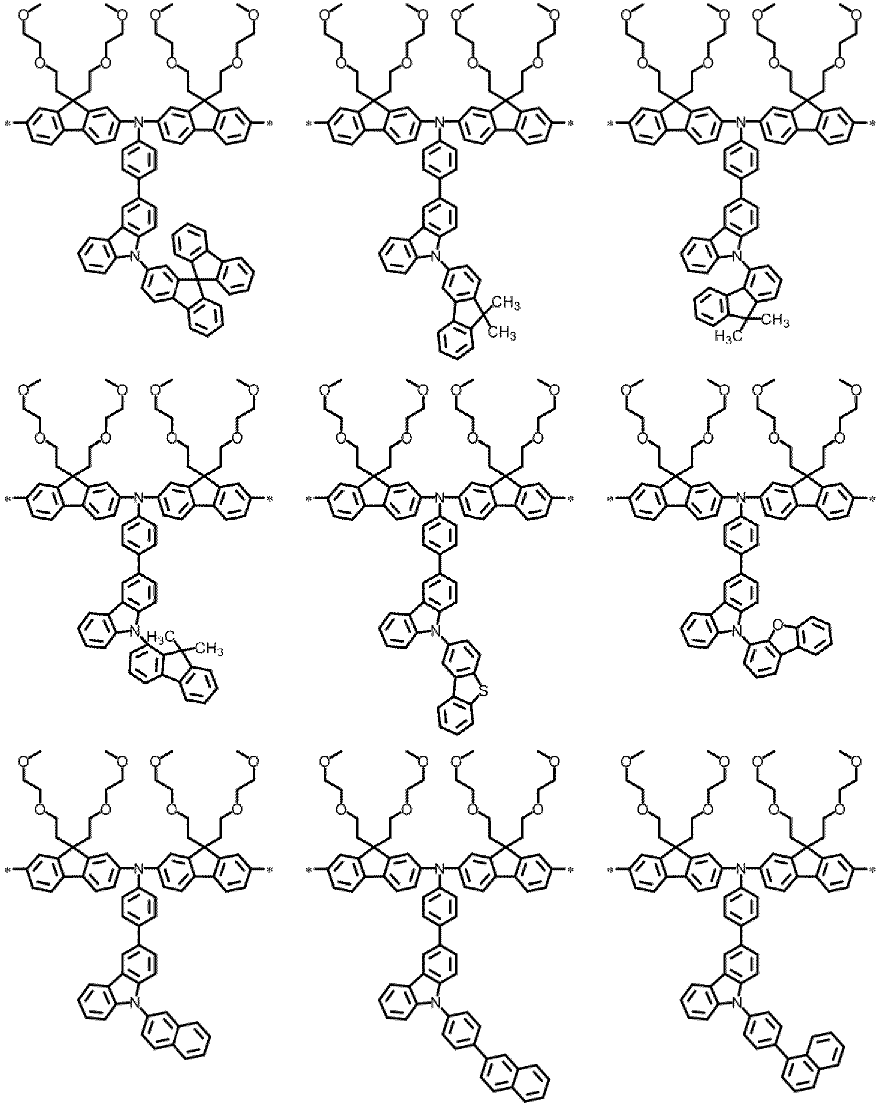

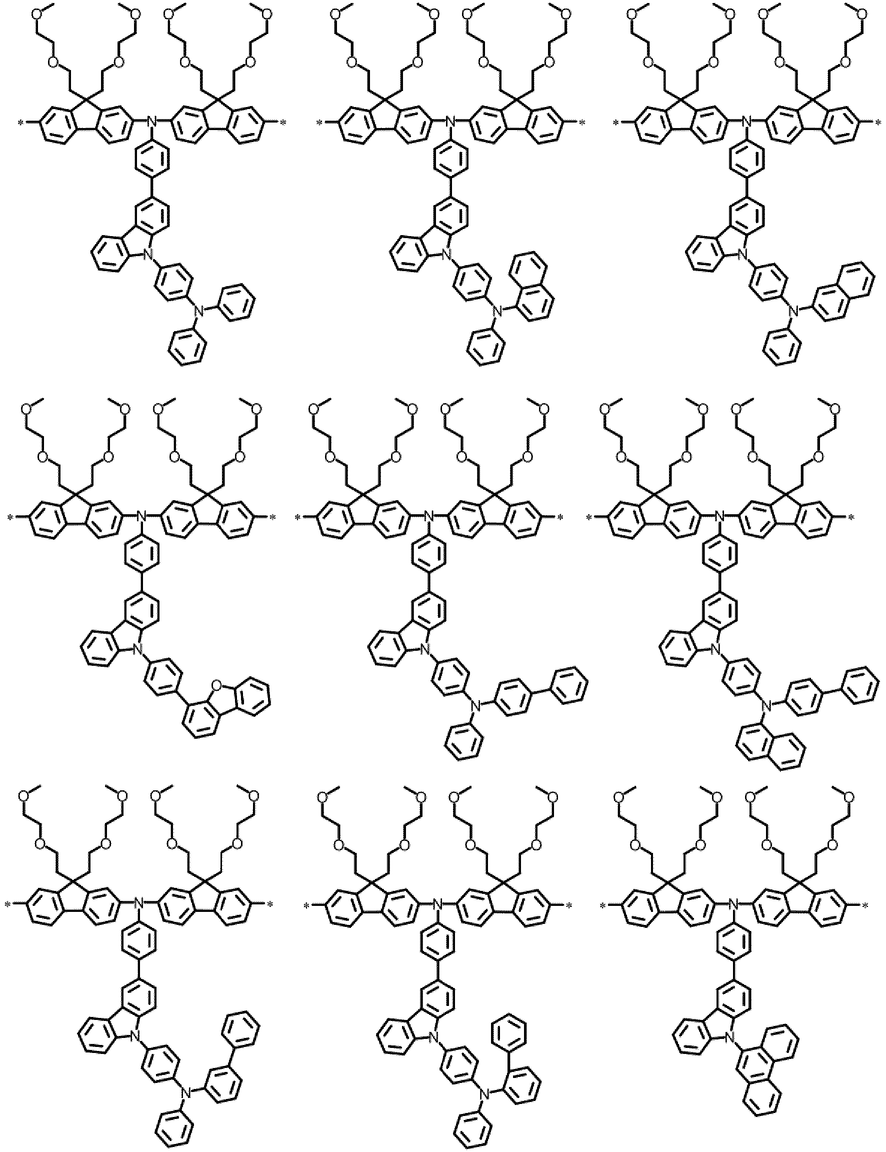

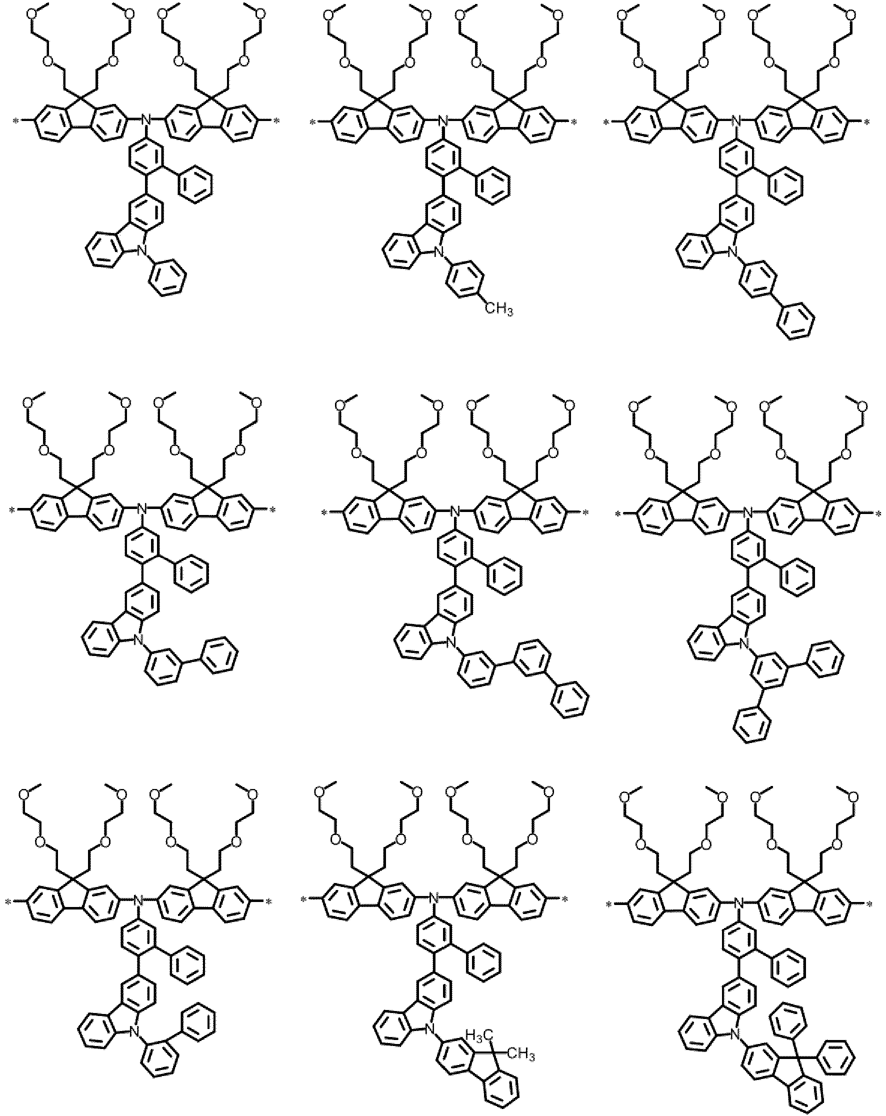

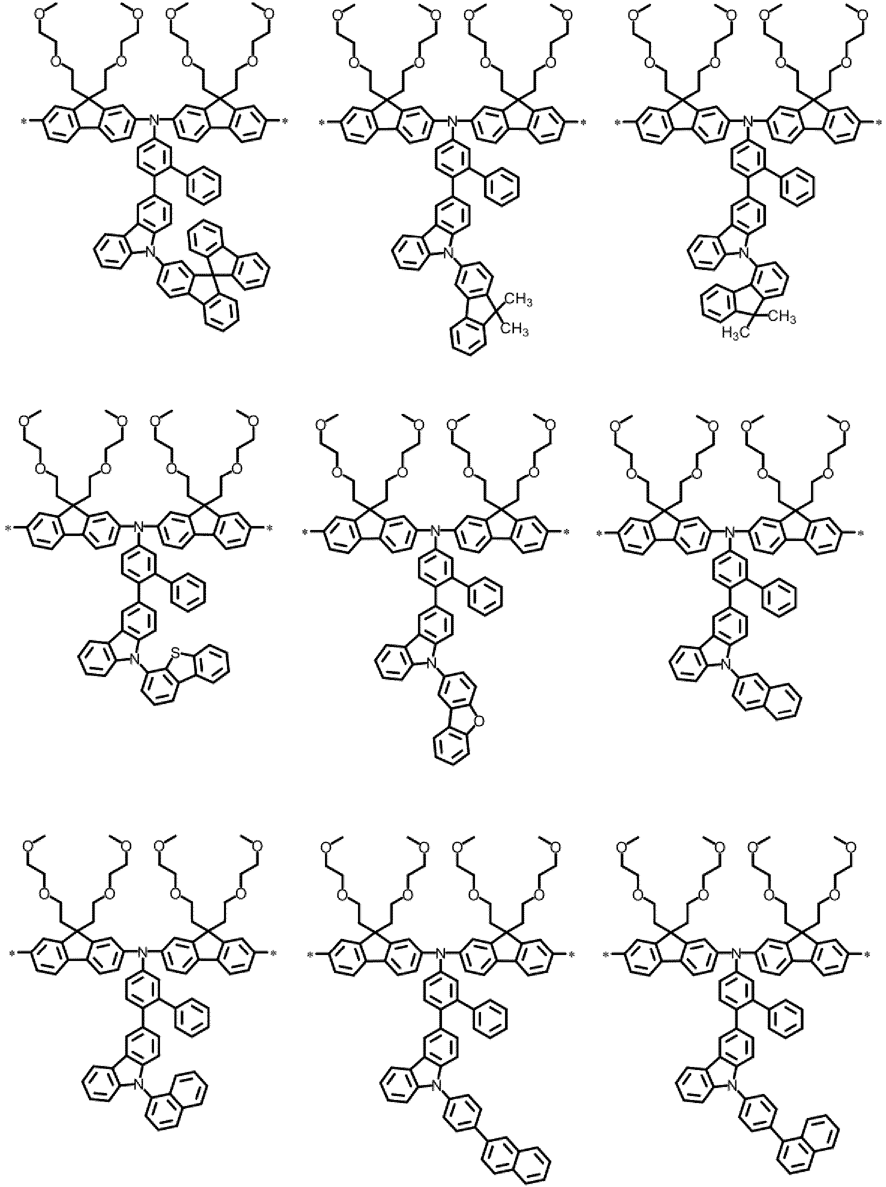

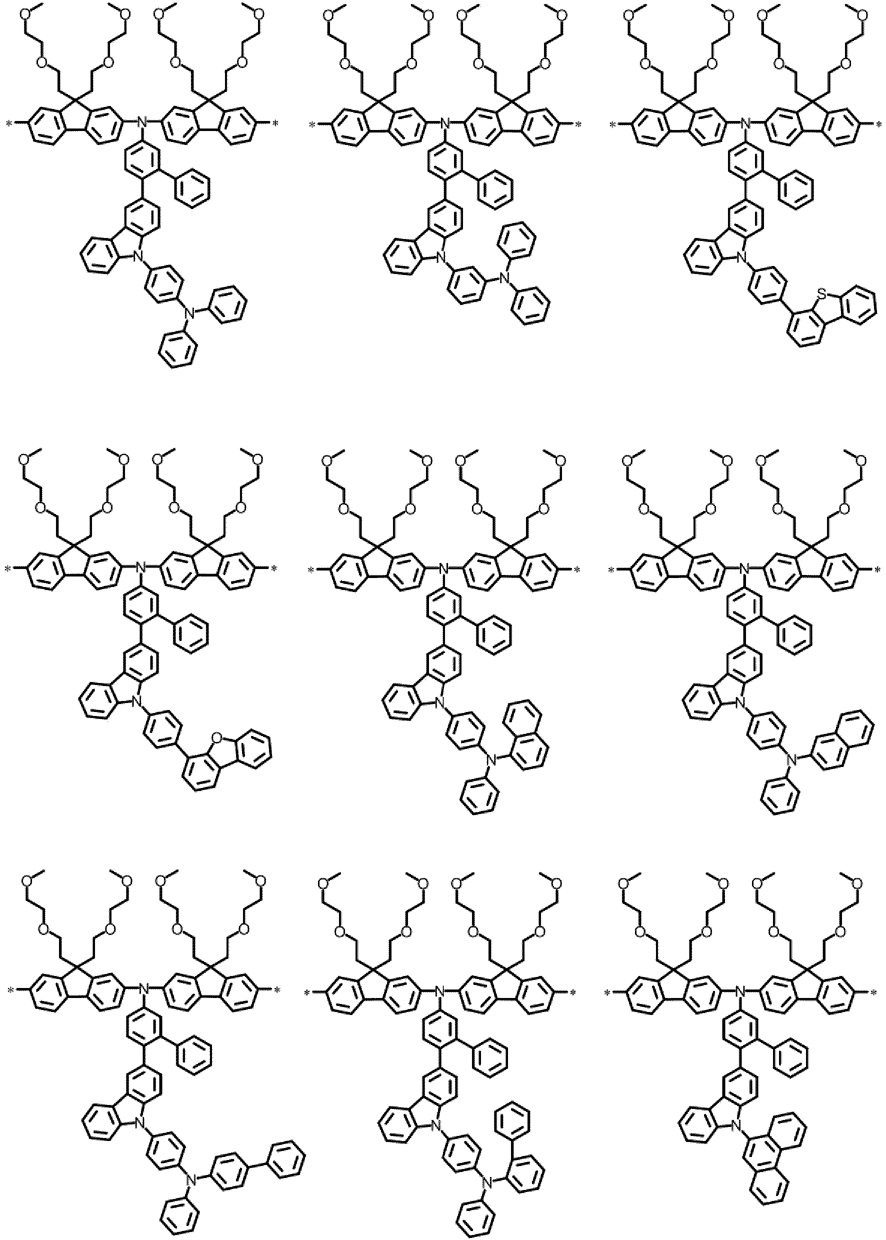

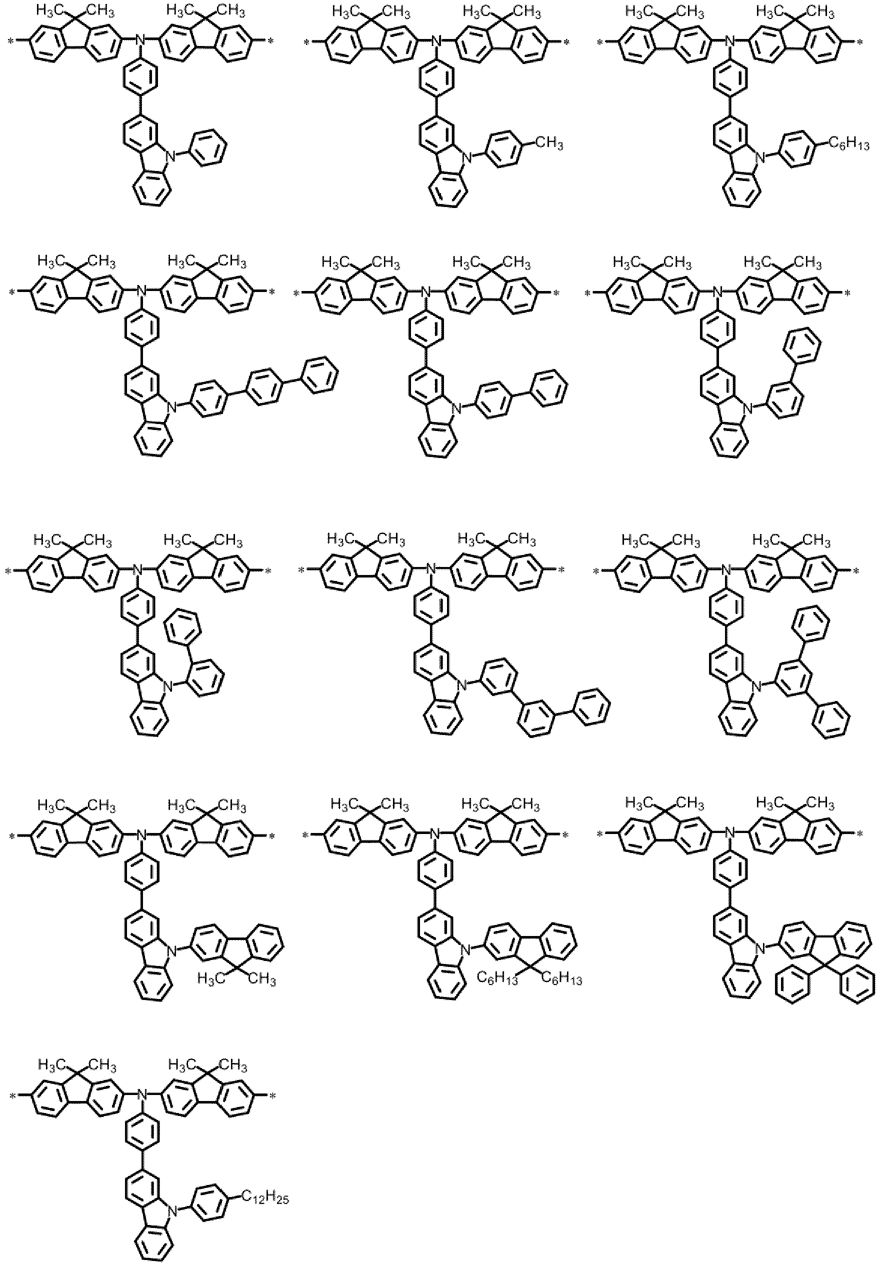

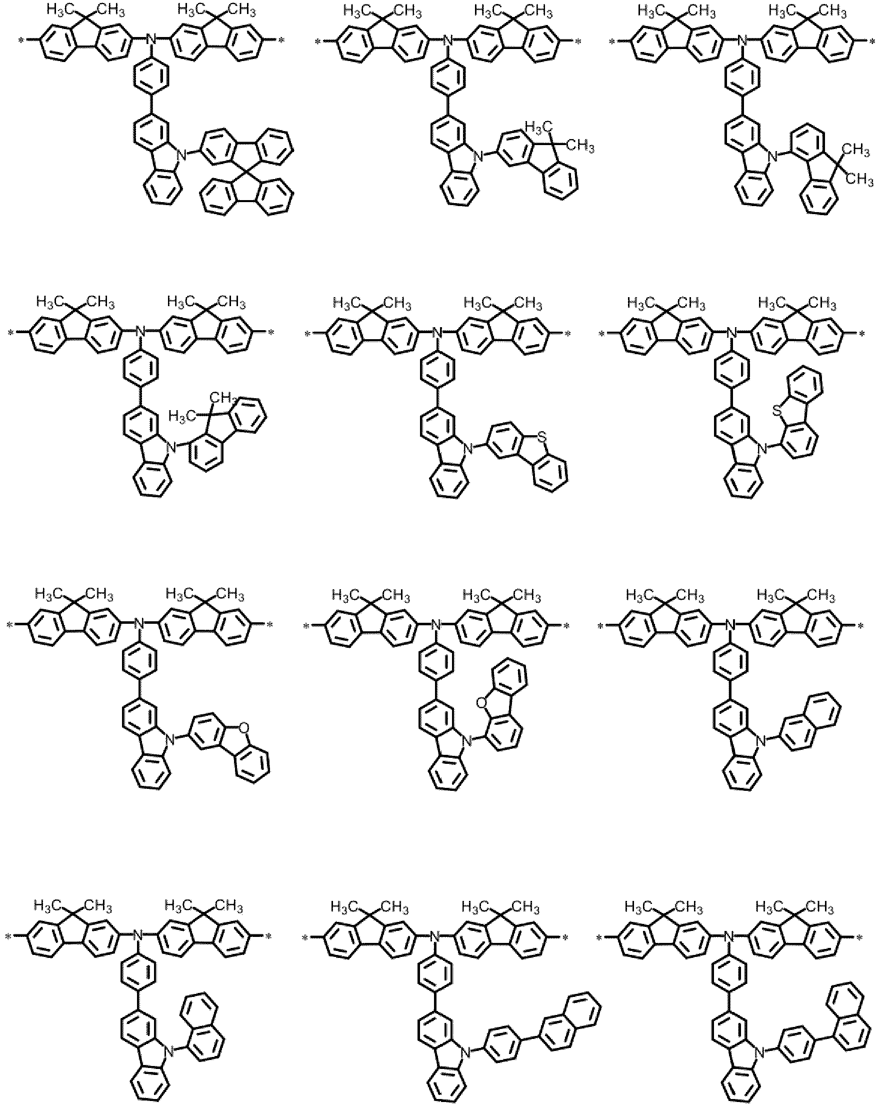

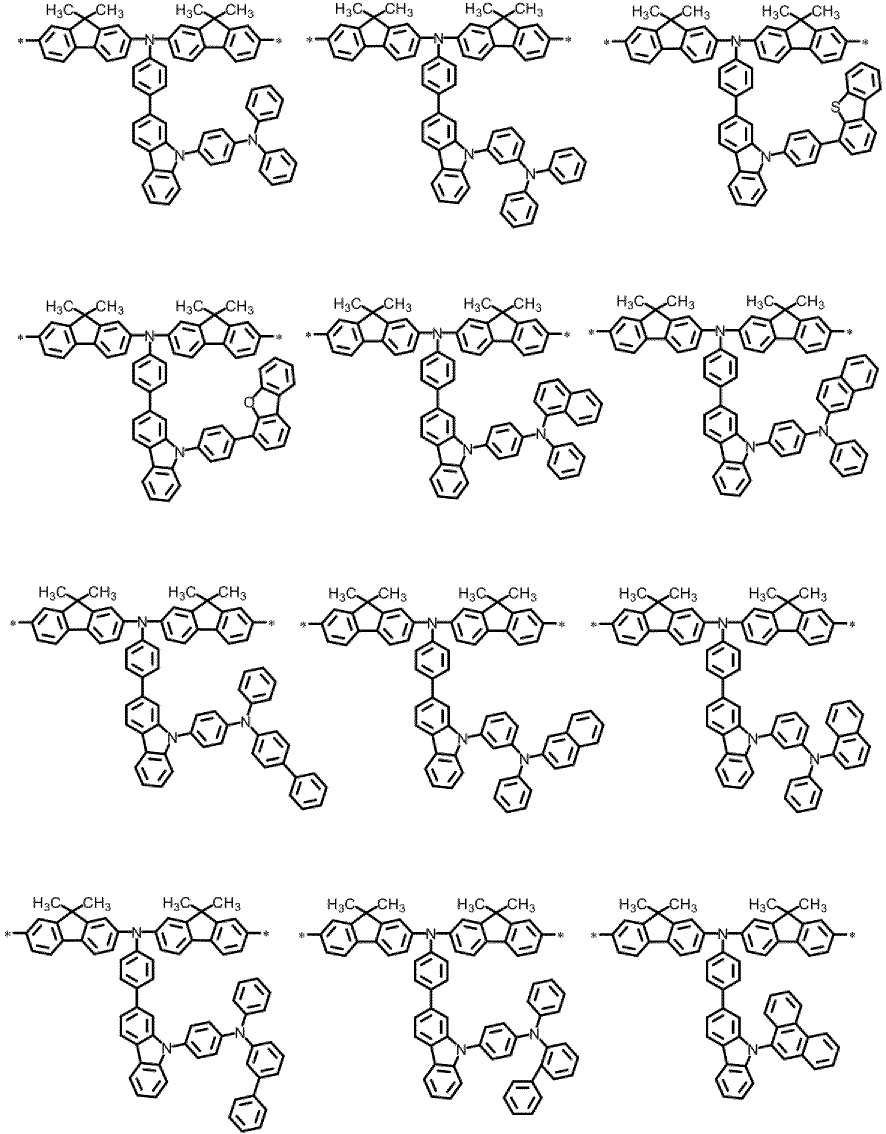

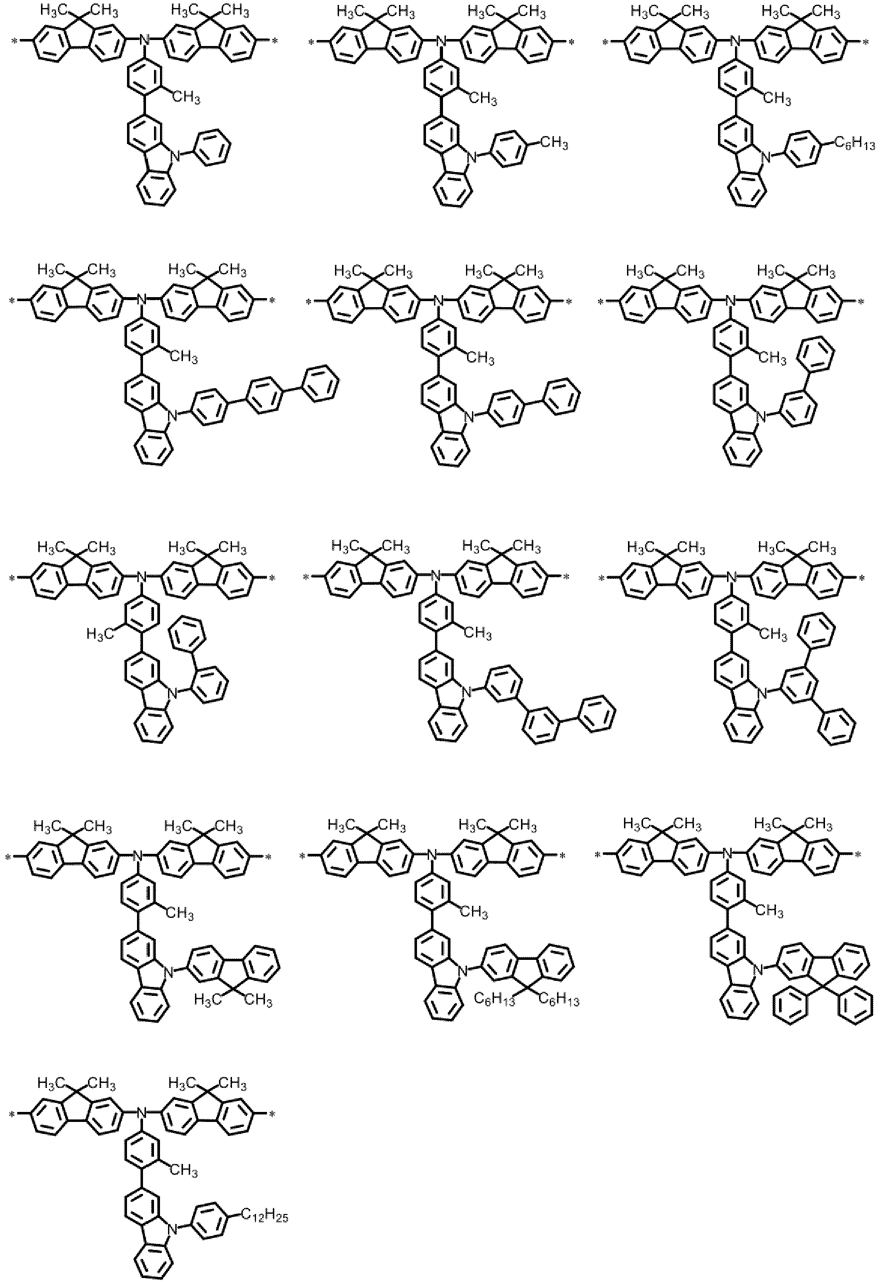

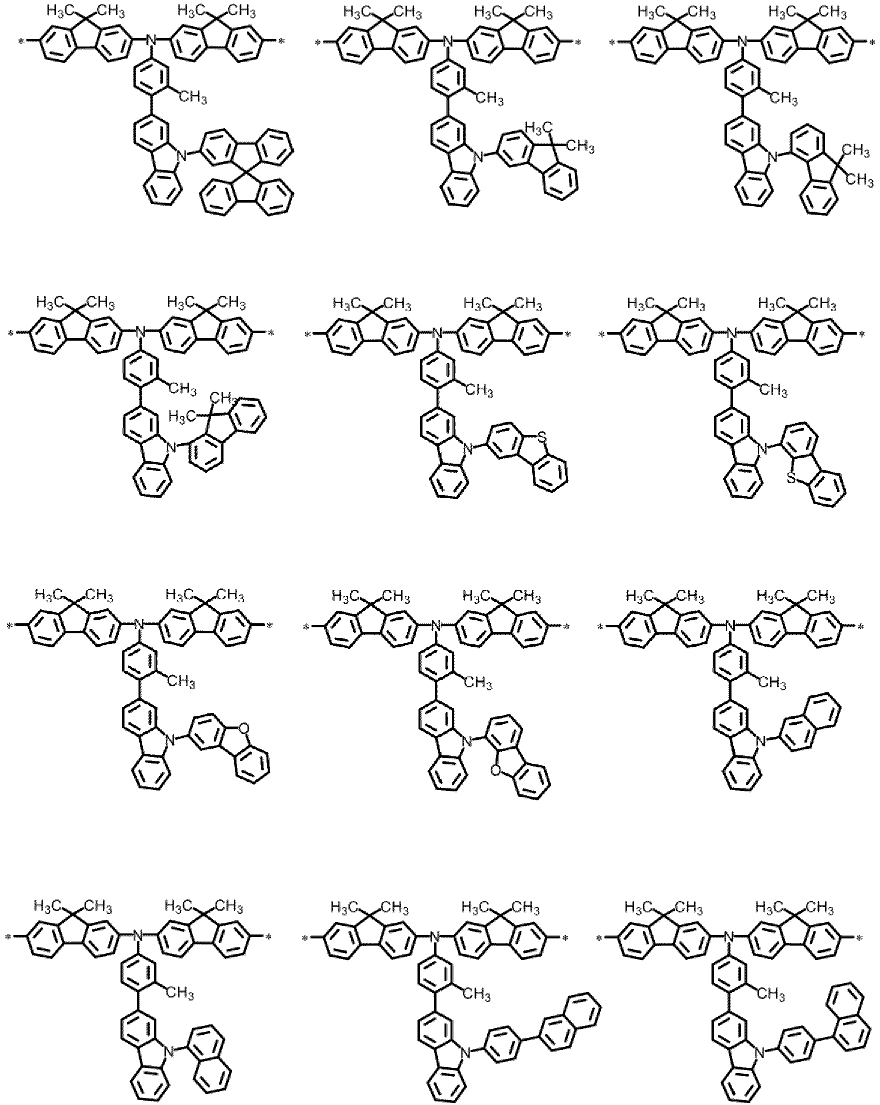

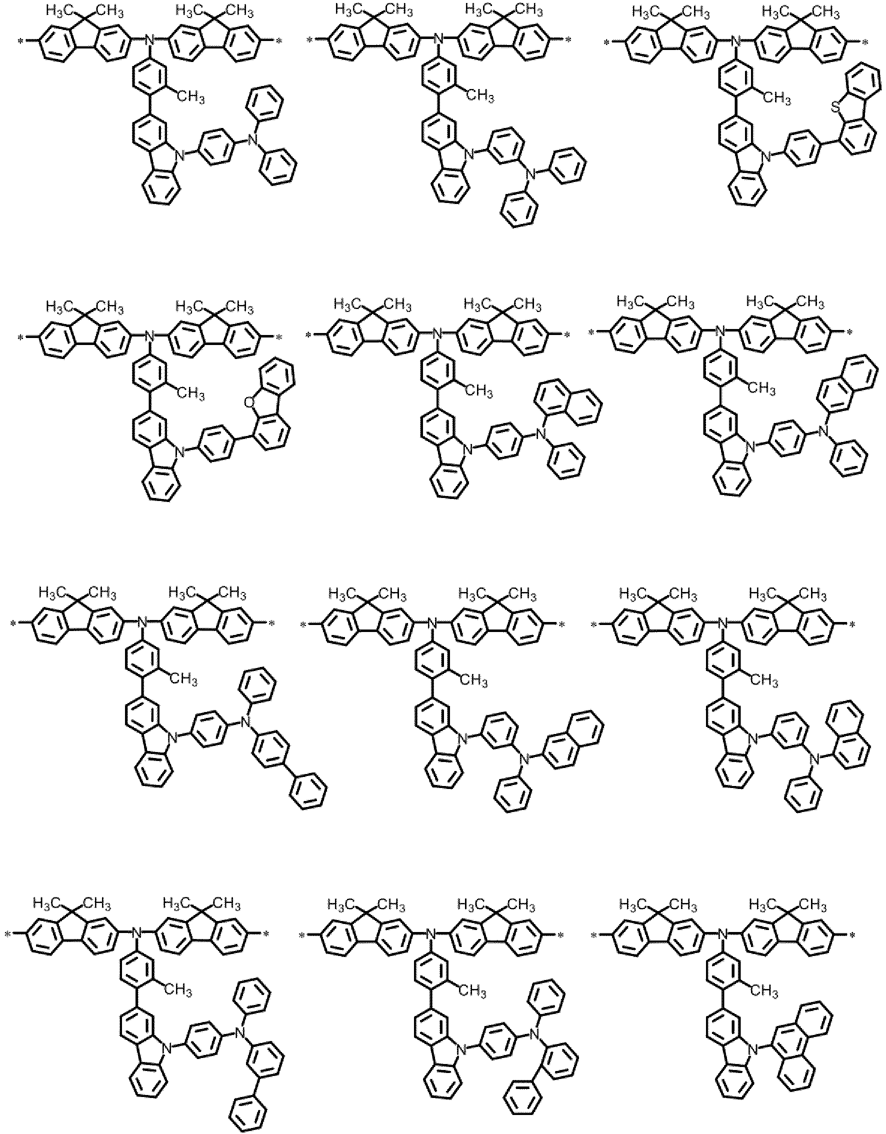

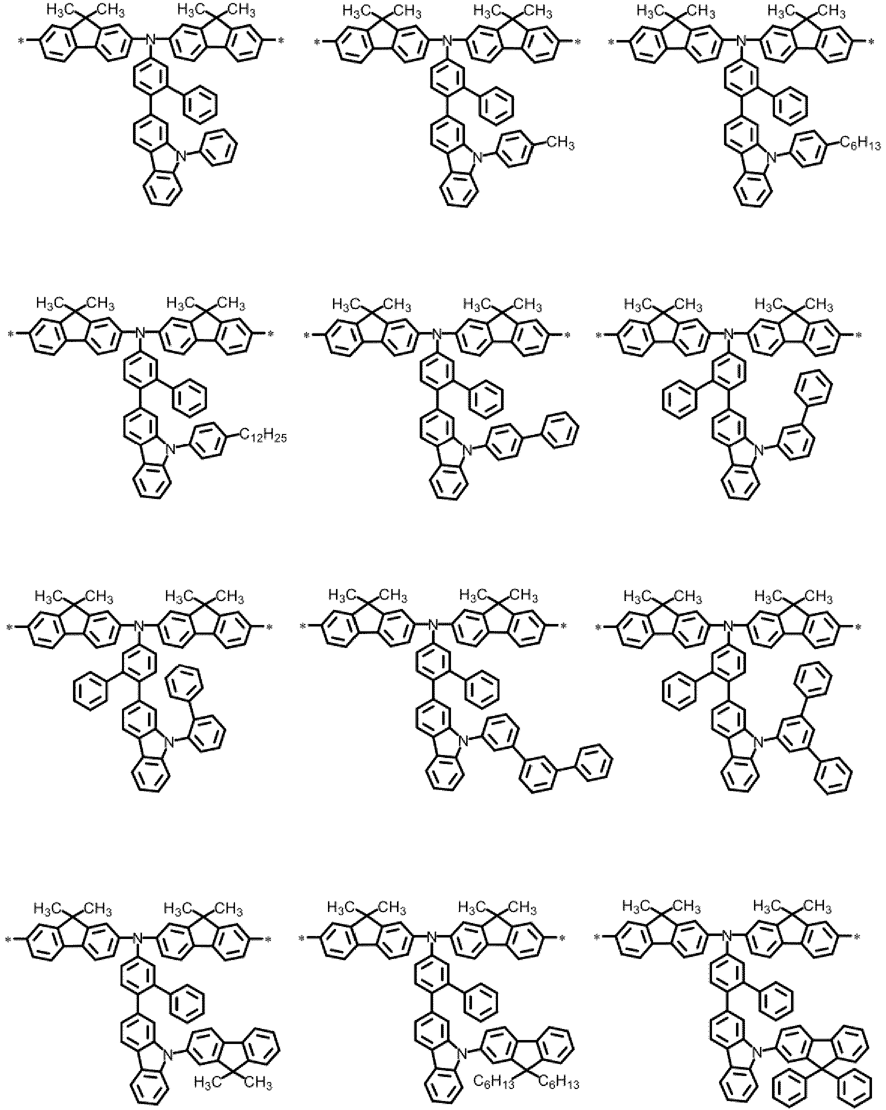

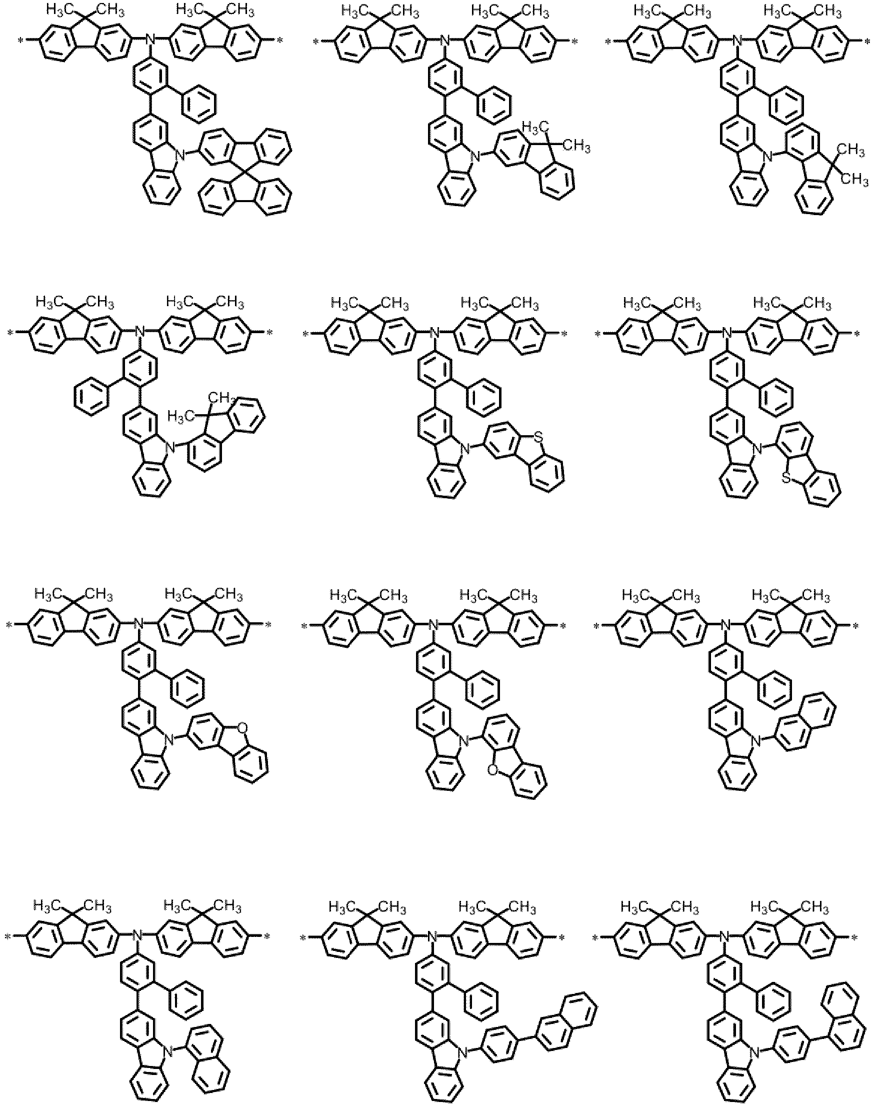

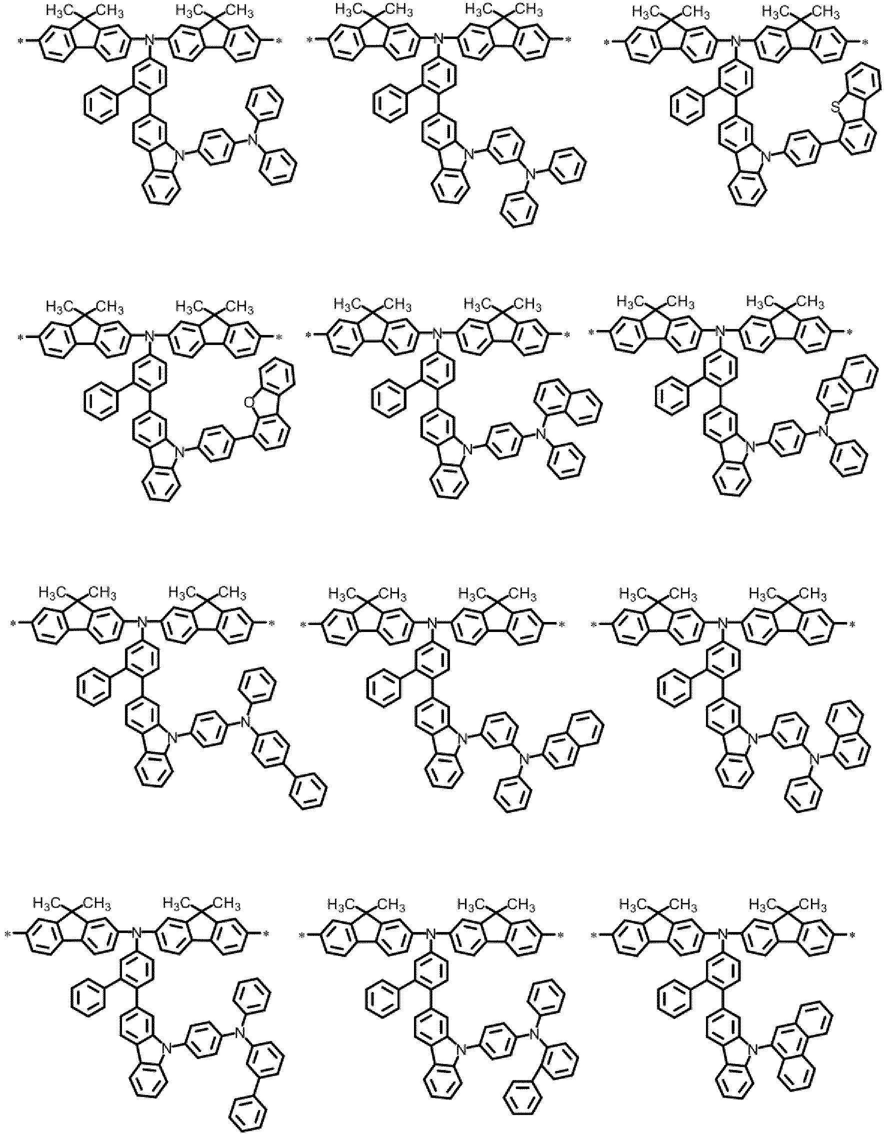

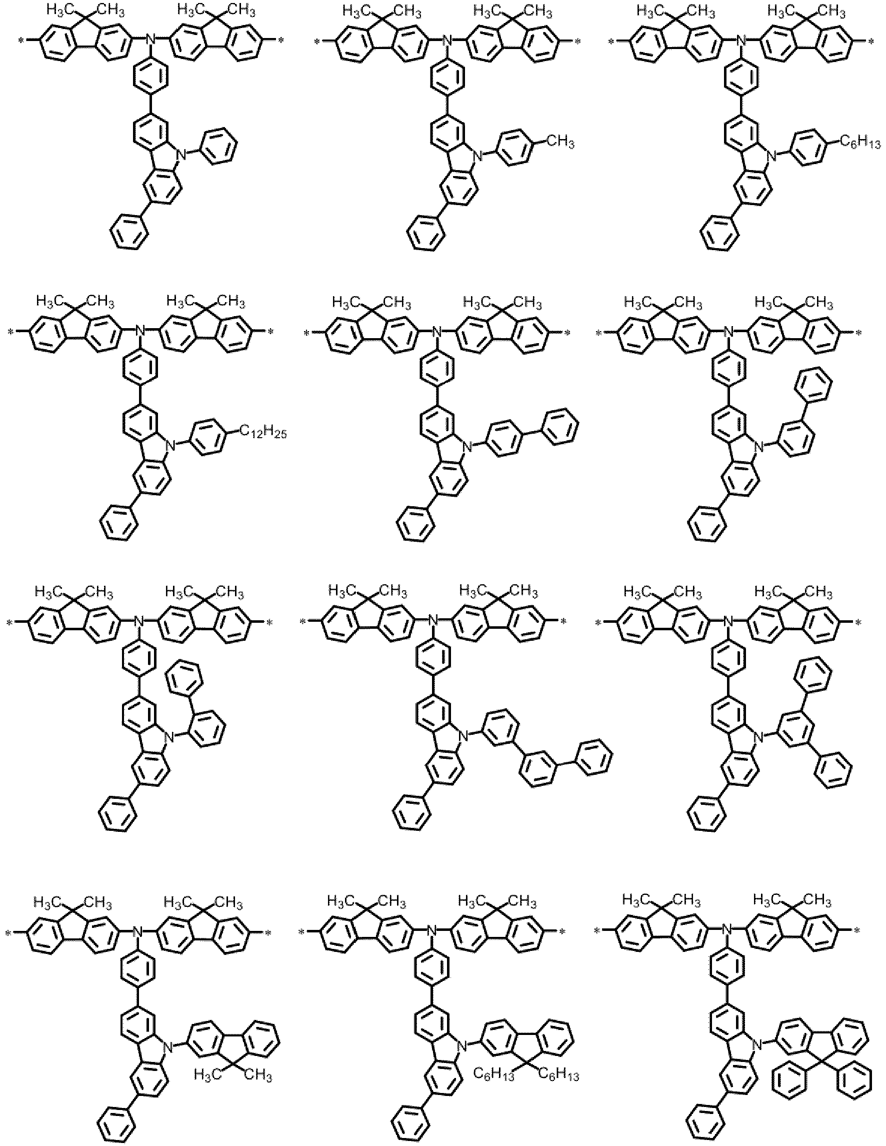

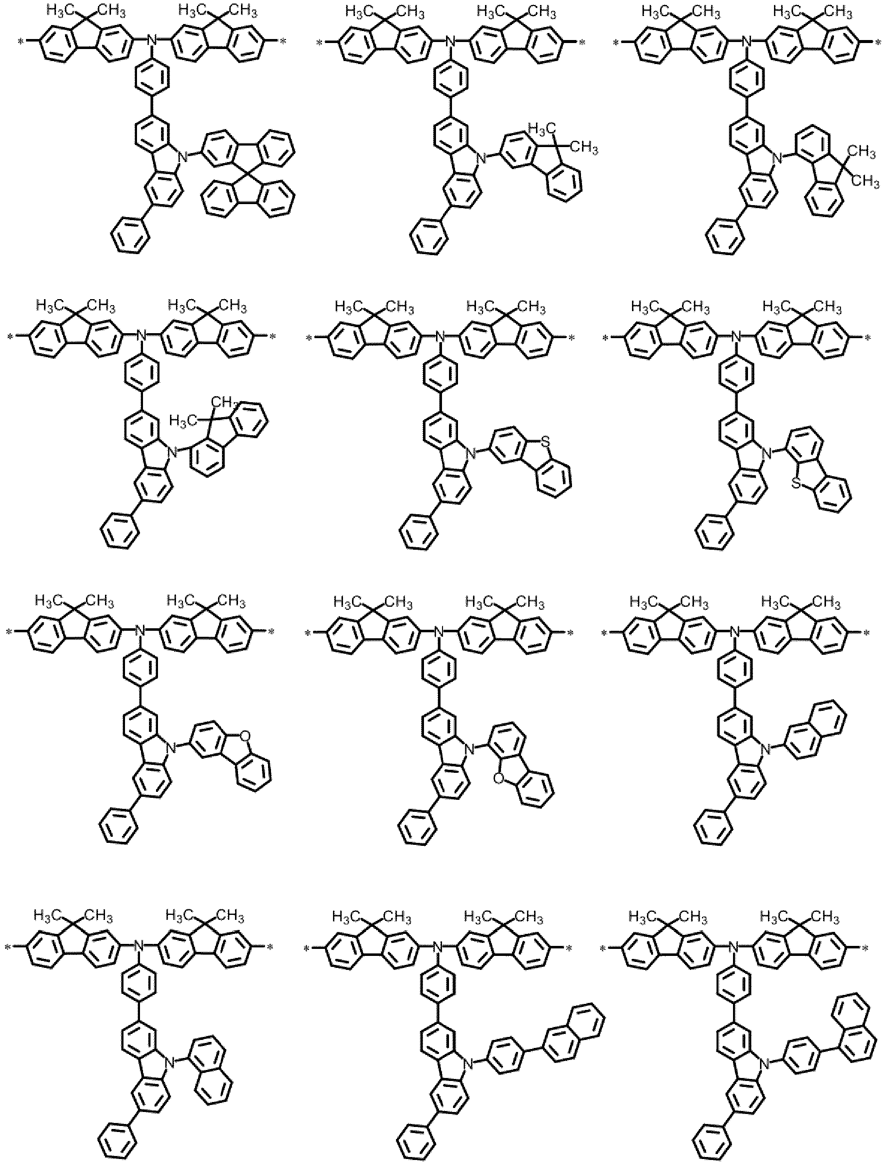

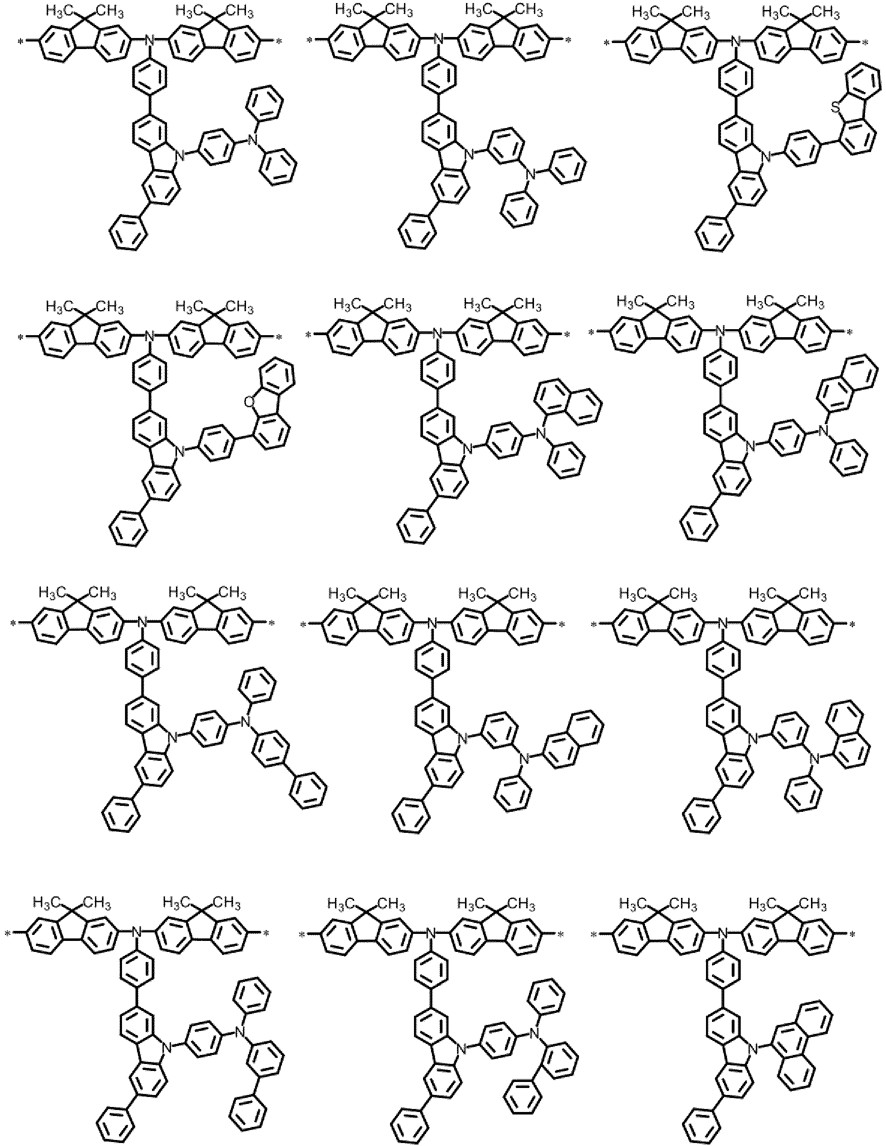

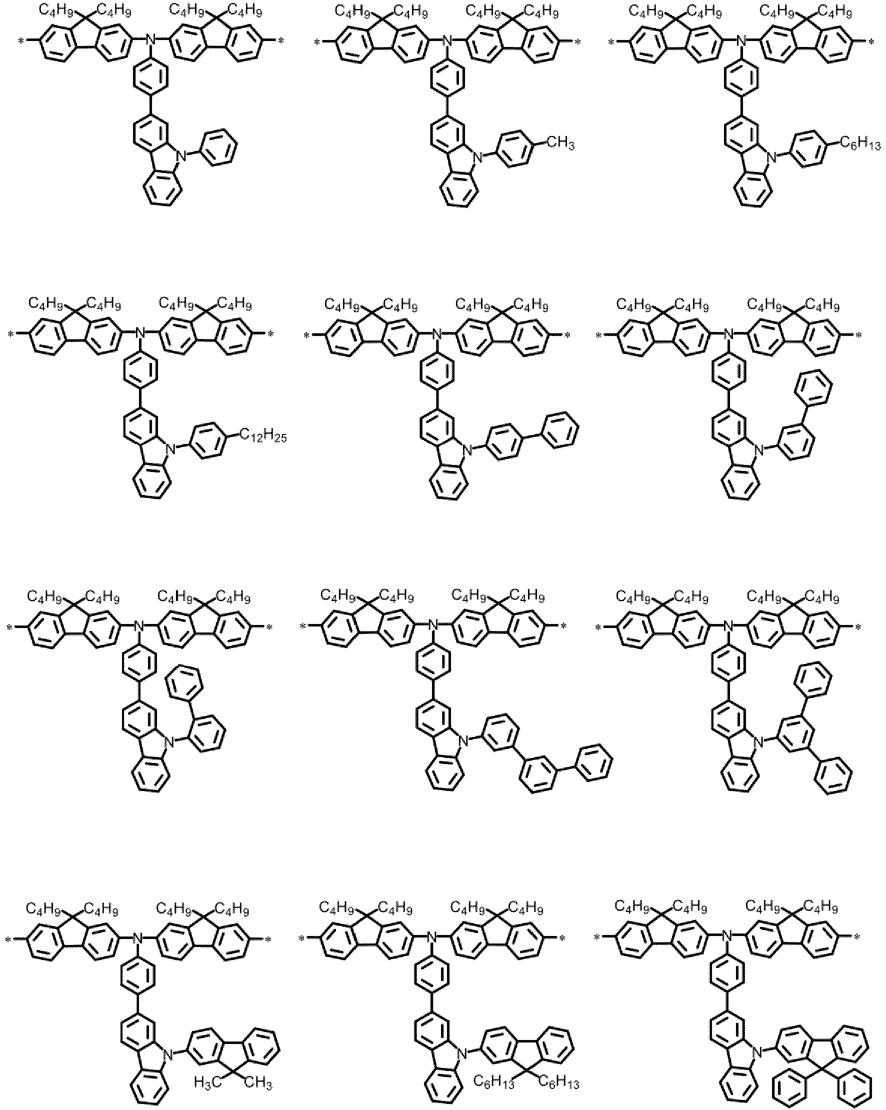

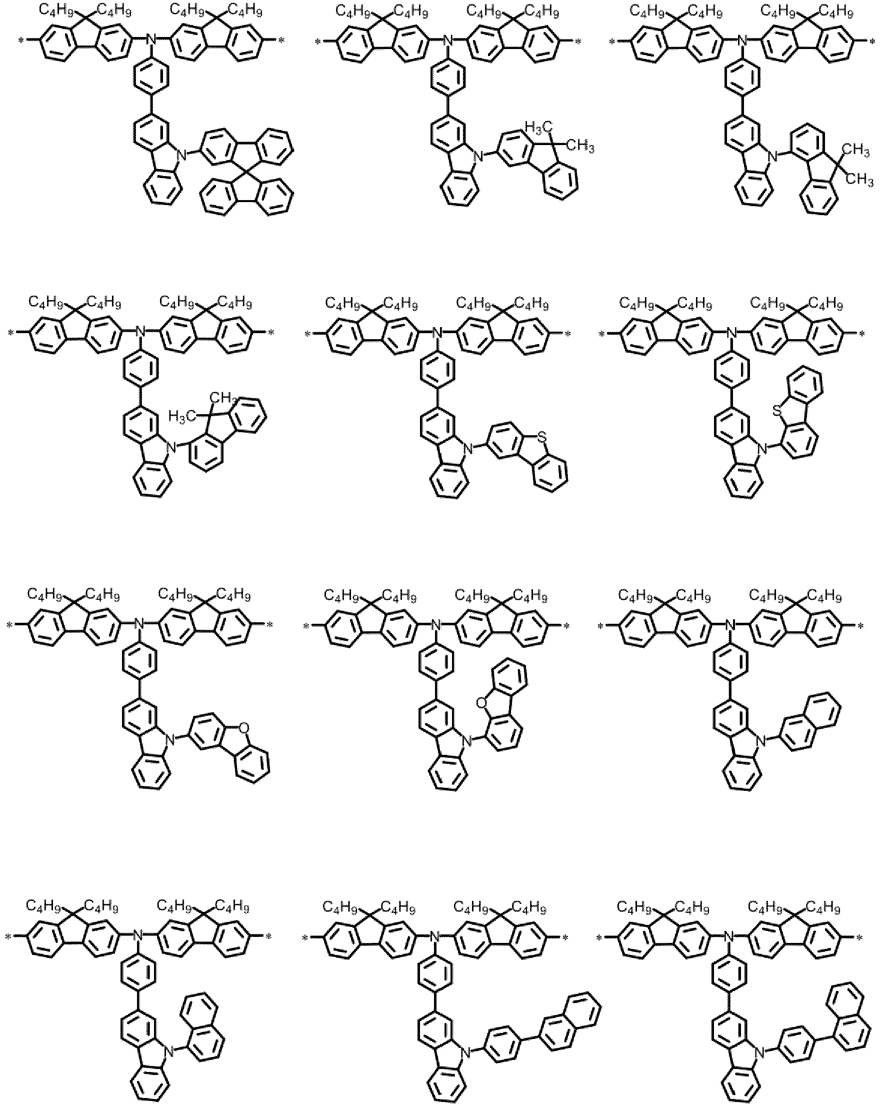

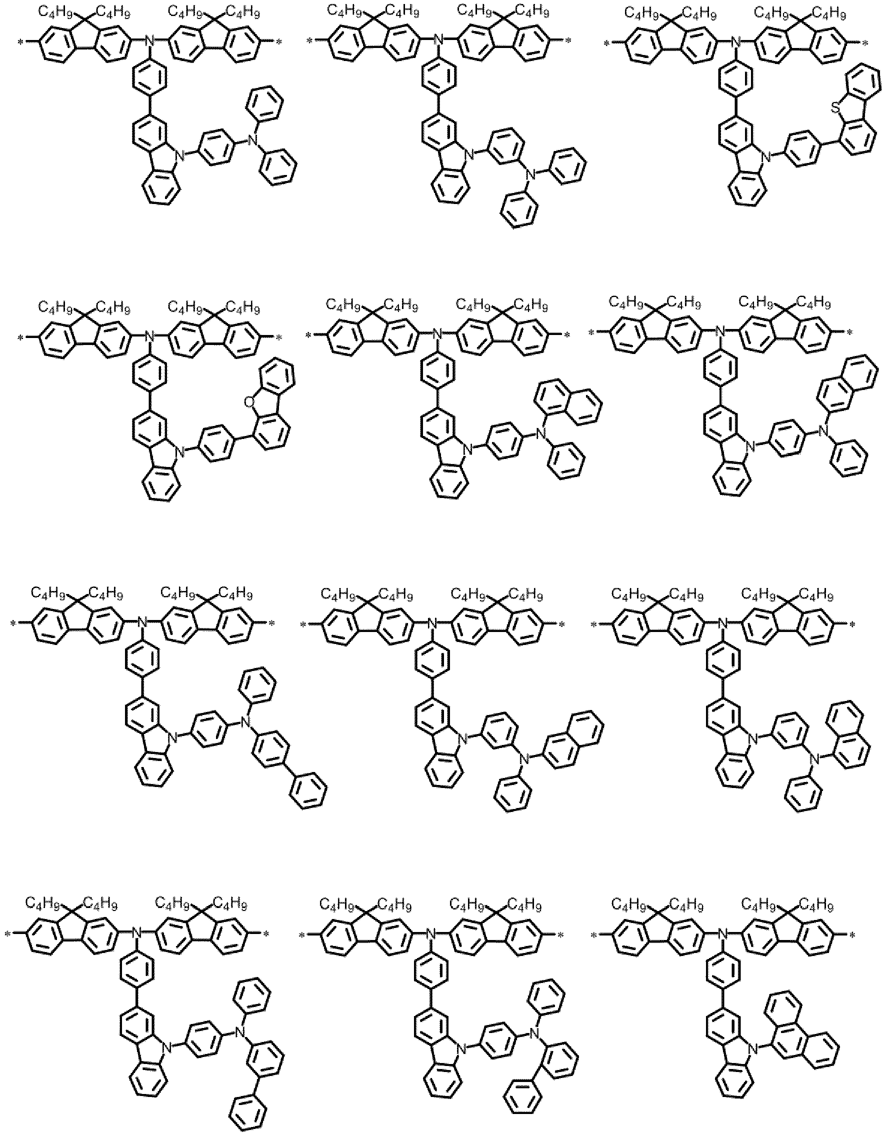

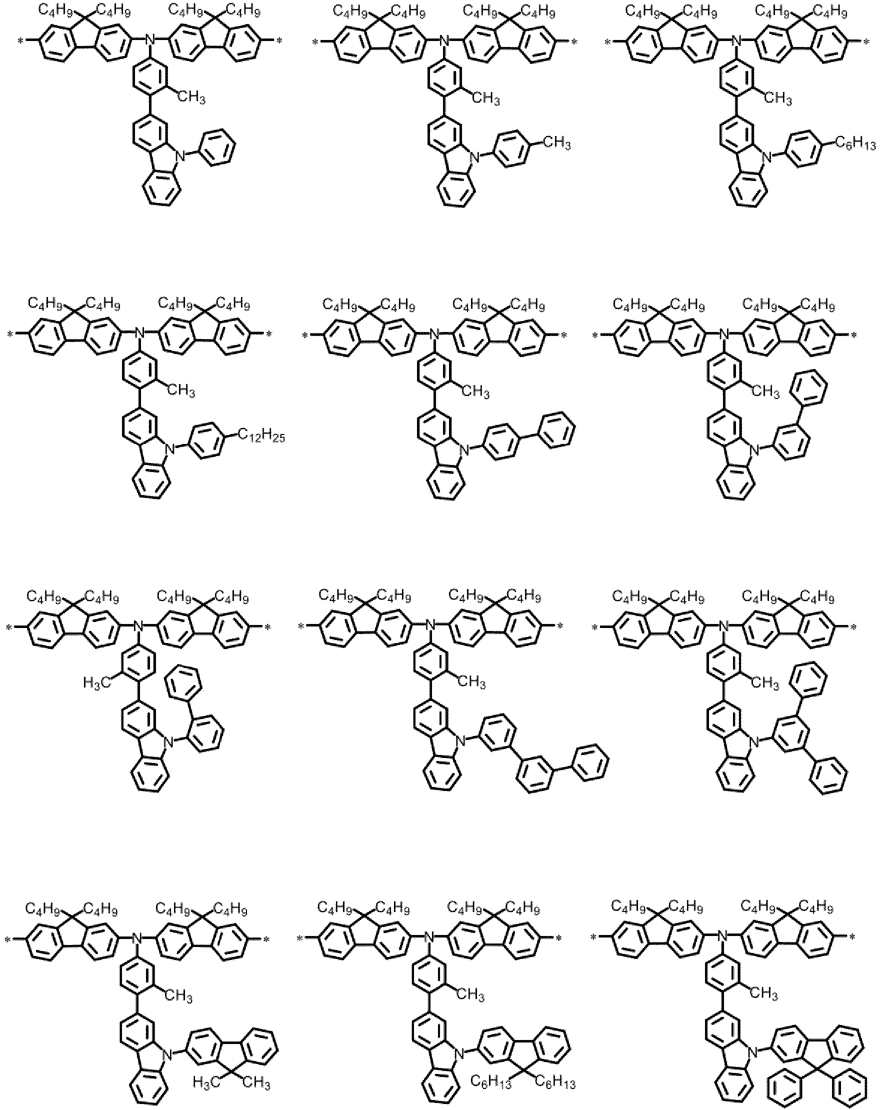

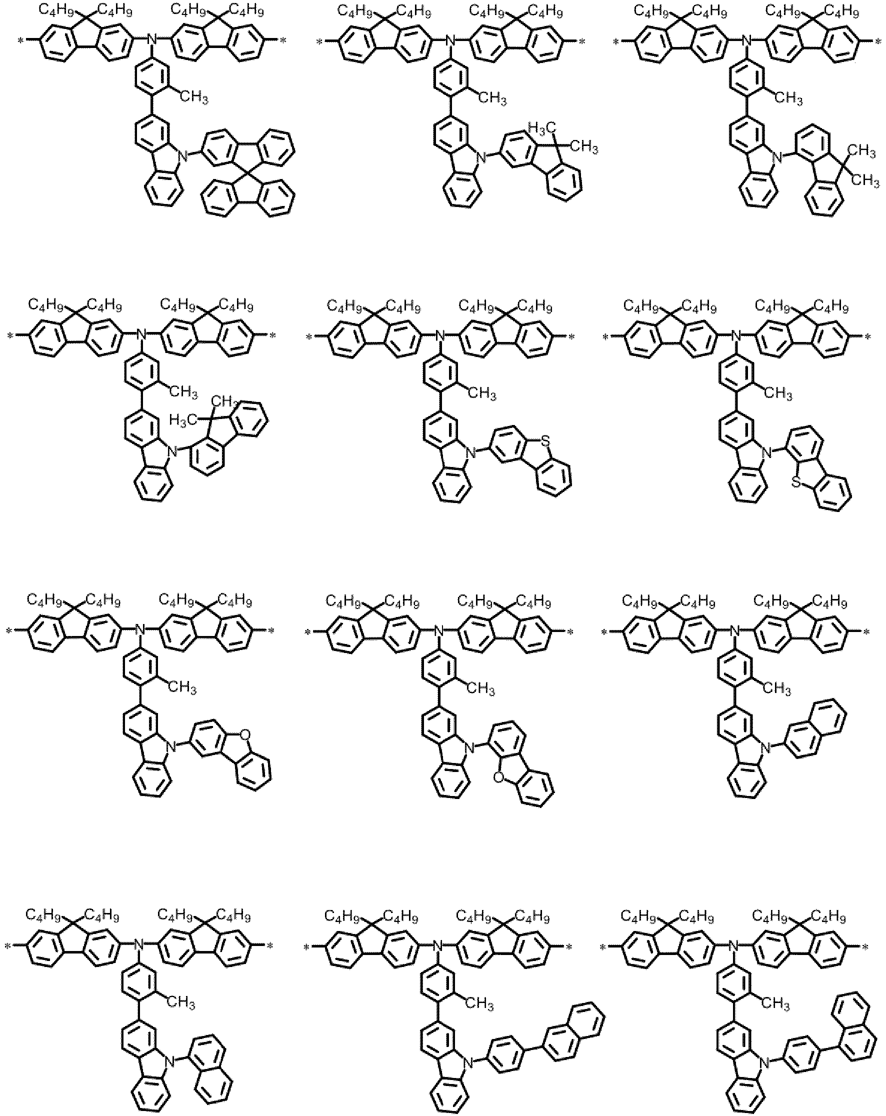

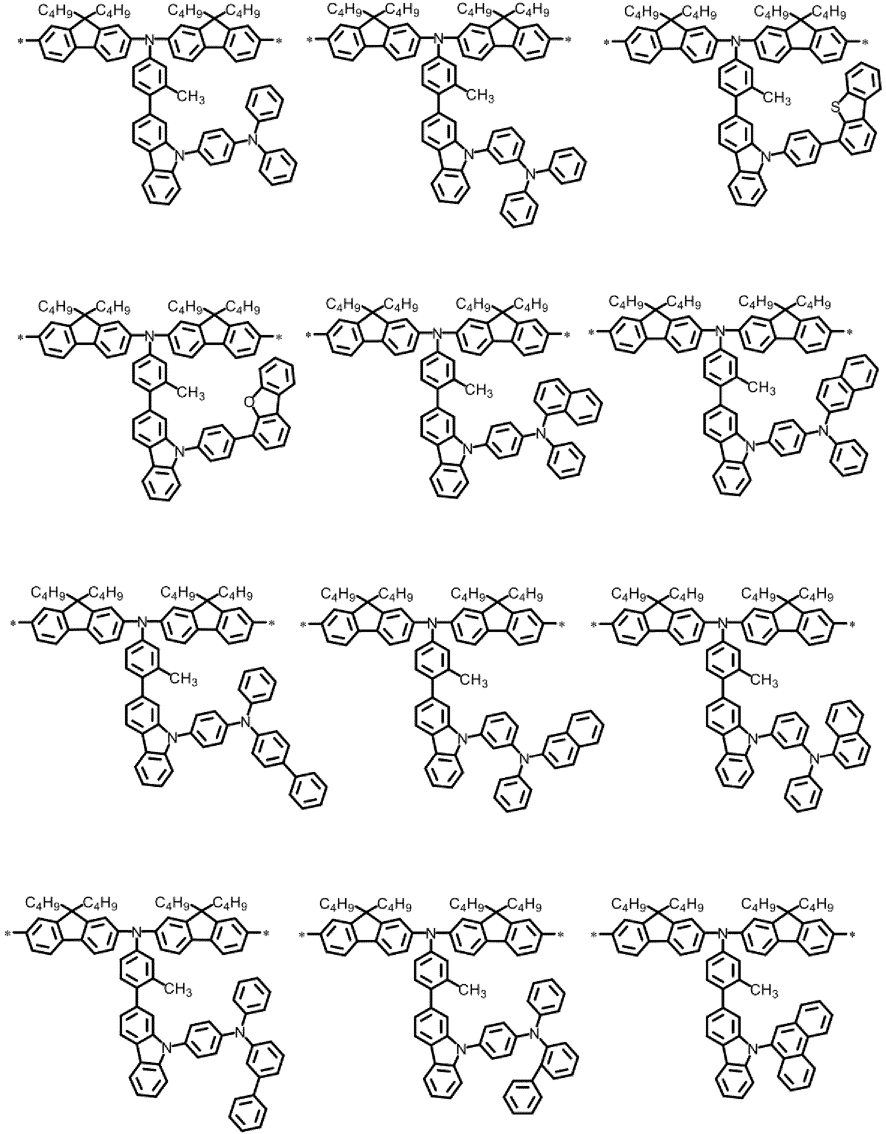

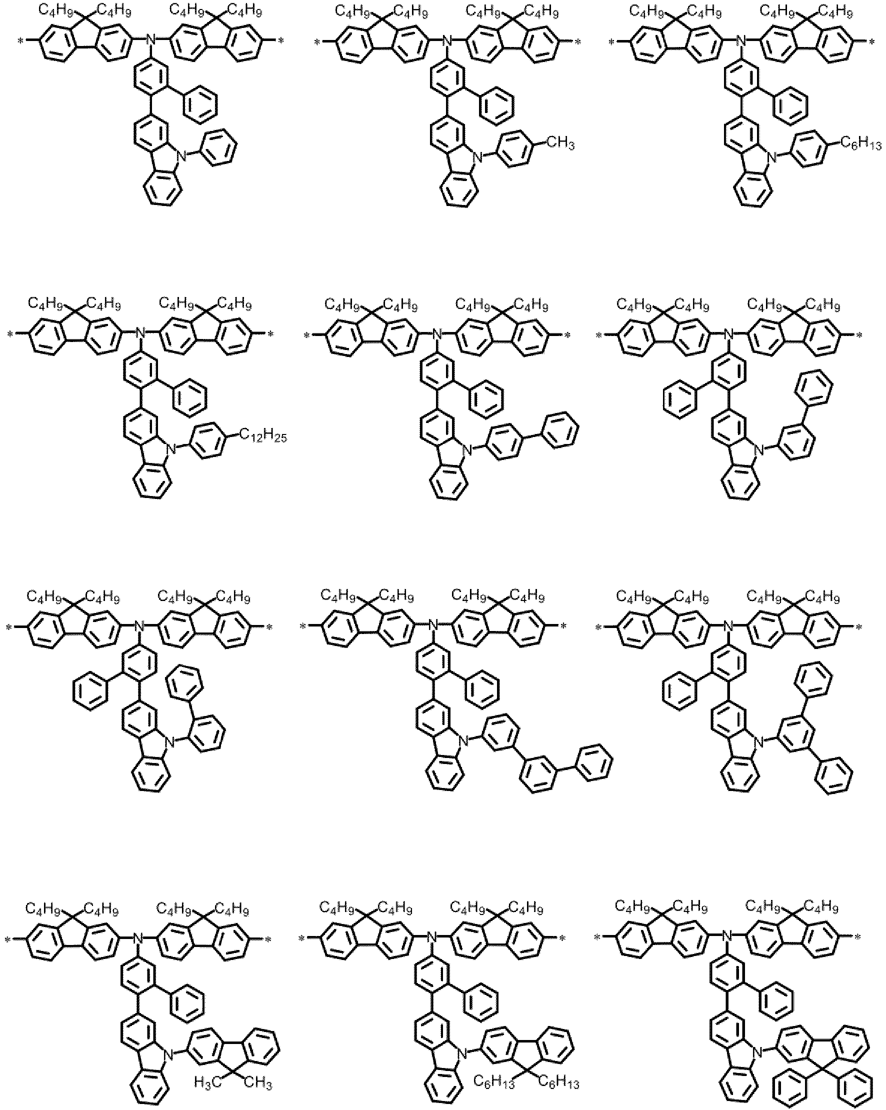

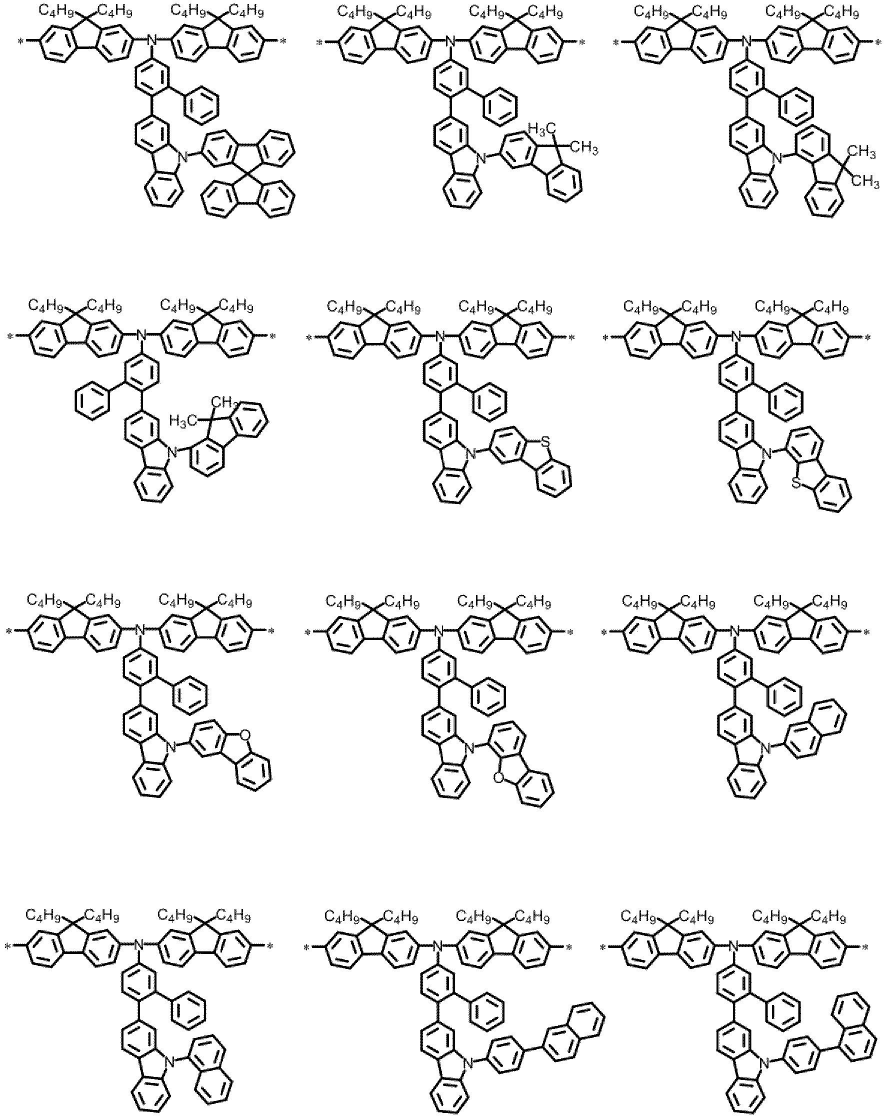

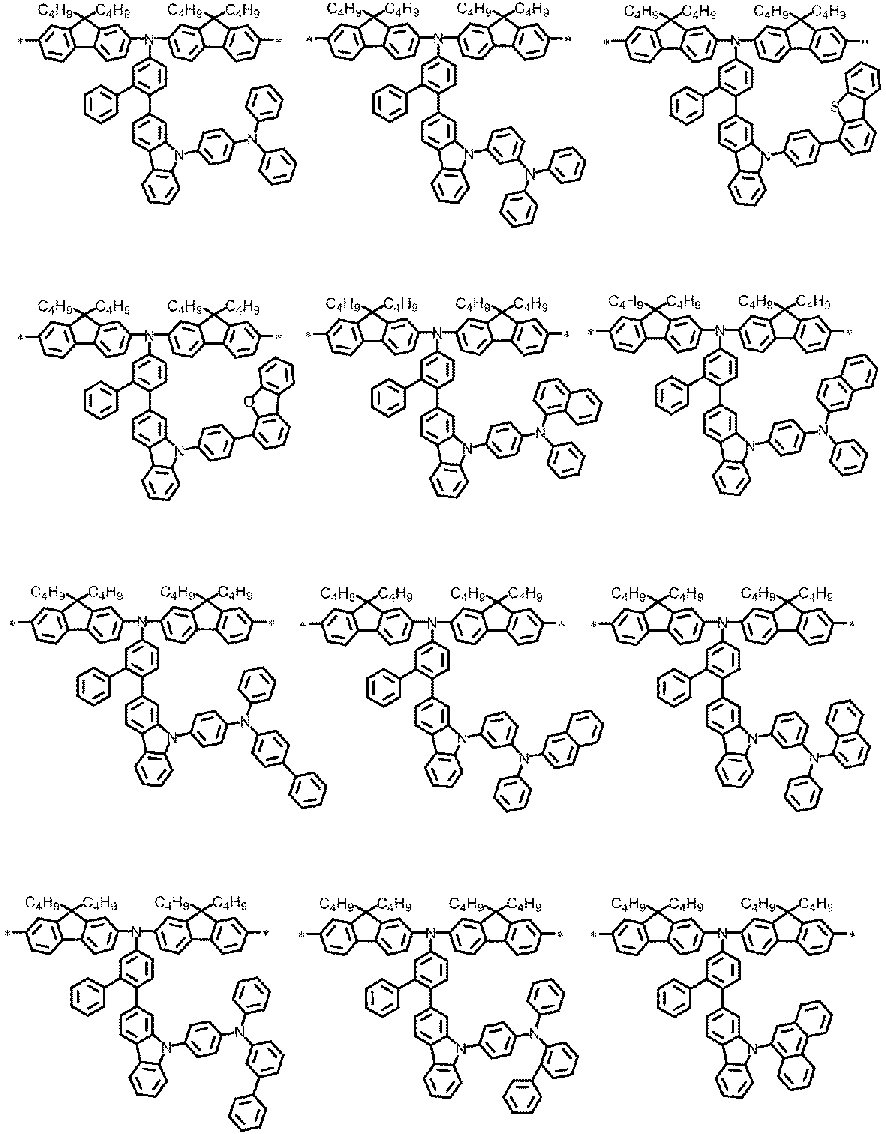

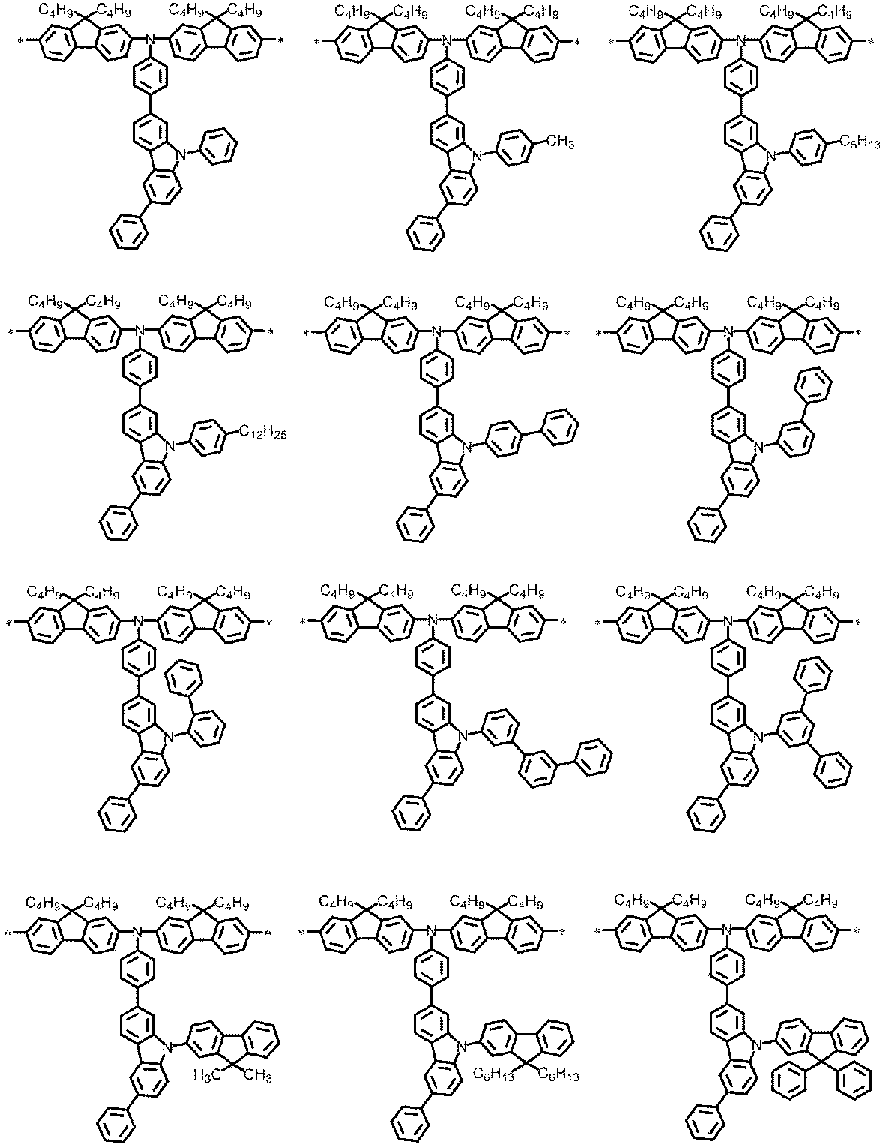

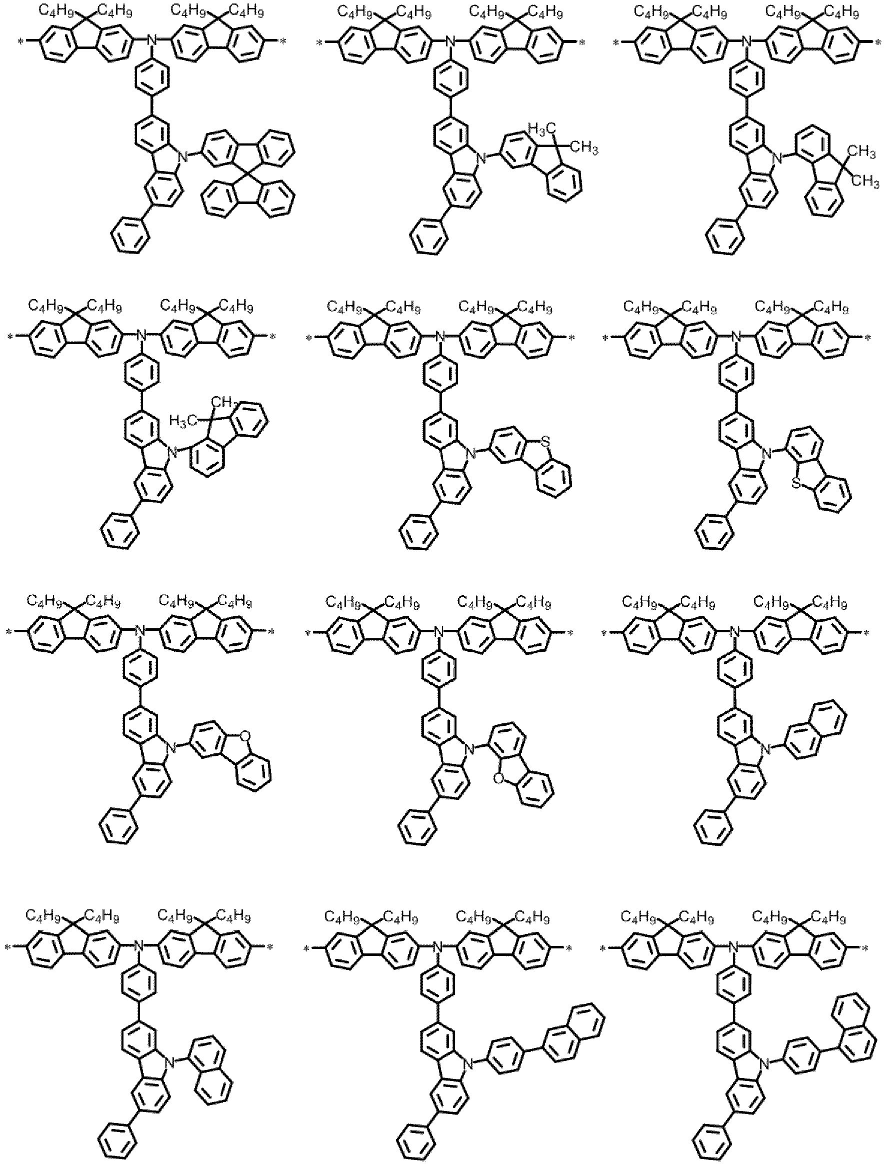

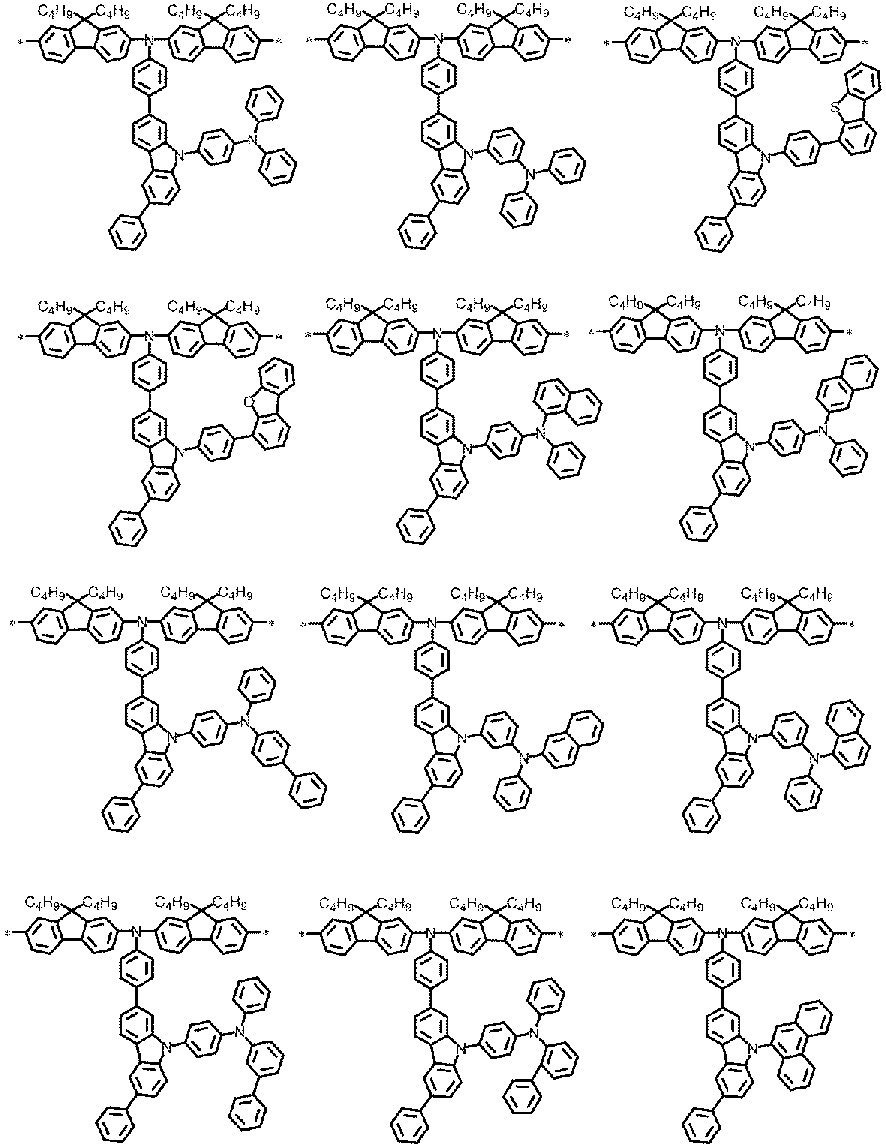

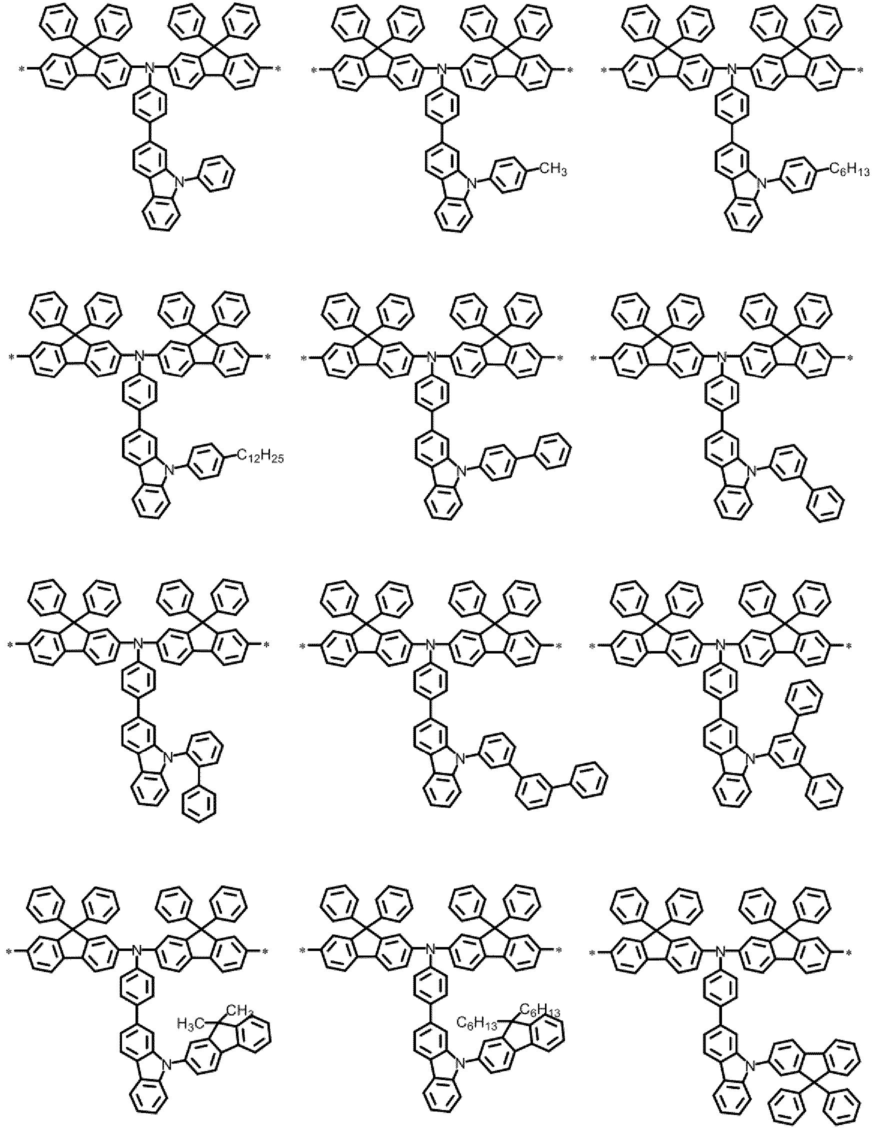

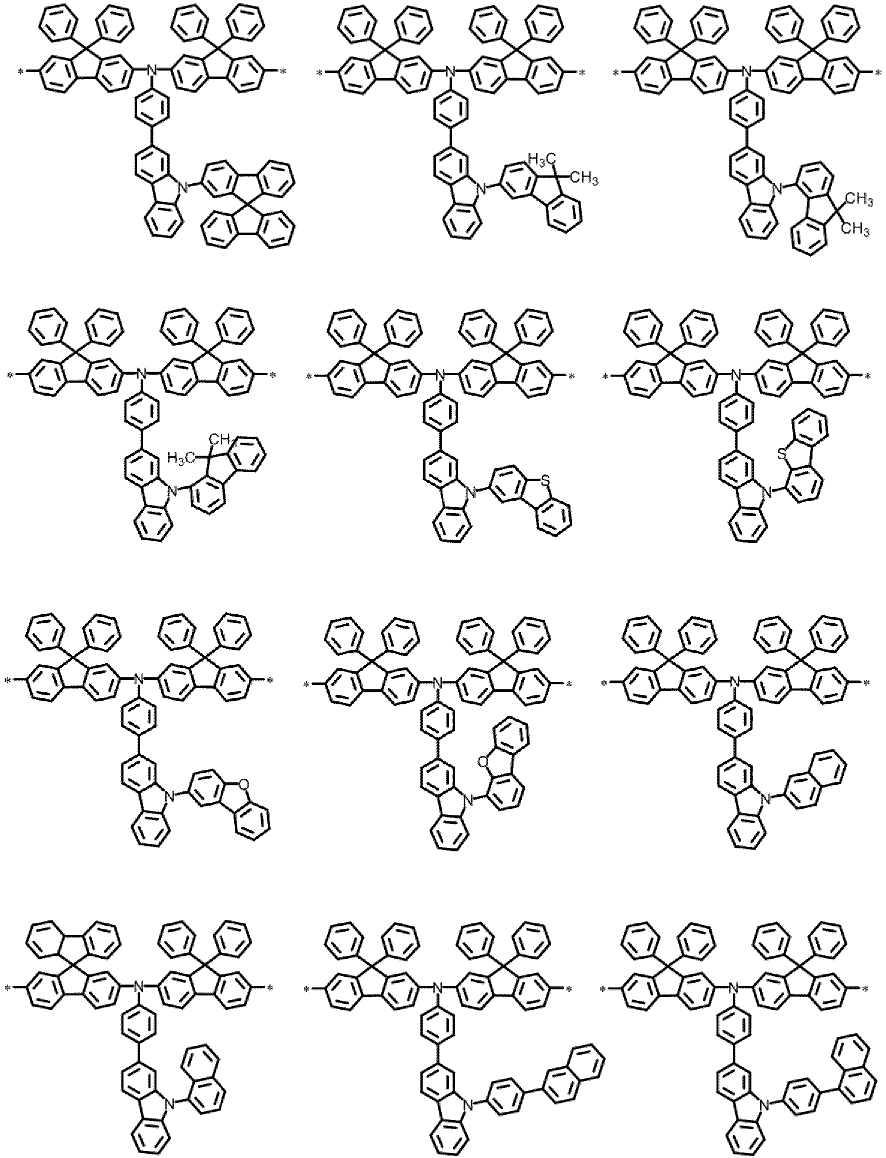

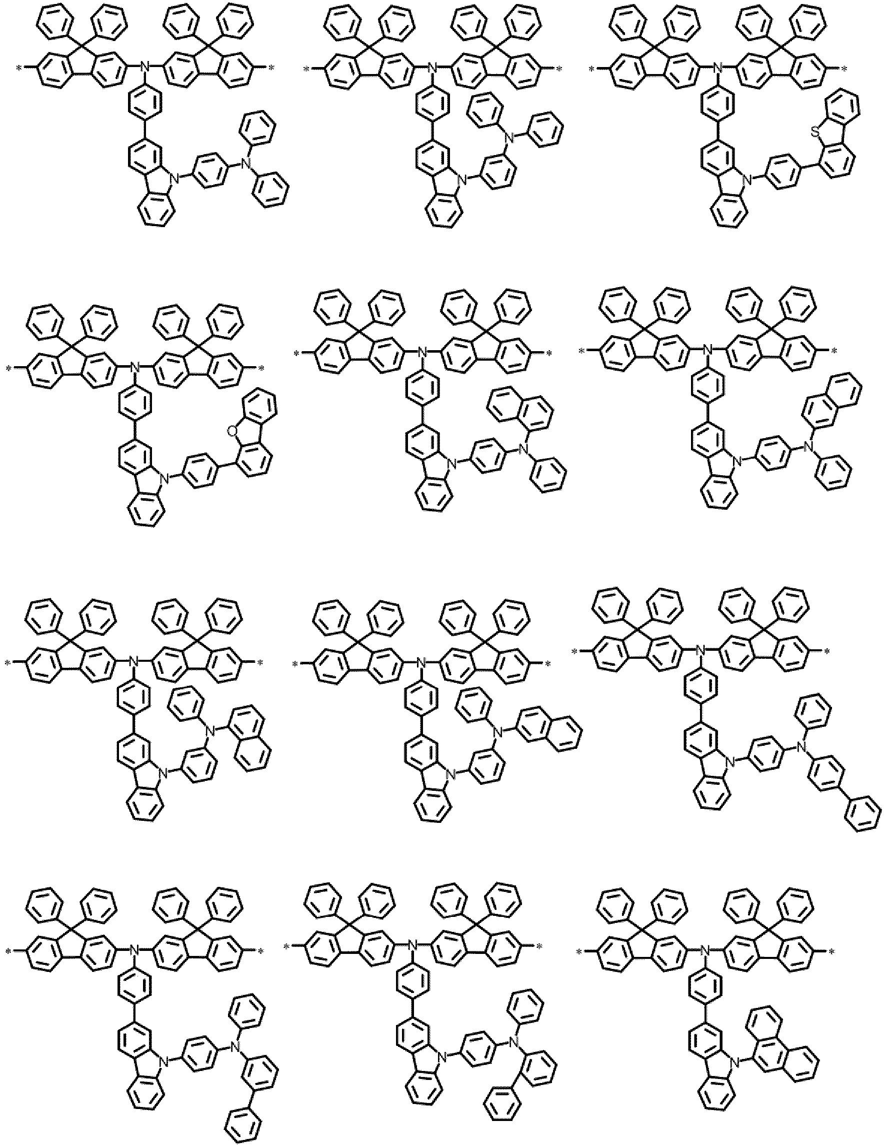

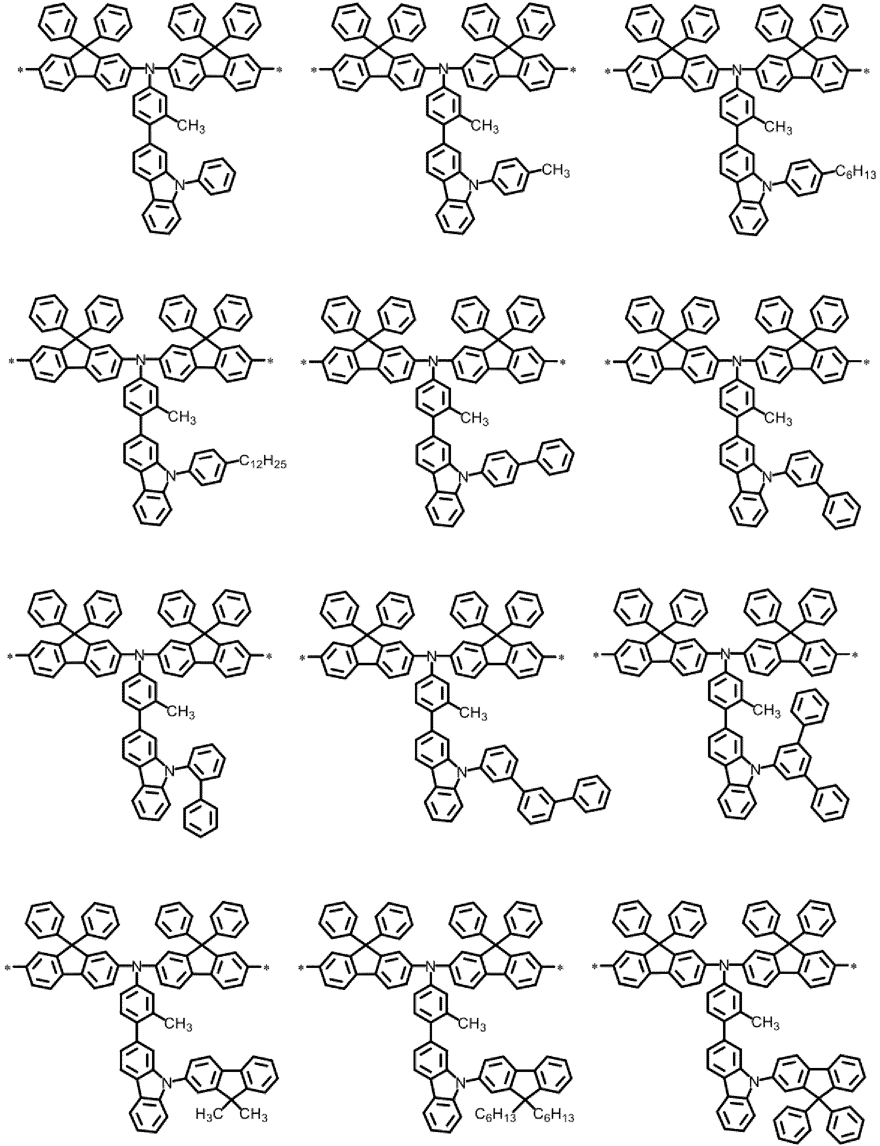

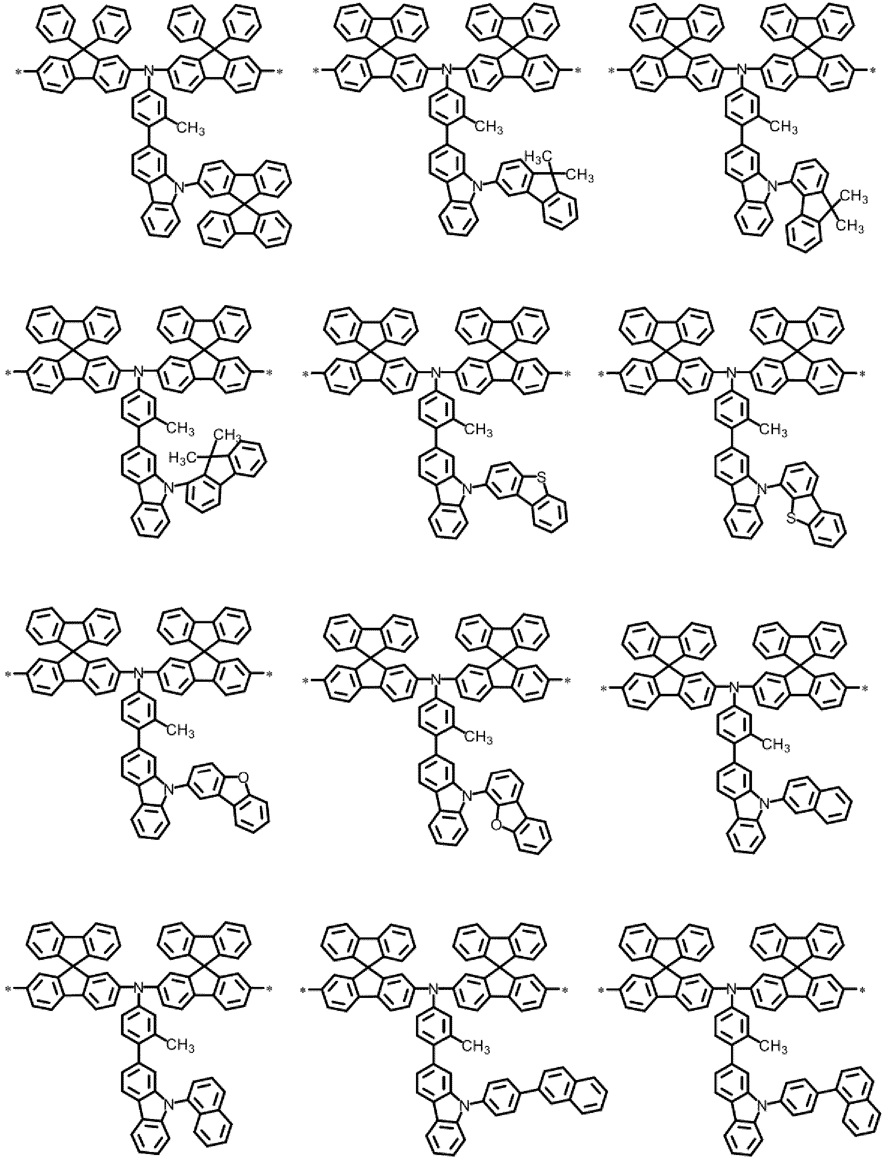

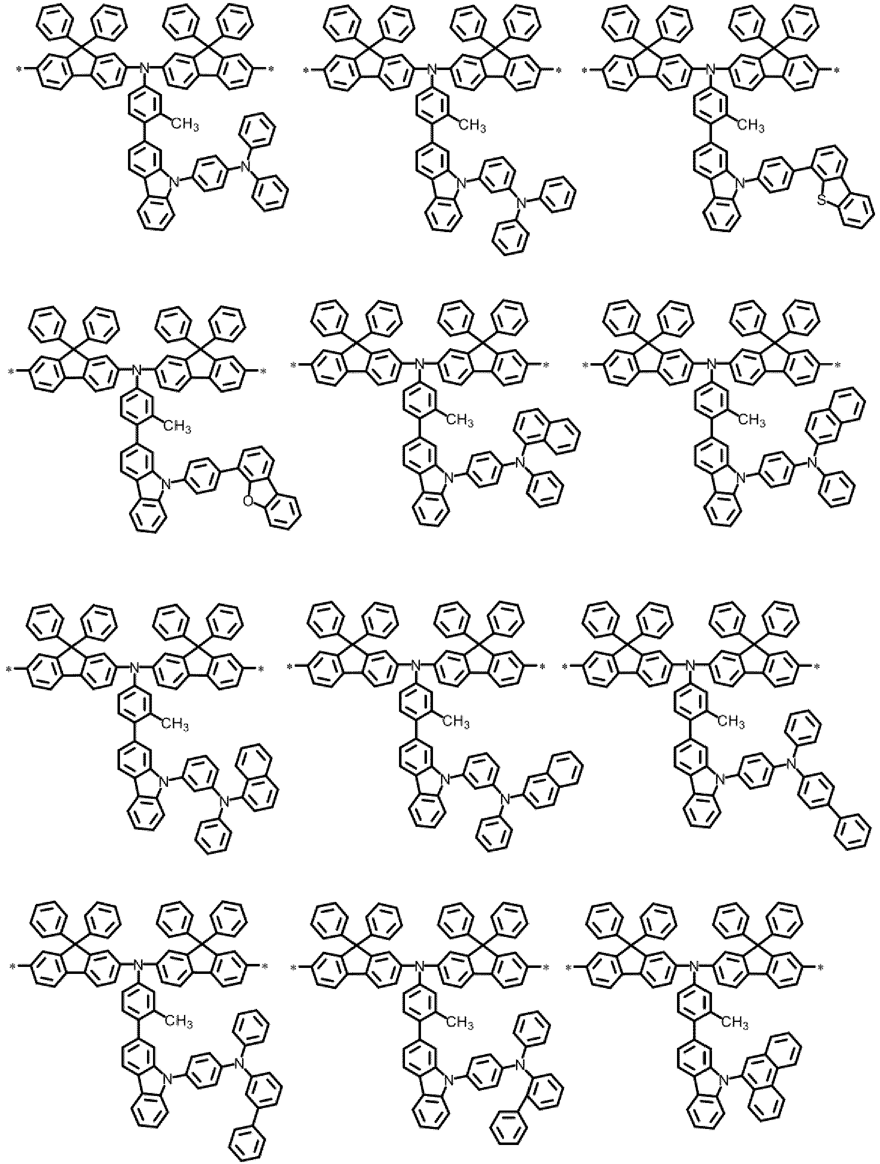

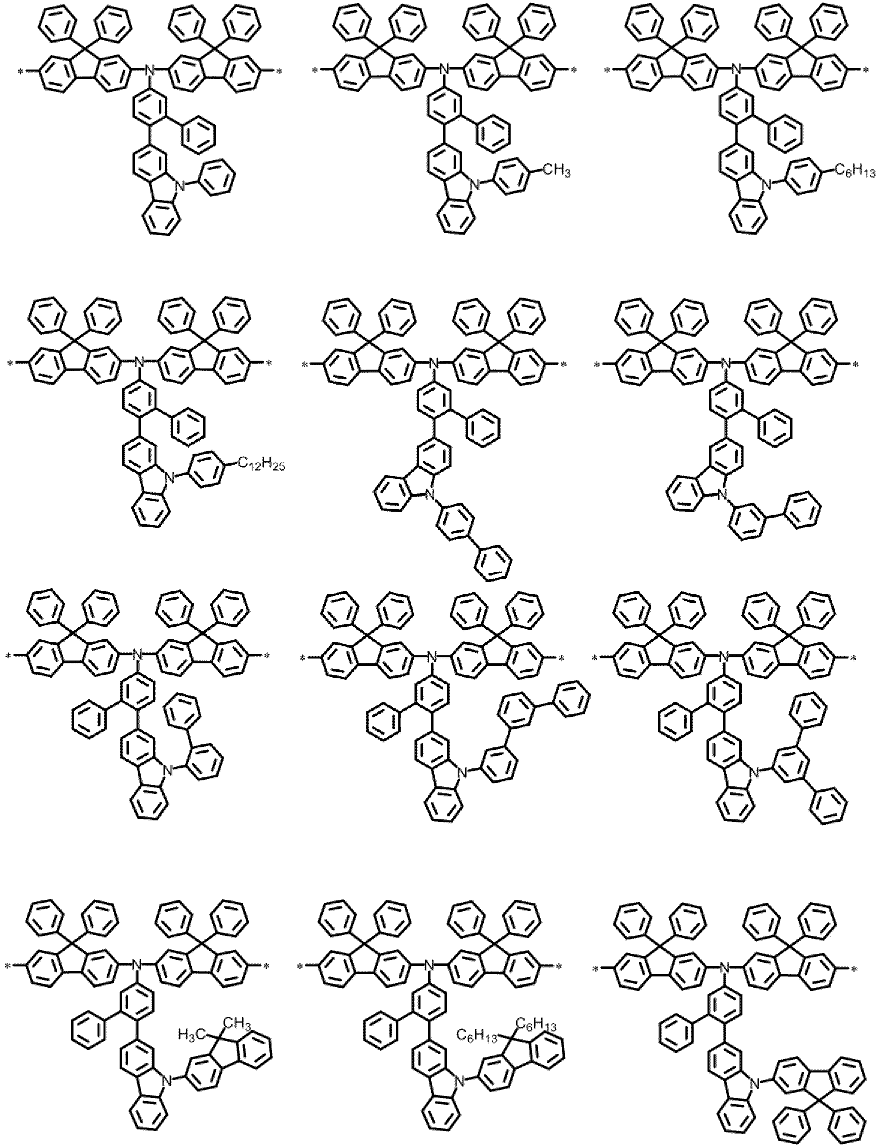

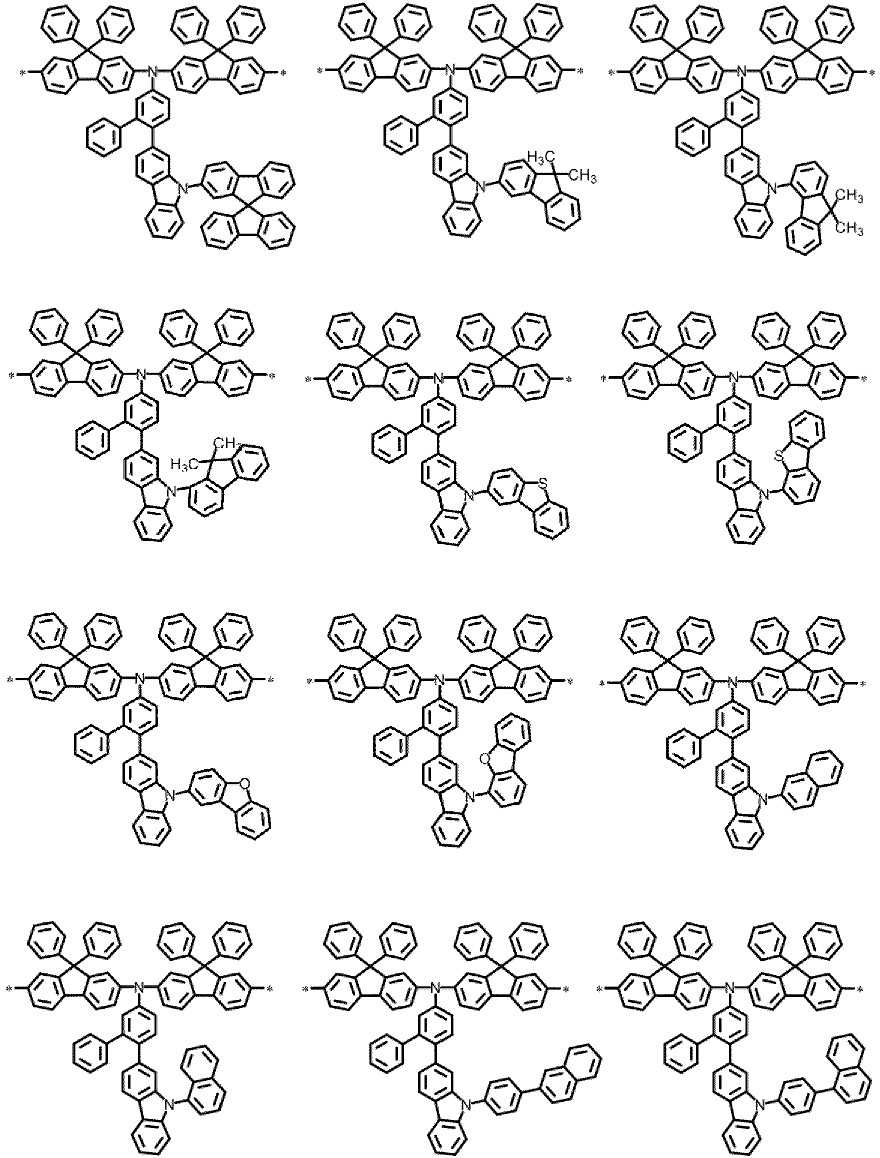

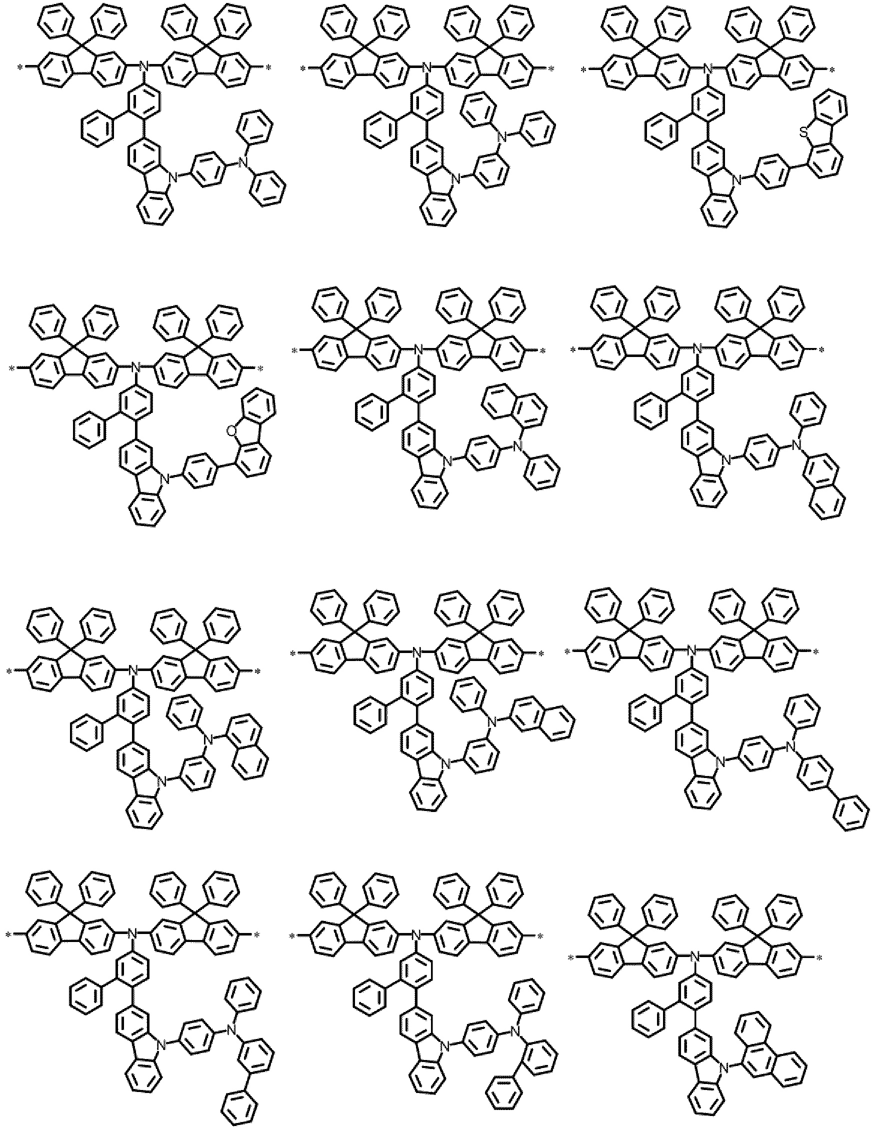

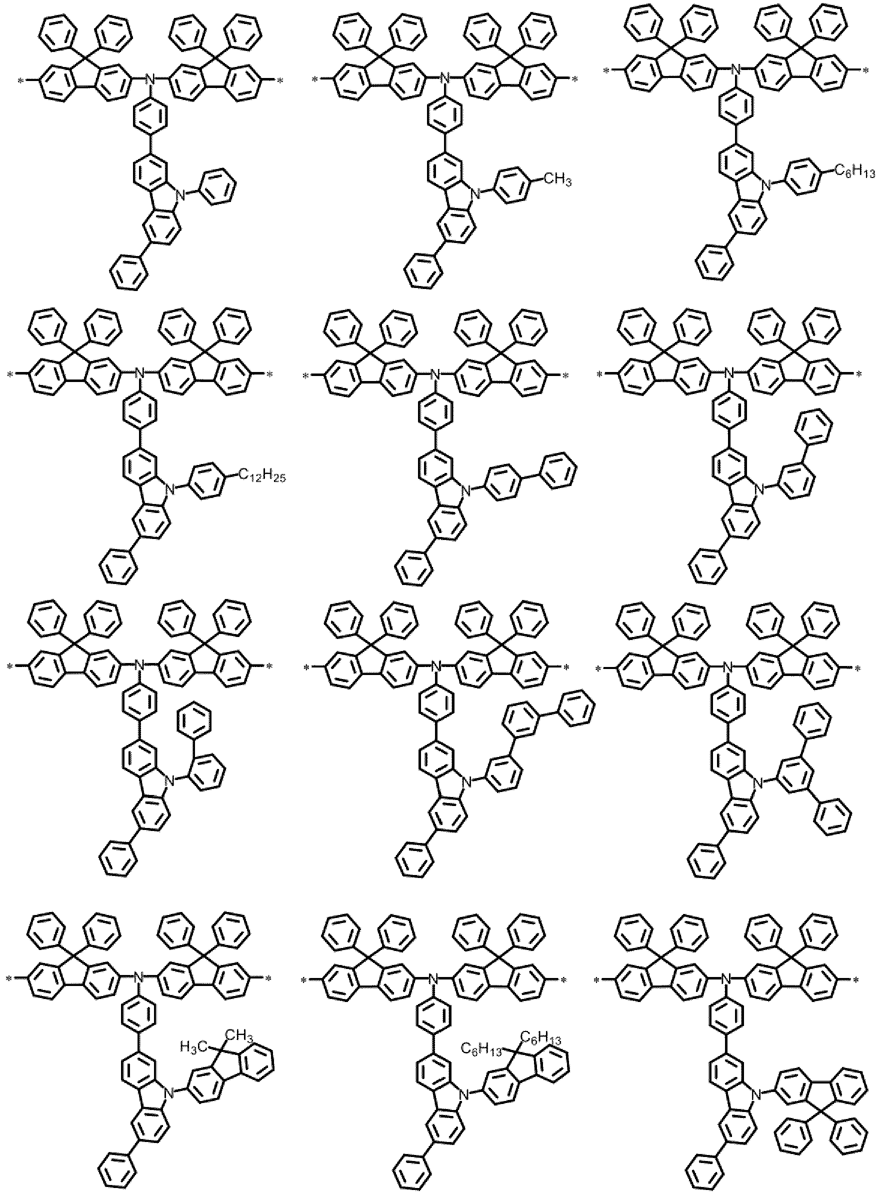

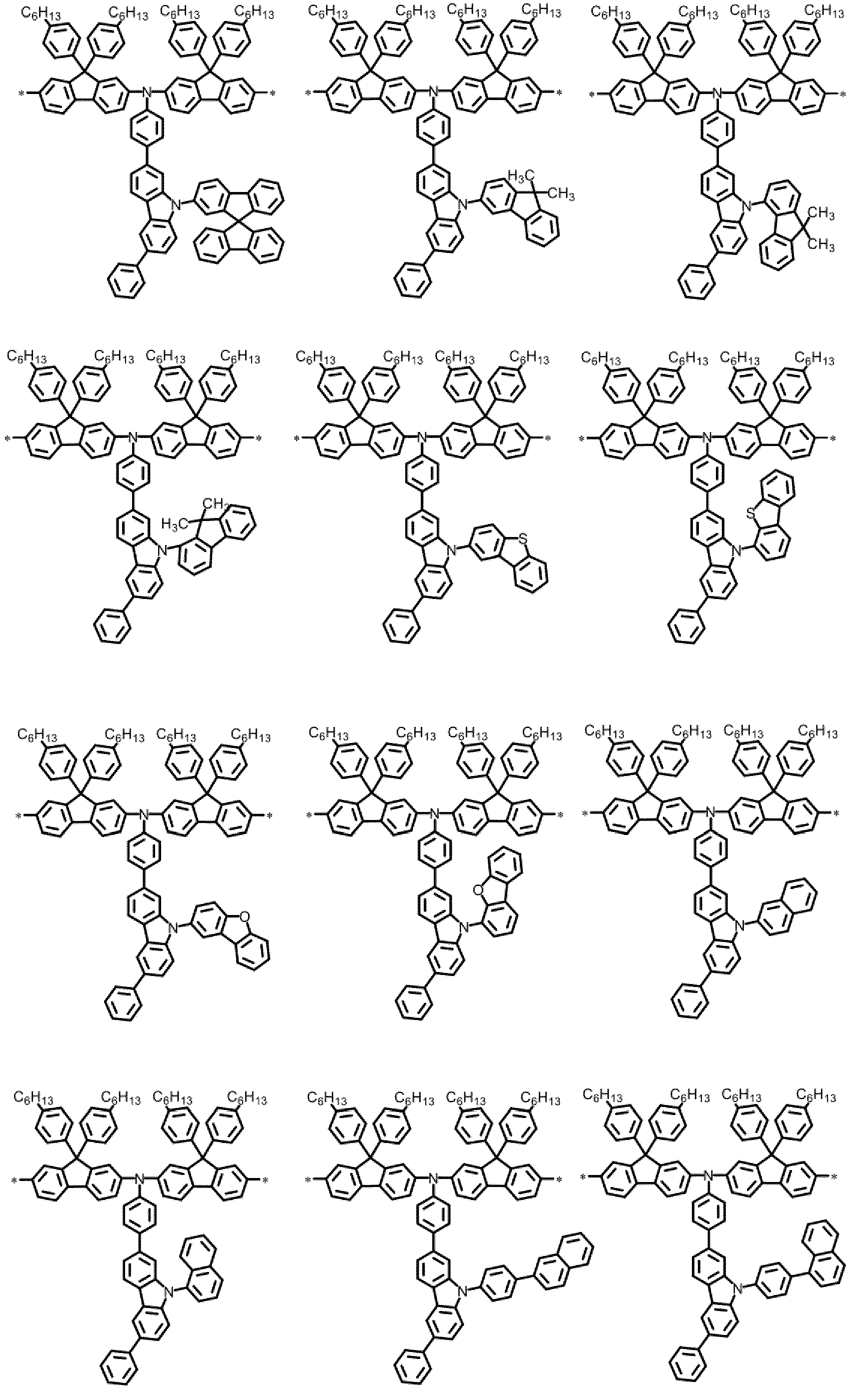

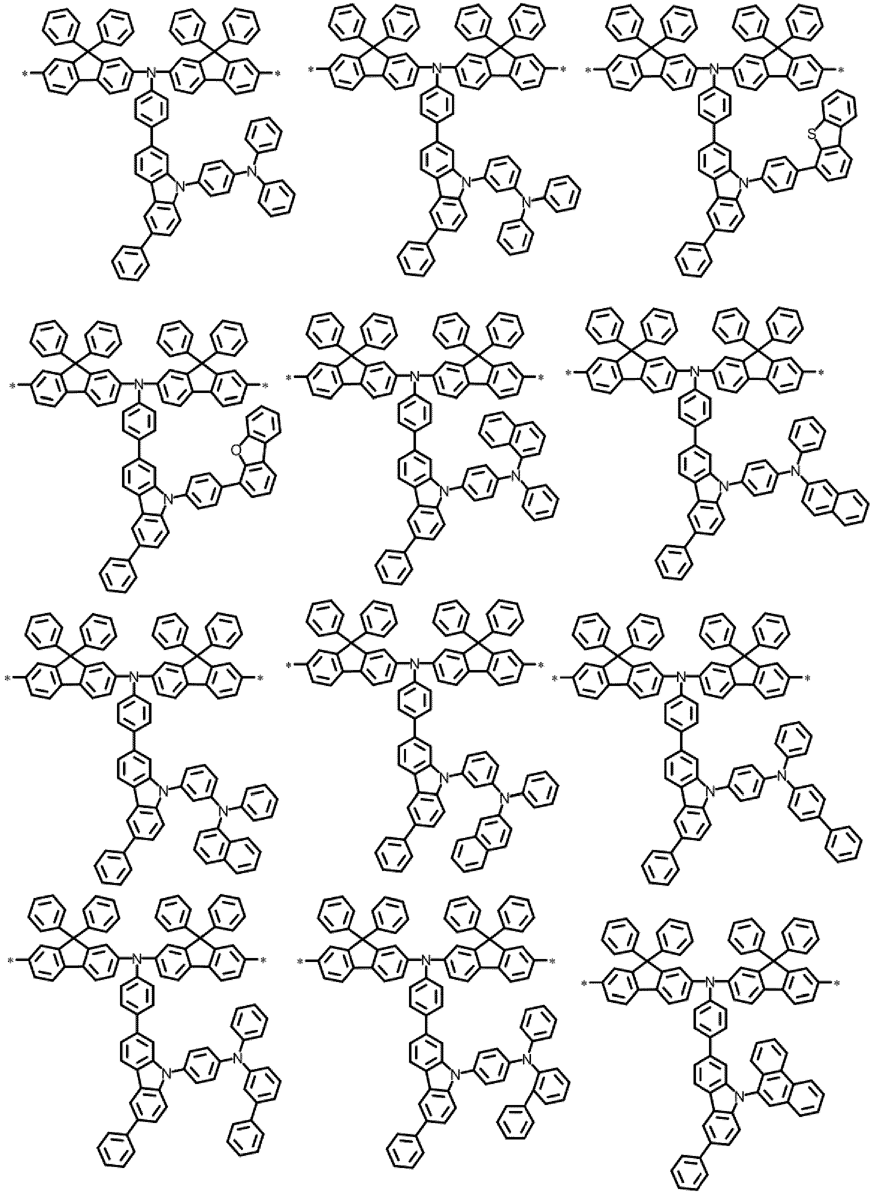

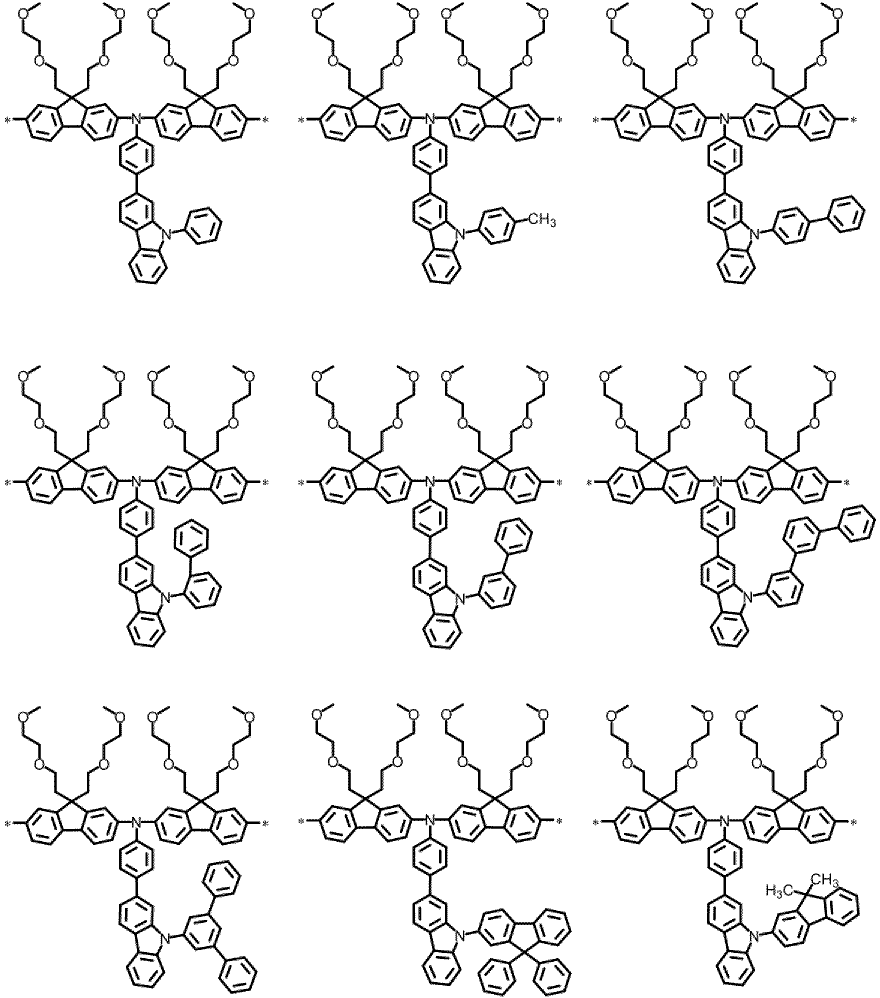

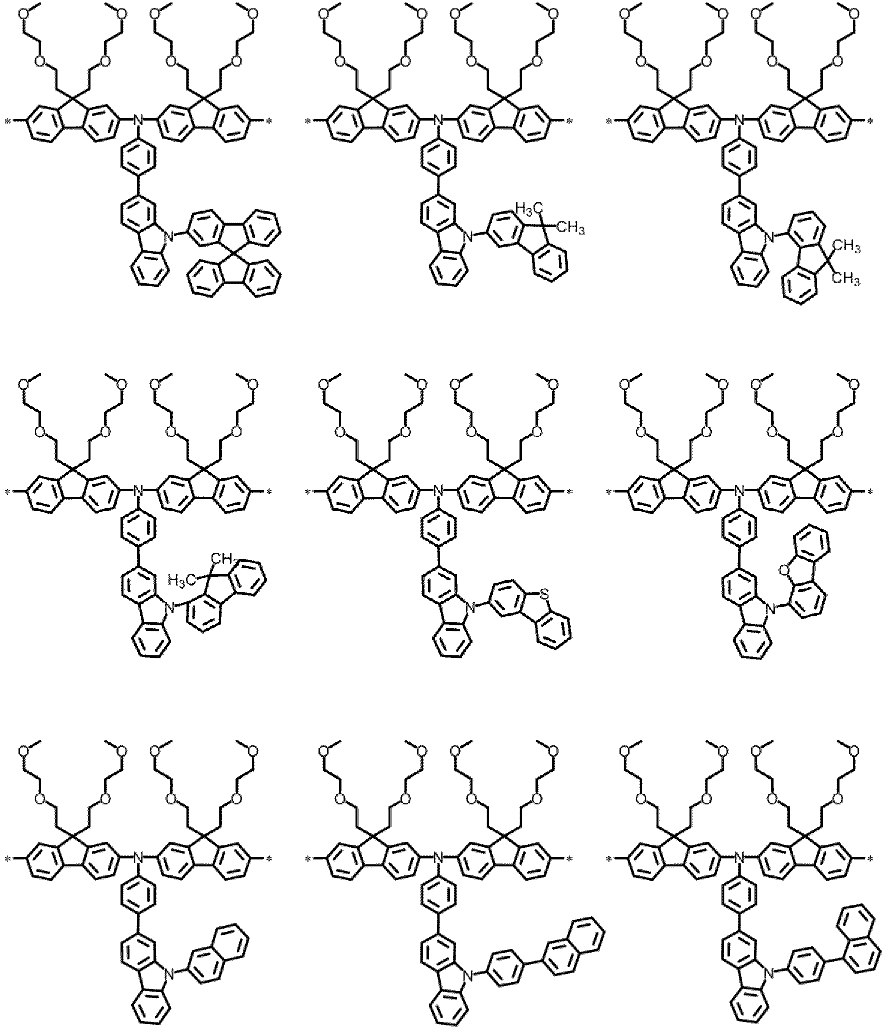

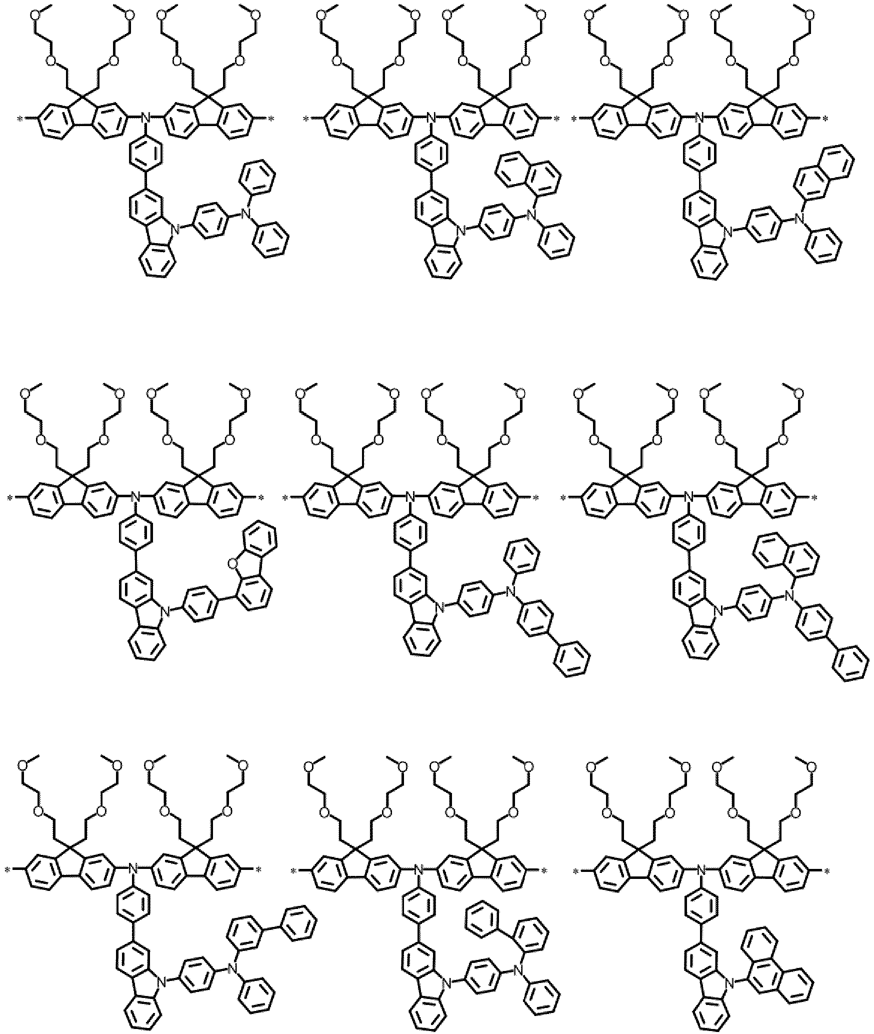

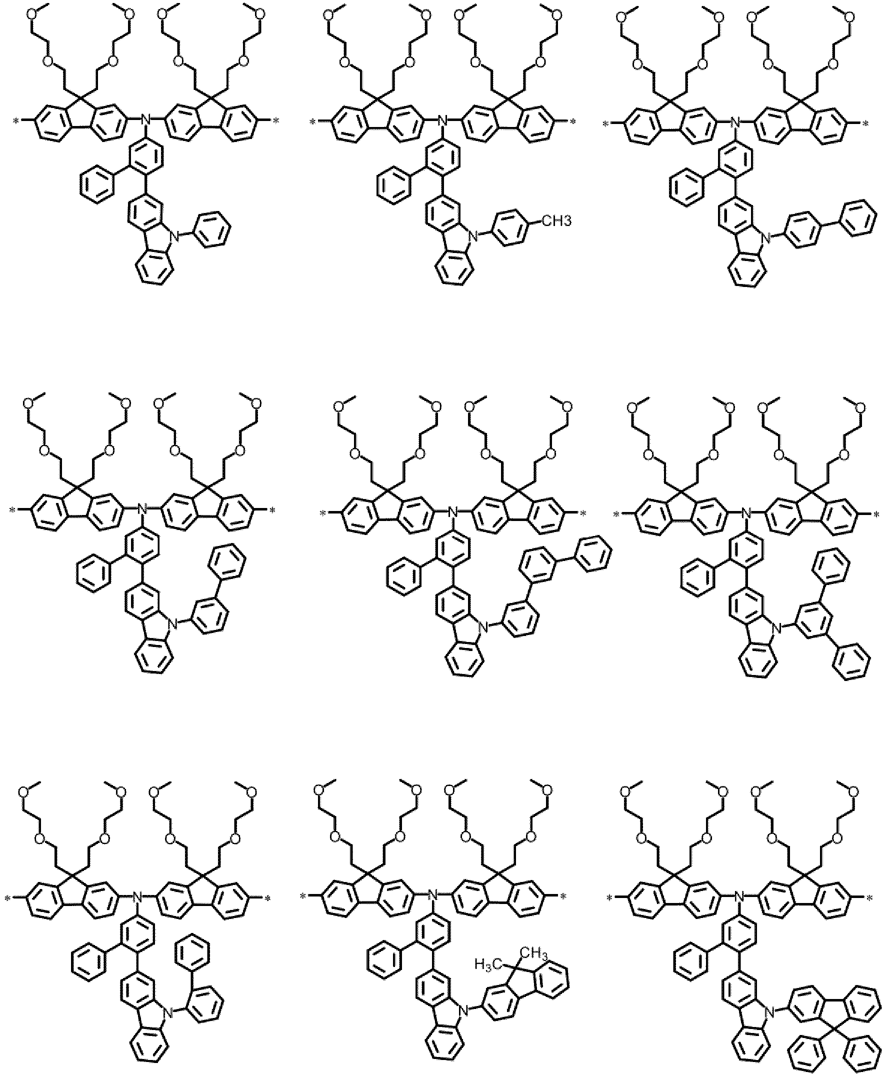

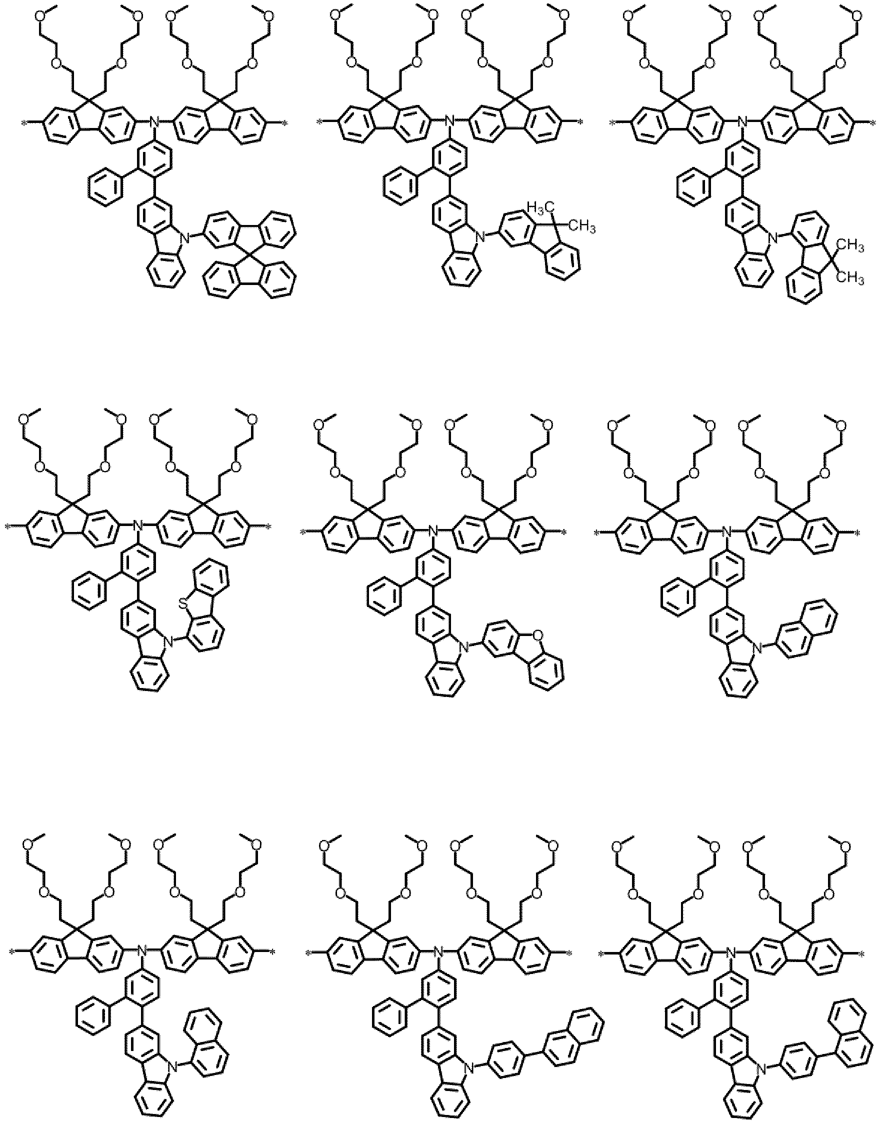

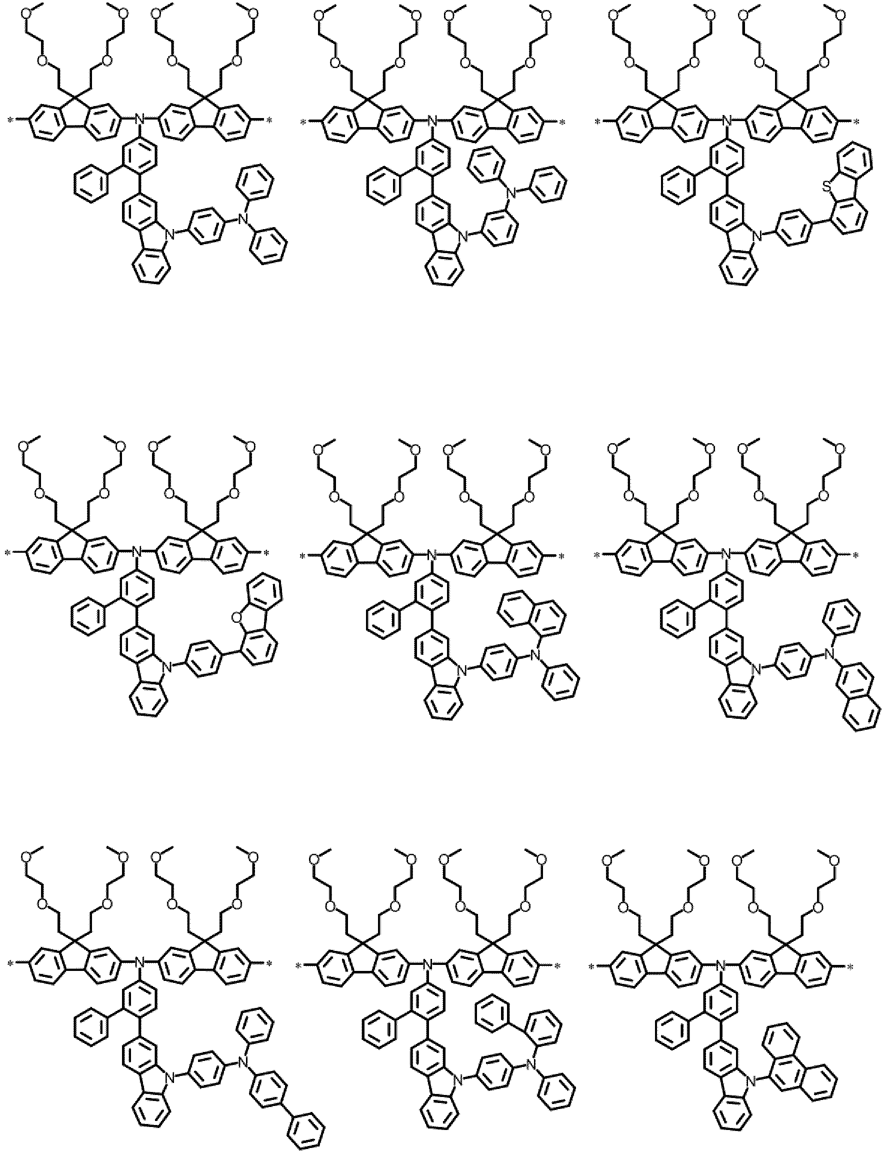

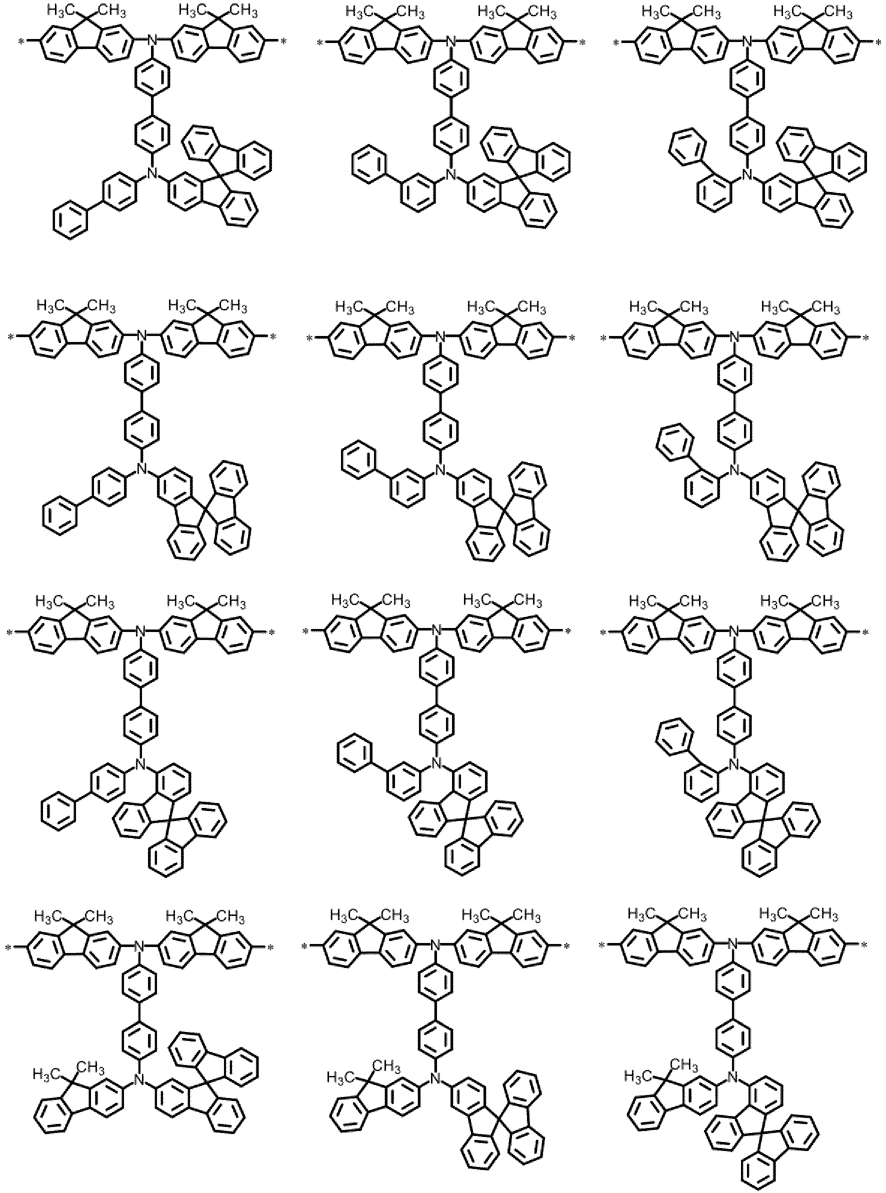

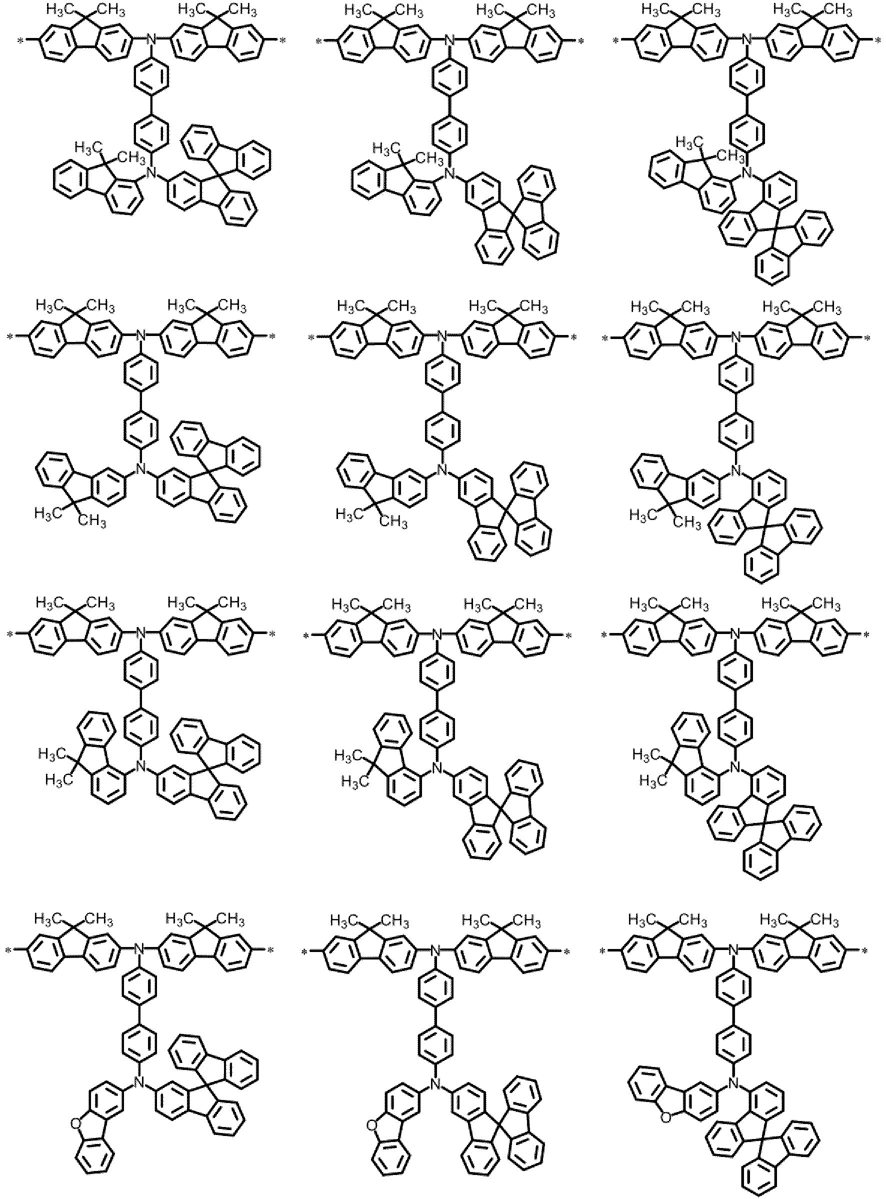

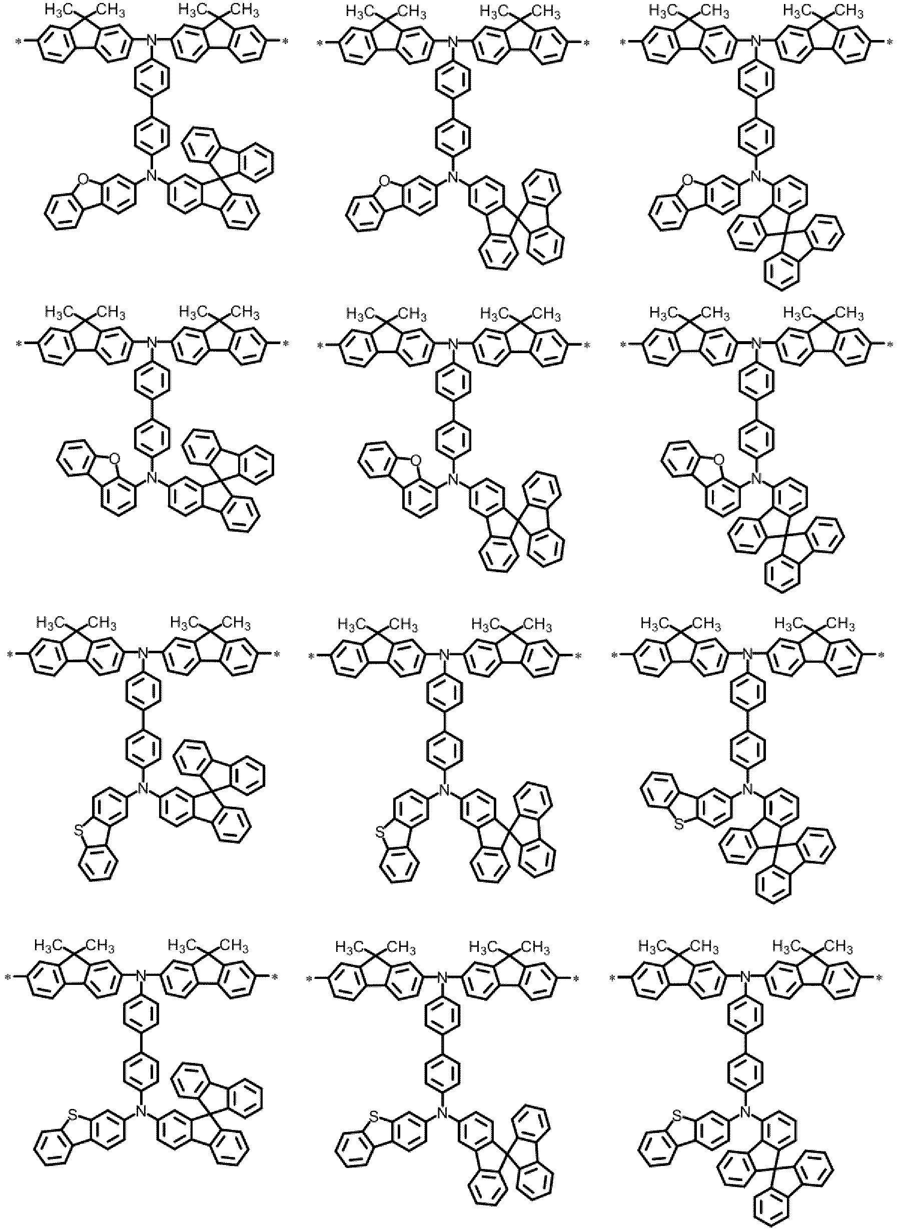

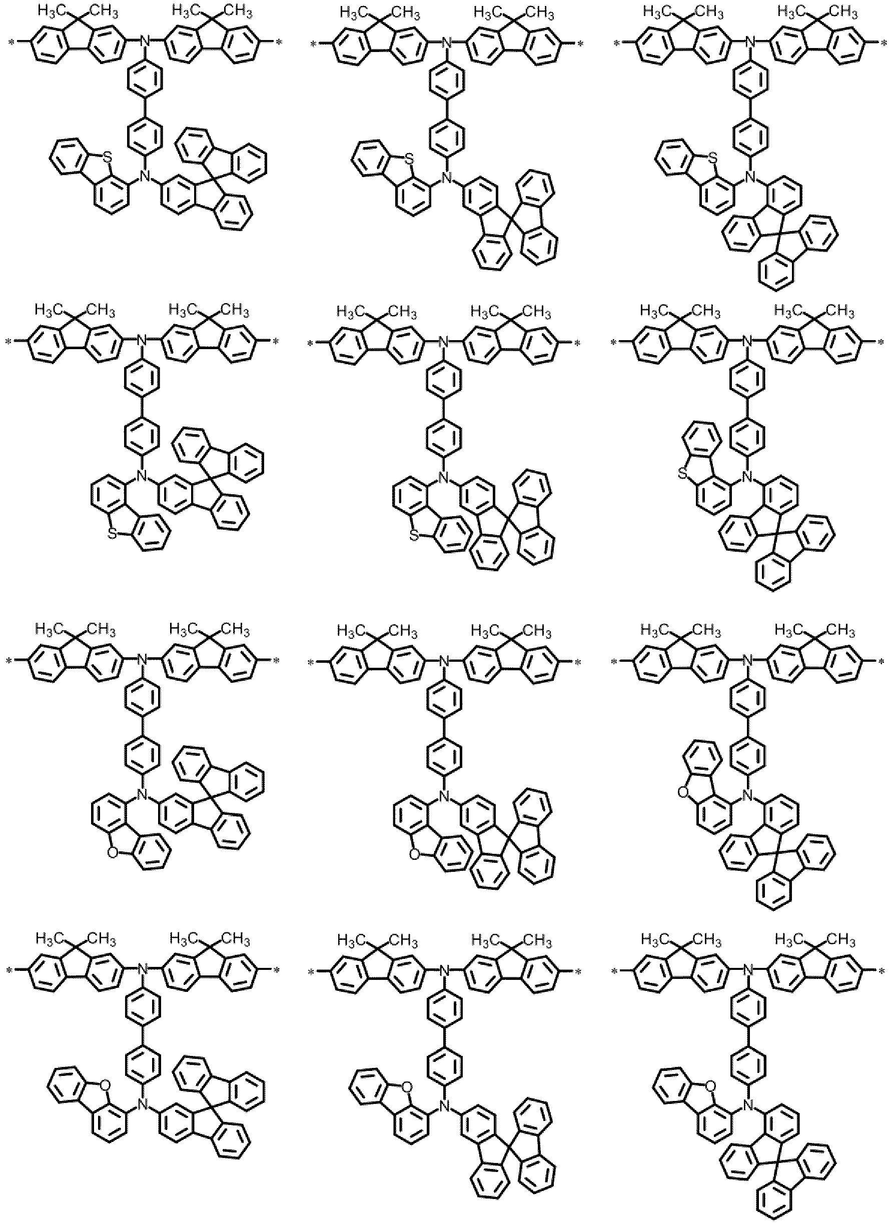

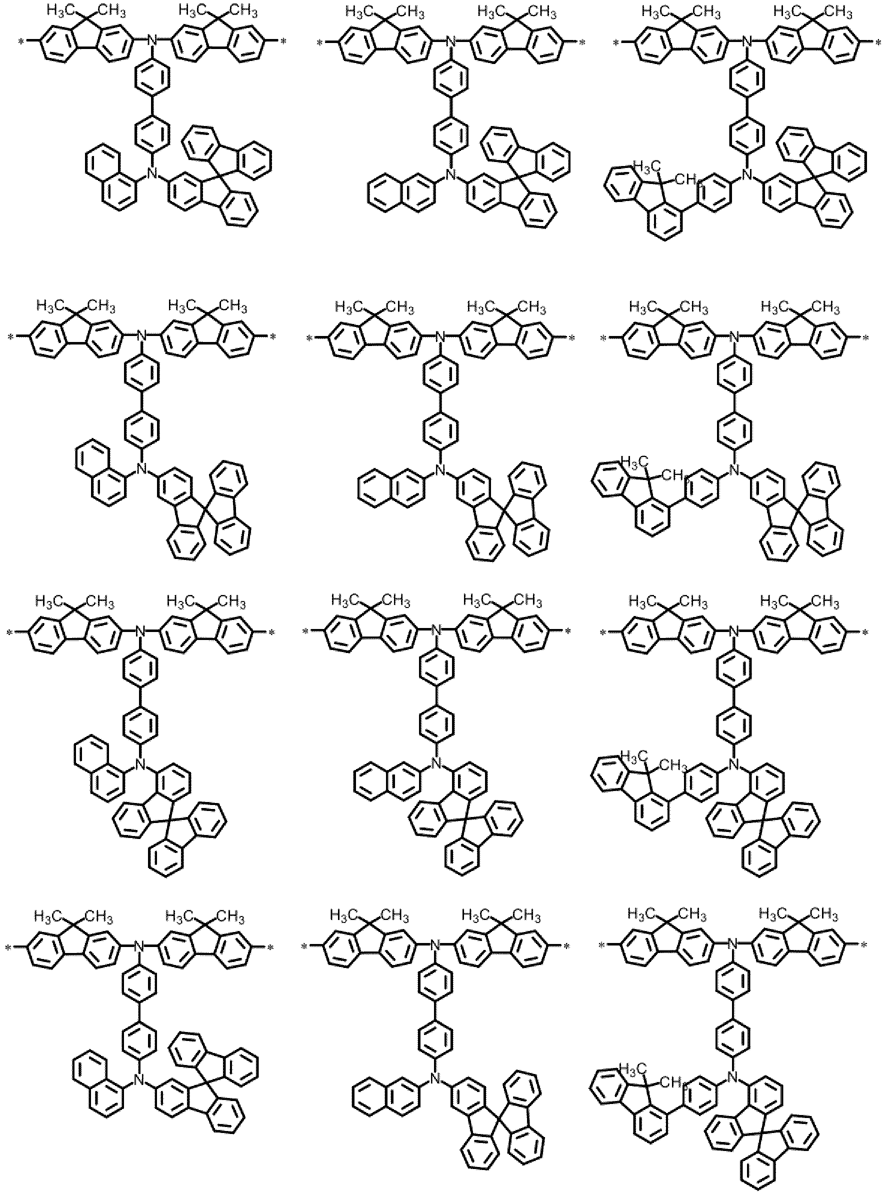

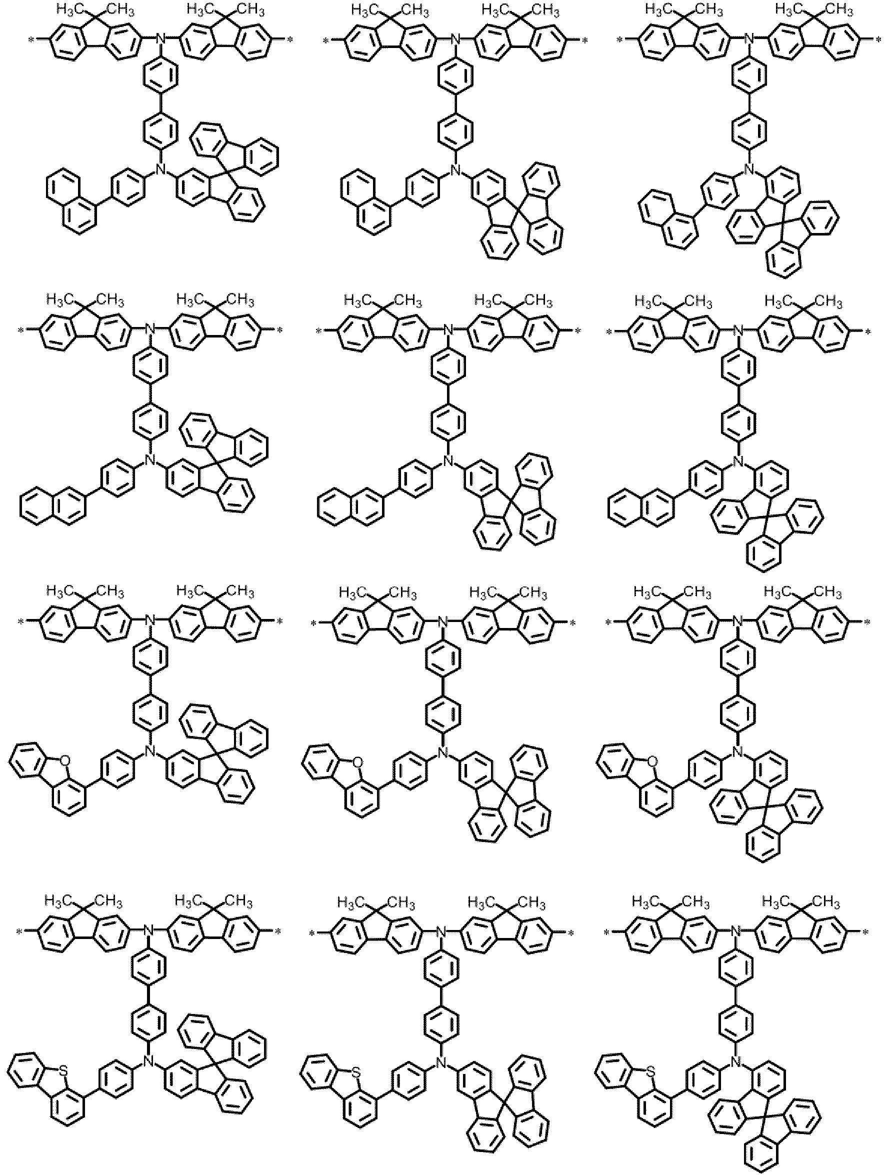

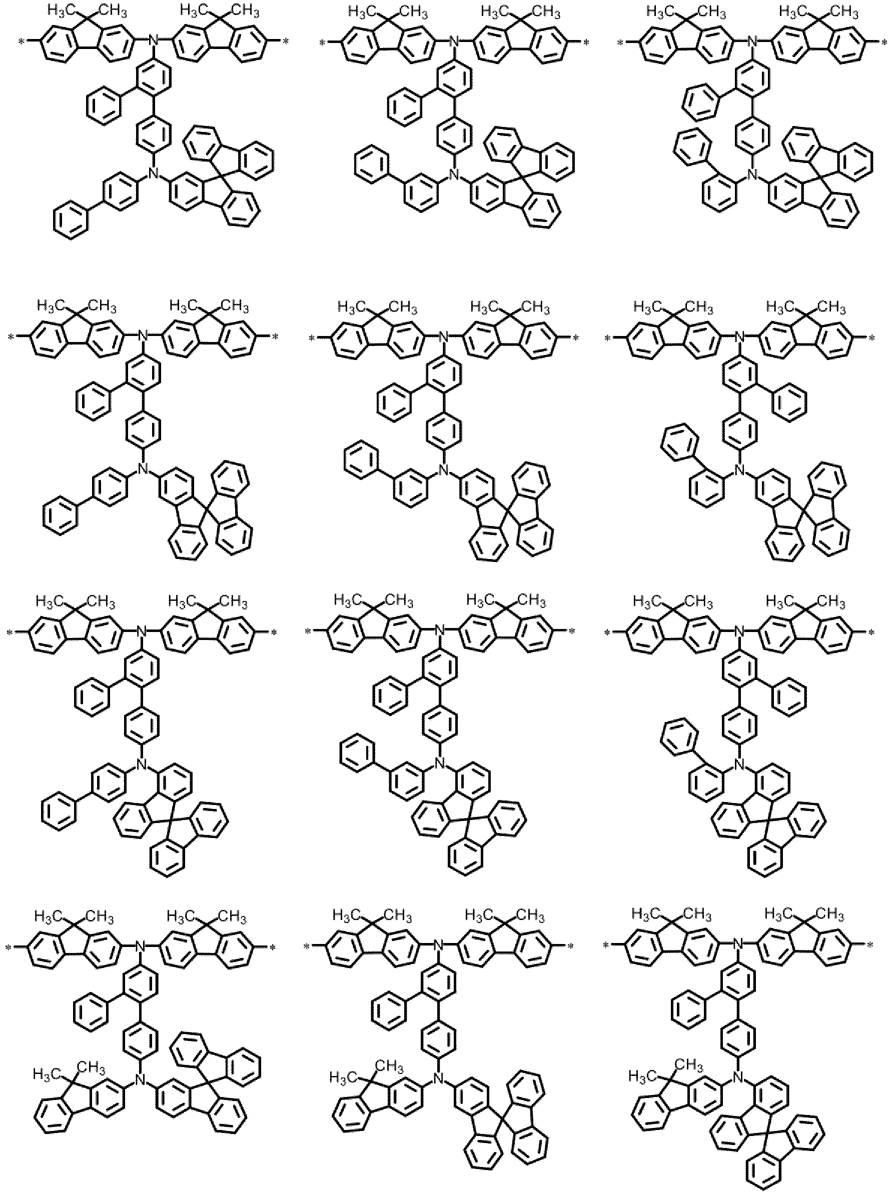

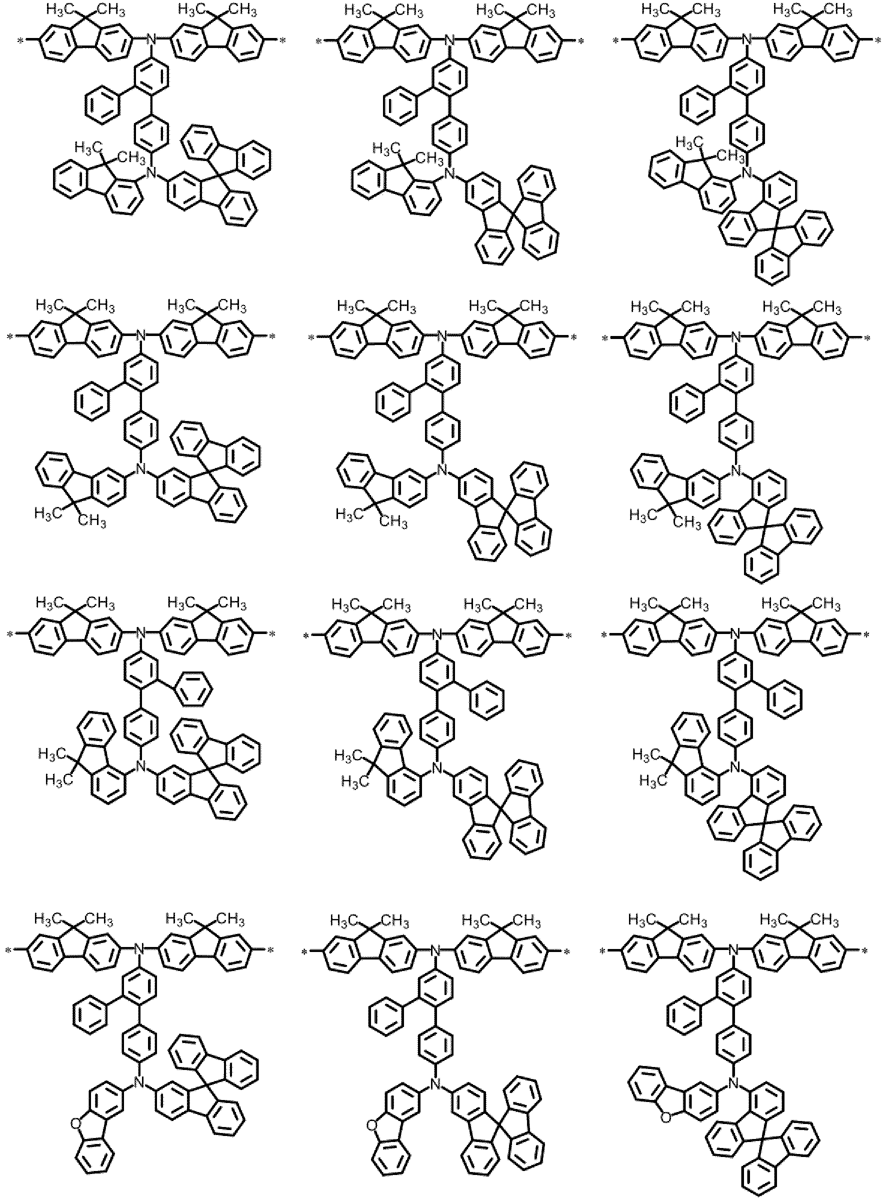

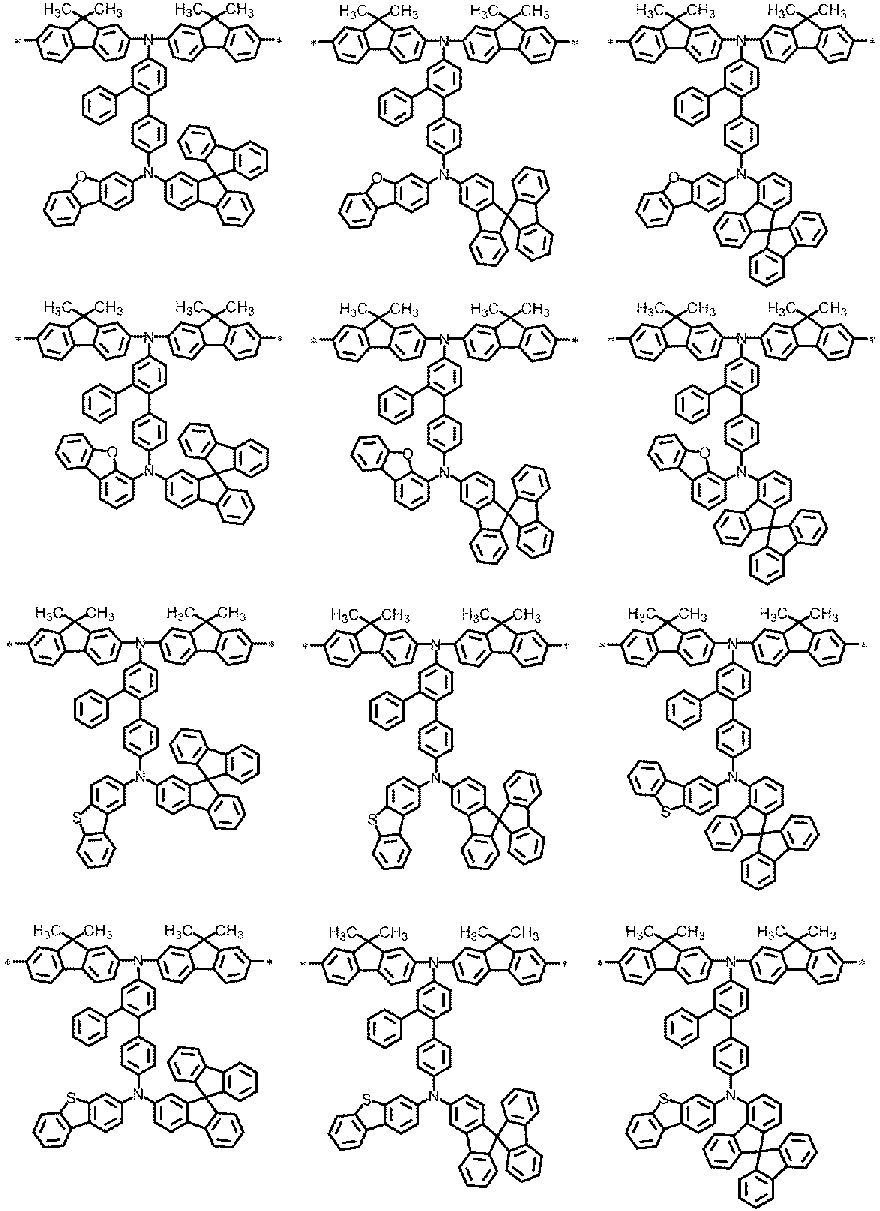

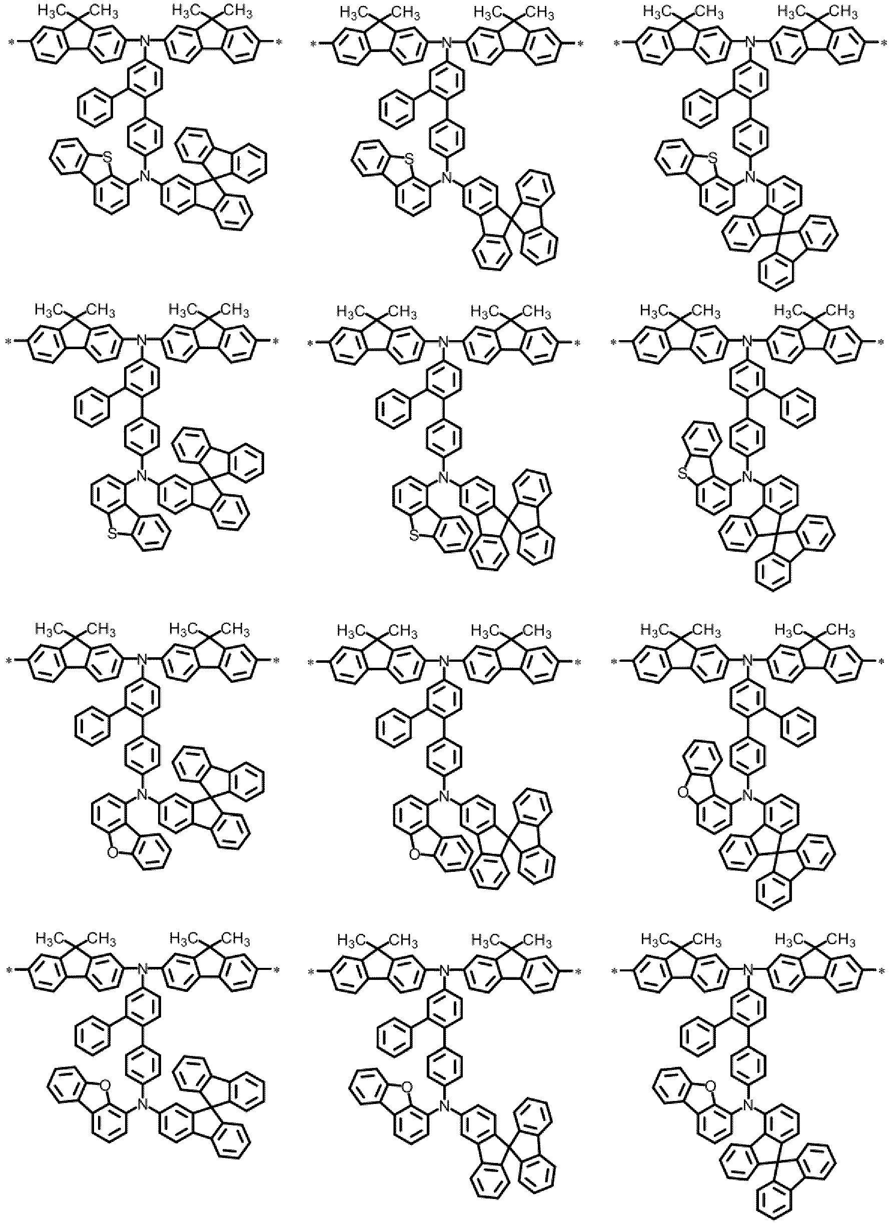

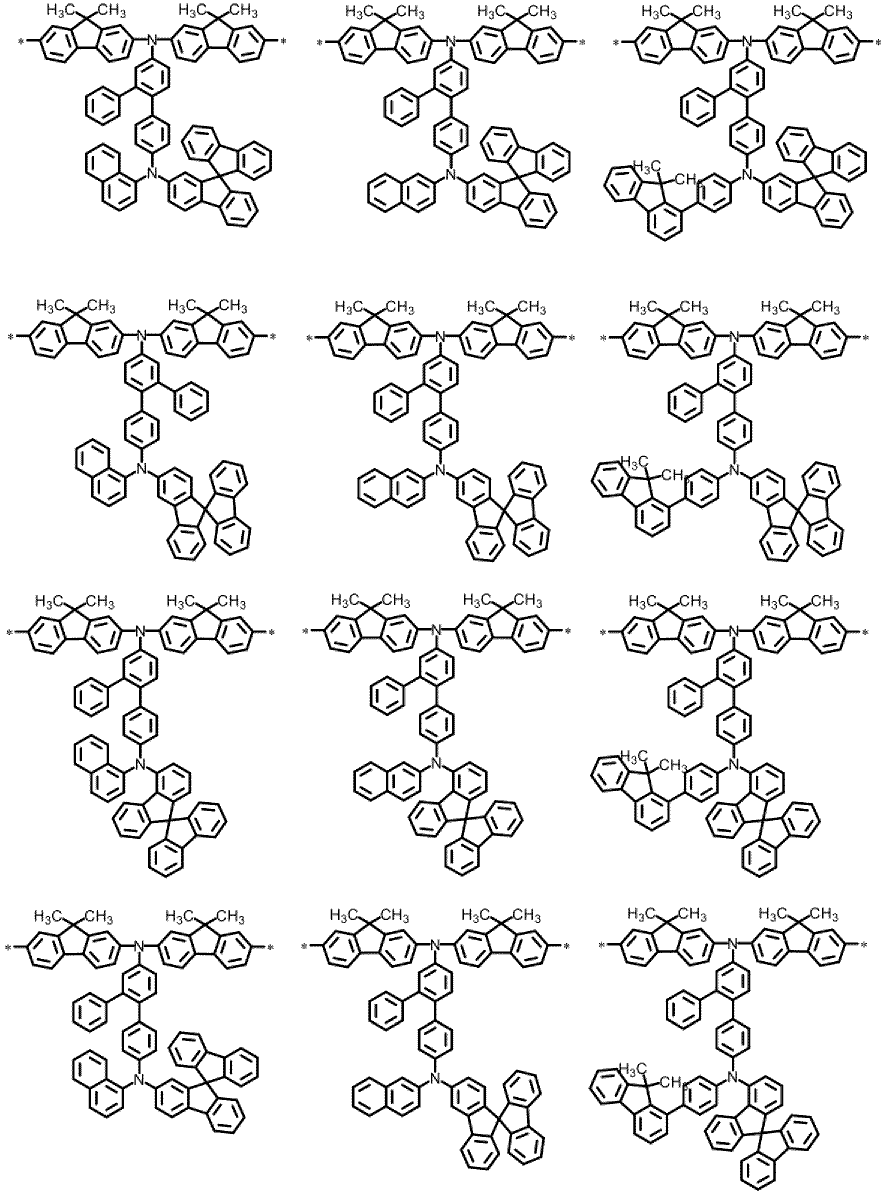

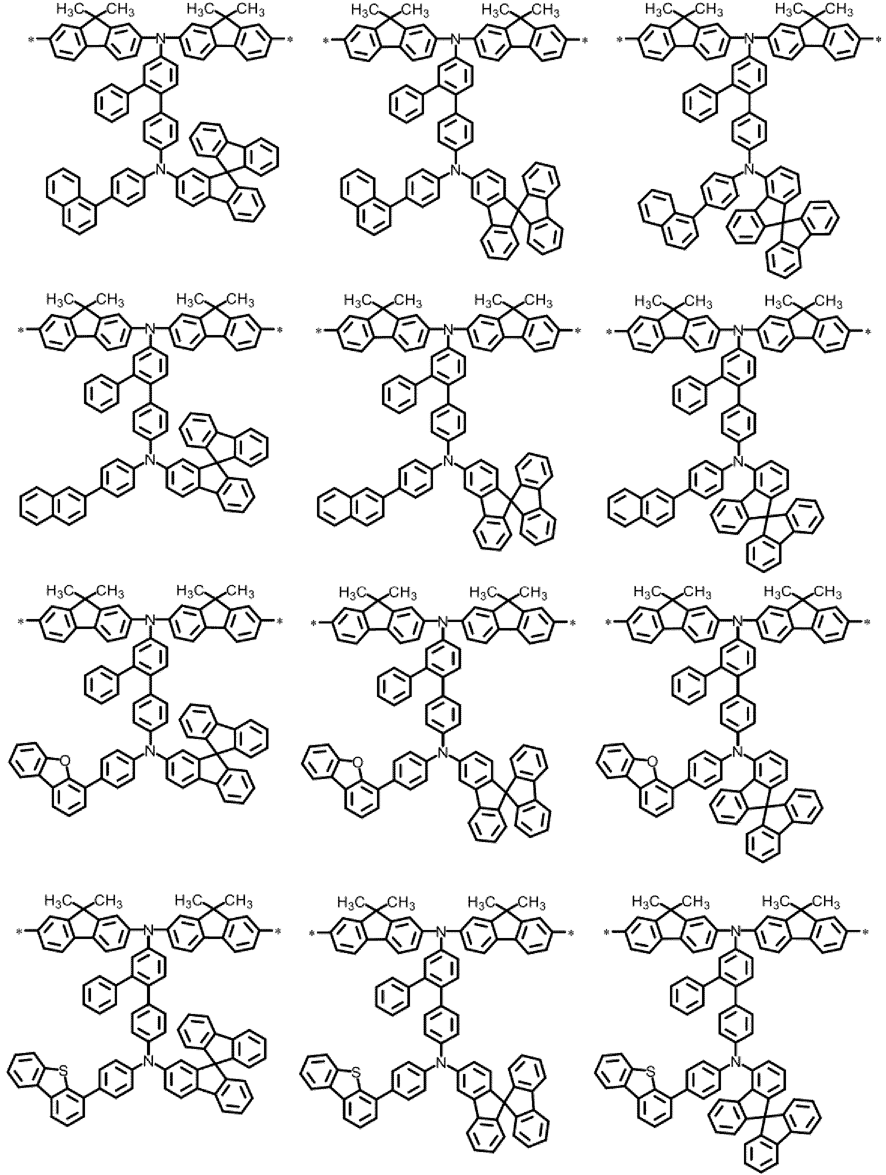

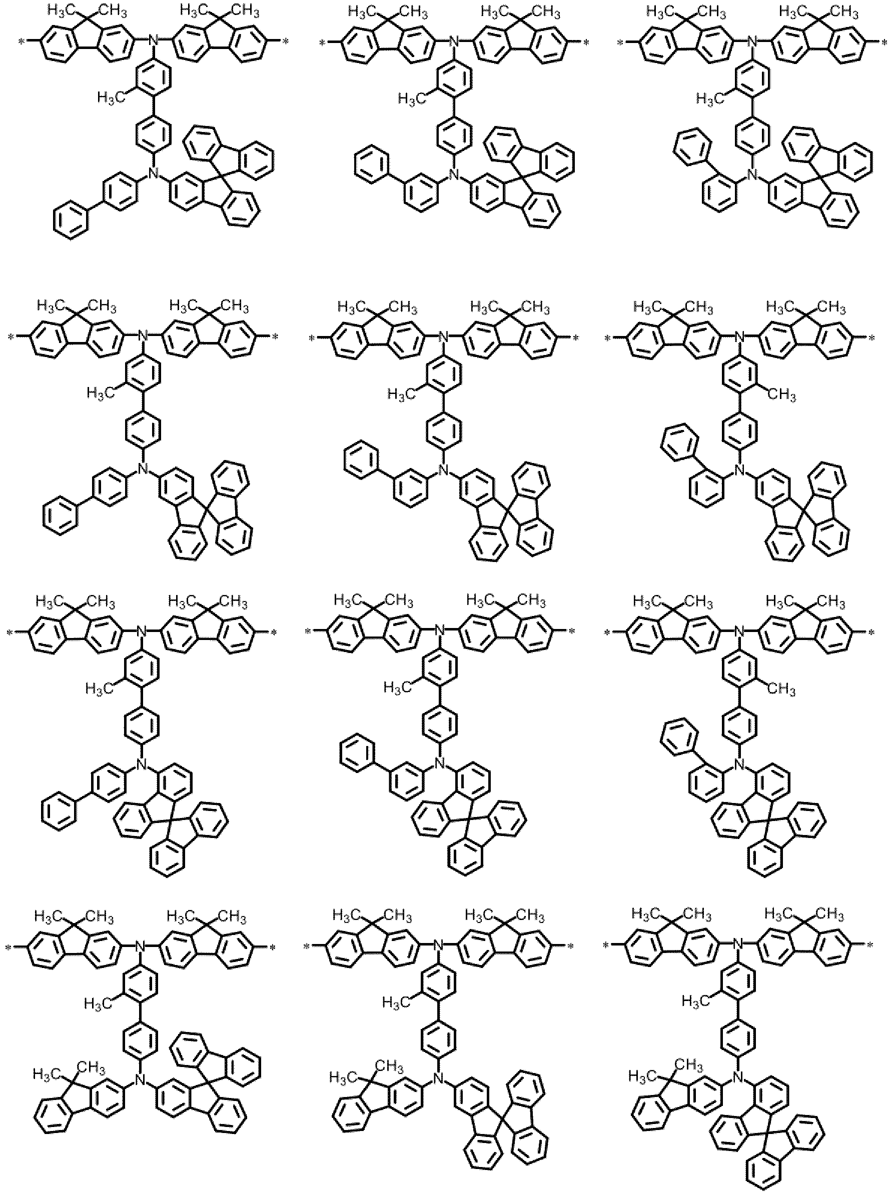

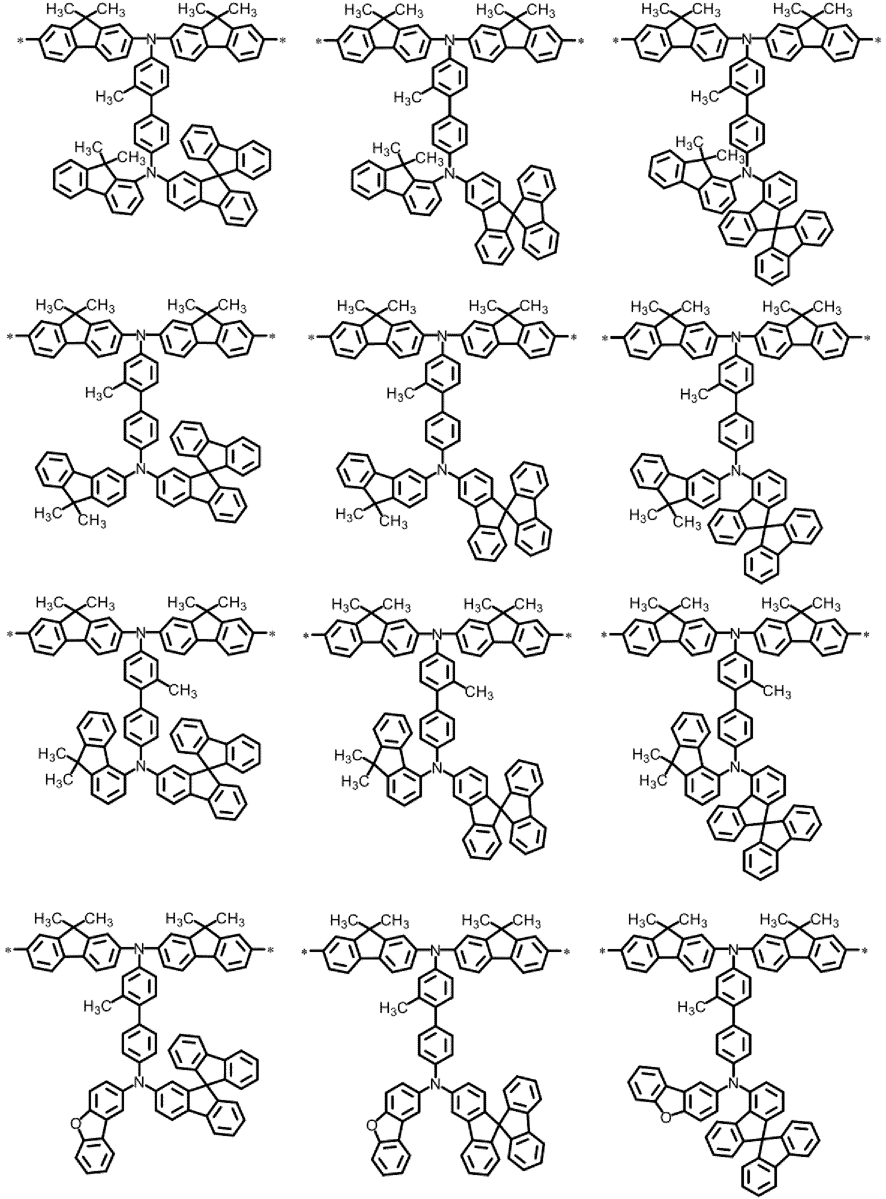

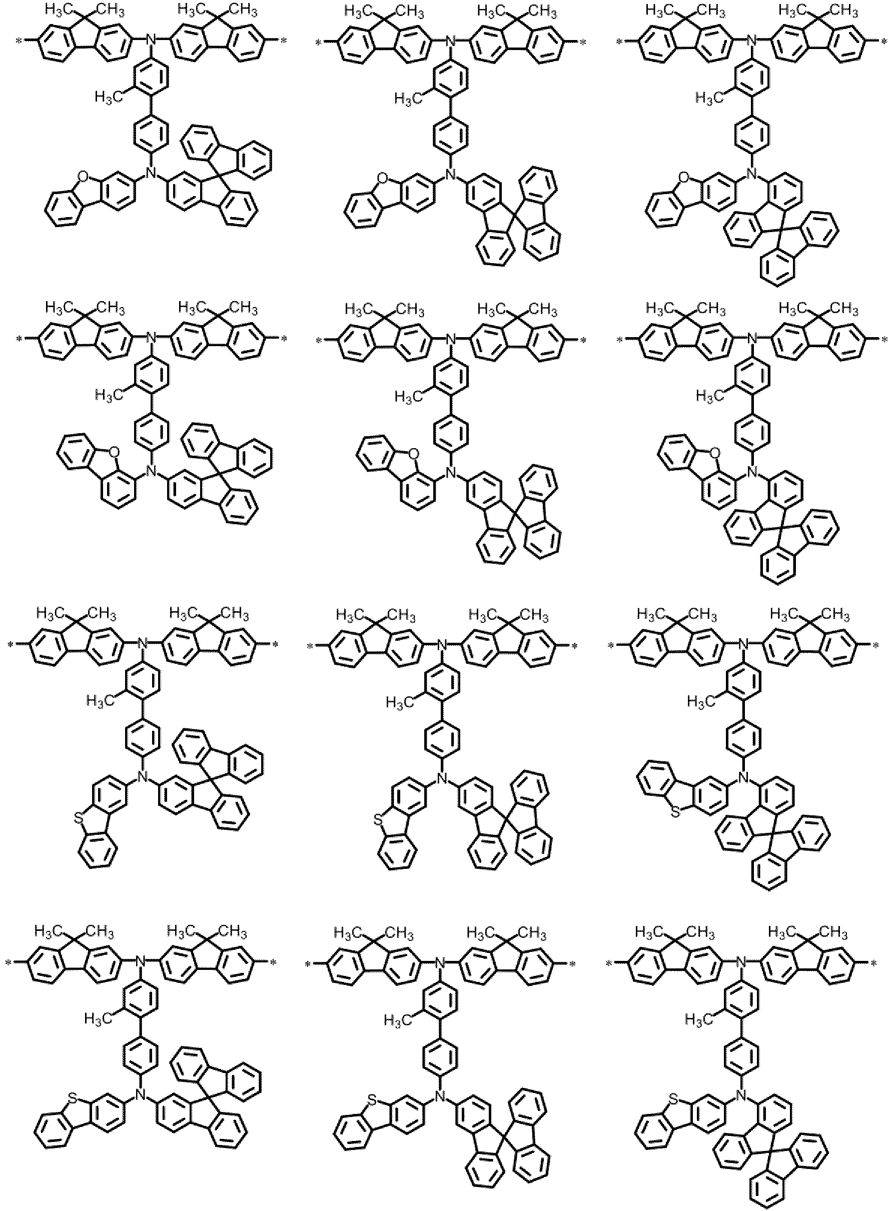

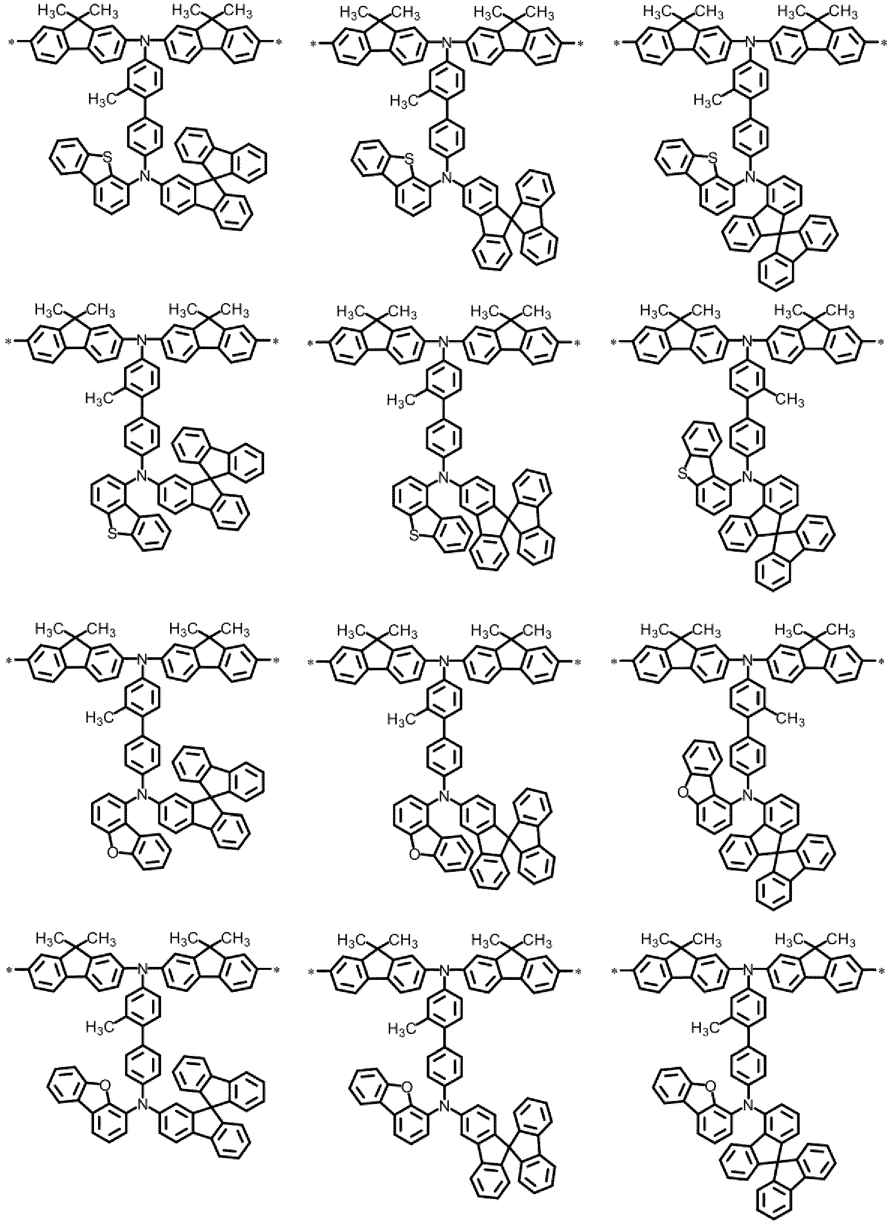

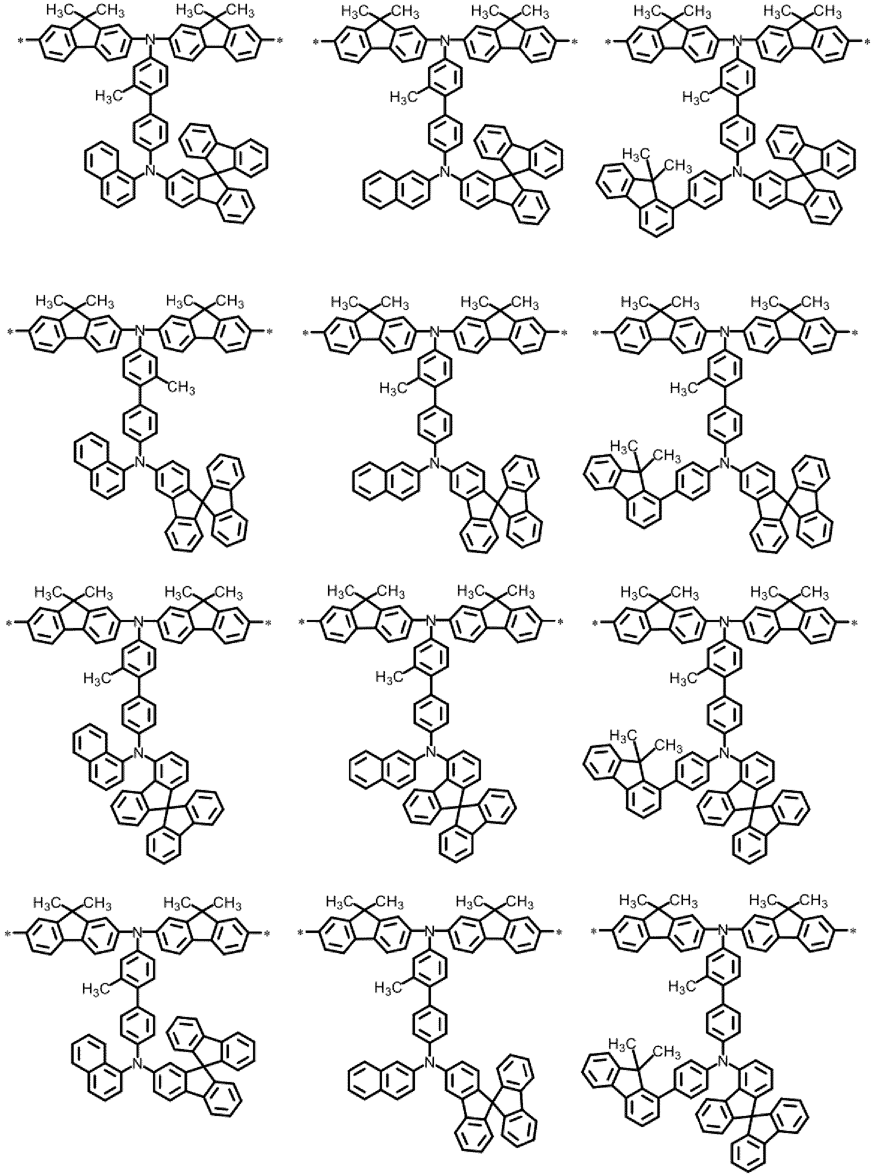

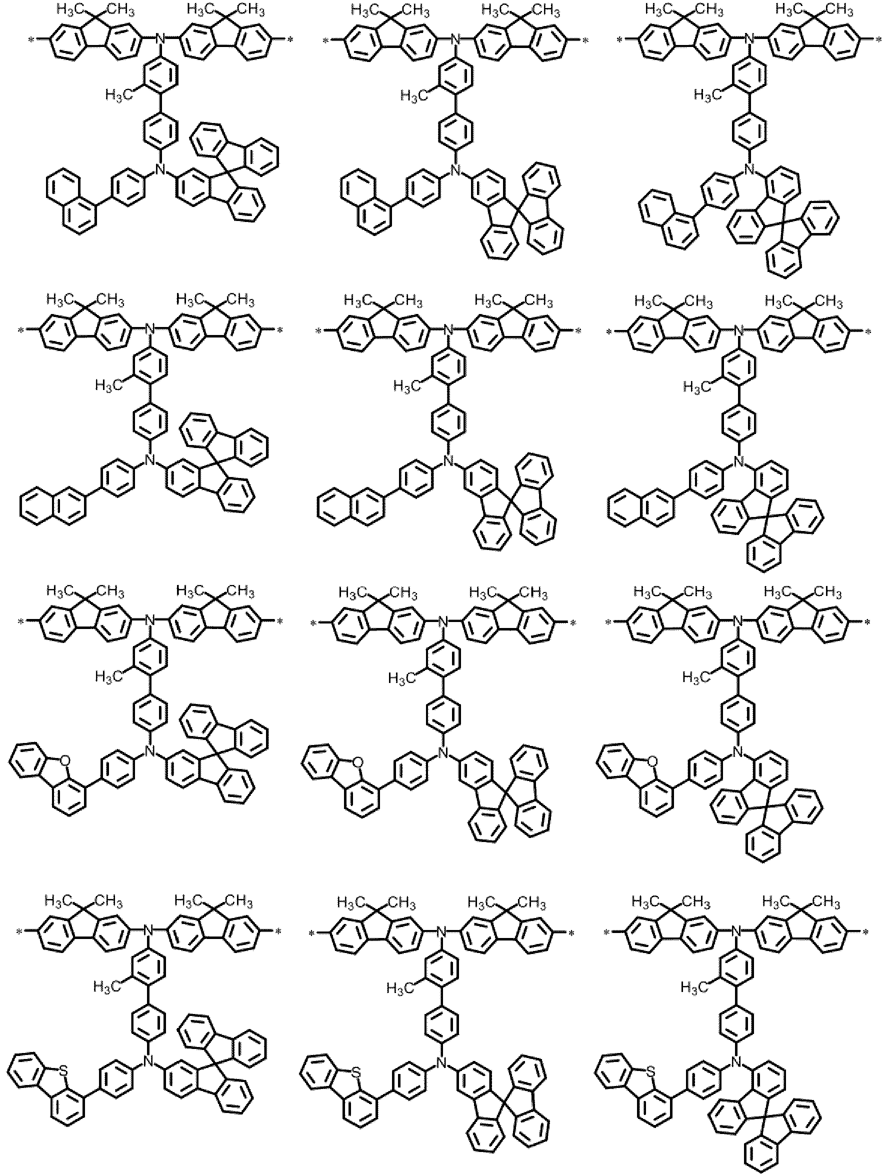

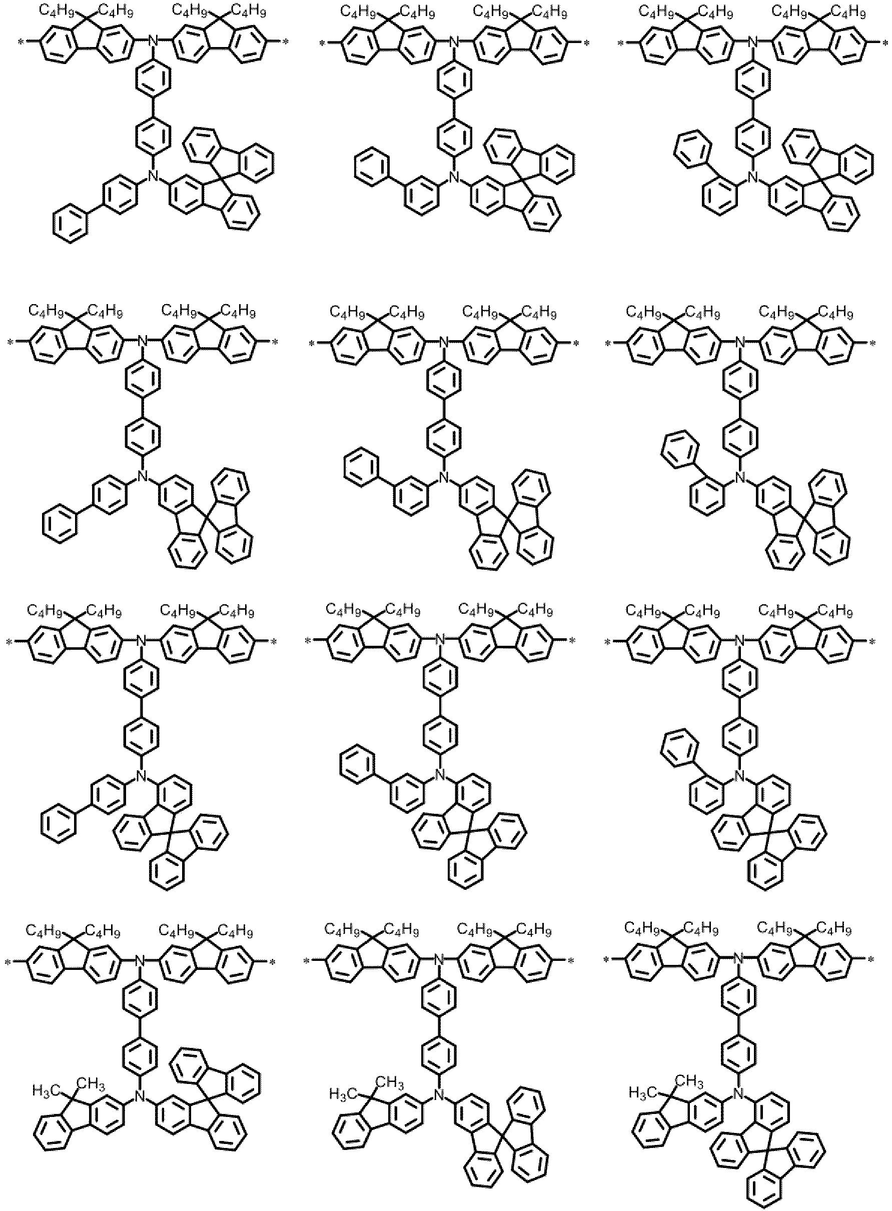

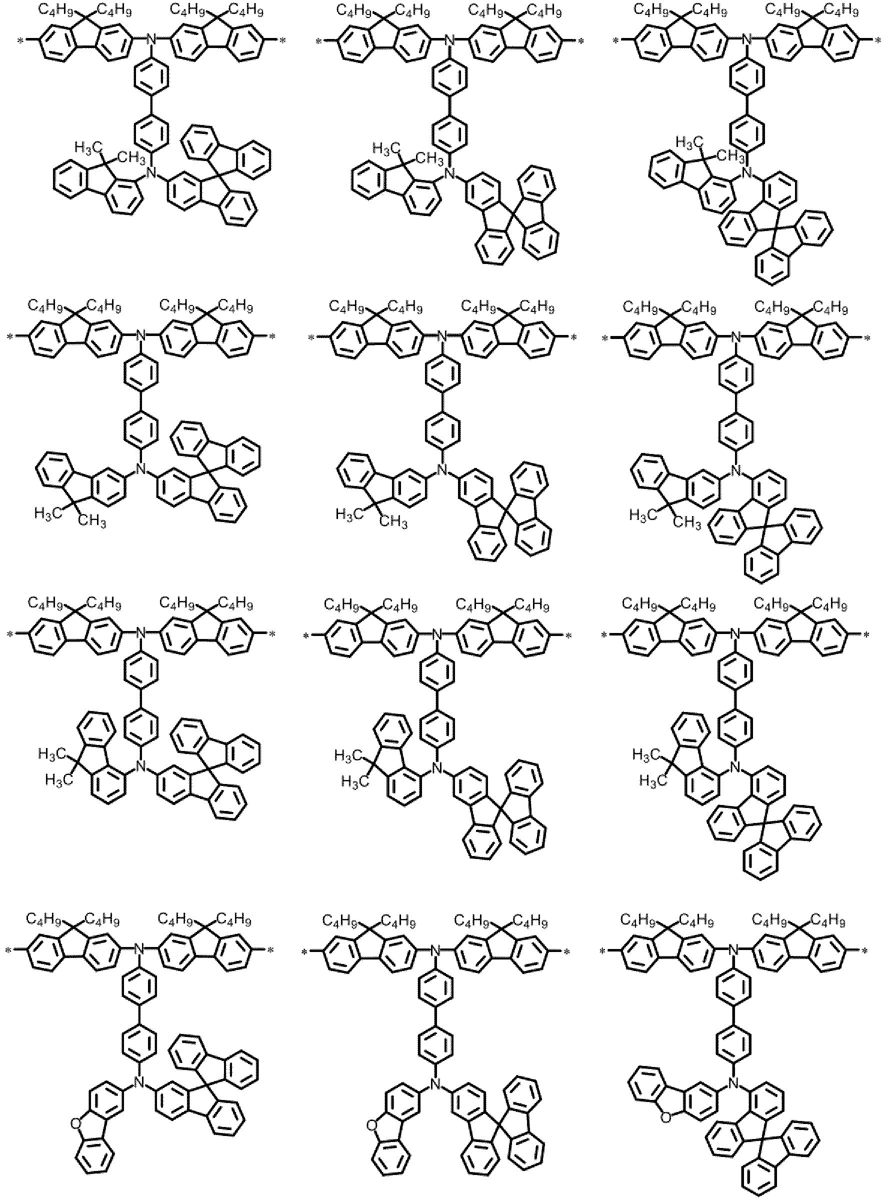

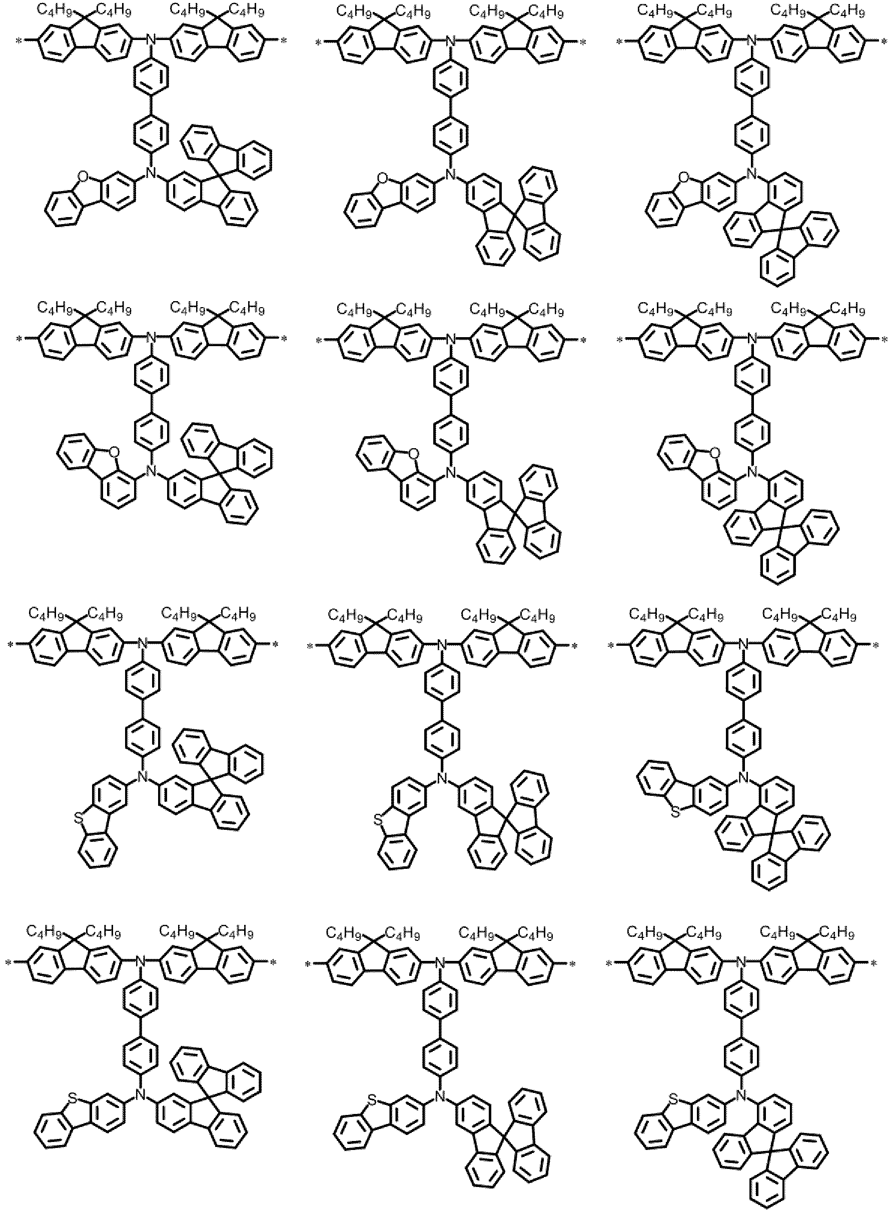

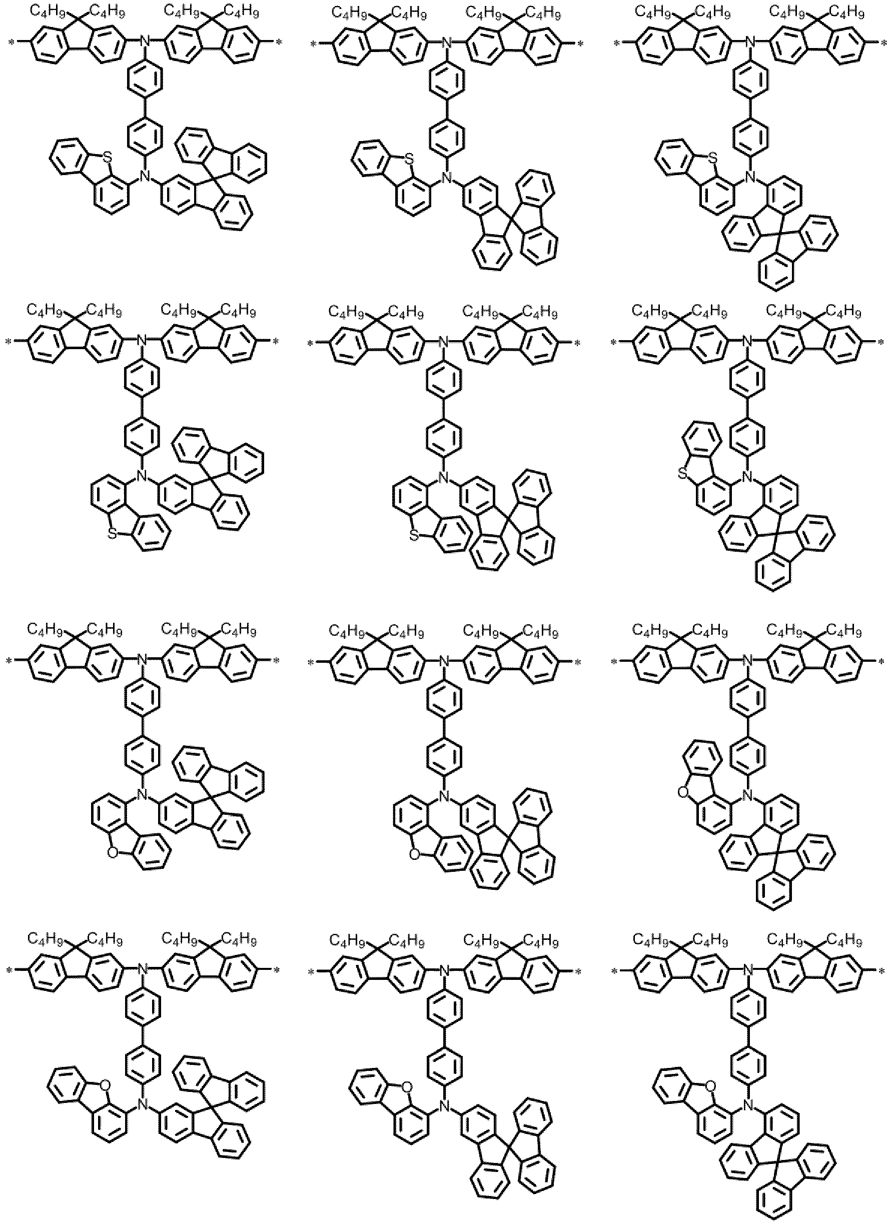

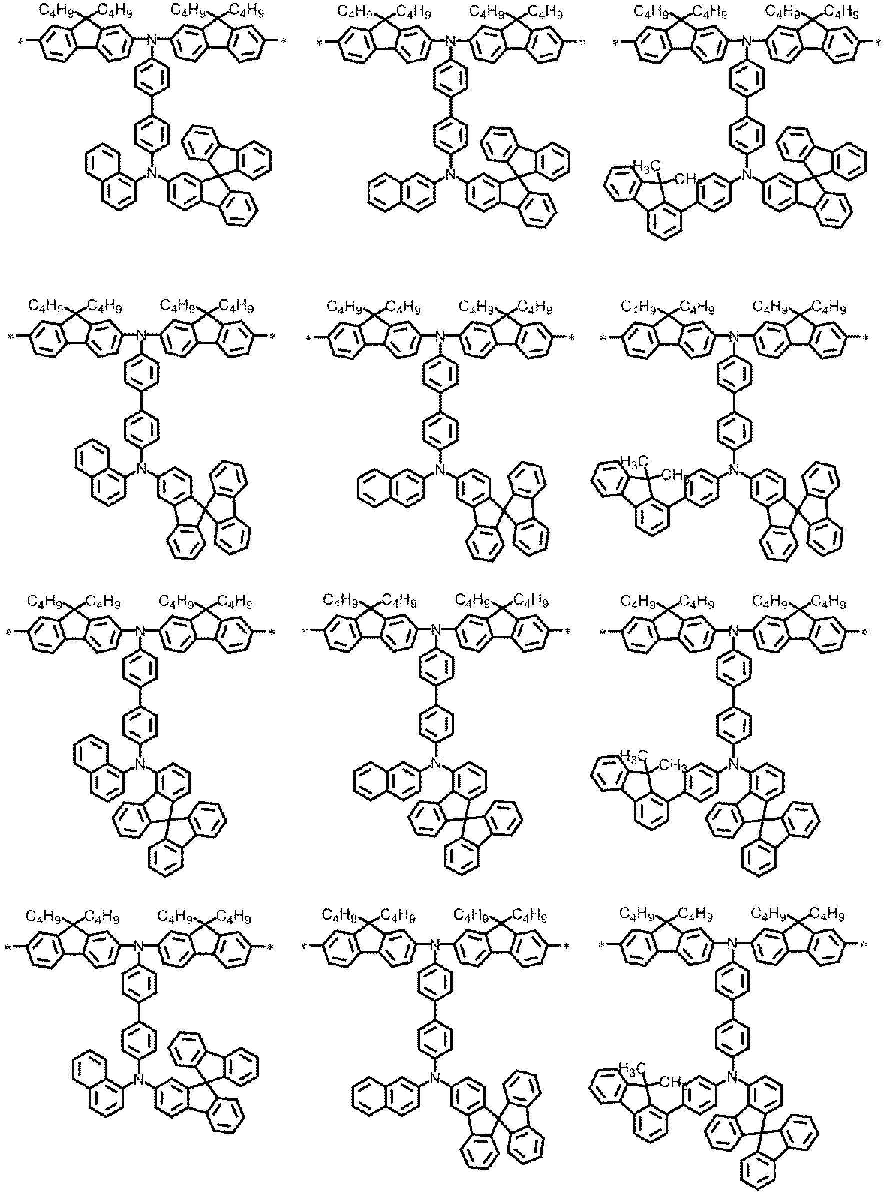

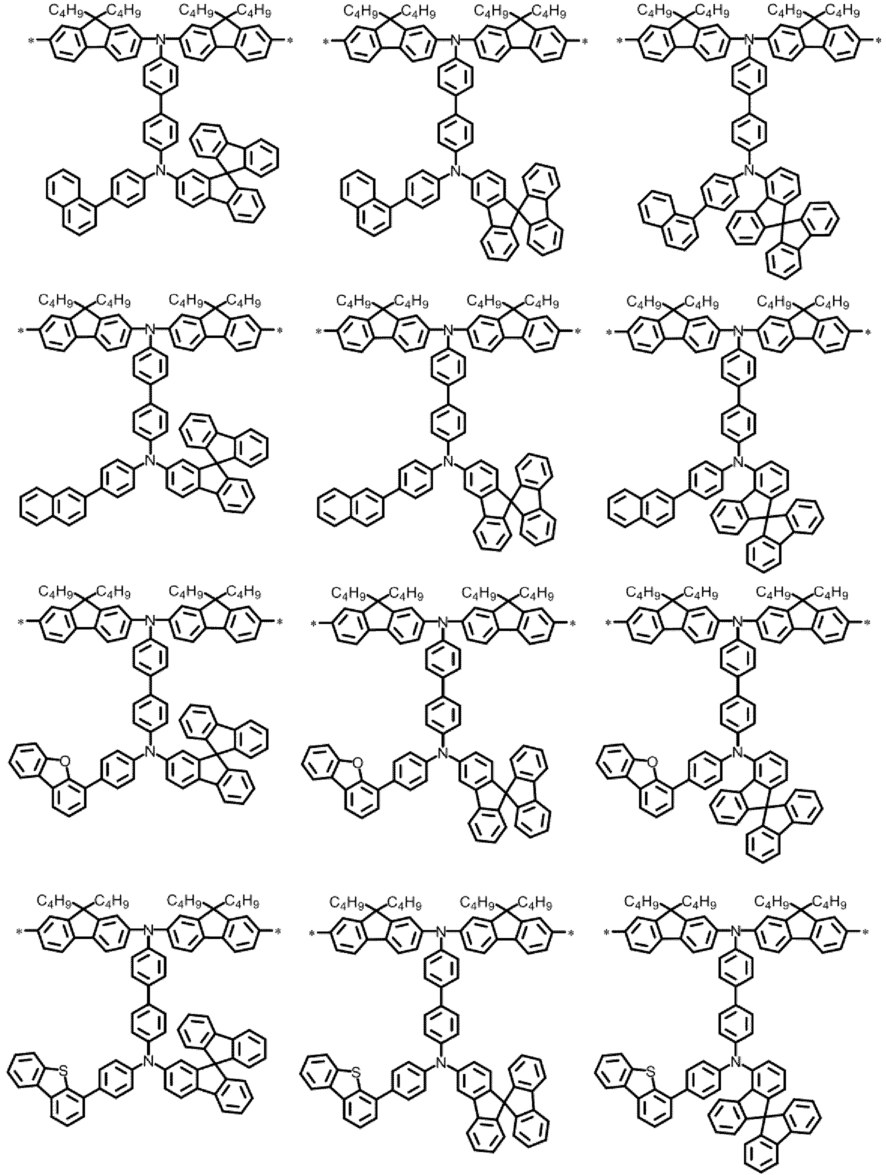

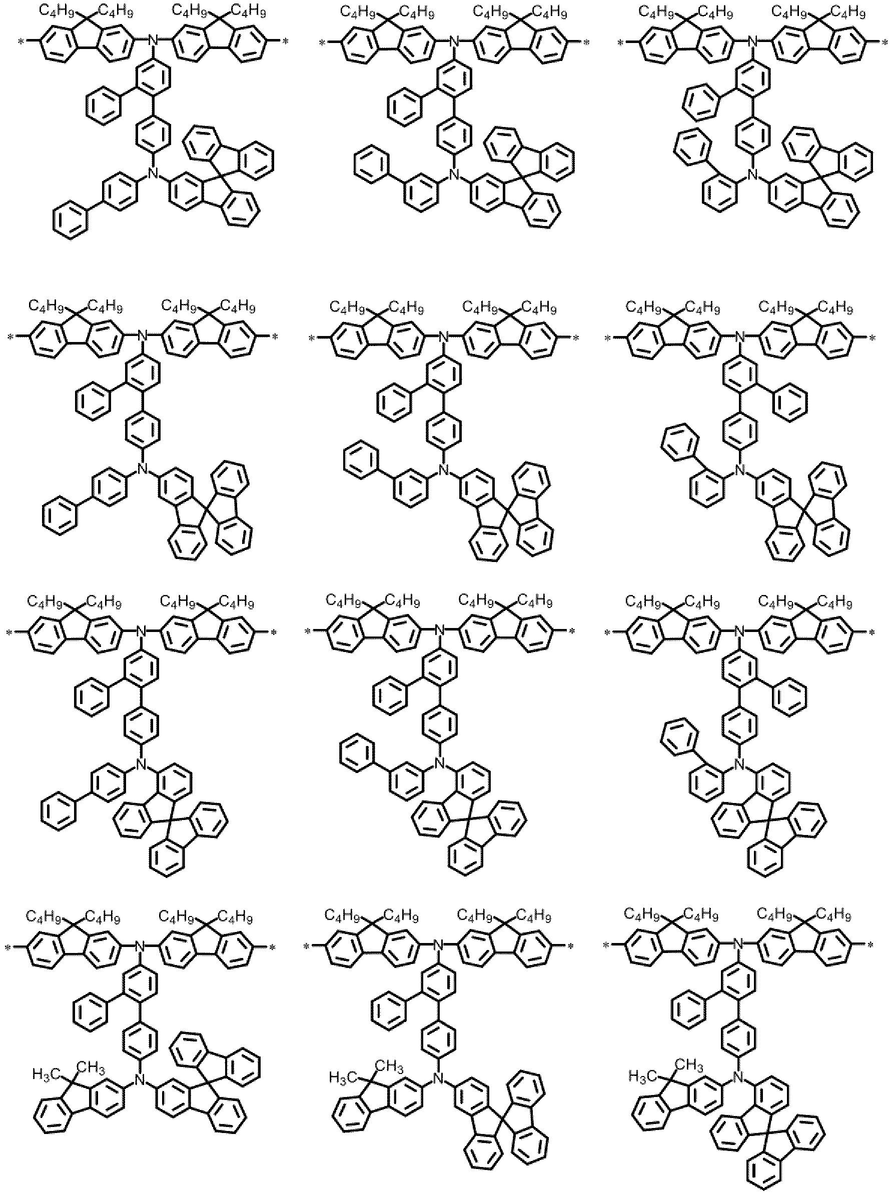

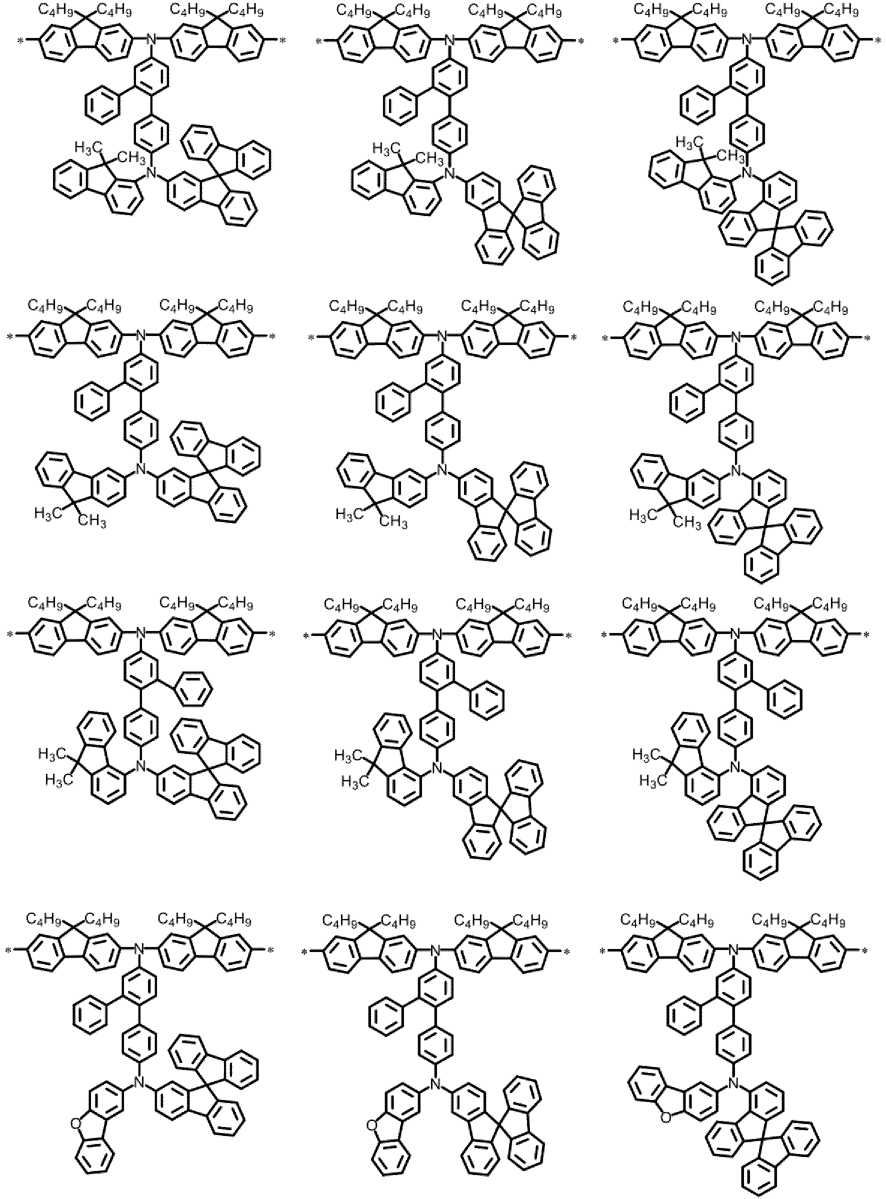

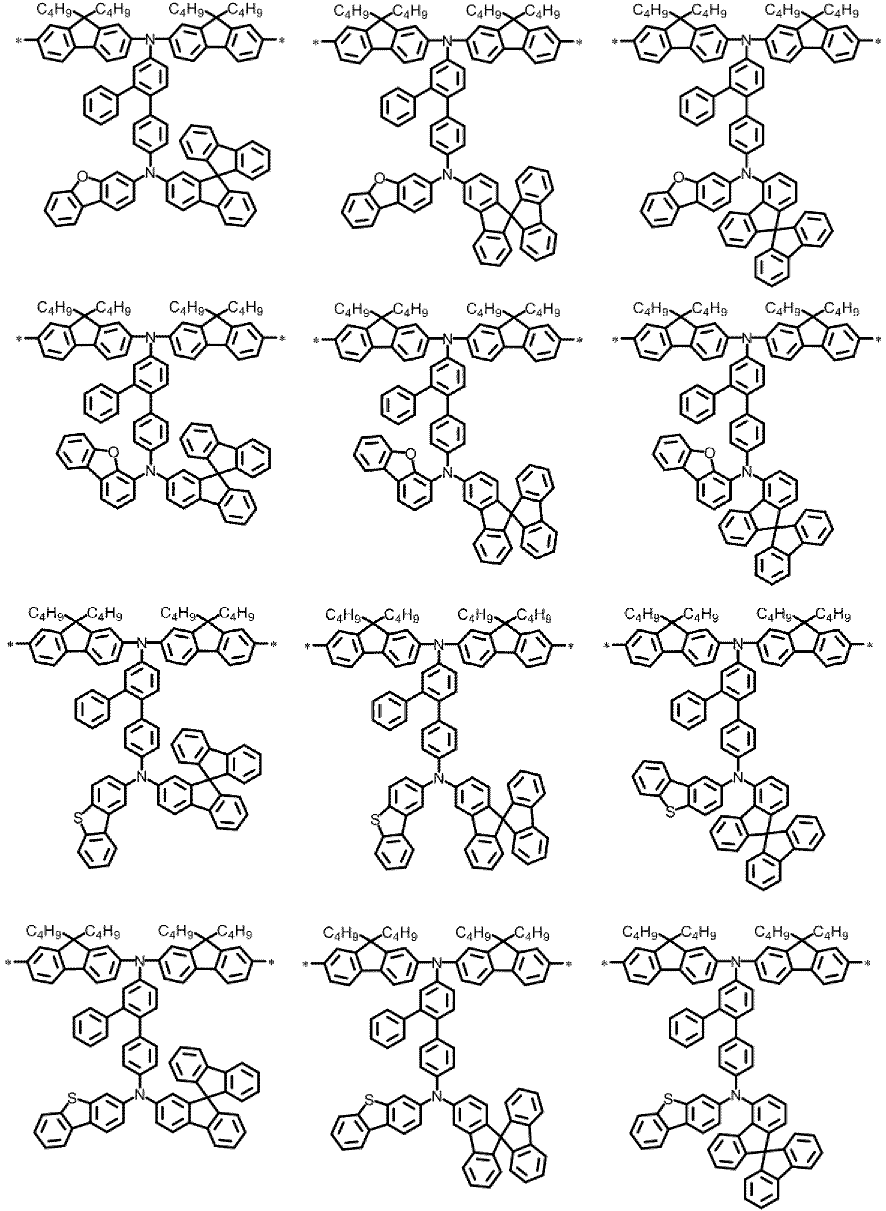

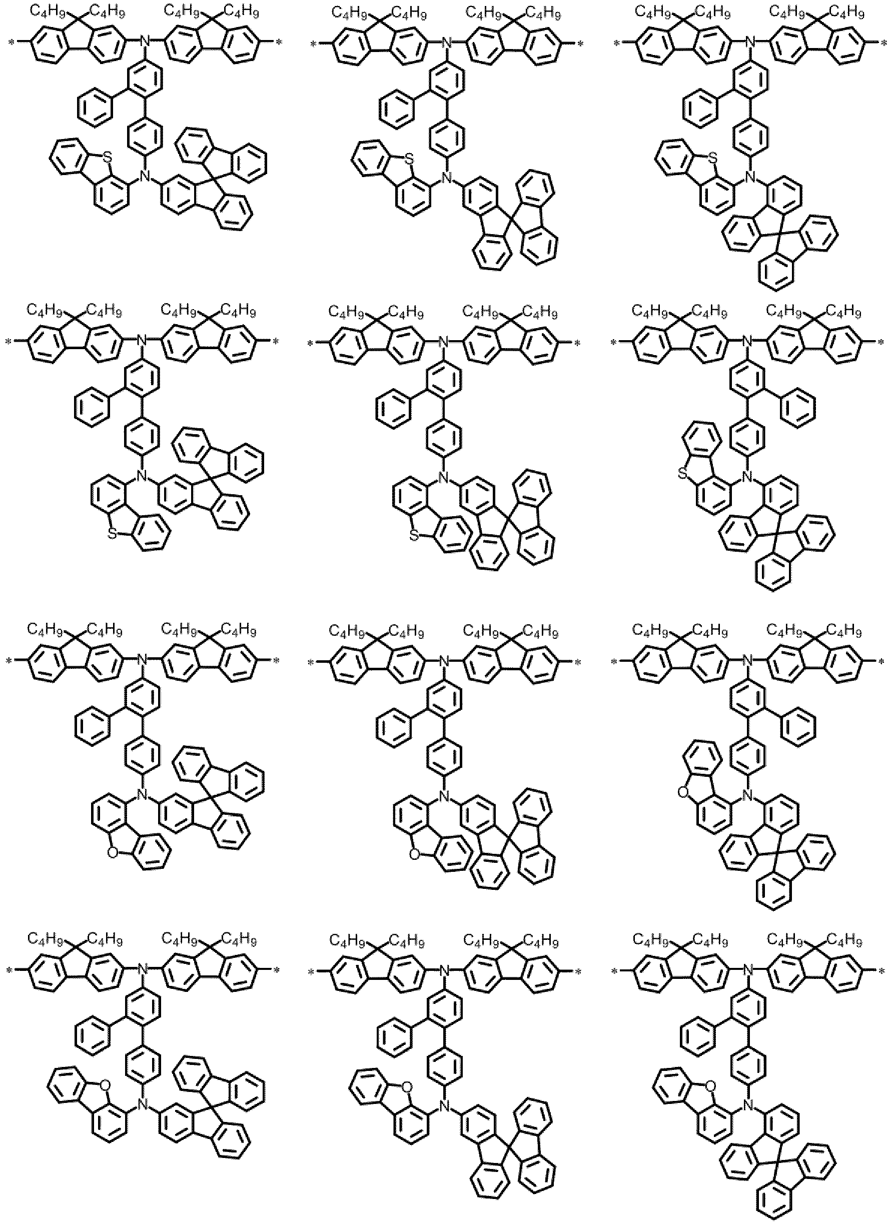

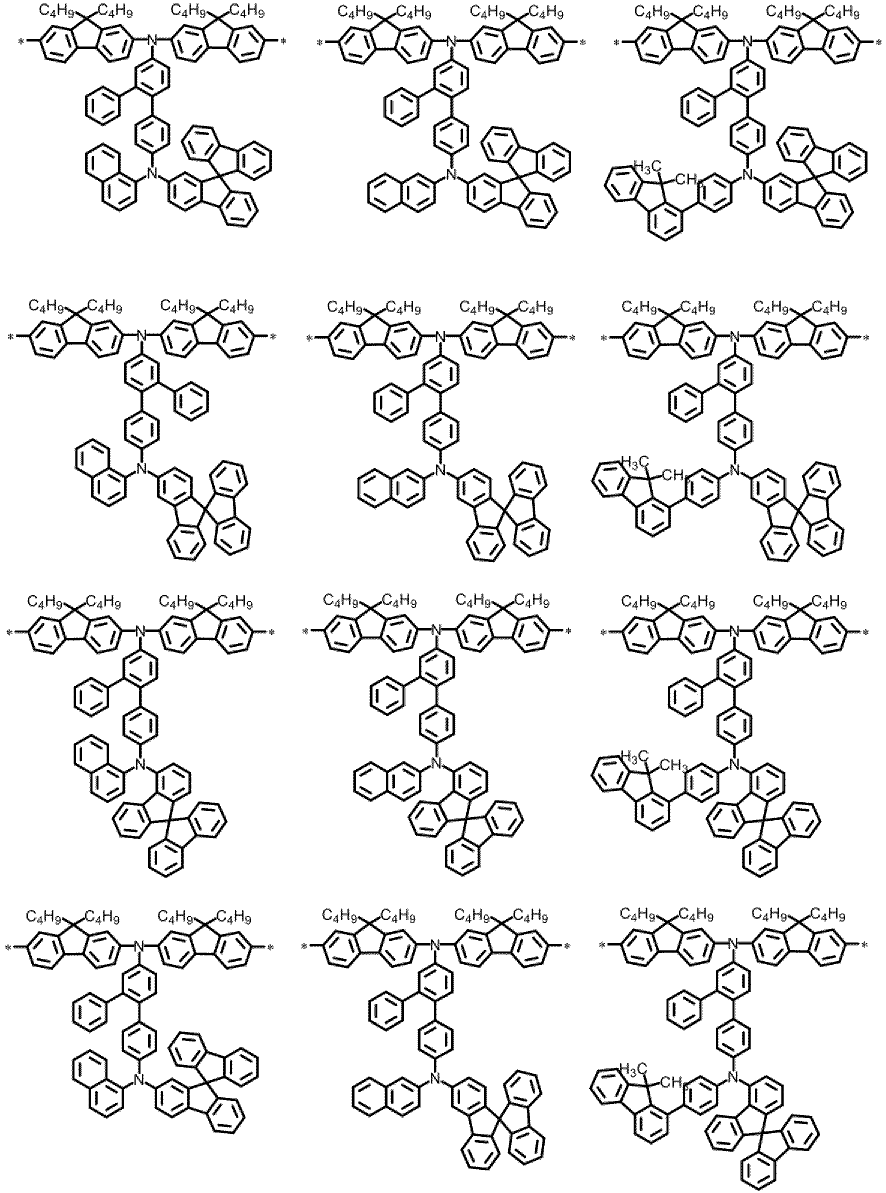

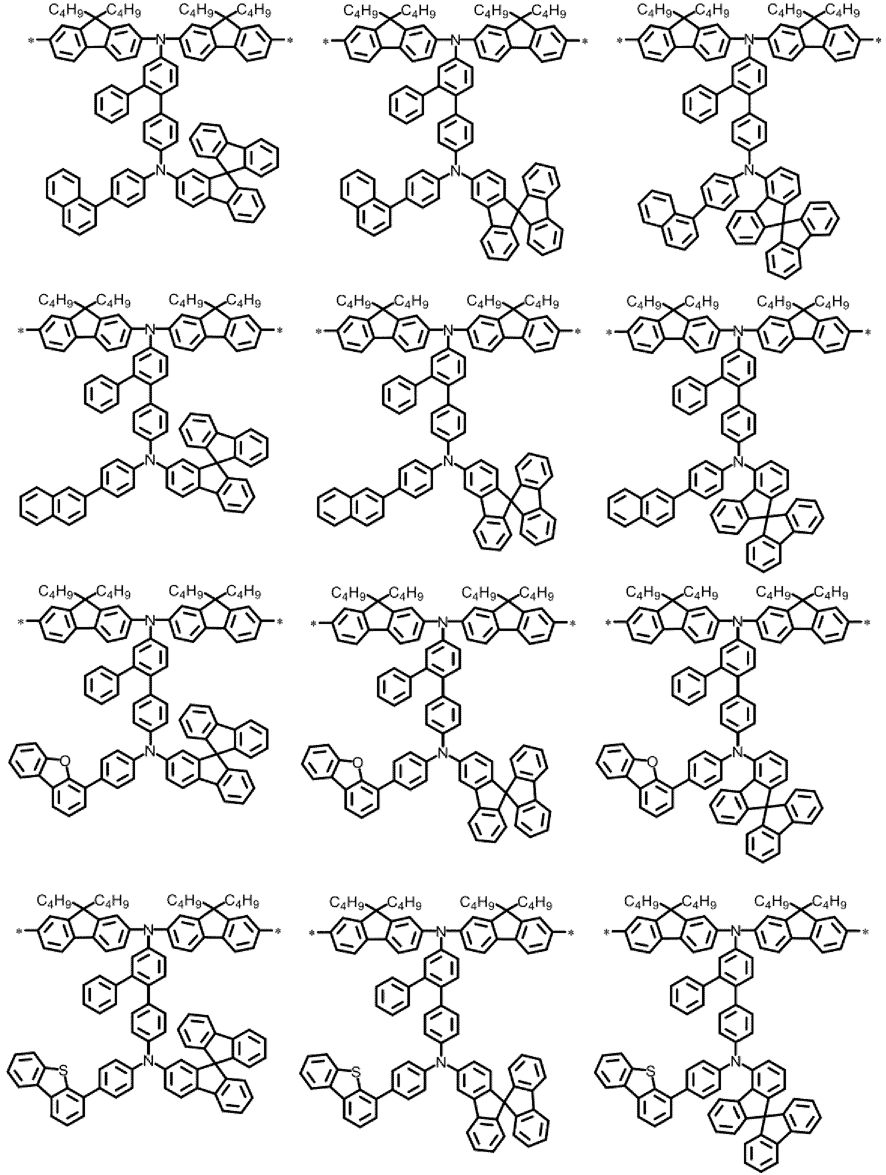

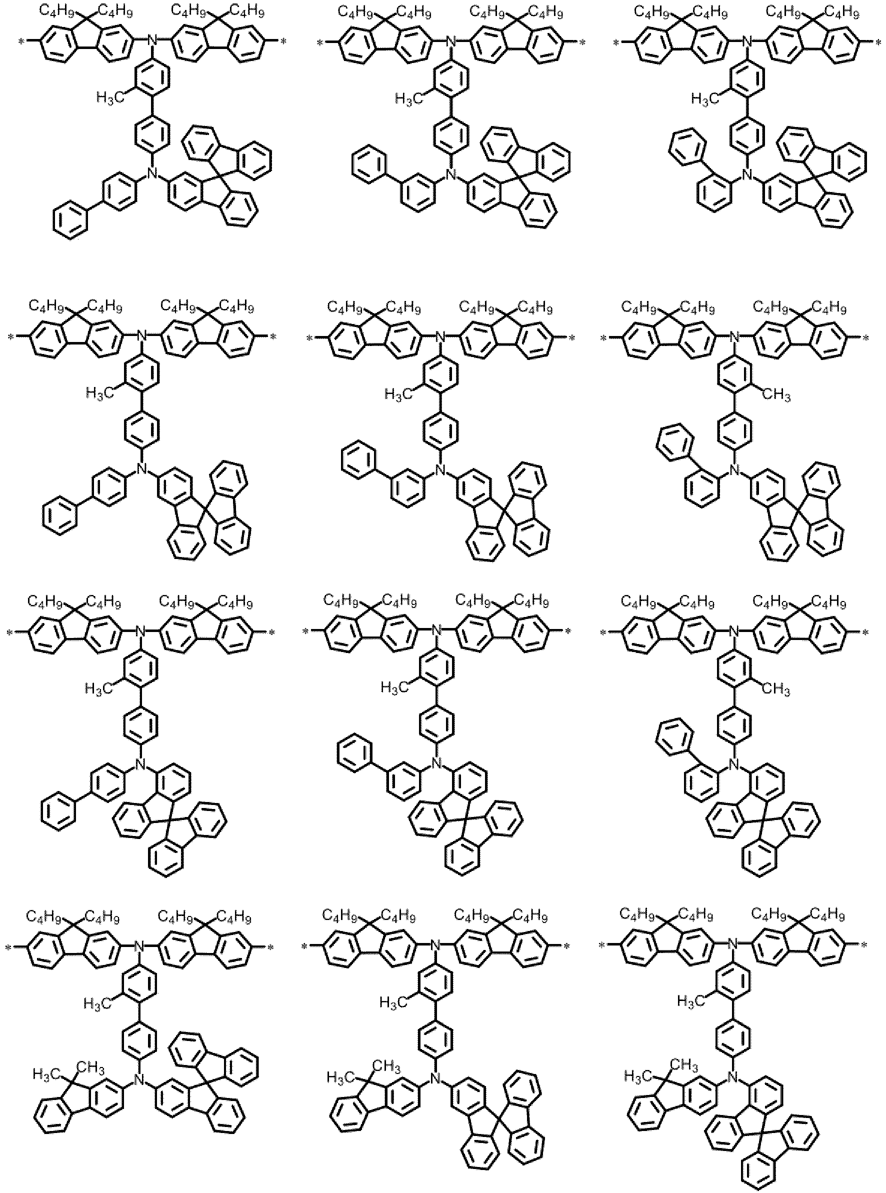

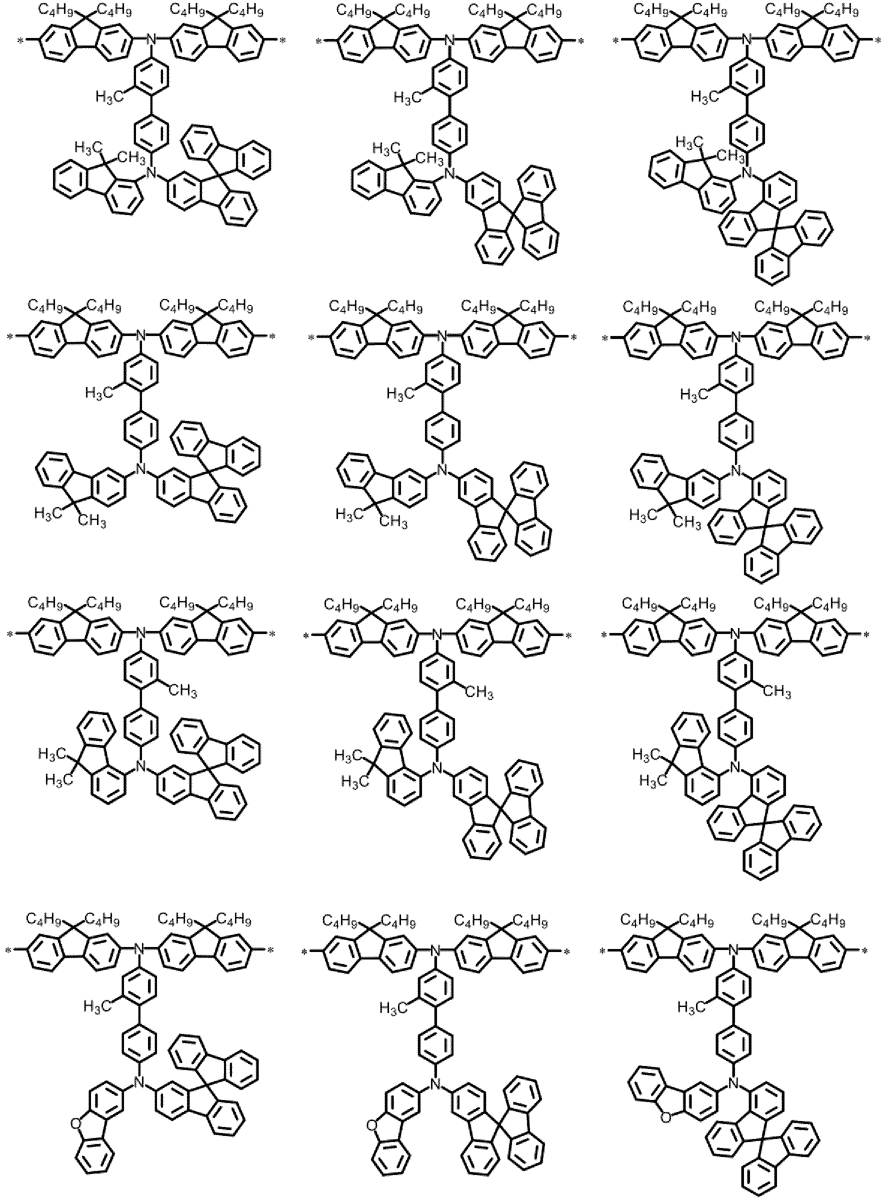

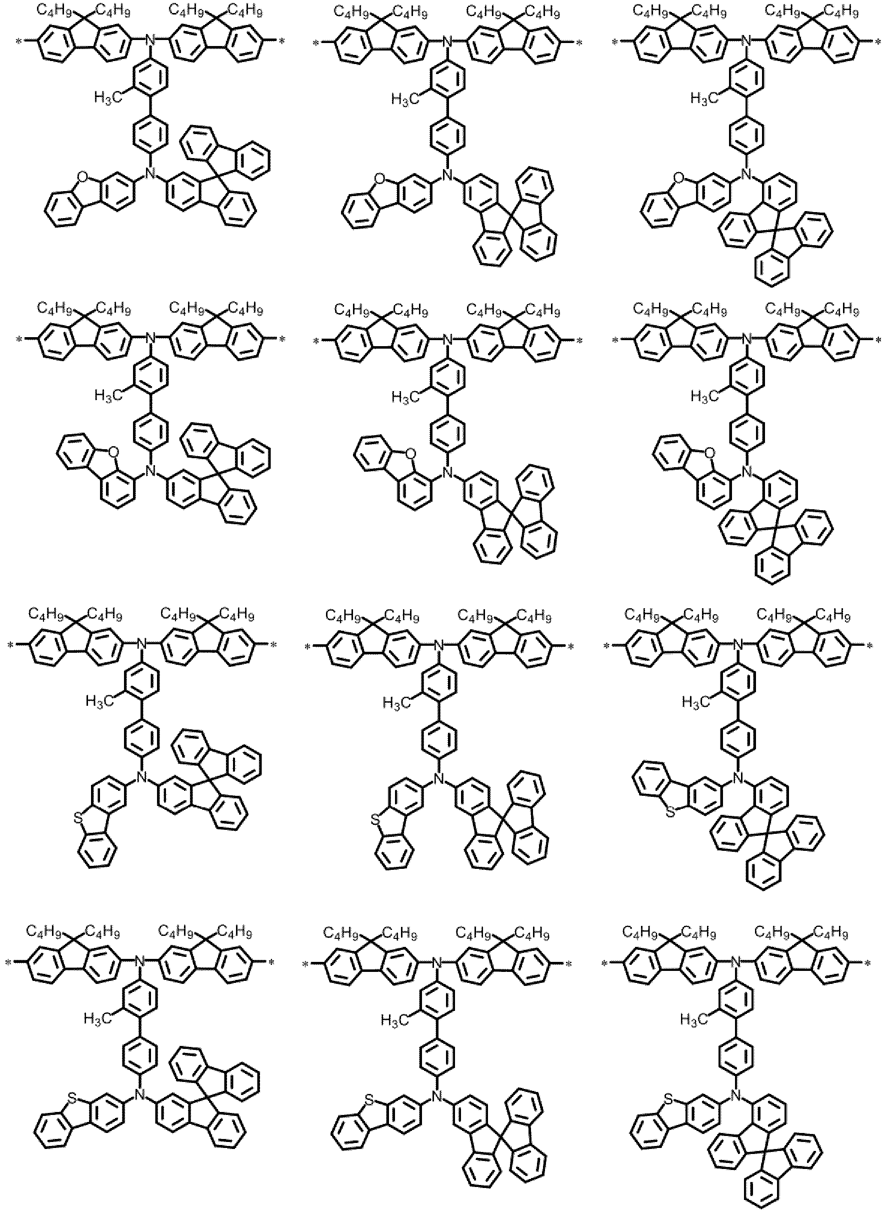

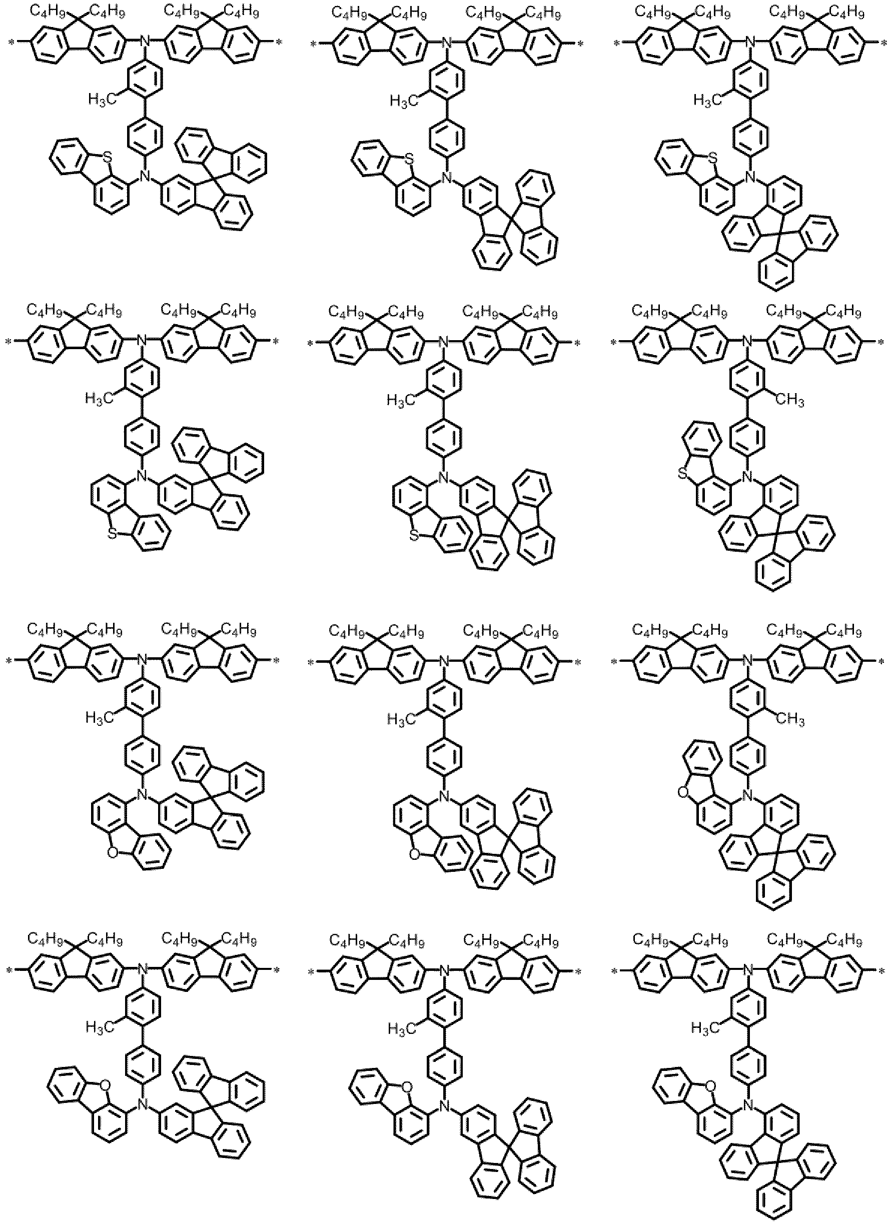

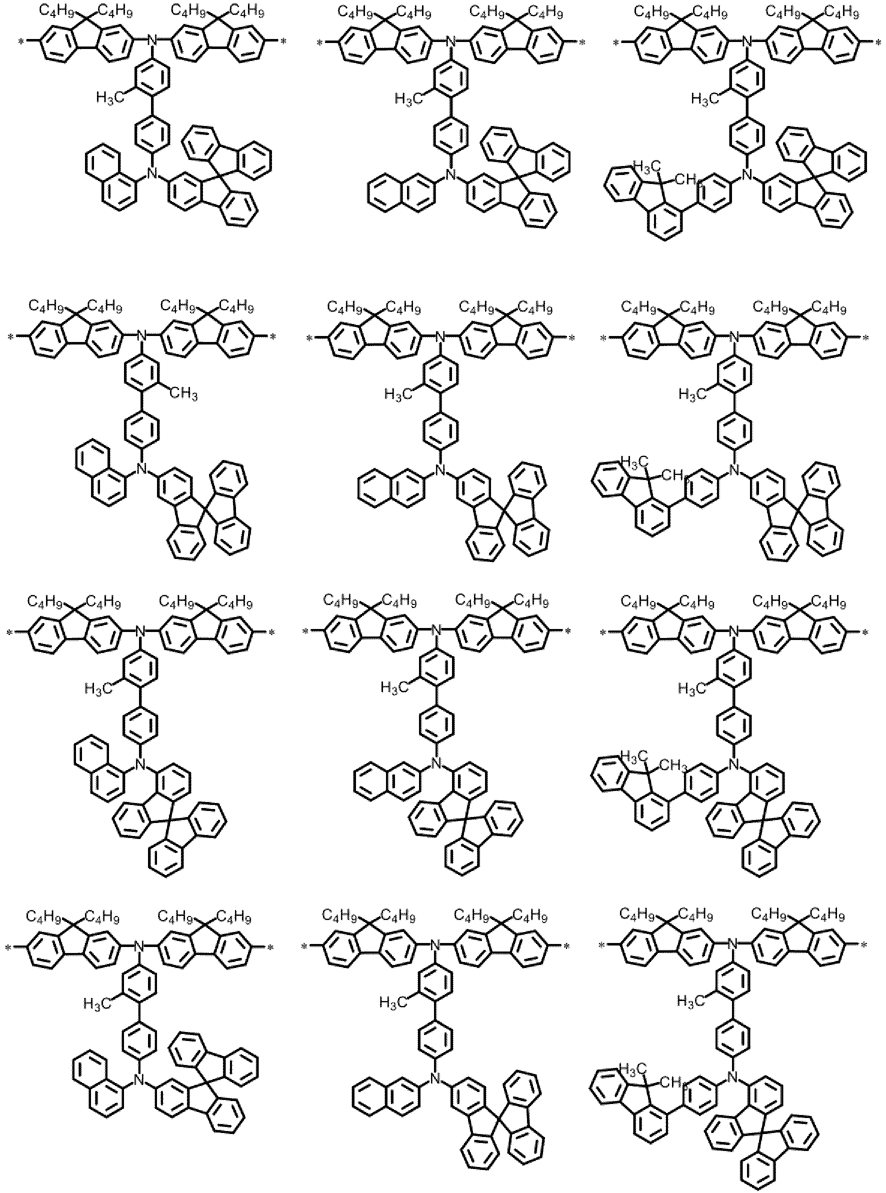

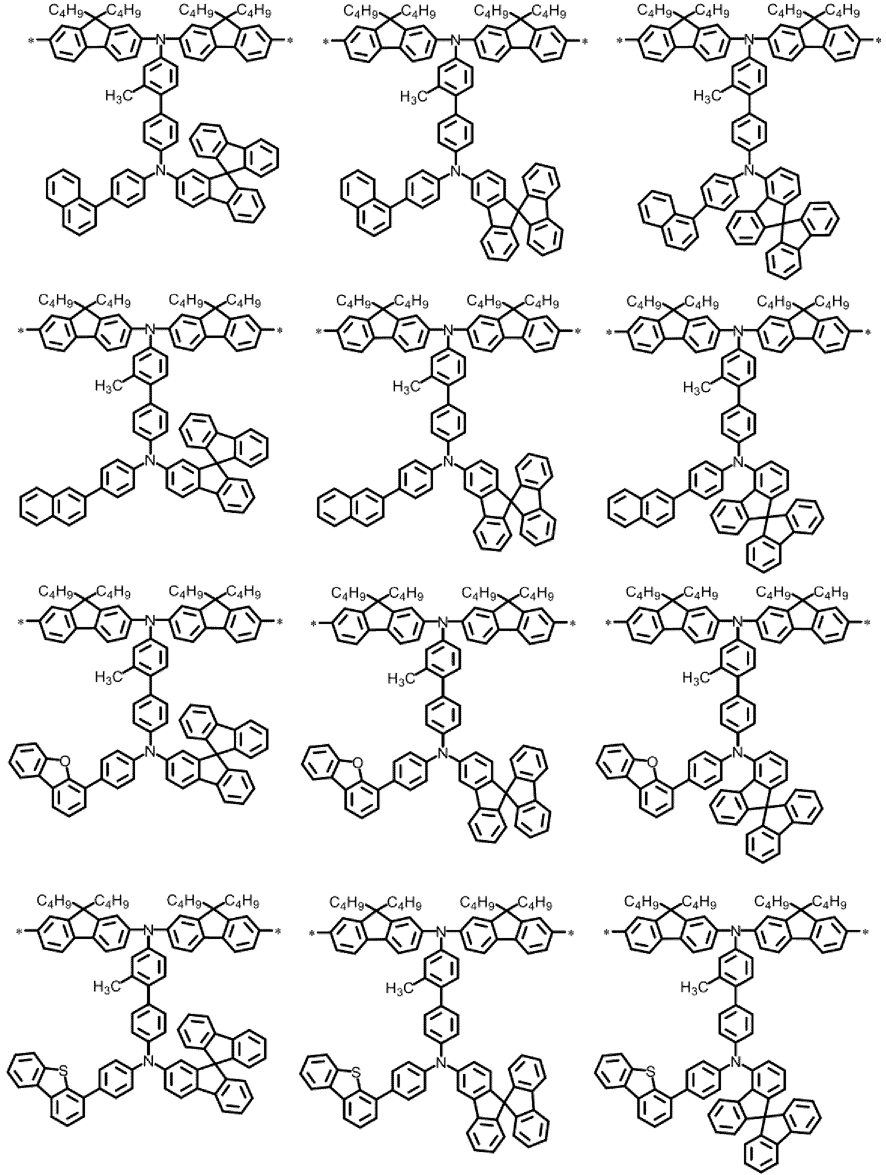

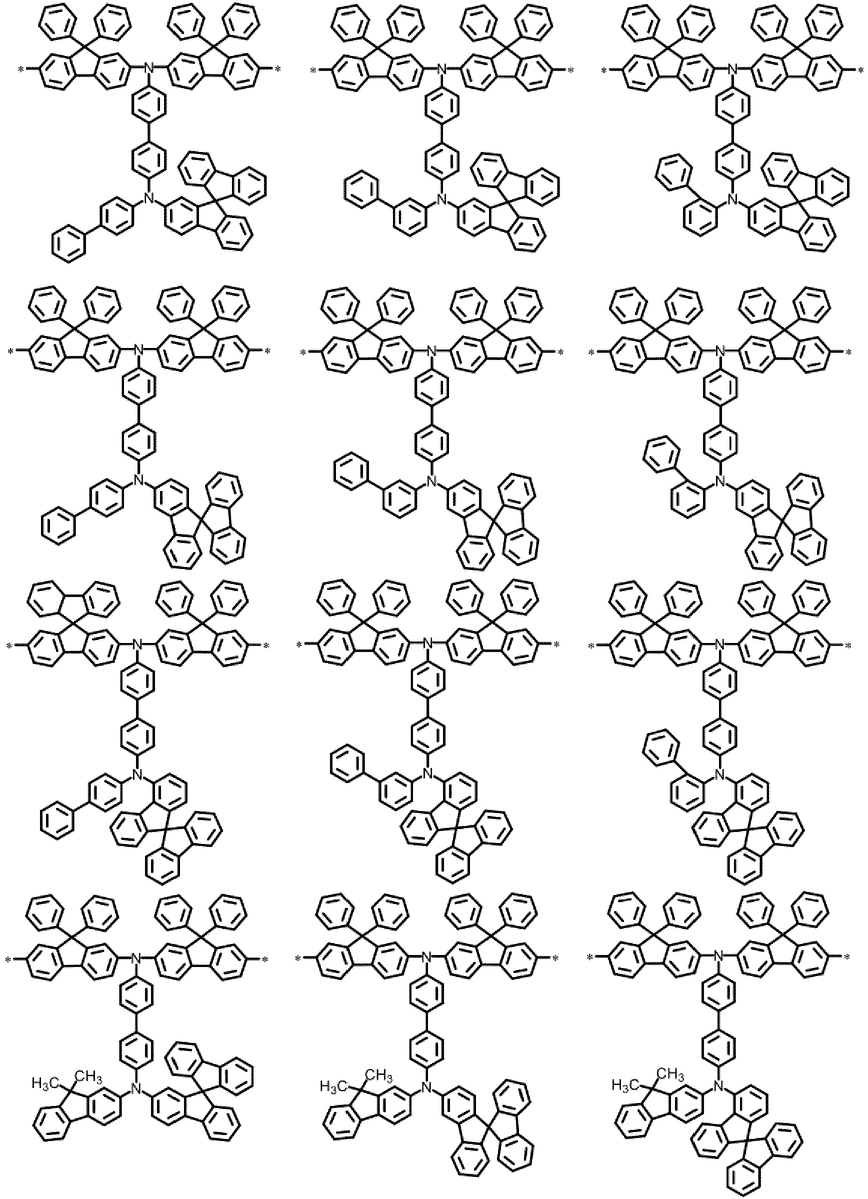

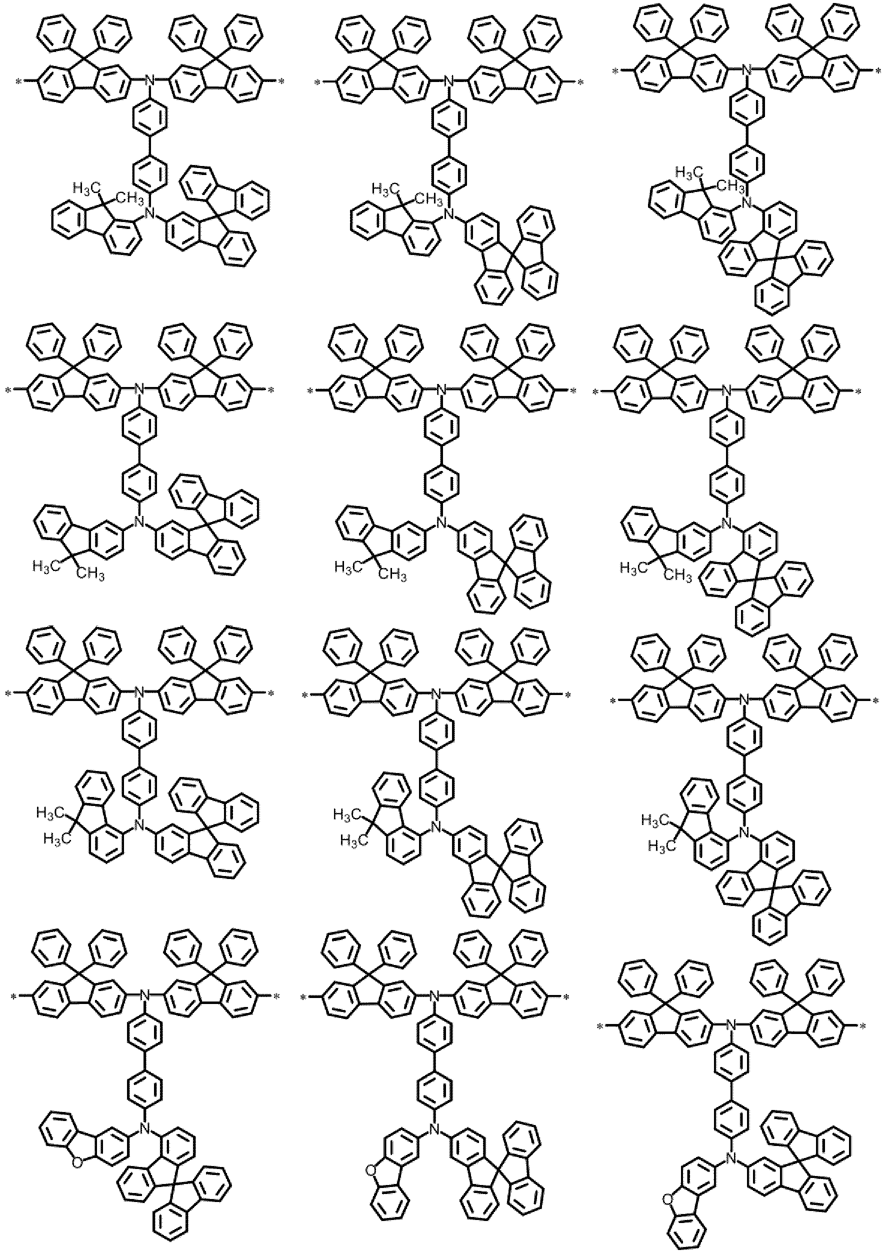

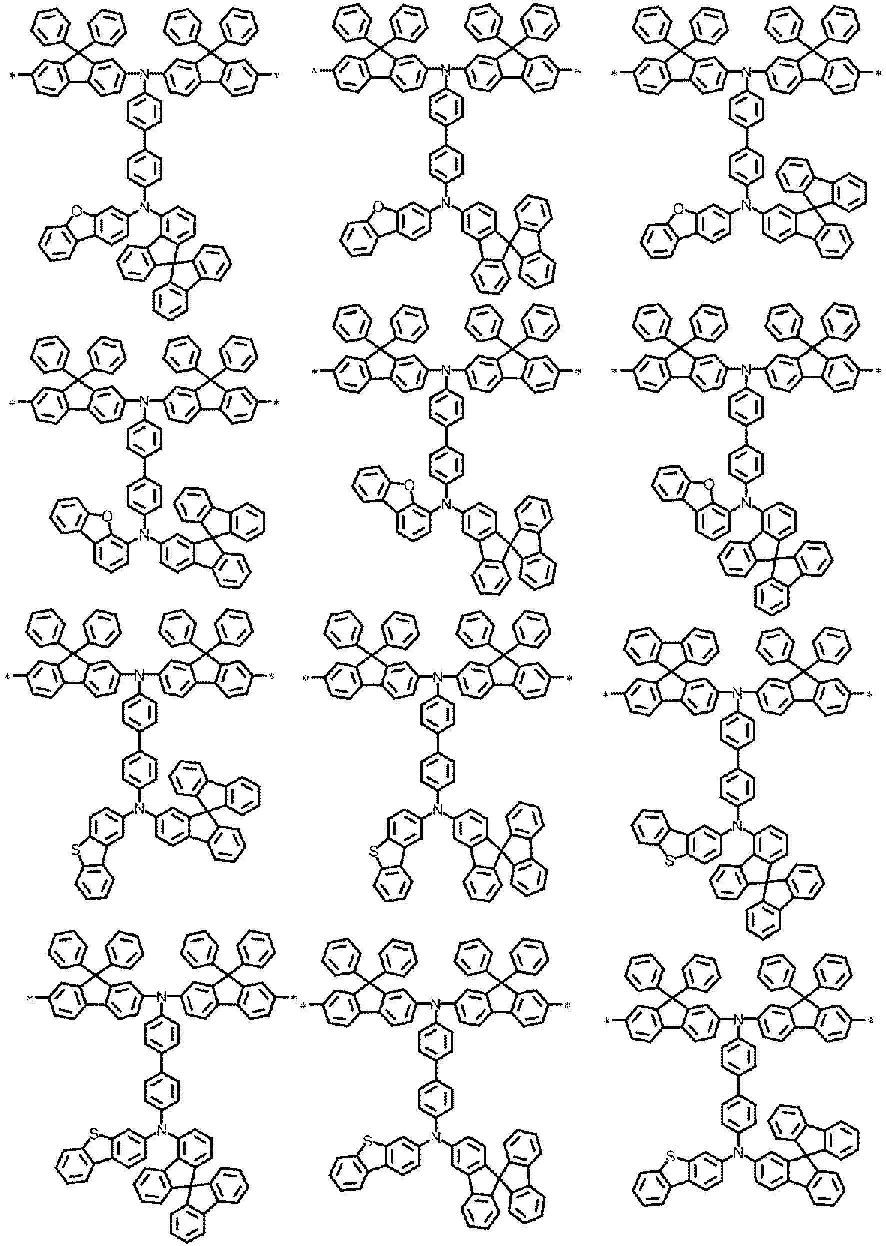

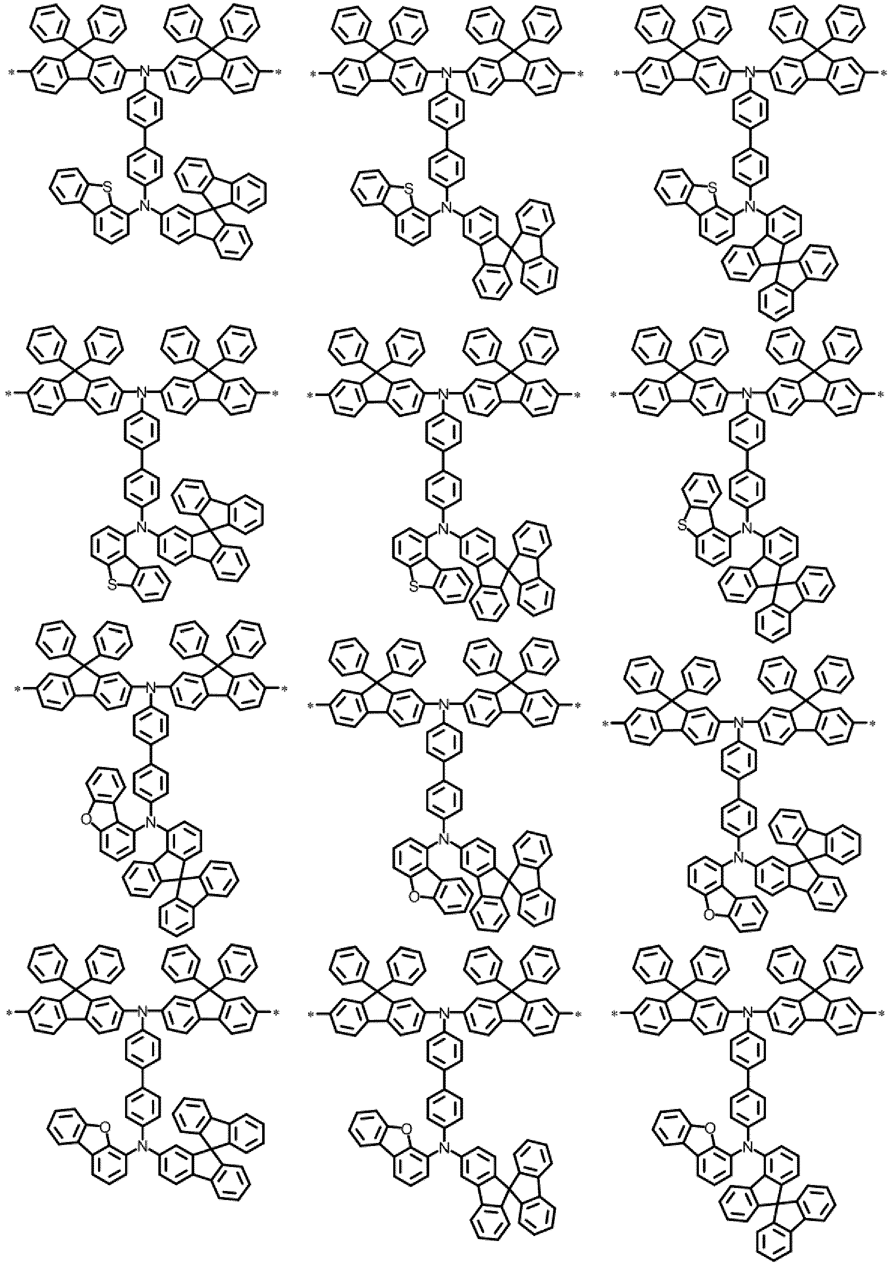

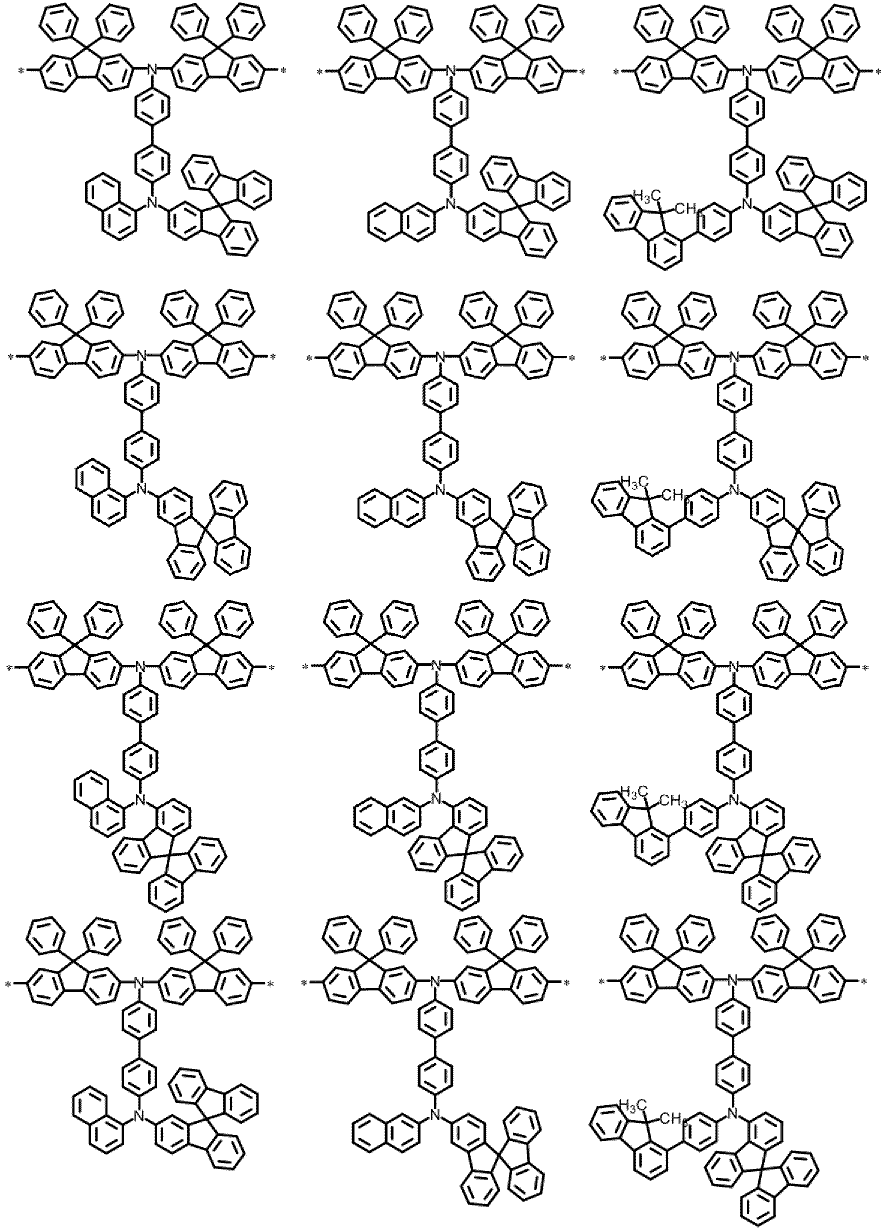

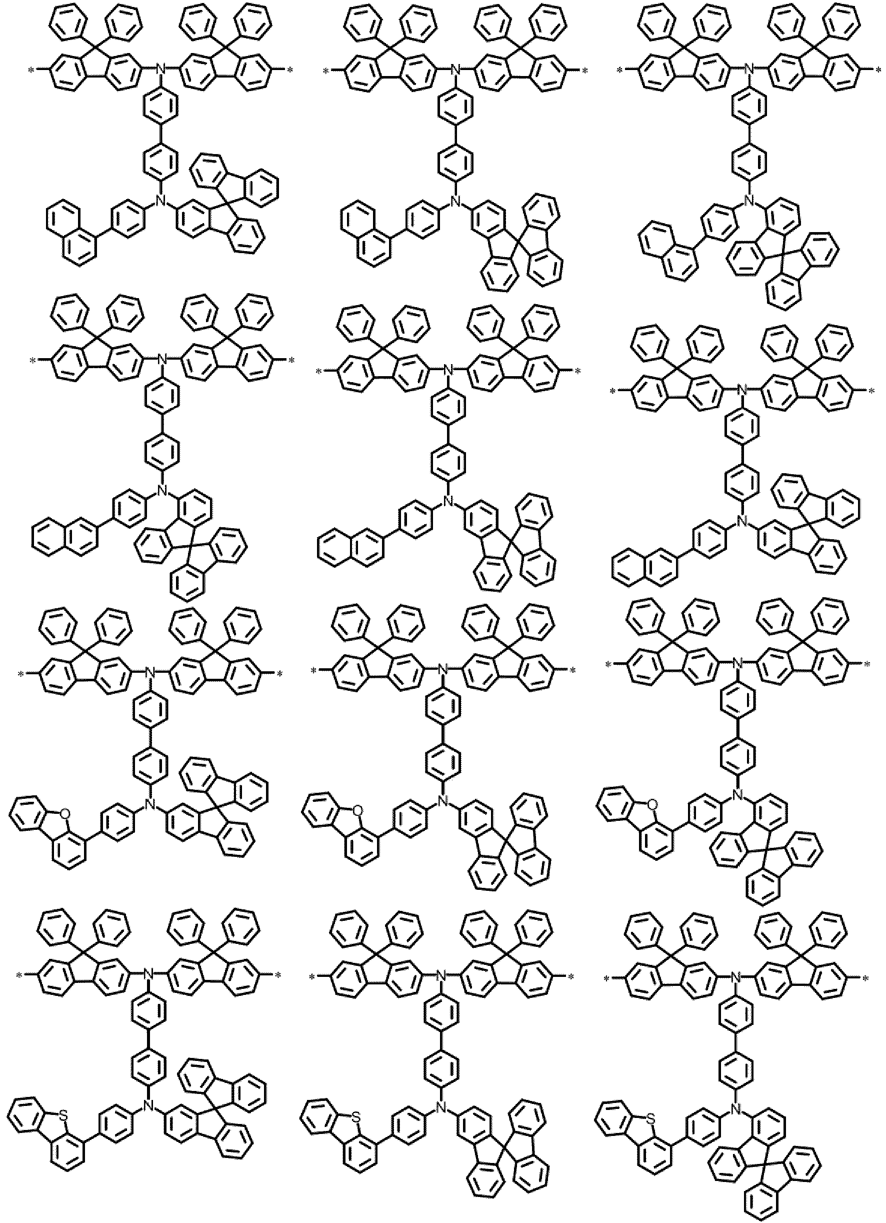

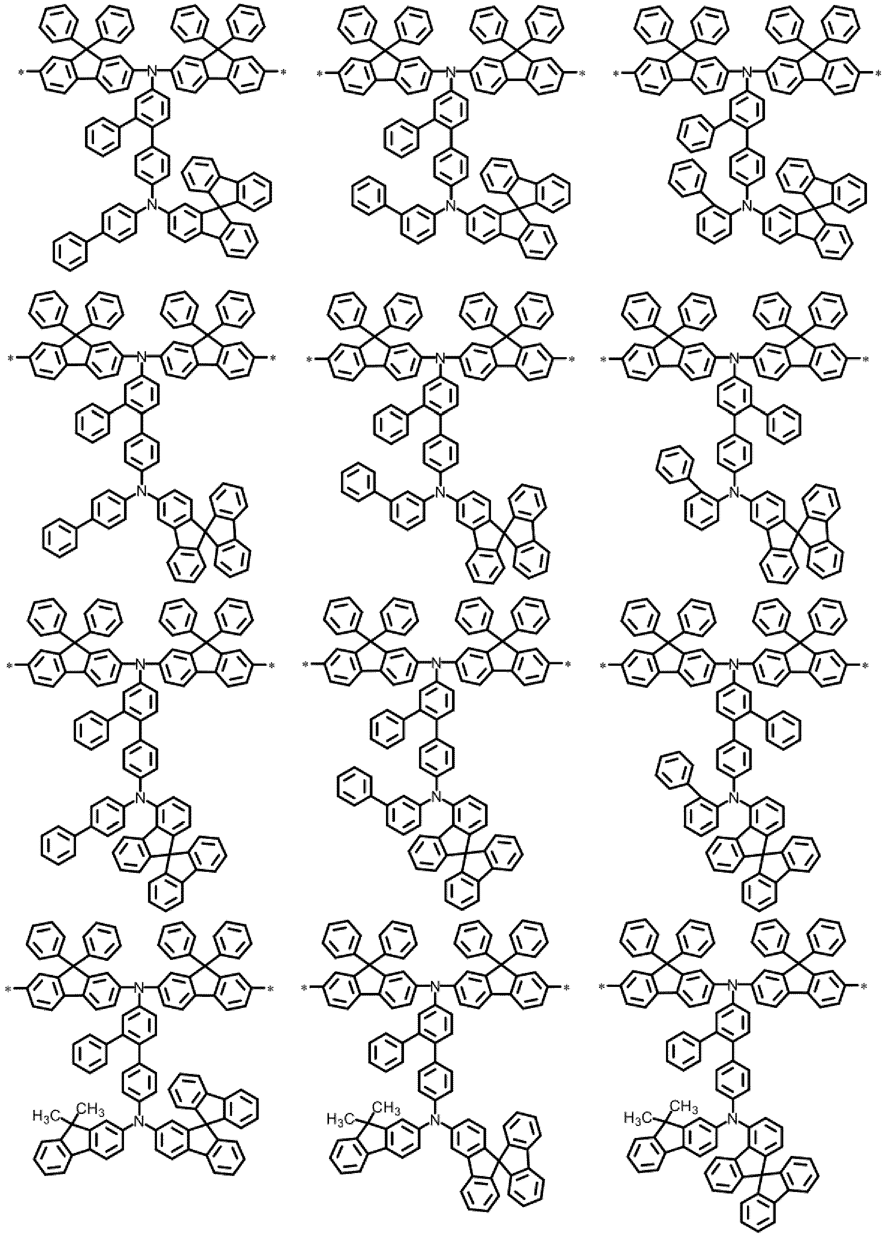

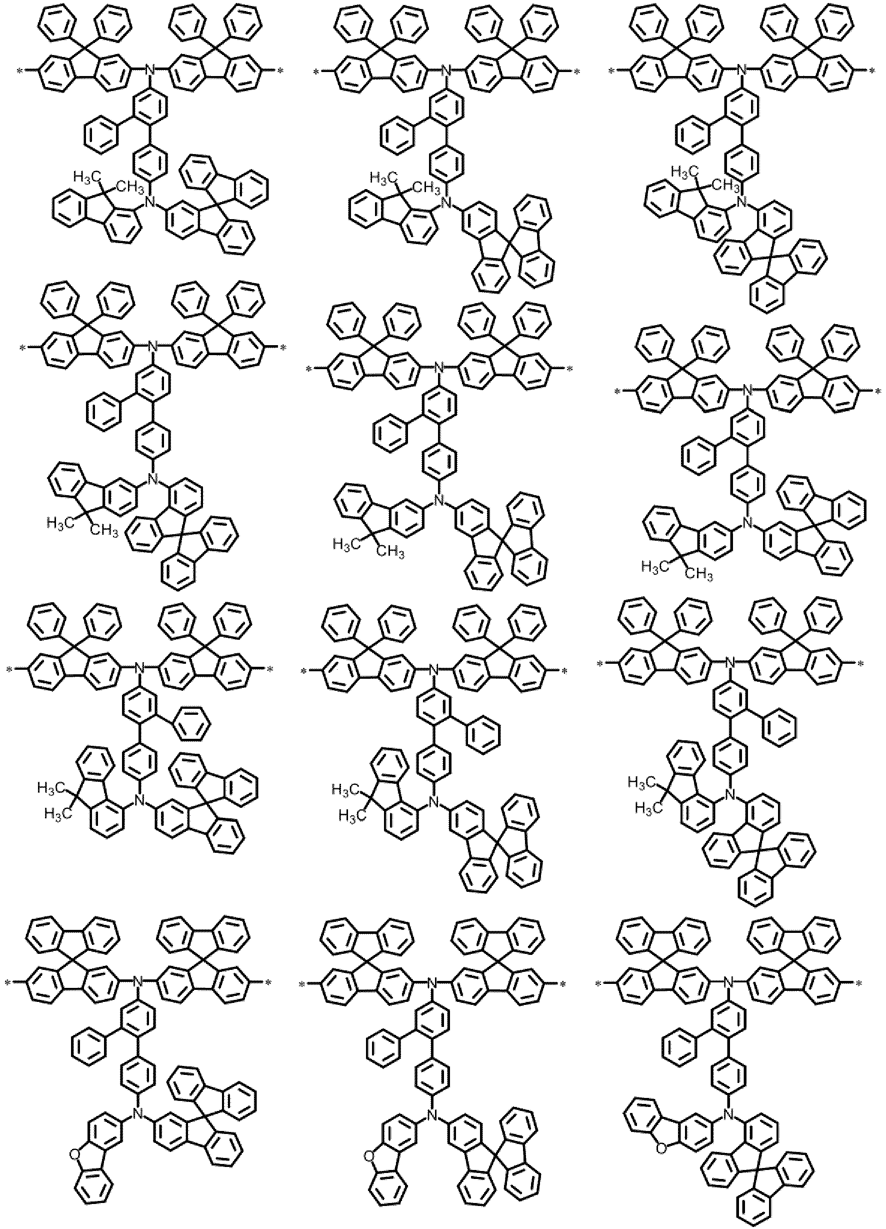

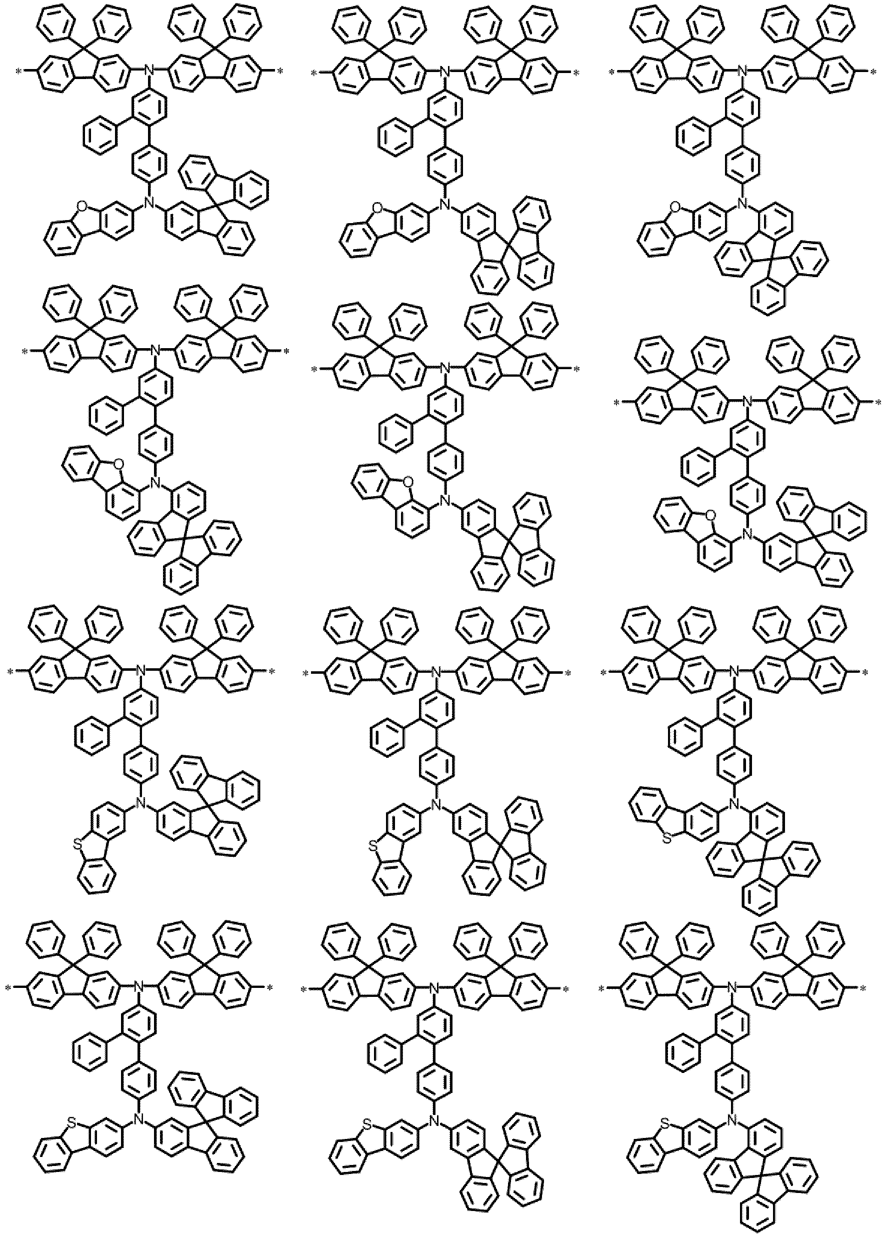

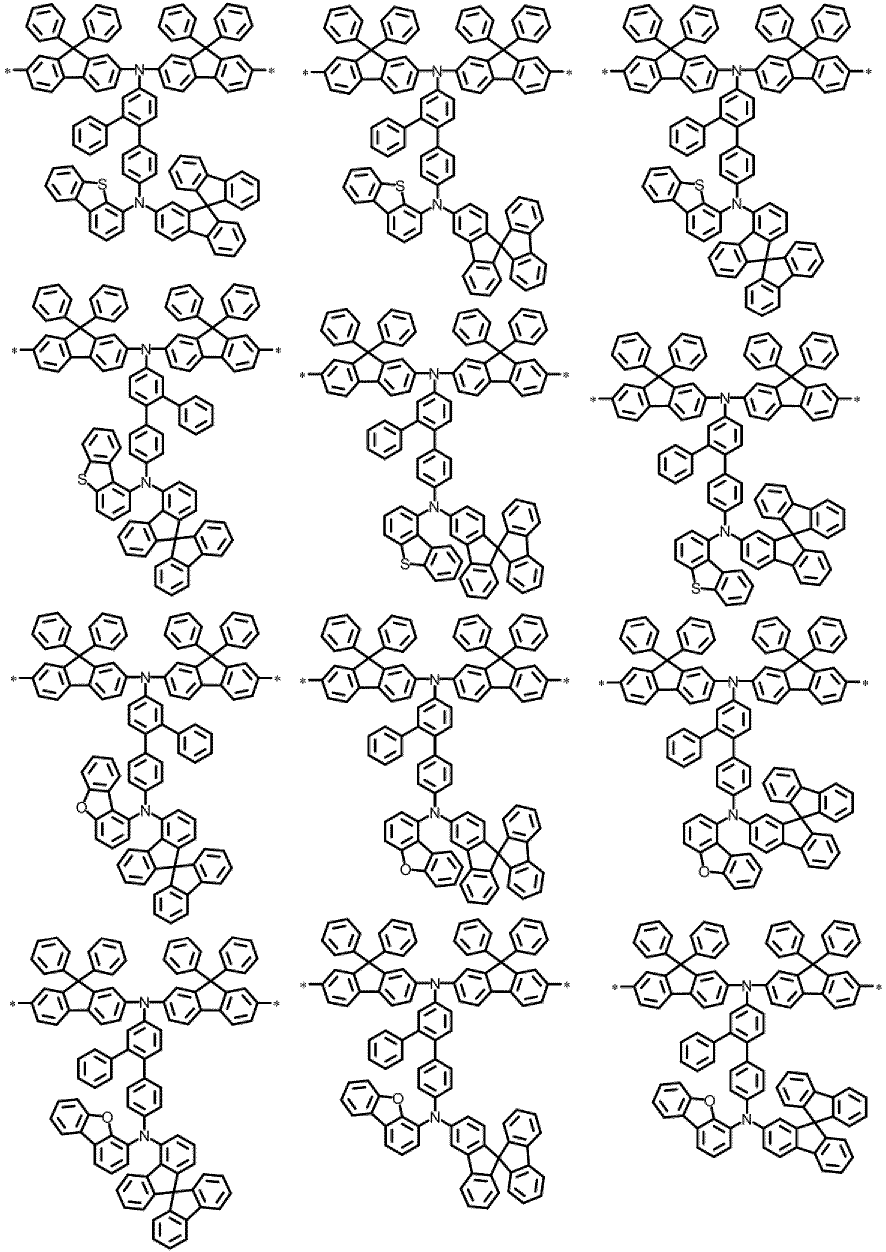

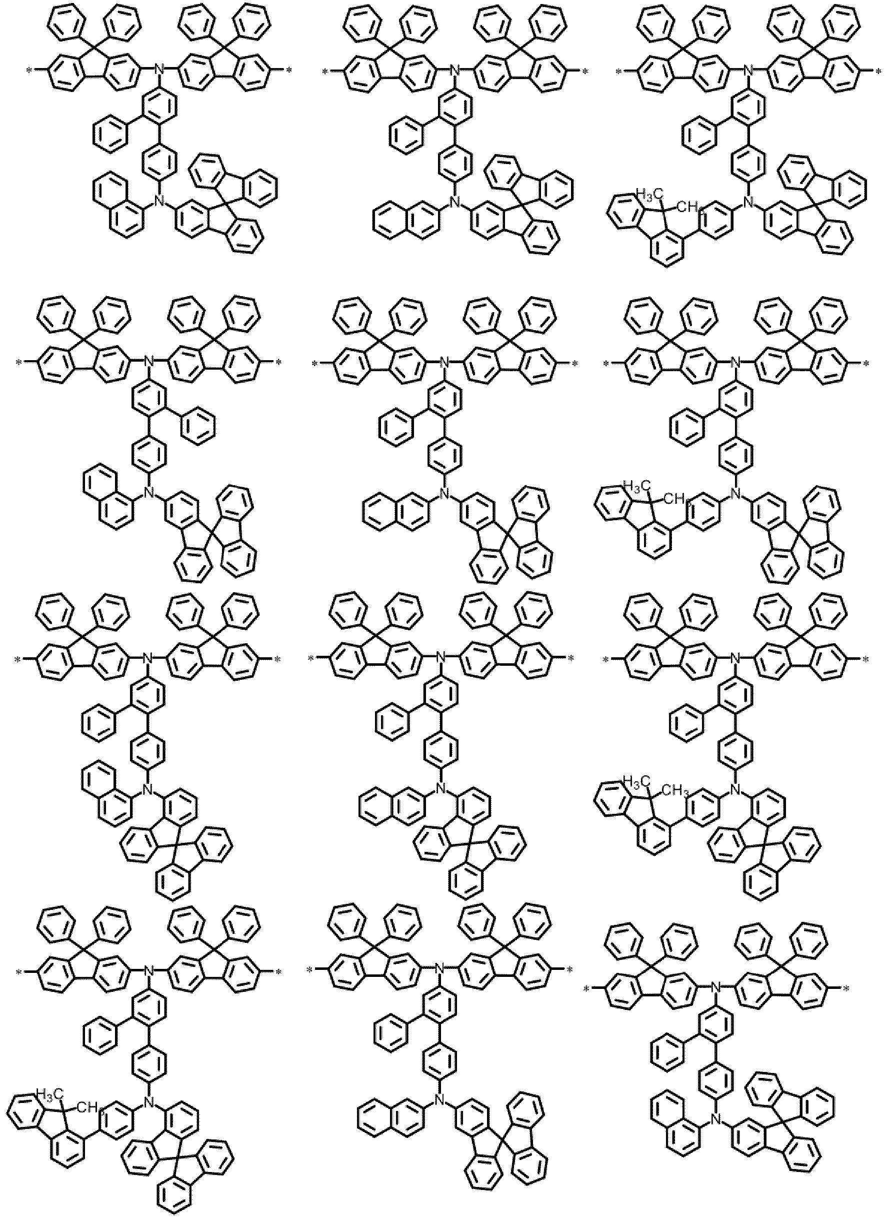

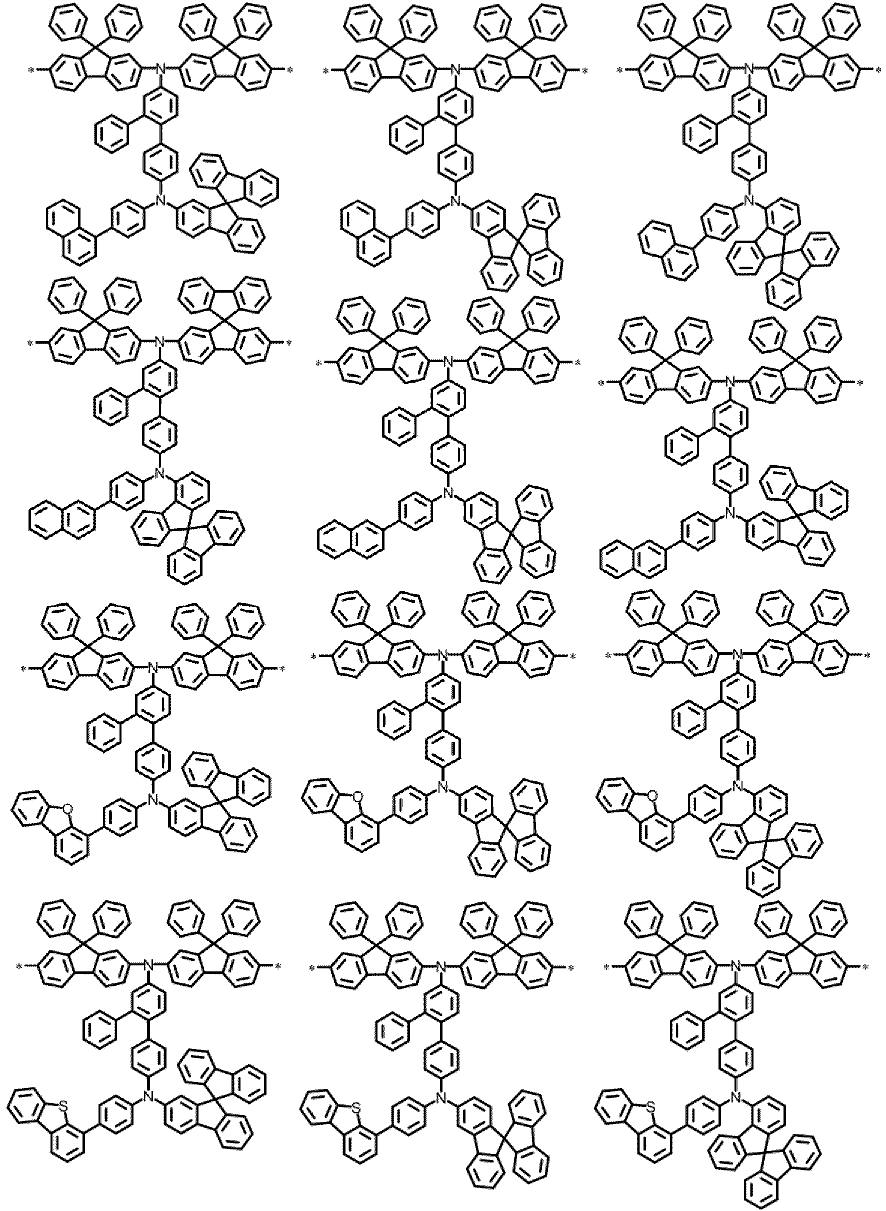

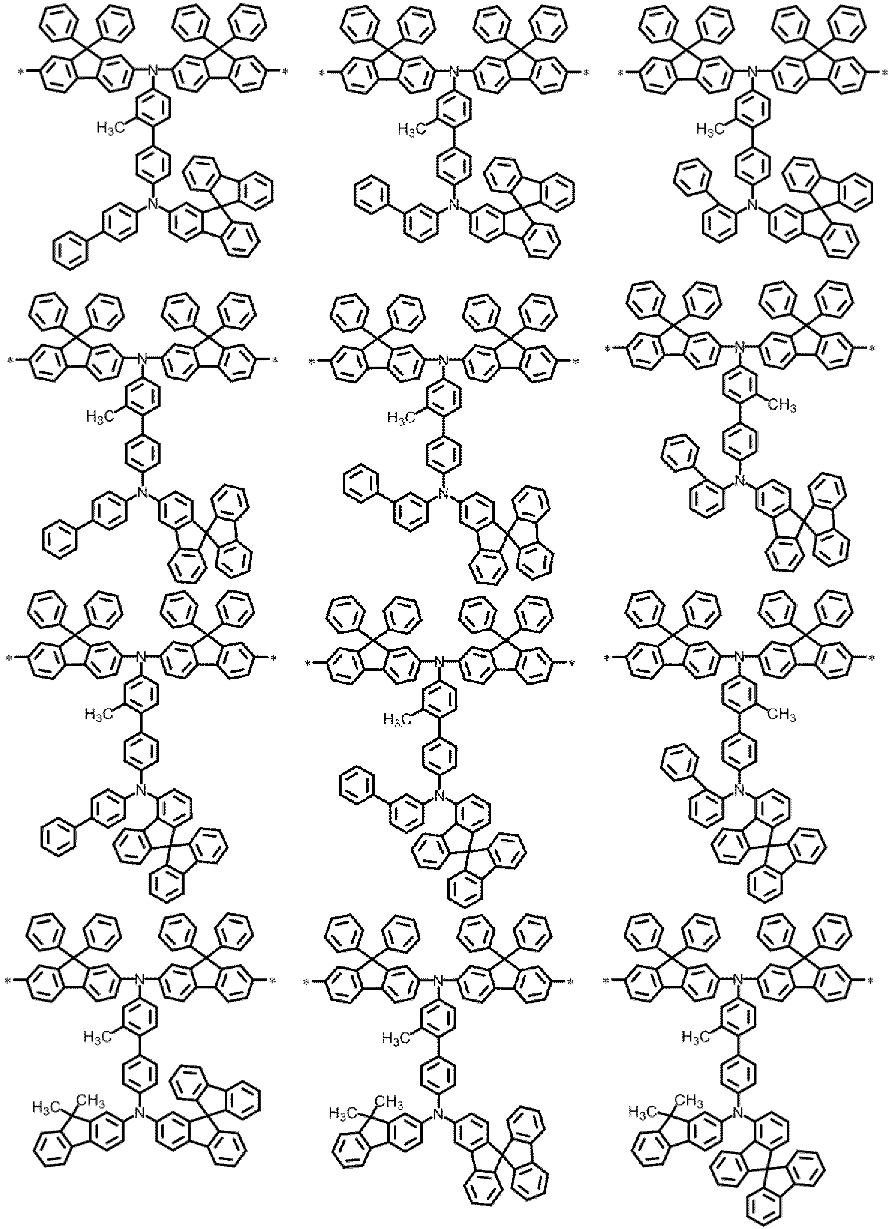

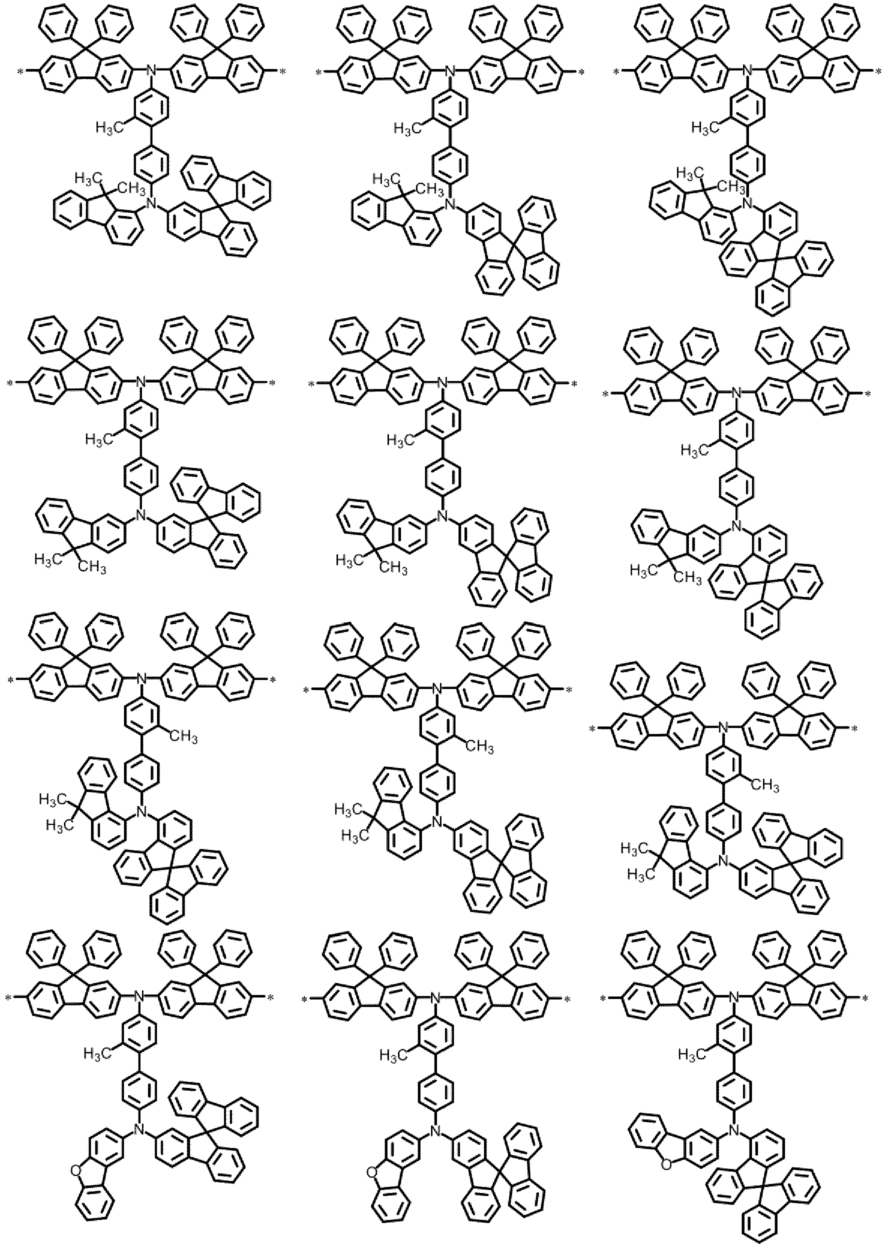

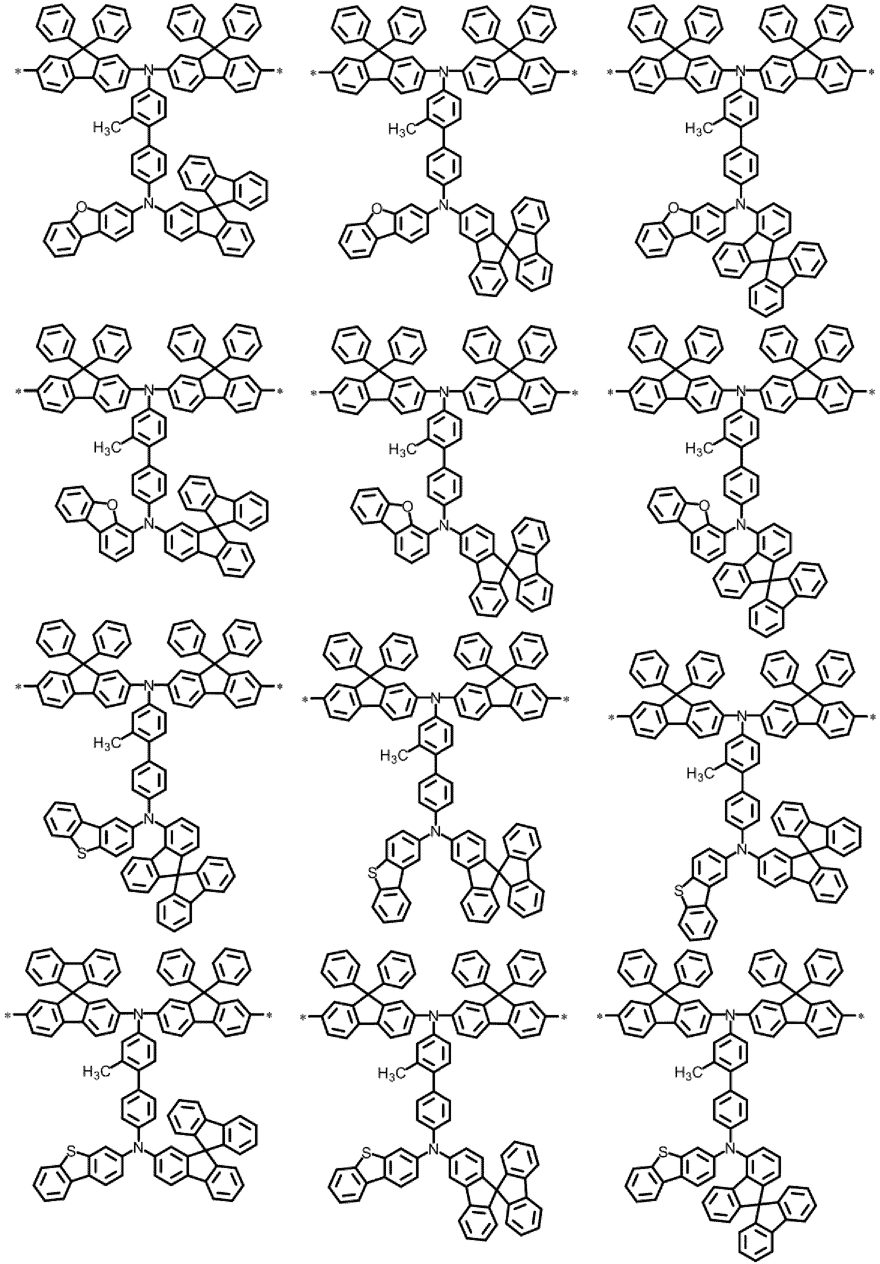

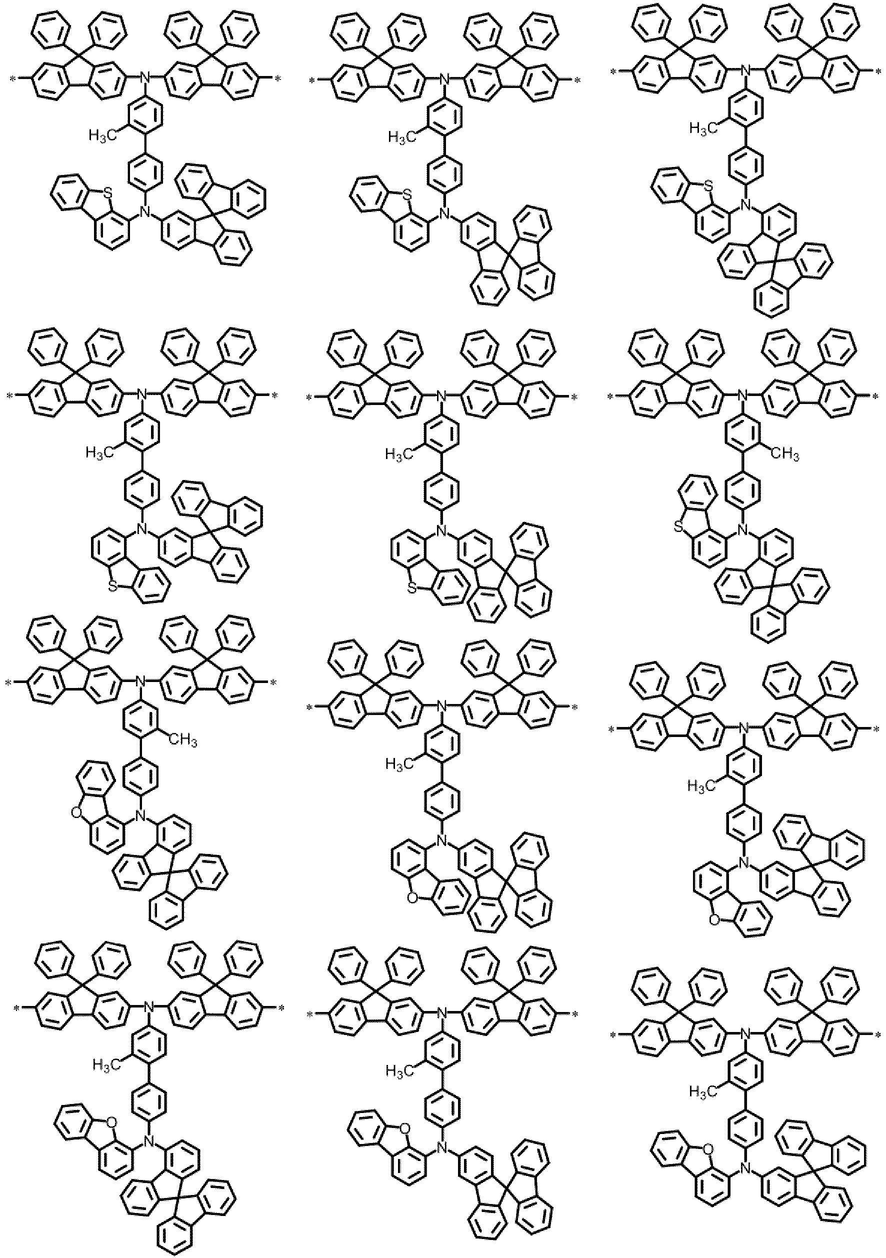

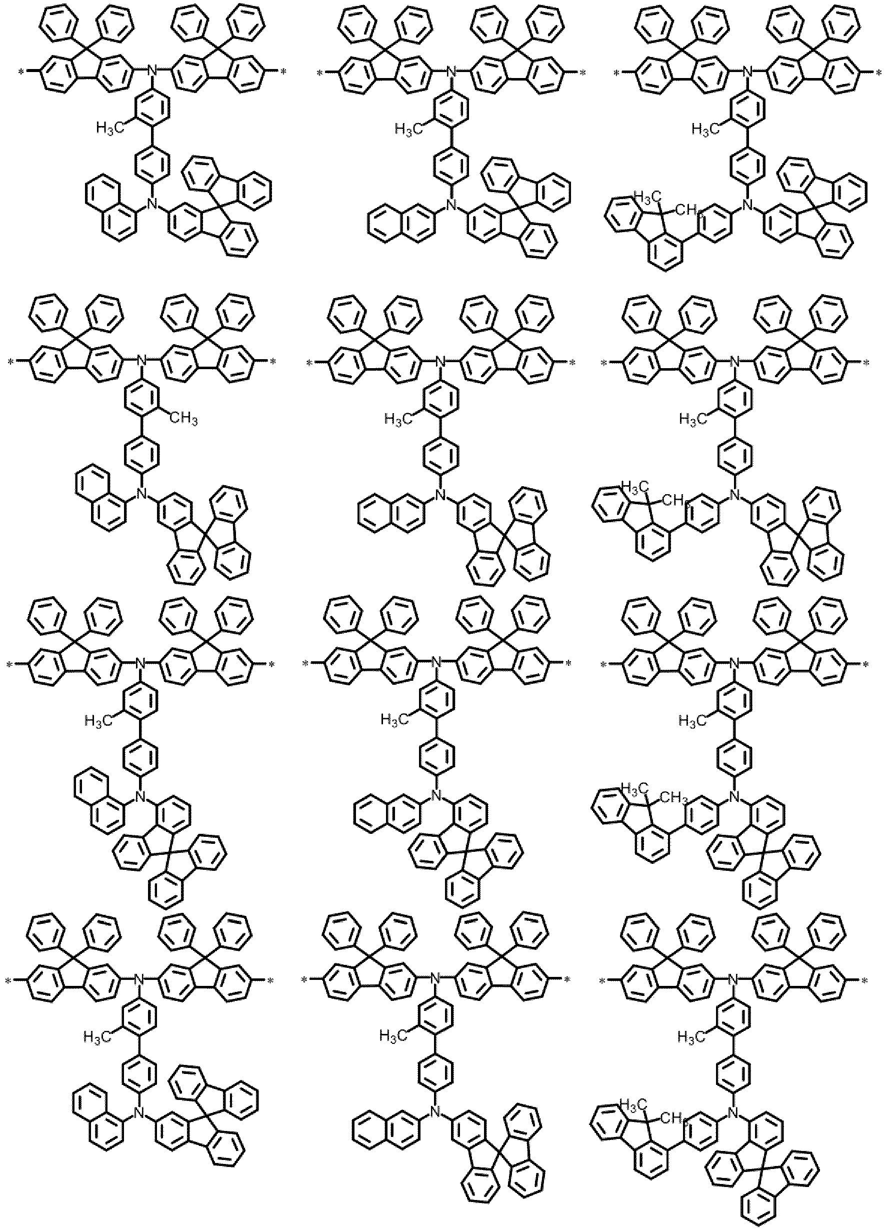

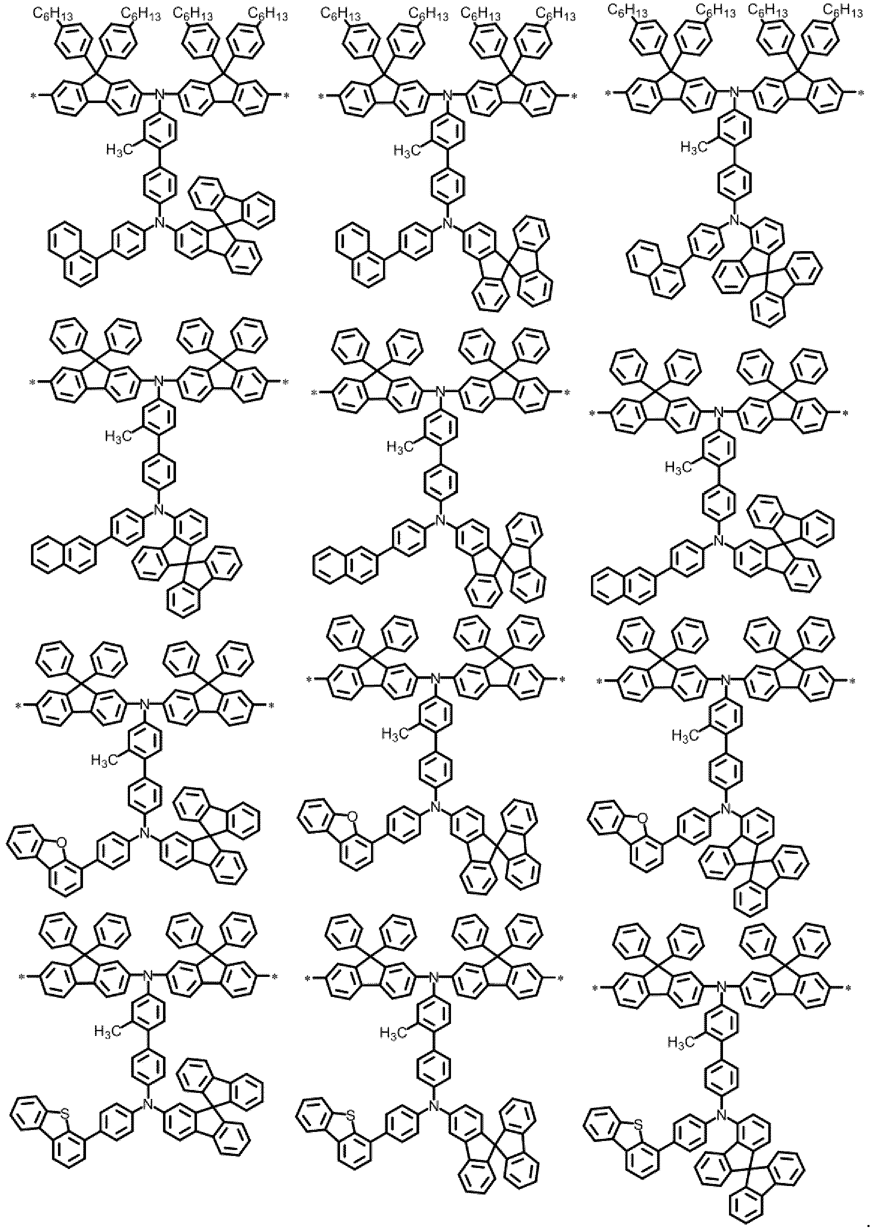

The copolymer further includes a structural unit represented by Chemical Formula 2 in addition to the structural unit represented by Chemical Formula 1:

Chemical Formula 2 *²-A⁴-*²

In Chemical Formula 2, A⁴ is a substituted or unsubstituted aromatic ring group having 6 to 60 ring-forming atoms, or a substituted or unsubstituted heteroaromatic ring group having 3 to 60 ring-forming atoms. Here, the aromatic ring group having 6 to 60 carbon atoms is not particularly limited, and non-limiting examples thereof include groups derived from an aromatic ring compound such as benzene (phenylene group), pentacene, indene, naphthalene, anthracene, azulene, heptacene, acenaphthene, phenalene, fluorene, phenanthrene, biphenyl, terphenyl, quaterphenyl, quinquephenyl, pyrene, 9,9-diphenylfluorene, 9,9'-spirobi[fluorene], 9,9-dialkylfluorene, or the like. The divalent heteroaromatic ring group having 3 to 60 ring-forming atoms is not particularly limited, and non-limiting examples thereof include groups derived from a heteroaromatic ring compound such as acridine, phenazine, benzoquinoline, benzoisoquinoline, phenanthridine, phenanthroline, dibenzofuran, dibenzothiophene, carbazole, imidazophenanthridine, benzimidazophenanthridine, azadibenzofuran, 9-phenylcarbazole, azacarbazole, azadibenzothiophene, diazadibenzofuran, diazacarbazole, diazadibenzothiophene, xanthone, thioxanthone, pyridine, quinoline, anthraquinoline, or the like. A⁴ may be one aromatic ring group as described above, or a structure including two or more aromatic ring groups as described above, a structure including one heteroaromatic ring group as described above, a structure including two or more heteroaromatic ring groups as described above, or a structure including a combination of one or more aromatic ring groups as described above and one or more heteroaromatic ring groups as described above.

Among these, from the viewpoint of a more appropriate HOMO level, A⁴ may be a group derived from a compound that is, for example, substituted or unsubstituted benzene, substituted or unsubstituted dibenzofuran, or substituted or unsubstituted fluorene. For example, A⁴ may be a group derived from a compound that is substituted or unsubstituted benzene, or substituted or unsubstituted fluorene, or, for example, a group derived from substituted or unsubstituted fluorene.

In Chemical Formula 2, *² is a bonding position with another atom.

For example, the structural unit (2) according to an embodiment may be selected from the structures shown in Group 4. In the structure below, *² is a bonding position with another atom. That is, *2 is a binding site that forms the main chain.

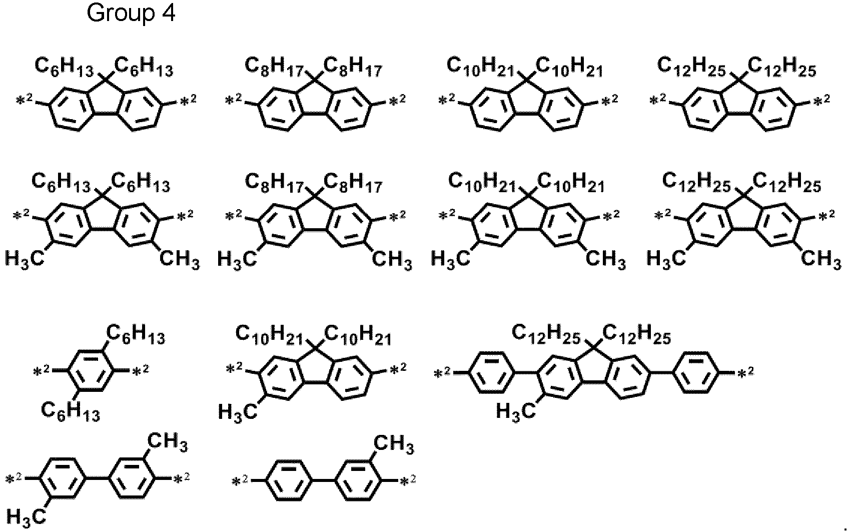

In some embodiments the structural unit represented by Chemical Formula 2 may include a structural unit represented by Chemical Formula 2'. As used herein, the structural unit represented by Chemical Formula 2' is simply referred to as "structural unit (2')" or "structural unit (2') according to an embodiment."

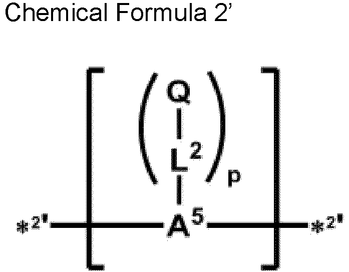

In Chemical Formula 2', A⁵ is a substituted or unsubstituted aromatic ring group having 6 to 60 ring-forming atoms, or a substituted or unsubstituted heteroaromatic ring group having 3 to 60 ring-forming atoms; L² is a single bond, a substituted or unsubstituted alkylene group having 1 to 30 carbon atoms, or a substituted or unsubstituted aromatic ring group having 6 to 30 ring-forming atoms; Q is a crosslinkable group; p is an integer greater than or equal to 1, and *^{2'} is a binding site that forms the main chain.

As used herein, the term "substitutable number" means a number that can be bonded with a group having a different structure. For example, if A⁵ is a phenylene group that has no substituents other than "*^{a3}-L²-Q" (*^{a3} is a bonding position with another atom), then among the six substitution positions where substituents can be introduced on the benzene ring, two are bonded to the main chain, and thus the number of possible substitutions is 4. In addition, when A⁵ is a fluorenediyl group that does not have a substituent other than "*^{a3}-L²-Q" (*^{a3} is a bonding position with another atom), among the 10 substitution positions where a substituent of the fluorene ring can be introduced, 2 are bonded to the main chain, and thus the possible number of substitutions is 8.

Since the structural unit (2') has a crosslinkable group, a copolymer having the structural unit (2') may easily form a film. The copolymer of the embodiment may include one type of structural unit (2') among the structural units (2), or may include two or more types of structural units (2'). In addition, among the structural units (2), the structural unit (2') may not be included, only structural unit (2') may be included, or both the structural unit (2') and the structural unit not including a crosslinkable group may be included.

In Chemical Formula 2', A⁵ may represent a substituted or unsubstituted aromatic ring group having 6 to 60 ring-forming atoms, or a substituted or unsubstituted heteroaromatic ring group having 3 to 60 ring-forming atoms. Here, "aromatic ring group having 6 to 60 ring-forming atoms" and "heteroaromatic ring group having 3 to 60 ring-forming atoms" have the same definitions as "aromatic ring group having 6 to 60 ring-forming atoms" and "heteroaromatic ring group having 3 to 60 ring atoms" in A⁴ of Chemical Formula 2, and therefore, explanation is omitted here. Among these, considering the ease of film formation by the obtained copolymer, the effect of improving film strength, and the like, A⁵ may be a group derived from a compound that is fluorene or benzene, and for example, may be a group derived from fluorene. That is, in an embodiment, A⁵ may be a fluorenediyl group and/or a phenylene group. Additionally, in another embodiment, A⁵ may be a fluorenediyl group. In another embodiment, A⁵ is a fluorenediyl group, and the fluorenediyl group as A⁵ may be at least one of the groups represented by Group 5. In Group 5, Z¹ and Z² are groups represented by "*^{a3}-L²-Q" (*^{a3} is a bonding position with another atom), and they may be the same or different. Additionally, among Group 5, *^{2'} is a binding site that forms the main chain.

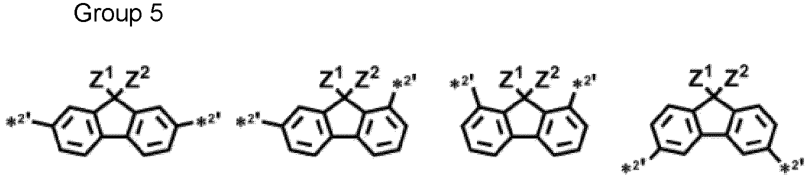

Among the structures of Group 5, the fluorenediyl group may have a structure in which the 2nd and 7th positions may be, for example bonded to the main chain:

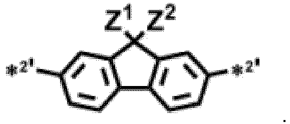

In Chemical Formula 2', L² may be a single bond, a substituted or unsubstituted alkylene group having 1 to 30 carbon atoms, or a substituted or unsubstituted aromatic ring group having 6 to 30 ring-forming atoms. Here, when there are a plurality of L² groups, that is, when p is an integer greater than or equal to 2, the plurality of L² groups may be the same or different.

An alkylene group having 1 to 30 carbon atoms may be a linear or a branched alkylene group. Among these, L² is not particularly limited, but may be a linear or a branched alkylene group having 1 to 8 carbon atoms. For example, a methylene group, an ethylene group, a trimethylene group, a propylene group, or the like may be exemplified. In an embodiment, L² may be an ethylene group.

In addition, considering the ease of film formation of the obtained copolymer, the effect of improving film strength, and the like, L² may be a single bond, or a linear or branched alkylene group having 1 to 8 carbon atoms, or may be a single bond, or a linear or branched alkylene group having 1 to 6 carbon atoms.

In Chemical Formula 2', Q represents a crosslinkable group. Here, if there are a plurality of Qs, that is, if p is an integer greater than or equal to 2, the plurality of Qs may be the same or different. The crosslinkable group Q is not particularly limited as long as it is a group capable of inducing a crosslinking reaction by heat or an active energy ray. However, considering the ease of film formation of the obtained copolymer, the effect of improving film strength, etc., it may be one of Group 6:

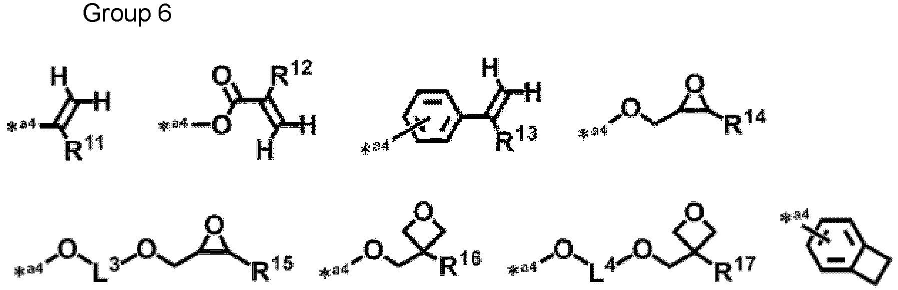

In Group 6, R¹¹ to R¹⁷ may each independently be hydrogen atom or a substituted or unsubstituted alkyl group having 1 to 10 carbon atoms, L³ and L⁴ may each independently be *^{a5}-(CH₂)_{q}-*^{a5} (wherein q is an integer of 1 to 10, and *^{a5} may be a bonding position with another atom), and *^{a4} may be a bonding position with another atom.

Here, the alkyl group having 1 to 10 carbon atoms is not particularly limited, but may be a linear or branch group having 1 to 10 carbon atoms. Non-limiting examples of the alkyl group include a methyl group, an ethyl group, a n-propyl group, an isopropyl group, a n-butyl group, an isobutyl group, a sec-butyl group, a tert-butyl group, a n-pentyl group, an isopentyl group, a tert-pentyl group, a neopentyl group, a 1,2-dimethylpropyl group, a n-hexyl group, an isohexyl group, a 1,3-dimethylbutyl group, a 1-isopropylpropyl group, a 1,2-dimethylbutyl group, a n-heptyl group, a 1,4-dimethylpentyl group, a 3-ethylpentyl group, a 2-methyl-1-isopropylpropyl group, a 1-ethyl-3-methylbutyl group, a n-octyl group, a 2-ethylhexyl group, a 3-methyl-1-isopropylbutyl group, a 2-methyl-1-isopropylbutyl group, a 1-tert-butyl-2-methylpropyl group, a n-nonyl group, a 3,5,5-trimethylhexyl group, a n-decyl group, or the like. Among these, R¹¹ to R¹⁷ may each independently be a hydrogen atom, or a linear or branched alkyl group having 1 to 5 carbon atoms, for example, a hydrogen atom, or a linear or branched alkyl group having 1 to 3 carbon atoms, for example, a hydrogen atom. Additionally, q may be an integer greater than or equal to 1, and less than or equal to 10.

Among these, considering the crosslinking reactivity (ease of crosslinking, ease of film formation, and the like), the stability of the crosslinking structure, the electrochemical stability, and the like, Q in Chemical Formula 2' may be a group derived from a benzocyclobutene ring of the structure below (bicyclo[4.2.0]octa-1,3,5-trienyl group), or a vinyl group (*^{a4}-CH=CH₂, where *^{a4} is a bonding position with another atom). In addition, from the viewpoint of crosslinking reactivity (ease of crosslinking), and the like, Q may be a cyclic ether group such as an epoxy group or an oxetane group, or a vinyl ether group.

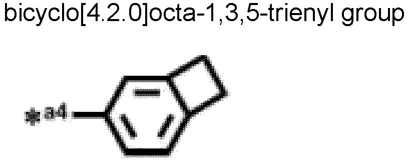

In Chemical Formula 2', p is an integer greater than or equal to 1, and its range is defined by A⁵ as described above. p is not particularly limited, and may be an integer greater than or equal to 1 and less than or equal to 3, for example, 1 or 2, for example, 2.

Additionally, in an embodiment, the copolymer may include a structural unit represented by Chemical Formula 4.

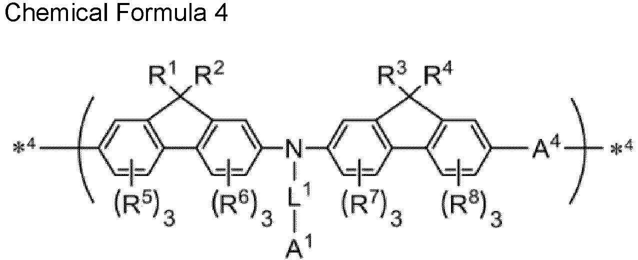

In Chemical Formula 4, R¹, R², R³, R⁴, R⁵, R⁶, R⁷, and R⁸, L¹, A¹, and A⁴ have the same meanings as defined in Chemical Formula 1 and Chemical Formula 2, respectively. Also, *⁴ is the bonding position with another atom.

The copolymer of the embodiment may include the structural unit represented by Chemical Formula 4 as a repeating unit. When the structural unit represented by Chemical Formula 4 is used as a repeating unit, the copolymer according to an embodiment may be in the form of an alternating copolymer in which the structural unit represented by Chemical Formula 1 and the structural unit represented by Chemical Formula 2 exist alternately. The copolymer of the embodiment may include, for example, the repeating unit represented by Chemical Formula 4. In an embodiment, the copolymer of the embodiment may be composed of the repeating units represented by Chemical Formula 4.

In some embodiments, the structural unit (4) may include a structural unit (repeating unit) selected from the structural units shown in Group 7. In the structure below, *⁴ is a bonding position with another atom. That is, *⁴ is a binding site that forms the main chain.

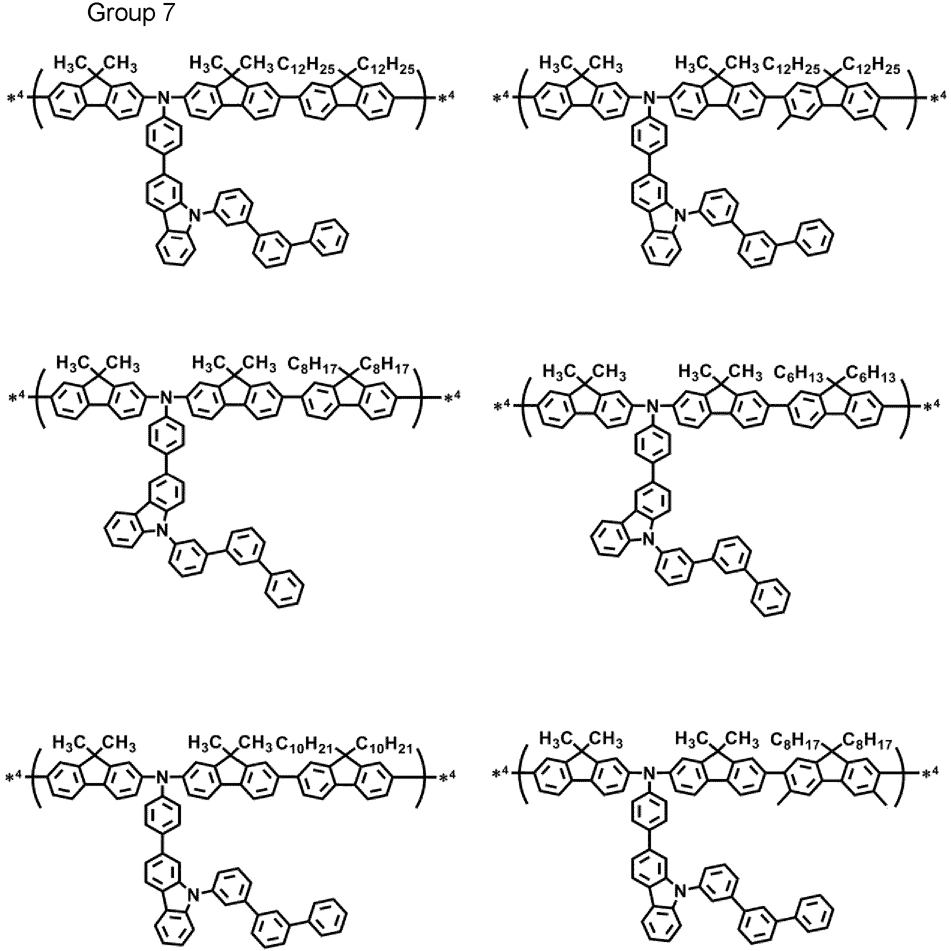

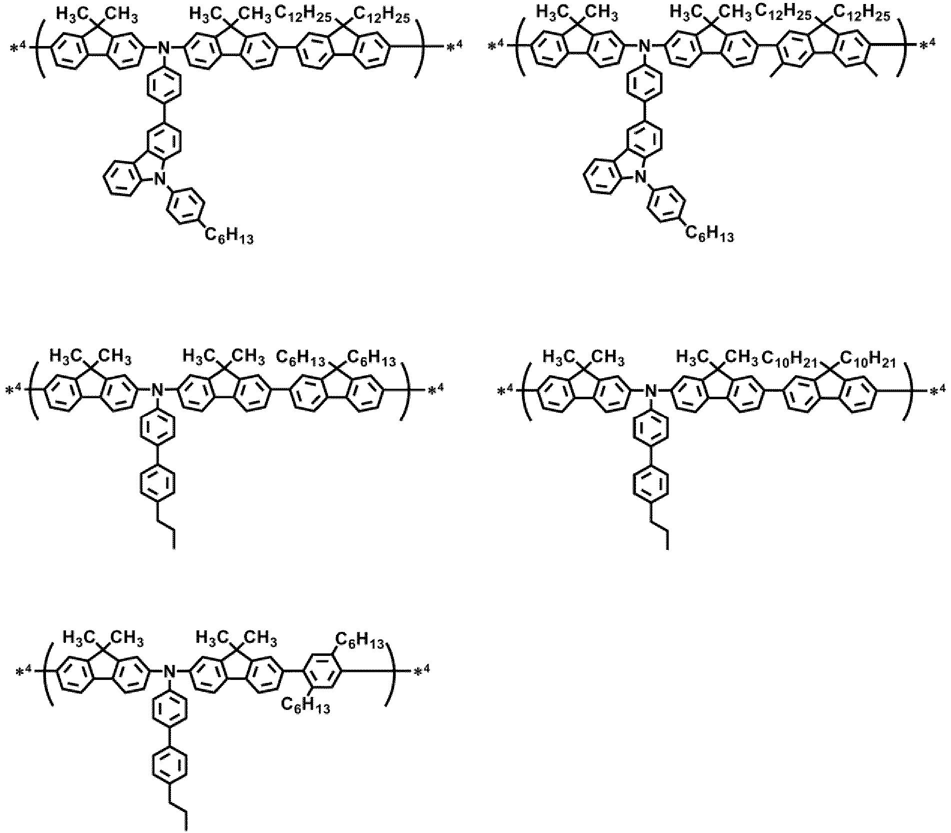

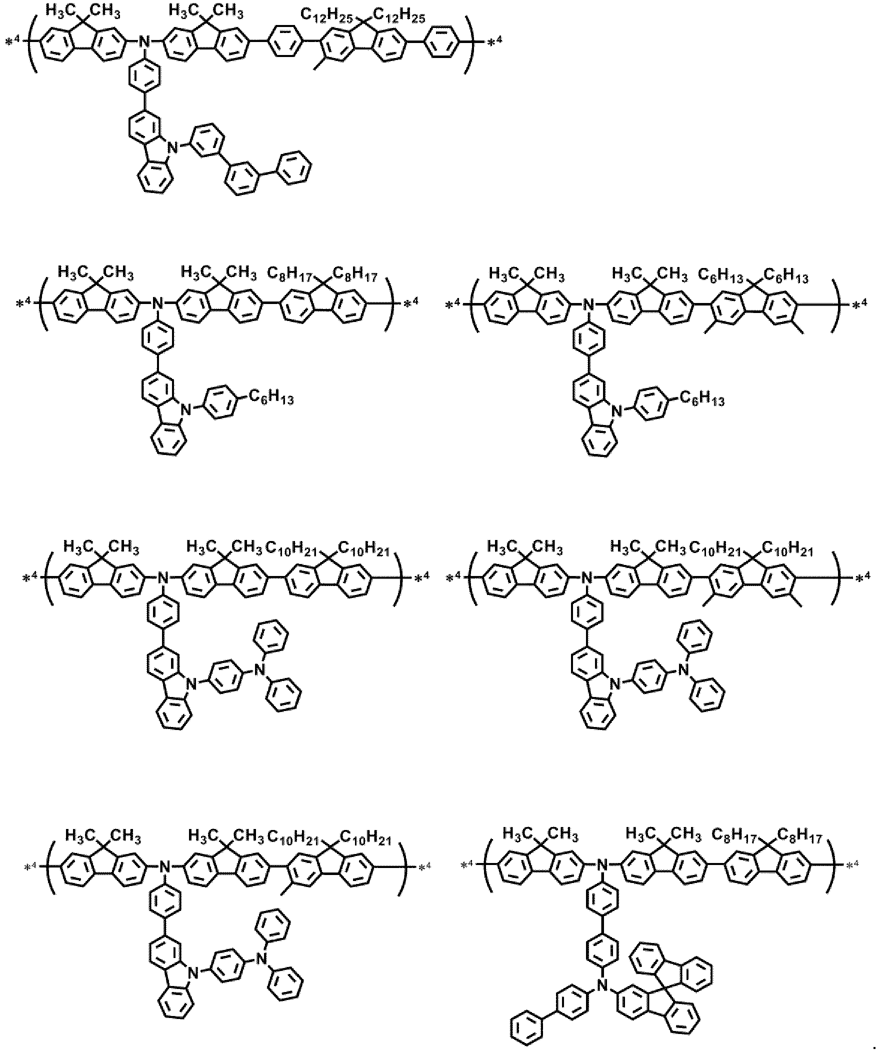

A weight average molecular weight (Mw) of the copolymer is not particularly limited, as long as the intended effect is obtained. The weight average molecular weight (Mw) may be, for example, greater than or equal to about 5,000 Daltons (Da) and less than or equal to about 300,000 Da, greater than or equal to about 10,000 Da and less than or equal to about 250,000 Da, greater than or equal to about 20,000 Da and less than or equal to about 200,000 Da, or greater than or equal to about 40,000 Da and less than or equal to about 200,000 Da. With such a weight average molecular weight, by appropriately preparing a coating solution for forming a layer (e.g., a hole injection layer, a hole transport layer) using the copolymer, a layer having an almost uniform film thickness and good solvent resistance may be formed.

Additionally, a number average molecular weight (Mn) of the copolymer is not particularly limited. The number average molecular weight (Mn) may be, for example, greater than or equal to about 3,000 Da and less than or equal to about 100,000 Da. With such a number average molecular weight, a coating solution for forming a layer (e.g., a hole injection layer, a hole transport layer) using a copolymer may be appropriately prepared, and a layer having a uniform film thickness and good solvent resistance may be formed. Additionally, the polydispersity (weight average molecular weight/number average molecular weight) of the copolymer may be, for example, greater than or equal to about 1.2 and less than or equal to about 8.0.

Here, the measurement of the number average molecular weight (Mn) and the weight average molecular weight (Mw) is not particularly limited, and may be applied using any known method or by appropriately modifying a known method. As used herein, the number average molecular weight (Mn) and weight average molecular weight (Mw) values were measured by the following methods. The polydispersity (Mw/Mn) of the polymer was calculated by dividing the weight average molecular weight (Mw) by the number average molecular weight (Mn) measured by the following method.

Measurement of Number Average Molecular Weight (Mn) and Weight Average Molecular Weight (Mw)

The number average molecular weight (Mn) and weight average molecular weight (Mw) of the copolymer were measured by Size Exclusion Chromatography (SEC) using polystyrene as a standard material under the following conditions:
SEC Measurement Condition
Analysis equipment (SEC): Shimadzu Corporation, Prominence
Column: Polymer Laboratories, PLgel MIXED-B
Column temperature: 40 °C
Flow rate: 1.0 mL/min
Injection amount of sample solution: 20 µL (concentration of polymer: about 0.05 mass%)
Eluent: tetrahydrofuran (THF)
Detector (UV-VIS detector): Shimadzu Corporation, SPD-10AV
Standard sample: polystyrene.

The terminal end of the main chain of the copolymer according to an embodiment is not particularly limited and is appropriately defined depending on the type of raw material used, but is usually a hydrogen atom.

The copolymer may be synthesized using a known organic synthesis method or polymerization method. A specific synthesis method of a copolymer described herein can be readily understood by those of ordinary skill in the art and by referring to the examples described below. Specifically, the copolymer may be produced by a polymerization reaction using one or more monomers (X) represented by Chemical Formula X'. In addition, at this time, if necessary, it may be produced by a copolymerization reaction using one or more monomers (X) represented by Chemical Formula X' and other monomers corresponding to the other structural units.

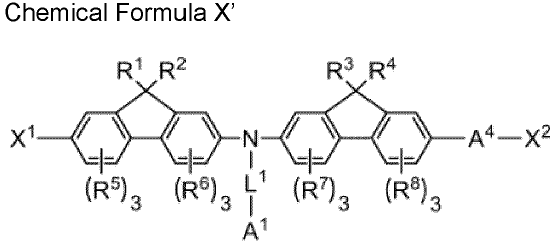

Alternatively, the copolymer may be produced by a polymerization reaction using at least one monomer (Y) represented by Chemical Formula Y' and at least one monomer (Z) represented by Chemical Formula Z'. In addition, at this time, if necessary, it may be produced by a copolymerization reaction using one or more monomers (Y) represented by Chemical Formula Y', one or more monomers (Z) represented by Chemical Formula Z', and other monomers corresponding to the other structural units.

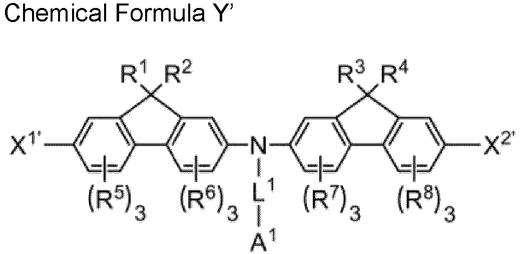

Chemical Formula Z' X^{1"}-A⁴-X^{2"}

The monomers used in the polymerization of the copolymer may be synthesized by appropriately combining known synthetic reactants, and their structures can also be confirmed by known methods (e.g., NMR, LC-MS, or the like).

In Chemical Formula X', Chemical Formula Y', and Chemical Formula Z', R¹, R², R³, R⁴, R⁵, R⁶, R⁷, and R⁸, L¹, A¹, and A⁴ have the same meanings as in Chemical Formula 1 and Chemical Formula 2, respectively. In addition, in Chemical Formula X', Chemical Formula Y', and Chemical Formula Z', X¹ and X², X^{1'} and X^{2'}, and X^{1"} and X^{2"} are each independently a halogen atom (a fluorine atom, a chlorine atom, a bromine atom, or an iodine atom, particularly a bromine atom), or a group represented by Chemical Formula W:

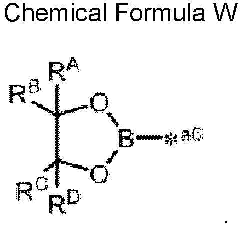

In Chemical Formula W, R^{A} to R^{D} may each independently be an alkyl group having 1 to 3 carbon atoms, and *^{a6} may be a bonding position with another atom. For example, R^{A} to R^{D} may each be a methyl group.

X¹ and X² in Chemical Formula X', X^{1'} and X^{2'} Chemical Formula Y', and X^{1"} and X^{2"} in Chemical Formula Z' may be the same or different, respectively. However, in order to prevent the monomers (Y) from polymerizing with each other, X^{1'} and X^{2'} in Chemical Formula Y' may be atoms or groups that do not react with each other. Similarly, to inhibit polymerization of monomers (Z), X^{1"} and X^{2"} in Chemical Formula Z' may be atoms or groups that do not react with each other. For example, X¹ and X² in Chemical Formula X' and X^{1'} and X^{2'} in Chemical Formula Y' may each be the same. Additionally, for example, X^{1"} and X^{2"} in Chemical Formula Z' may be different from each other.

The copolymer has a structural unit (1) and a structural unit (2). Because of this, the copolymer has a deep HOMO level. Therefore, when the copolymer is used as a hole injection material or a hole transport material, for example, a hole transport material, good luminous efficiency may be achieved.

The HOMO level of the copolymer may be greater than or equal to about -5.7 electron Volts (eV) and less than or equal to about -5.4 eV. In an electroluminescent device (e.g., a quantum dot electroluminescent device) that uses such a copolymer in a hole transport layer, the ability to transport holes from the hole injection layer to the light emitting layer (and therefore the durability (luminescence life-span)) may be improved. In this specification, the HOMO level adopts a value measured by the method described in the examples below.

The copolymer has a high resistance to solvents that are commonly used in coating solutions for forming a light emitting layer, i.e., the copolymer has a high solvent resistance. Non-limiting examples of the solvent used in forming the light emitting layer may include cyclohexane, hexane, octane, decane, tetradecane, hexadecane, indane, butanol, octanol, cyclohexylbenzene, dodecylbenzene, o-dichlorobenzene, or the like. Therefore, the copolymer has high resistance to solvents.

As used herein, the evaluation of the solvent resistance of the copolymer may be performed based on the film retention rate obtained by the following method:

### Solvent Resistance (Film Retention Rate)

The solvent resistance of the copolymer may be evaluated by the following method. That is, a copolymer may be dissolved in xylene, a solvent, at a concentration of 1 mass% to prepare a polymer coating solution. Next, the copolymer coating solution may be coated on a quartz substrate by spin coating, and then dried at 230°C for 30 minutes to form a film with a dry film thickness of 25 nm. Then, the absorption spectrum of the formed film (film before solvent immersion) may be measured using an ultraviolet-visible spectrophotometer (UV-1800, manufactured by Shimadzu Corporation). The wavelength of the peak on the longest wavelength side of the absorption spectrum may be measured and used as the reference wavelength.

Next, the same film on the quartz substrate (the film before solvent immersion) may be immersed in cyclohexylbenzene (CHB), a solvent, for 20 minutes, then taken out of the solvent and dried at 230 °C for 30 minutes. The absorption spectrum of the film after drying (film after solvent immersion) may be measured using an ultraviolet-visible spectrophotometer in the same manner as above. For this absorption spectrum, a ratio of the intensity at the reference wavelength of the absorption spectrum after immersion in the solvent to the intensity at the reference wavelength of the absorption spectrum before immersion in the solvent {("Intensity at the reference wavelength of the absorption spectrum after immersion in the solvent" / "Intensity at the reference wavelength of the absorption spectrum before immersion in the solvent") × 100 (%)} may be defined as the film retention rate (%) and may be determined for samples.

The film retention rate obtained by the method described above may be greater than or equal to about 80%, for example, greater than or equal to about 90%. If the film retention rate is approximately greater than or equal to about 80%, it is considered equivalent to the copolymer being insoluble in the solvent used to form the adjacent layer (having a high solvent resistance). If the above film retention rate is less than about 80%, mixing of the hole transport layer and the adjacent layer (especially the light emitting layer) may occur, which may deteriorate the performance of the electroluminescent device.

In addition, a glass transition temperature (Tg (°C)) of the copolymer according to an embodiment may be, for example, greater than or equal to about 100°C, greater than or equal to about 120°C, greater than or equal to about 150°C, greater than or equal to about 170°C, or greater than or equal to about 180°C. The upper limit of Tg is not specifically limited, but in practice it is, for example, about 250°C. And, the glass transition temperature may be measured using a differential scanning calorimeter (DSC), and more specifically, may be measured by the method described in the examples.

### Electroluminescent Device Material

The copolymer may be used, for example, as a material for an electroluminescent device to provide excellent durability (luminescence life-span). In addition, the copolymer provides a material for an electroluminescent device having an excellent luminous efficiency, a high triplet energy level (current efficiency), and a low driving voltage. In addition, the copolymer may exhibit a high solubility in a solvent and a high heat resistance. Therefore, a film can be readily formed (thinned) using a wet (coating) method using the copolymer as described herein. Accordingly, another aspect provides an electroluminescent device material including the copolymer as described herein. Alternatively, in another aspect, the copolymer as described herein may be used as a material for an electroluminescent device.

### Electroluminescent Device

As described above, the copolymer described herein may be used, for example, in an electroluminescent device. That is, an electroluminescent device includes a pair of electrodes and at least one layer of an organic film that is disposed between the electrodes. The organic film (organic layer) includes the copolymer (or the electroluminescent device material). Such electroluminescent devices may exhibit excellent durability (luminescence life-span). In addition, such electroluminescent devices may exhibit high luminous efficiency (especially good luminous efficiency at low driving voltages). Accordingly, another aspect provides an electroluminescent device that includes a first electrode, a second electrode, and at least one layer of an organic film that is disposed between the first electrode and the second electrode, wherein the at least one layer of the organic film includes the copolymer as described herein. The purpose (or effect) may also be achieved by an electroluminescent device according to this aspect. For example, the electroluminescent device may further include a light emitting layer disposed between the electrodes, and including a light emitting material capable of emitting light from triplet excitons. The electroluminescent device is an example of an electroluminescent device according to an embodiment, and is not limited.

Another aspect provides a method for manufacturing an electroluminescent device including a pair of electrodes and at least one layer of an organic film that is disposed between the pair of electrodes and including the copolymer as described herein, wherein the at least one layer of the organic film is formed by a coating method. This method provides an electroluminescent device in which at least one layer of the organic film is formed by a coating method.

The copolymer as described herein, and the electroluminescent device material (EL device material) as described herein (hereinafter collectively referred to as "copolymer/EL device material") have excellent solubility in organic solvents. Therefore, the copolymer/EL device material as described herein may be used, for example, in the manufacture of a device (e.g., a thin film) by a coating method (wet process). Accordingly, another aspect provides a (liquid) composition including the copolymer as described herein, and at least a solvent. Such a (liquid) composition is an example of a liquid composition as described herein.

In addition, the electroluminescent device material according to the above-described embodiment can be used, for example, in the manufacture of a device (particularly a thin film) by a coating method (using a wet process). In view of the above, another aspect provides a (thin) film including the copolymer as described herein. Such a (thin) film is an example of a thin film as described herein.

In addition, the EL device material as described herein has excellent hole injection properties and hole mobility. Due to this, the EL device material can also be used for the formation of another organic film, such as a hole injection material, a hole transport material, or a light emitting material (host). Among these, from the viewpoint of hole transportability, it may be used, for example, as a hole injection material or a hole transport material, and may be used, for example, as a hole transport material.

That is, a composition according to another embodiment may include the copolymer as described herein and at least one material that is a hole transport material, an electron transport material, or a light emitting material. Here, the luminescent material included in the composition is not particularly limited, but may include an organometallic complex (luminescent organometallic complex compound) or a semiconductor nanoparticle (semiconductor inorganic nanoparticle). That is, an electroluminescent device according to an embodiment may have a pair of electrodes, and at least one organic layer that includes the composition between the pair of electrodes. The electroluminescent device may further include, for example, a layer including quantum dots, and the quantum dots may provide an electroluminescent device that includes an inorganic nanoparticle.

Hereinafter, an electroluminescent device according to an embodiment will be described in further detail with reference to the FIGURE. The FIGURE is a schematic view showing an electroluminescent device according to an embodiment. As used herein, the term "electroluminescent device" is sometimes abbreviated as "EL device."

As shown in the FIGURE, the EL device 100 comprises a substrate 110, a first electrode 120 disposed on the substrate 110, a hole injection layer 130 disposed on the first electrode 120, a hole transport layer 140 disposed on the hole injection layer 130, an emitting layer 150 disposed on the hole transport layer 140, an electron transport layer 160 disposed on the emitting layer 150, an electron injection layer 170 disposed on the electron transport layer 160, and a second electrode 180 disposed on the electron injection layer 170.

The copolymer/EL device material as described herein may be included in, for example, an organic film (an organic layer) that is disposed between the first electrode 120 and the second electrode 180. For example, the copolymer/EL device material may be included in a hole injection layer 130 as a hole injection material, a hole transport layer 140 as a hole transport material, or a light-emitting layer 150 as a light emitting material (host). For example, the copolymer/EL device material may be included in the hole injection layer 130 as a hole injection material, or in the hole transport layer 140 as a hole transport material. The copolymer/EL device material may be included in the hole transport layer 140 as, for example, a hole transport material. That is, the electroluminescent device according to an embodiment may include an organic film including a copolymer/EL device material as described herein in a hole transport layer, a hole injection layer, or a light emitting layer. For example, an organic film including the copolymer as described herein is a hole transport layer or a hole injection layer. For example, an organic film including the copolymer as described herein is a hole transport layer.

In addition, the organic film including the copolymer/EL device material may be formed by a coating method (solution coating method). For example, the organic film may be formed using a solution coating method such as a spin coat method, a casting method, a micro gravure coat method, a gravure coat method, a bar coat method, a roll coat method, a wire bar coat method, a dip coat method, a spray coat method, a screen printing method, a flexographic printing method, an offset printing method, an ink jet printing method, or the like, or a combination thereof.

Any suitable solvent that can dissolve the copolymer/EL device material may be used as the solvent for the solution coating method, and can be appropriately selected depending on the type of copolymer used. Non-limiting examples thereof include toluene, xylene, ethylbenzene, diethylbenzene, mesitylene, propylbenzene, cyclohexylbenzene, dimethoxybenzene, anisole, ethoxytoluene, phenoxytoluene, isopropylbiphenyl, dimethylanisole, phenyl acetate, phenyl propionate, methyl benzoate, ethyl benzoate, or the like, or a combination thereof. Solvents used to form the light emitting layer include cyclohexane, hexane, octane, decane, tetradecane, hexadecane, indane, butanol, octanol, cyclohexylbenzene, dodecylbenzene, o-dichlorobenzene, or the like, or a combination thereof.

An amount of solvent used is not particularly limited, but considering ease of coating, and other factors, the concentration of the copolymer may be, for example, greater than or equal to about 0.1 mass% and less than or equal to about 10 mass%, for example, greater than or equal to about 0.5 mass% and less than or equal to about 5 mass%.

And, there is no particular limitation on the method for forming a film other than an organic film including a copolymer/EL device material. A layer other than an organic film including a copolymer/EL device material according to an embodiment may be formed by, for example, a vacuum deposition method or a solution coating method.

The substrate 110 may be any suitable substrate used in general EL devices. For example, the substrate 110 may be a semiconductor substrate such as a glass substrate, a silicon substrate, or a transparent plastic substrate.

The first electrode 120 is formed on the substrate 110. The first electrode 120 is, specifically, an anode and is formed of a metal, an alloy, a conductive compound, or the like having a large work function. For example, the first electrode 120 may be formed as a transparent electrode using indium tin oxide (In₂O₃-SnO₂, ITO), indium zinc oxide (In₂O₃, ZnO), tin oxide (SnO₂), zinc oxide (ZnO), or the like, which have excellent transparency and conductivity. Additionally, the first electrode 120 may be formed as a reflective electrode by laminating magnesium (Mg), aluminum (Al), silver (Ag), or the like on the transparent conductive film. Additionally, after forming the first electrode 120 on the substrate 110, if necessary, cleaning and UV-ozone treatment may be performed.

The hole injection layer 130 is formed on the first electrode 120. The hole injection layer 130 is a layer that facilitates the injection of holes from the first electrode 120, and specifically, may be formed to a thickness (dry film thickness; the same applies hereinafter) of about 10 nanometers (nm) to about 1000 nm, more specifically, about 20 nm to about 50 nm.

The hole injection layer 130 may be formed using a hole injection material. The hole injection materials for forming the hole injection layer 130 may include, for example, at least one of poly(ether ketone)-containing triphenylamine (TPAPEK), 4-isopropyl-4'-methyldiphenyliodonium tetrakis(pentafluorophenyl)borate (PPBI), N,N'-diphenyl-N,N'-bis-[4-(phenyl-m-tolyl-amino)-phenyl]-biphenyl-4,4'-diamine (DNTPD), copper phthalocyanine, 4,4',4"-tris(3-methylphenylphenylamino)triphenylamine (m-MTDATA), N,N'-di(1-naphthyl)-N,N'-diphenylbenzidine (NPB), 4,4',4"-tris(diphenylamino)triphenylamine (TDATA), 4,4',4"-tris(N,N-2-naphthylphenylamino)triphenylamine (2-TNATA), polyaniline/dodecylbenzenesulphonic acid, poly(3,4-ethylenedioxythiophene)/poly(4-styrenesulfonate): PEDOT/PSS, or polyaniline/10-camphorsulfonic acid, but embodiments are not limited thereto.

The hole transport layer 140 is formed on the hole injection layer 130. The hole transport layer 140 is a layer having a function of transporting holes, and may be formed with a thickness of, for example, about 10 nm to about 150 nm, for example, about 20 nm to about 50 nm. The hole transport layer 140 may be formed by a solution coating method using the copolymer as described herein. According to this method, the durability (luminescence life-span) of the EL device 100 may be extended. Additionally, it is also possible to improve the performance (luminous efficiency) of the EL device 100. Additionally, it is possible to improve the current efficiency of the EL device 100 and reduce the driving voltage. In addition, since the hole transport layer may be formed by a solution coating method, a large-area film may be efficiently formed.

However, when another organic film of the EL device 100 includes the copolymer as described herein, the hole transport layer 140 may be formed of a hole transport material. The hole transport materials may include, for example, at least one of a carbazole derivative such as 1,1-bis[(di-4-tolyl amino)phenyl]cyclohexane (TAPC), N-phenylcarbazole, and polyvinylcarbazole, N,N'-bis(3-methylphenyl)-N,N'-diphenyl-[1,1-biphenyl]-4,4'-diamine (TPD), 4,4',4"-tris(N-carbazolyl)triphenylamine (TCTA), or N,N'-di(1-naphthyl)-N,N'-diphenylbenzidine (NPB), but embodiments are not limited thereto.

The light emitting layer 150 is formed on the hole transport layer 140. The light emitting layer 150 is a layer that emits light by fluorescence, phosphorescence, or the like, and is formed using a vacuum deposition method, spin coating method, inkjet printing method, or the like. The light emitting layer 150 may be formed with a thickness of, for example, greater than or equal to about 10 nm and less than or equal to about 60 nm, for example, greater than or equal to about 20 nm and less than or equal to about 50 nm. As the light emitting material of the light emitting layer 150, any known light emitting material may be used. However, the light emitting material included in the light emitting layer 150 may be a light emitting material capable of light emission from triplet excitons (i.e., phosphorescence). In this case, the driving life-span of the EL device 100 may be further improved.

The light emitting layer 150 is not particularly limited and may have a known configuration. For example, the light emitting layer may include at least one of semiconductor nanoparticles or a perovskite-type compound. That is, in an embodiment, the organic film has an emitting layer including semiconductor nanoparticles or organometallic complexes. And, when the emitting layer includes semiconductor nanoparticles, the EL device is a quantum dot electroluminescent device (QLED), a quantum dot light emitting diode, or a quantum dot light emitting device. Additionally, when the emitting layer includes an organometallic complex, the EL device is an organic electroluminescent device (OLED).

In the form of a light emitting layer including semiconductor nanoparticles (QLED), the light emitting layer is a single layer or multiple layers of a plurality of semiconductor nanoparticles (a plurality of quantum dots). Here, semiconductor nanoparticles (quantum dots) are particles of a certain size that have a quantum confinement effect. The diameter of semiconductor nanoparticles (quantum dots) is not particularly limited, but is approximately greater than or equal to about 1 nm and less than or equal to about 10 nm.

The plurality of semiconductor nanoparticles (plurality of quantum dots) arranged in the light emitting layer may be synthesized by a wet chemical process, an organometallic chemical vapor deposition process, a molecular beam epitaxy process, or other similar processes. Among these, the wet chemical process is a method of growing particles by adding precursor materials to an organic solvent.

In a wet chemical process, when a crystal grows, an organic solvent is naturally distributed to the surface of the quantum dot crystal and acts as a dispersant, thereby controlling a growth of the crystal. Accordingly, in wet chemical processes, the growth of semiconductor nanocrystal particles may be controlled easily and at low cost compared to vapor deposition methods such as metal organic chemical vapor deposition (MOCVD) or molecular beam epitaxy (MBE).

Semiconductor nanoparticles (quantum dots) may control the energy band gap by controlling their size, so that light of various wavelengths can be obtained from the light emitting layer (quantum dot light emitting layer). Therefore, by using multiple quantum dots of different sizes, it is possible to create a display that emits light of multiple wavelengths. The size of the quantum dots may be selected to emit a red light, a green light, or a blue light, enabling color displays to be constructed. Additionally, the size of the quantum dots may be combined to emit white light or various colors.

As the semiconductor nanoparticles (quantum dots), a semiconductor material that is a Group II-VI semiconductor compound; a Group III-V semiconductor compound; a Group IV-VI group semiconductor compound; a Group IV element or compound; or a combination thereof may be used.

The Group II-VI semiconductor compound is not particularly limited, and examples thereof include a binary compound that is CdSe, CdTe, ZnS, ZnSe, ZnTe, ZnO, HgS, HgSe, HgTe, or a mixture thereof; a ternary compound that is CdSeS, CdSeTe, CdSTe, ZnSeS, ZnTeSe, ZnSTe, HgSeS, HgSeTe, HgSTe, CdZnS, CdZnSe, CdZnTe, CdHgS, CdHgSe, CdHgTe, HgZnS, HgZnSe, HgZnTe, or a mixture thereof; or a quaternary compound that is CdZnSeS, CdZnSeTe, CdZnSTe, CdHgSeS, CdHgSeTe, CdHgSTe, HgZnSeS, HgZnSeTe, HgZnSTe, or a mixture thereof.

The Group III-V semiconductor compound is not particularly limited, and examples thereof include a binary compound that is GaN, GaP, GaAs, GaSb, AIN, AlP, AlAs, AlSb, InN, InP, InAs, InSb, or a mixture thereof; a ternary compound that is GaNP, GaNAs, GaNSb, GaPAs, GaPSb, AINP, AlNAs, AlNSb, AlPAs, AlPSb, InNP, InNAs, InNSb, InPAs, InPSb, or a mixture thereof; or a quaternary compound that is GaAlNP, GaAINAs, GaAINSb, GaAlPAs, GaAlPSb, GaInNP, GaInNAs, GaInNSb, GaInPAs, GaInPSb, InAlNP, InAINAs, InAINSb, InAlPAs, InAlPSb, or a mixture thereof.

The Group IV-VI semiconductor compound is not particularly limited, and examples thereof include a binary compound that is SnS, SnSe, SnTe, PbS, PbSe, PbTe, or a mixture thereof; a ternary compound that is SnSeS, SnSeTe, SnSTe, PbSeS, PbSeTe, PbSTe, SnPbS, SnPbSe, SnPbTe, or a mixture thereof; or a quaternary compound that is SnPbSSe, SnPbSeTe, SnPbSTe, or a mixture thereof.

The Group IV element or compound is not particularly limited, and examples thereof include a single element that is Si, Ge, or a mixture thereof; or a binary elemental compound that is SiC, SiGe, or a mixture thereof.

The semiconductor nanoparticles (quantum dots) can have a homogeneous single structure or a core-shell dual structure. The core and shell may include different materials. The material constituting each core and shell may be composed of a different semiconductor compound. However, the energy bandgap of the shell material is larger than the energy bandgap of the core material. For example, the structures may be ZnTeSe/ZnSe/ZnS, InP/ZnSe/ZnS, CdSe/ZnS, InP/ZnS, or the like.

For example, a process of producing a quantum dot having a core (CdSe)/shell (ZnS) structure is described. First, a core (CdSe) precursor material such as (CH₃)₂Cd (dimethylcadmium) and TOPSe (trioctylphosphine selenide) are injected into an organic solvent using TOPO (trioctylphosphine oxide) as a surfactant to form a crystal. At this time, after maintaining the crystal at a high temperature for a certain period of time so that it grows to a certain size, a precursor material for the shell (ZnS) is injected to form a shell on the surface of the already formed core. This allows the production of TOPO-capped CdSe/ZnS quantum dots.

In addition, in the form (OLED) in which the light emitting layer includes an organometallic complex, the light emitting layer 150 may include, as a host material, for example, at least one of 6,9-diphenyl-9'-(5'-phenyl-[1,1':3',1"-terphenyl]-3-yl)3,3'-bi[9H-carbazole], 3,9-diphenyl-5-(3-(4-phenyl-6-(5'-phenyl-[1,1':3',1"-terphenyl]-3-yl)-1,3,5,-triazin-2-yl)phenyl)-9H-carbazole, 9,9'-diphenyl-3,3'-bi[9H-carbazole], tris(8-quinolinato)aluminium (Alq₃), 4,4'-bis(carbazol-9-yl)biphenyl (CBP), poly(N-vinyl carbazole) (PVK), 9,10-di(naphthalene)anthracene (AND), 4,4',4\"-tris(N-carbazolyl)triphenylamine (TCTA), 1,3,5-tris(N-phenyl-benzimidazol-2-yl)benzene (TPBI), 3-tert-butyl-9,10-di(naphth-2-yl)anthracene (TBADN), distyrylarylene (DSA), 4,4'-bis(9-carbazole)2,2'-dimethyl-bipheny (dmCBP), or the like, but embodiments are not limited thereto.

In addition, the light emitting layer 150 may include, as a dopant material, for example, perylene or a derivative thereof, rubrene or a derivative thereof, coumarin or a derivative thereof, 4-dicyanomethylene-2-(dimethylaminostyryl)-6-methyl-4H-pyran (DCM) or a derivative thereof, an iridium (Ir) complex such as bis[2-(4,6-difluorophenyl)pyridinate]picolinate iridium(III) (FIrpic), bis(1-phenylisoquinoline)(acetylacetonate)iridium(III) (Ir(piq)₂(acac)), tris(2-phenylpyridine)iridium(III) (Ir(ppy)₃), or fac-tris(2-(3-p-xylyl)phenyl) pyridine iridium (III), an osmium (Os) complex, a platinum (Pt) complex, or the like, but embodiments are not limited thereto. Among these, the light emitting material may be a luminescent organometallic complex compound.

The method for forming the light emitting layer is not particularly limited. The light emitting layer can be formed by coating a coating solution including semiconductor nanoparticles or an organometallic complex (solution coating method). Currently, as a solvent constituting the coating solution, it is desirable to select a solvent that does not dissolve the material (hole transport material, particularly the copolymer) in the hole transport layer.

The electron transport layer 160 is formed on the light emitting layer 150. The electron transport layer 160 is a layer that has the function of transporting electrons and is formed using a vacuum deposition method, spin coating method, inkjet method, or the like. The electron transport layer 160 may be formed to a thickness of, for example, greater than or equal to about 15 nm and less than or equal to about 50 nm.

The electron transport layer 160 may be formed of an electron transport material. Non-limiting examples of electron transport materials include at least one of (8-quinolinolato)lithium (lithium quinolate, Liq), tris(8-quinolinolato)aluminium (Alq₃), or a compound having a nitrogen-containing aromatic ring, but embodiments are not limited thereto. Non-limiting examples of the compound having a nitrogen-containing aromatic ring may include a compound including a pyridine ring, such as 1,3,5-tri[(3-pyridyl)-phen-3-yl]benzene, a compound including a triazine ring, such as 2,4,6-tris(3'-(pyridin-3-yl)biphenyl-3-yl)-1,3,5-triazine, or a compound including an imidazole ring, such as 2-(4-(N-phenylbenzoimidazolyl-1-yl-phenyl)-9,10-dinaphthylanthracene or 1,3,5-tris(N-phenyl-benzimidazol-2-yl)benzene (TPBI). The electron transport material may be used alone or as a mixture of two or more types.

The electron injection layer 170 is formed on the electron transport layer 160. The electron injection layer 170 is a layer that has the function of facilitating the injection of electrons from the second electrode 180. The electron injection layer 170 is formed using a vacuum deposition method or the like. The electron injection layer 170 may be formed to a thickness of greater than or equal to about 0.1 nm and less than or equal to about 5 nm, for example greater than or equal to about 0.3 nm and less than or equal to about 2 nm. Any suitable material may be used as a material for forming the electron injection layer 170. For example, the electron injection layer 170 may be formed by a compound such as (8-quinolinato)lithium (lithium quinolate, Liq), lithium fluoride (LiF), sodium chloride (NaCl), cesium fluoride (CsF), lithium oxide (Li₂O), or barium oxide (BaO), but embodiments are not limited thereto.

The second electrode 180 is formed on the electron injection layer 170. The second electrode 180 is formed using a vacuum deposition method or the like. The second electrode 180 may be, specifically, a cathode and may be formed of a metal, an alloy, or a conductive compound having a small work function. For example, the second electrode 180 may be formed as a reflective electrode using a metal such as lithium (Li), magnesium (Mg), aluminum (Al), silver (Ag), calcium (Ca), or an alloy such as aluminum-lithium (Al-Li), magnesium-indium (Mg-In), or magnesium-silver (Mg-Ag). The second electrode 180 may be formed with a thickness of greater than or equal to about 10 nm and less than or equal to about 200 nm, for example, greater than or equal to about 50 nm and less than or equal to about 150 nm. Alternatively, the second electrode 180 may be formed as a transparent electrode by a thin film of the metal material having a thickness of 20 nm or less, a transparent conductive film such as indium tin oxide (In₂O₃-SnO₂) or indium zinc oxide (In₂O₃-ZnO).

As described above, as an example of an electroluminescent device as described herein, an EL device 100 according to the present embodiment has been described. The EL device 100 according to the present embodiment can further improve durability (luminescence life-span) by including an organic film (particularly a hole transport layer or a hole injection layer) including a copolymer as described herein. In addition, the luminous efficiency (current efficiency) may be further improved and the driving voltage may be reduced.

The stacked structure of the EL device 100 is not limited to the above example. The EL device 100 may be formed by another known stacked structure. For example, the EL device 100 may omit one or more of the hole injection layer 130, the hole transport layer 140, the electron transport layer 160, and/or the electron injection layer 170, and may additionally include other layers. Additionally, each layer of the EL device 100 may be formed as a single layer or as multiple layers.

For example, the EL device 100 may further include a hole blocking layer between the electron transport layer 160 and the light emitting layer 150 to prevent holes from diffusing into the electron transport layer 160. And, the hole blocking layer may be formed by, for example, an oxadiazole derivative, a triazole derivative, a phenanthroline derivative, or the like.

In addition, the copolymer as described herein may be applied to electroluminescent devices other than the QLED or OLED. Other electroluminescent devices to which the copolymer as described herein can be applied include, but are not particularly limited to, organic-inorganic perovskite light-emitting devices.

The present disclosure is exemplified by the following non-limiting aspects.

Aspect 1. A copolymer comprising a structural unit represented by Chemical Formula 1, and a structural unit represented by Chemical Formula 2: 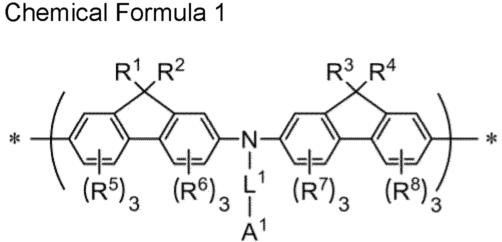 wherein, in Chemical Formula 1,
A¹ is a substituted or unsubstituted aromatic ring group having 6 to 60 ring-forming atoms, a substituted or unsubstituted heteroaromatic ring group having 3 to 60 ring-forming atoms, or a group represented by Chemical Formula 3,
L¹ is a single bond, or a substituted or unsubstituted aromatic ring group having 6 to 60 ring-forming atoms,
R¹ to R⁴ are each independently a substituted or unsubstituted aromatic ring group having 6 to 30 ring-forming atoms, a substituted or unsubstituted alkyl group having 1 to 30 carbon atoms, or a substituted or unsubstituted ethylene glycol group or oligoethylene glycol group having 2 to 30 carbon atoms,
wherein, R¹ and R² are optionally bonded with each other to form a ring, or R³ and R⁴ are optionally bonded with each other to form a ring,
R⁵ to R⁸ are each independently a hydrogen atom, or a substituted or unsubstituted alkyl group having 1 to 30 carbon atoms, and
* is a bonding position with another atom, 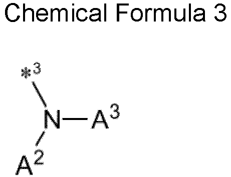
wherein, in Chemical Formula 3,
A² and A³ are each independently a substituted or unsubstituted aromatic ring group having 6 to 30 ring-forming atoms, or a substituted or unsubstituted heteroaromatic ring group having 3 to 30 ring-forming atoms, and
*³ is a bonding position with another atom,

   Chemical Formula 2 *²-A⁴-*²
wherein, in Chemical Formula 2,
A⁴ is a substituted or unsubstituted aromatic ring group having 6 to 60 ring-forming atoms, or a substituted or unsubstituted heteroaromatic ring group having 3 to 60 ring-forming atoms, and
*² is a bonding position with another atom.

Aspect 2. The copolymer described in Aspect 1, comprising a structural unit represented by Chemical Formula 4: 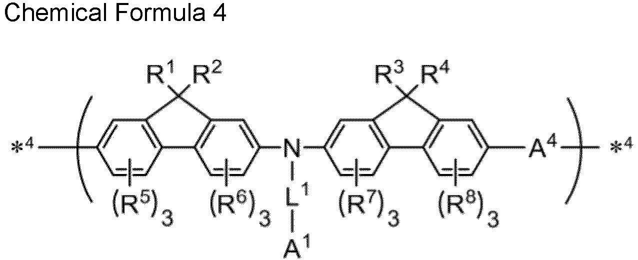 wherein, in Chemical Formula 4,
A¹ is a substituted or unsubstituted aromatic ring group having 6 to 60 ring-forming atoms, a substituted or unsubstituted heteroaromatic ring group having 3 to 60 ring-forming atoms, or a group represented by Chemical Formula 3,
L¹ is a single bond, or a substituted or unsubstituted aromatic ring group having 6 to 60 ring-forming atoms,
R¹ to R⁴ are each independently a substituted or unsubstituted aromatic ring group having 6 to 30 ring-forming atoms, a substituted or unsubstituted alkyl group having 1 to 30 carbon atoms, or a substituted or unsubstituted ethylene glycol group or oligoethylene glycol group having 2 to 30 carbon atoms,
wherein, R¹ and R² are optionally bonded with each other to form a ring, or R³ and R⁴ are optionally bonded with each other to form a ring,
R⁵ to R⁸ are each independently a hydrogen atom, or a substituted or unsubstituted alkyl group having 1 to 30 carbon atoms,
A⁴ is a substituted or unsubstituted aromatic ring group having 6 to 60 ring-forming atoms, or a substituted or unsubstituted heteroaromatic ring group having 3 to 60 ring-forming atoms, and
*⁴ is a bonding position with another atom.

Aspect 3. The copolymer described in Aspect 1 or 2, wherein in Chemical Formula 1, wherein L¹ is a group represented by Chemical Formula 5 or Chemical Formula 6: 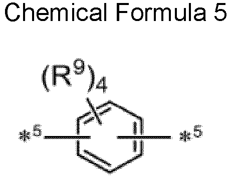 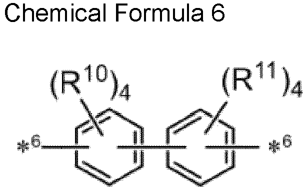 wherein, in Chemical Formula 5 and Chemical Formula 6,
R⁹ to R¹¹ are each independently a hydrogen atom, a substituted or unsubstituted aromatic ring group having 6 to 30 ring-forming atoms, or a substituted or unsubstituted alkyl group having 1 to 30 carbon atoms, and
*⁵ and *⁶ are a bonding position with another atom.

Aspect 4. The copolymer described in any one of Aspects 1 to 3, wherein A¹ is a group represented by Chemical Formula 7: 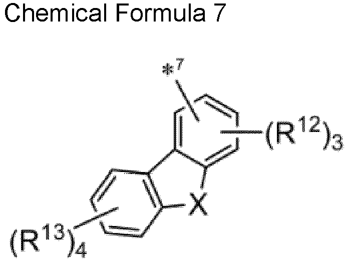 wherein, in Chemical Formula 7,
R¹² and R¹³ are each independently a hydrogen atom, a substituted or unsubstituted aromatic ring group having 6 to 30 ring-forming atoms, or a substituted or unsubstituted alkyl group having 1 to 30 carbon atoms,
X represents *'-C(R¹⁴)(R¹⁵)-*', *'-N(R¹⁶)-*', *'-O-*', or *'-S-*',
wherein R¹⁴ and R¹⁵ are each independently a substituted or unsubstituted aromatic ring group having 6 to 30 carbon atoms, or a substituted or unsubstituted alkyl group having 1 to 30 carbon atoms, or R¹⁴ and R¹⁵ are optionally bonded to each other to form a ring structure,
R¹⁶ is a substituted or unsubstituted aromatic ring group having 6 to 30 ring-forming atoms, or a substituted or unsubstituted alkyl group having 1 to 30 carbon atoms,
*' is a bonding position with another atom, and
*⁷ is a bonding position with another atom.

Aspect 5. The copolymer described in any one of Aspects 1 to 3, wherein A¹ is the group represented by Chemical Formula 3.

Aspect 6. A composition comprising the copolymer described in any one of Aspects 1 to 5, and at least one material that is a hole transport material, an electron transport material, or a light emitting material.

Aspect 7. A liquid composition comprising the copolymer as described in any one of Aspects 1 to 5, and at least one solvent.

Aspect 8. An electroluminescent device comprising a pair of electrodes, and at least one organic layer comprising the copolymer described in any one of Aspects 1 to 5, wherein the at least one organic layer is disposed between the pair of electrodes.

Aspect 9. An electroluminescent device comprising a pair of electrodes, and at least one organic layer comprising the composition described in Aspect 6 disposed between the pair of electrodes.

Aspect 10. The electroluminescent device described in Aspect 8 or 9, further comprising a layer comprising a plurality of quantum dots, wherein the plurality of quantum dots are inorganic nanoparticles.

### EXAMPLES

The present subject matter is described in further detail using the following examples and comparative examples. However, the technical range is not limited to the following examples. In the following examples, unless specifically described, each operation was performed at room temperature (25 °C). In addition, unless specifically stated, "%" and "a part" mean "mass%" and "a part by mass", respectively. Additionally, in the examples below, "copolymer" is also called "polymer compound."

Synthesis of Fluorene Compounds

### Synthesis Example 1: Synthesis of Compound 1

### Synthesis of Intermediate 1-1

Intermediate 1-1 was synthesized according to Reaction Scheme 1-1.

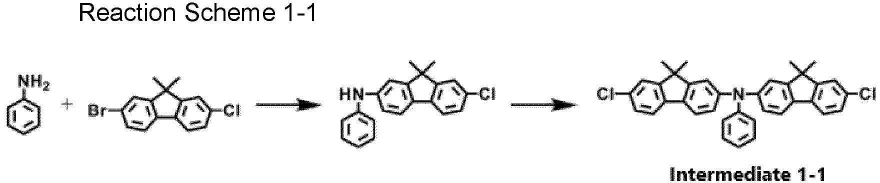

Under an argon atmosphere, aniline (15.0 grams (g), 161.0 millimoles (mmol)), 2-bromo-5-chloro-9,9-dimethylfluorene (48.5 g, 157.8 mmol), sodium t-butoxide (tBuONa) (18.6 g, 193.3 mmol), and toluene (300 mL) were added to a reaction vessel, and stirred for 30 minutes. Subsequently, [1,1'-bis(diphenylphosphino)ferrocene]dichloropalladium(II) (PdCl₂(dppf)) (0.707 g, 0.97 mmol) was added thereto, and stirred under reflux for 5 hours. The reaction mixture was cooled to room temperature. Subsequently, the reaction mixture was filtered by using Celite^{™} to filter and separate impurities. This reaction solution was used as is in the following reaction.

Under an argon atmosphere, the reaction solution, 2-bromo-5-chloro-9,9-dimethylfluorene (49.5 g, 161.0 mmol), and tBuONa (18.6 g, 193.3 mmol) were added to a reaction vessel, and stirred for 30 minutes. Subsequently, [1,1'-bis(diphenylphosphino)ferrocene]dichloropalladium(II) (PdCl₂(dppf)) (0.707 g, 0.97 mmol) was added thereto, and stirred under reflux for 6 hours. The reaction mixture was cooled to room temperature. Subsequently, the reaction mixture was filtered using Celite^{™} to filter and separate impurities. The obtained filtrate, from which the solvent was removed under reduced pressure, was purified by column chromatography to obtain a solid of Intermediate 1-1 (77.2 g, Yield: 88%).

### Synthesis of Intermediate 1-2

Intermediate 1-2 was synthesized according to Reaction Scheme 1-2.

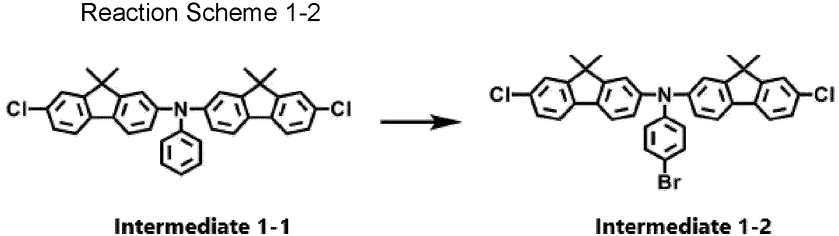

Under an argon atmosphere, Intermediate 1-1 (30.0 g, 54.9 mmol) and tetrahydrofuran (THF) (300 milliliters (mL)) were added to a reaction vessel, and stirred at less than 1°C. Subsequently, N-bromosuccinimide (9.3 g, 52.1 mmol) dissolved in dimethyl formamide (DMF) (500 mL) was added dropwise thereto, and the reaction mixture was stirred overnight. Then, the reaction mixture was filtered by using Celite^{™} to filter and separate impurities. After removing the solvent under a reduced pressure, a solid obtained therefrom was washed with methanol to obtain 31.5 g of Intermediate1-2 (Yield: 92%).

### Synthesis of Intermediate 1-3

Intermediate 1-3 was synthesized according to Reaction Scheme 1-3.

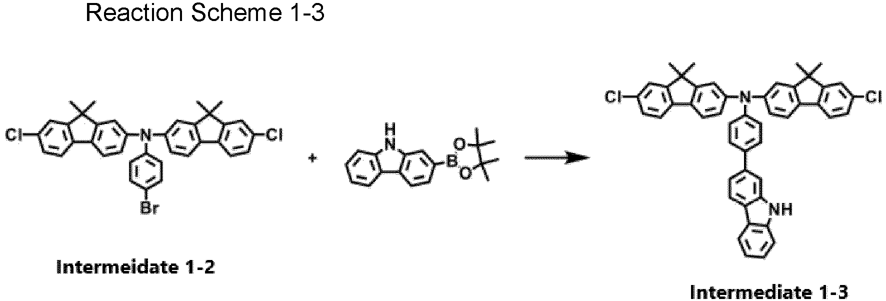

Under an argon atmosphere, Intermediate 1-2 (7.35 g, 12.9 mmol), (9H-carbazole-2-yl)boronic acid pinacol (15.47 g, 52.7 mmol), sodium carbonate (6.1 g, 57.5 mmol), toluene (200 mL), and water (100 mL) were added to a reaction vessel, and the contents were stirred for 30 minutes. Subsequently, tetrakis(triphenylphosphine)palladium(0) (Pd[PPh₃]₄) (1.53 g, 1.32 mmol) was added thereto, and the contents were then heated by stirring under reflux for 7 hours. When the reaction was completed, after separating the precipitated solid by filtration, a filtrate therefrom was transferred to a separatory funnel and extracted with toluene. An organic layer obtained therefrom was dried by using MgSO₄, filtered, and concentrated under reduced pressure. The concentrated residue was washed with methanol to obtain a solid. The obtained solid was combined with the filtered solid and then washed again with methanol to obtain 31.8 g (Yield: 93%) of a solid Intermediate1-3.

### Synthesis of Intermediate 1-4

Intermediate 1-4 was synthesized according to Reaction Scheme 1-4.

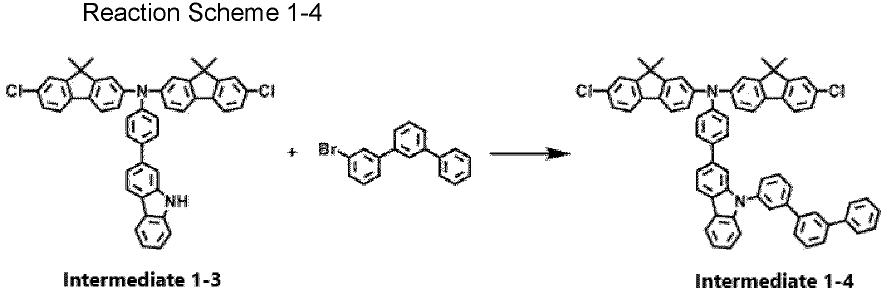

Under an argon atmosphere, Intermediate 1-3 (10.0 g, 14.0 mmol), bromoterphenyl (5.2 g, 16.8 mmol), tBuONa (2.02 g, 21.0 mmol), and toluene (120 mL) were added to a reaction vessel, and the contents were stirred for 30 minutes. Subsequently, palladium acetate (0.252 g, 1.12 mmol) and 2-dicyclohexylphosphino-2',4',6'-triisopropylbiphenyl (XPhos) (0.27 g, 0.56 mmol) were added thereto, and the contents were stirred under reflux for 10 hours. The reaction mixture was then cooled to room temperature. Subsequently, the reaction mixture was filtered using Celite^{™} to filter and separate impurities. The obtained filtrate, from which the solvent was removed under reduced pressure, was purified by column chromatography to obtain 11.2 g (Yield: 85%) of a solid Intermediate1-4.

### Synthesis of Compound 1

Compound 1 was synthesized according to Reaction Scheme 1-5.

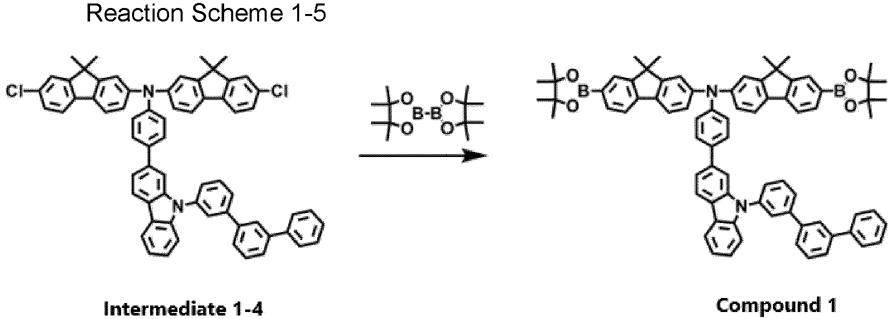

Under an argon atmosphere, Intermediate 1-4 (11.2 g, 12.0 mmol), bispinacolate diboron (15.2 g, 60.0 mmol), potassium acetate (7.07 g, 72.1 mmol), and dioxane (120 ml) were added to a reaction vessel, and the contents were stirred for 30 minutes. Subsequently, tris(dibenzylideneacetone)dipalladium (Pd₂(dba)₃) (0.33 g, 0.36 mmol), and XPhos (0.68 g, 1.44 mmol) were added thereto, and the contents were heated by stirring under reflux for 6 hours. After the reaction was completed, the reaction mixture was cooled to room temperature. Subsequently, the reaction mixture was filtered by using Celite^{™} to filter and separate impurities. The obtained filtrate, from which the solvent was removed under reduced pressure, was purified by column chromatography to obtain Compound 1 (9.7 g, Yield: 72%).

### Synthesis Example 2: Synthesis of Compound 2

### Synthesis of Intermediate 2-1

Intermediate 2-1 was synthesized according to Reaction Scheme 2-1.

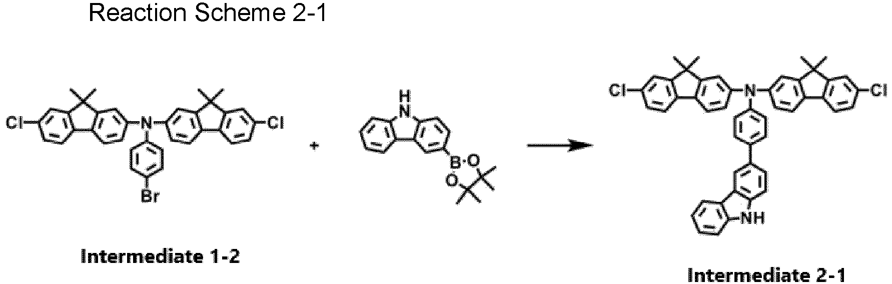

Under an argon atmosphere, Intermediate 1-2 (8.50 g, 13.6 mmol), (9H-carbazol-3-yl)boronic acid pinacol (3.98 g, 13.6 mmol), sodium carbonate (1.7 g, 16.3 mmol), toluene (100 mL), and water (50 mL) were added to a reaction vessel, and the contents were stirred for 30 minutes. Subsequently, tetrakis(triphenylphosphine)palladium (0) (Pd[PPh₃]₄) (0.94 g, 0.815 mmol) was added thereto, and the contents were heated by stirring under reflux for 7 hours. When the reaction was completed, after separating a solid precipitated therein by filtration, a filtrate therefrom was transferred to a separatory funnel, and extracted with toluene. The organic layer obtained therefrom was dried by using MgSO₄, filtered, and then concentrated under reduced pressure. The concentrated residue was washed with methanol to obtain a solid. The obtained solid was combined with the filtered solid and then washed again with methanol to obtain 9.2 g (Yield: 94%) of solid Intermediate 2-1.

### Synthesis of Intermediate 2-2

Intermediate 2-2 was synthesized according to Reaction Scheme 2-2.

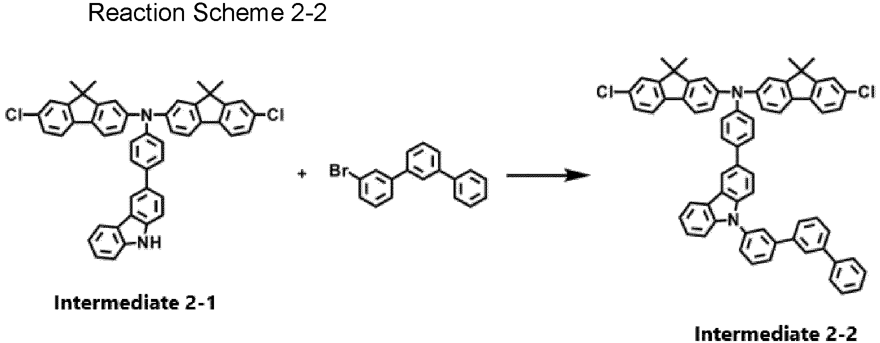

Under an argon atmosphere, Intermediate 2-1 (5.0 g, 7.0 mmol), bromoterphenyl (2.6 g, 8.4 mmol), tBuONa (1.01 g, 10.5 mmol), and toluene (80 mL) were added to a reaction vessel, and the contents were stirred for 30 minutes. Subsequently, palladium acetate (0.126 g, 0.56 mmol) and XPhos (0.13 g, 0.28 mmol) were added thereto, and the contents were heated by stirring under reflux for 12 hours. The reaction mixture was then cooled to room temperature. Subsequently, the reaction mixture was filtered by using Celite^{™} to filter and separate impurities. The obtained filtrate, from which the solvent was removed under reduced pressure, was purified by column chromatography to obtain 5.1 g (Yield: 76%) of solid Intermediate 2-2.

### Synthesis of Compound 2

Compound 2 was synthesized according to Reaction Scheme 2-3.

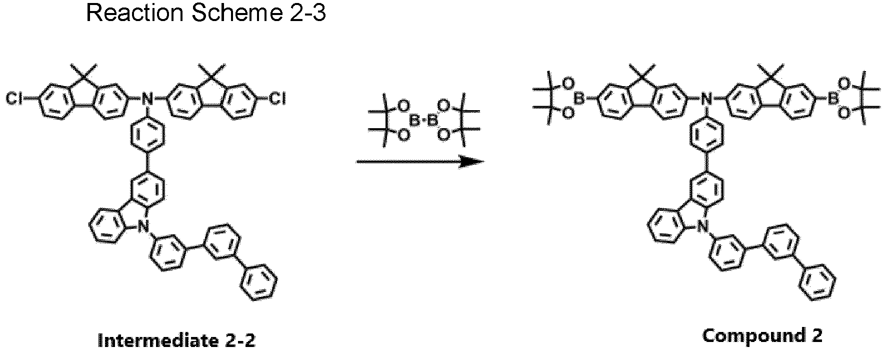

Under an argon atmosphere, Intermediate 2-2 (5.0 g, 5.3 mmol), bispinacolate diboron (6.8 g, 26.9 mmol), potassium acetate (3.17 g, 32.2 mmol), and dioxane (80 mL) were added to a reaction vessel, and the contents were stirred for 30 minutes. Subsequently, tris(dibenzylideneacetone)dipalladium (Pd₂(dba)₃) (0.14 g, 0.16 mmol), and XPhos (0.30 g, 0.64 mmol) were added thereto, and the contents were heated by stirring under reflux for 13 hours. After the reaction was completed, the reaction mixture was cooled to room temperature. Subsequently, the reaction mixture was filtered by using Celite^{™} to filter and separate impurities. The obtained filtrate, from which the solvent was removed under reduced pressure, was purified by column chromatography to obtain Compound 2 (4.4 g, Yield: 73%).

### Synthesis Example 3: Synthesis of Compound 3

### Synthesis of Intermediate 3-1

Intermediate 3-1 was synthesized according to Reaction Scheme 3-1.

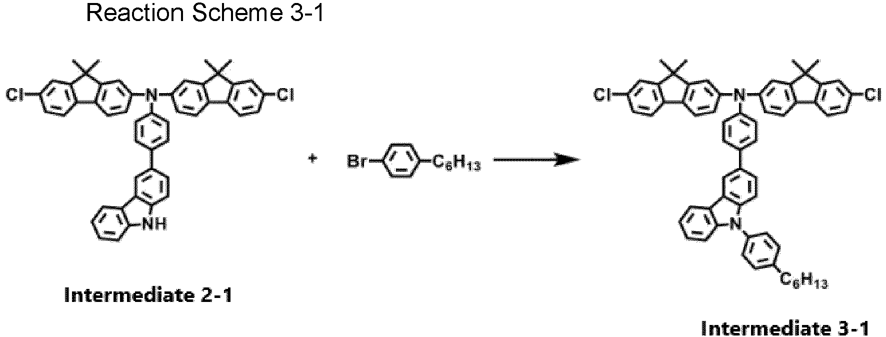

Under an argon atmosphere, Intermediate 2-1 (6.70 g, 9.4 mmol), bromohexylbenzene (2.72 g, 11.3 mmol), tBuONa (1.35 g, 14.1 mmol), and toluene (100 mL) were added to a reaction vessel, and the contents were stirred for 30 minutes. Subsequently, palladium acetate (0.169 g, 0.75 mmol), and XPhos (0.18 g, 0.38 mmol) were added thereto and then, heated by stirring under reflux for 12 hours. The reaction mixture was then cooled to room temperature. Subsequently, the reaction mixture was filtered by using Celite^{™} to filter and separate impurities. The obtained filtrate, from which the solvent was removed under reduced pressure, was purified by column chromatography to obtain 5.9 g (Yield: 71%) of solid Intermediate 3-1.

### Synthesis of Compound 3

Compound 3 was synthesized according to Reaction Scheme 3-2.

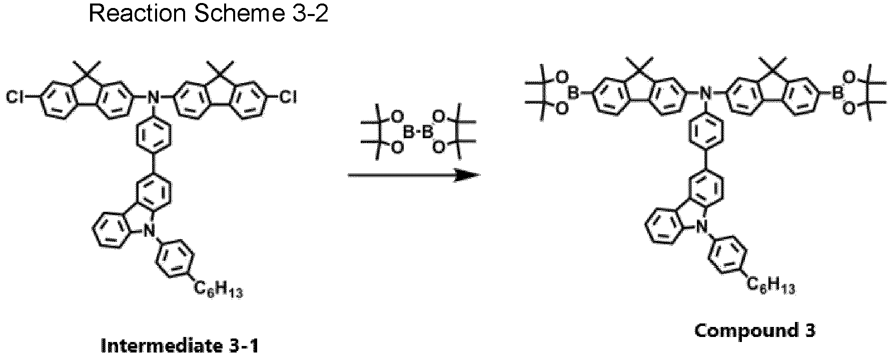

Under an argon atmosphere, Intermediate 3-1 (4.7 g, 5.4 mmol), bispinacolate diboron (5.47 g, 21.5 mmol), potassium acetate (3.17 g, 32.2 mmol), and dioxane (100 mL) were added to a reaction vessel, and the contents were stirred for 30 minutes. Subsequently, tris(dibenzylideneacetone)dipalladium (Pd₂(dba)₃) (0.14 g, 0.16 mmol), and XPhos (0.30 g, 0.64 mmol) were added thereto, and the contents were stirred under reflux for 6 hours. After the reaction was completed, the reaction mixture was cooled to room temperature. Subsequently, the reaction mixture was filtered by using Celite^{™} to filter and separate impurities. The obtained filtrate, from which the solvent was removed under reduced pressure, was purified by column chromatography to obtain Compound 3 (5.6 g, Yield: 99%).

### Synthesis Example 4: Synthesis of Compound 4

### Synthesis of Intermediate 4-1

Intermediate 4-1 was synthesized according to Reaction Scheme 4-1.

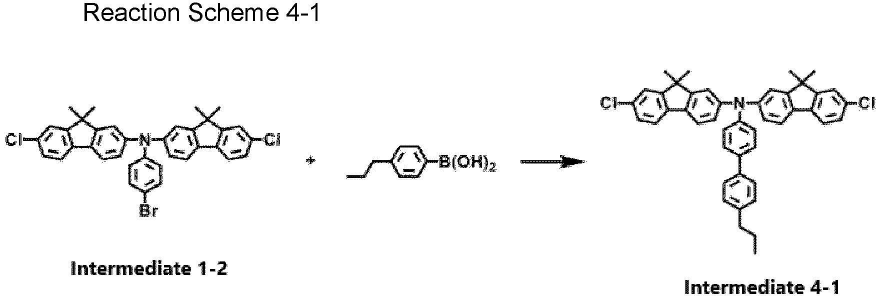

Under an argon atmosphere, Intermediate 1-2 (10.0 g, 16.0 mmol), propyl phenylboronic acid (2.6 g, 16.0 mmol), sodium carbonate (2.0 g, 19.2 mmol), toluene (140 mL), water (70 mL), and ethanol (10 mL) were added to a reaction vessel, and the contents were stirred for 30 minutes. Subsequently, tetrakis(triphenylphosphine)palladium (0) (Pd[PPh₃]₄) (1.10 g, 0.959 mmol) was added thereto, and the contents were heated by stirring under reflux for 6 hours. When the reaction was completed, the heating was stopped and the contents allowed to cool to room temperature. After separating the precipitated solid by filtration, the filtrate was transferred to a separatory funnel and extracted with toluene. An organic layer therefrom was dried by using MgSO₄, filtered, and concentrated under reduced pressure. The concentrated residue was washed with methanol to obtain a solid. The obtained solid was combined with the filtered and separated solid, and then washed again with methanol to obtain 8.3 g (Yield: 78%) of solid Intermediate 4-1.

### Synthesis of Compound 4

Compound 4 was synthesized according to Reaction Scheme 4-2.

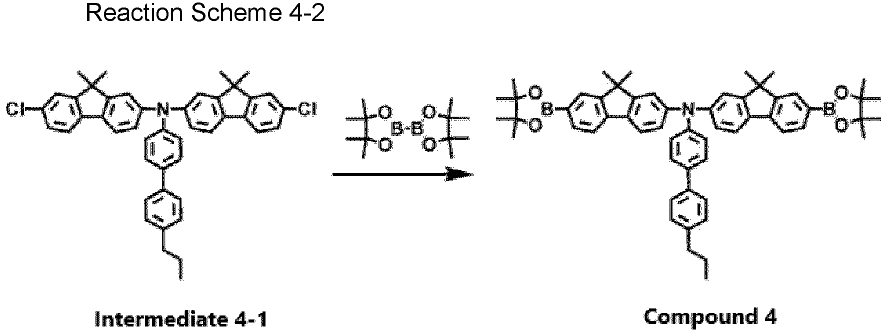

Under an argon atmosphere, Intermediate 4-1 (8.3 g, 12.5 mmol), bispinacolate diboron (15.9 g, 62.5 mmol), potassium acetate (7.37 g, 75.1 mmol), and dioxane (150 mL) were added to a reaction vessel, and the contents were stirred for 30 minutes. Subsequently, tris(dibenzylideneacetone)dipalladium (Pd₂(dba)₃) (0.34 g, 0.376 mmol) and XPhos (0.71 g, 1.50 mmol) were added thereto, and the contents were heated by stirring under reflux for 4 hours. After the reaction was completed, the reaction mixture was cooled to room temperature. Subsequently, the reaction mixture was filtered by using Celite^{™} to filter and separate impurities. The obtained filtrate, from which the solvent was removed under reduced pressure, was purified by column chromatography to obtain Compound 4 (10.0 g, Yield: 99%).

### Synthesis Example 5: Synthesis of Compound 5

### Synthesis of Intermediate 5-1

Intermediate 5-1 was synthesized according to Reaction Scheme 5-1.

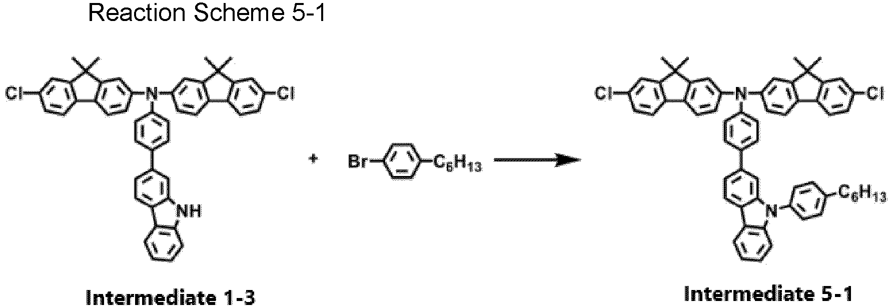

Under an argon atmosphere, Intermediate 1-3 (6.70 g, 9.4 mmol), bromohexylbenzene (2.72 g, 11.3 mmol), tBuONa (1.35 g, 14.1 mmol), and toluene (100 mL) were added to a reaction vessel, and the contents were stirred for 30 minutes. Subsequently, palladium acetate (0.169 g, 0.75 mmol) and XPhos (0.18 g, 0.38 mmol) were added thereto, and the contents were heated by stirring under reflux for 12 hours. The reaction mixture was then cooled to room temperature. Subsequently, the reaction mixture was filtered by using Celite^{™} to filter and separate impurities. The obtained filtrate, from which the solvent was removed under reduced pressure, was purified by column chromatography to obtain 6.1 g (Yield: 74%) of solid Intermediate 5-1.

### Synthesis of Compound 5

Compound 5 was synthesized according to Reaction Scheme 5-2.

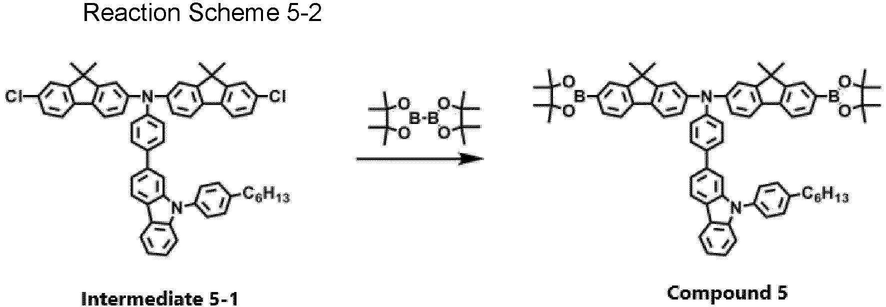

Under an argon atmosphere, Intermediate 5-1 (6.1 g, 7.0 mmol), bispinacolate diboron (8.9 g, 35.1 mmol), potassium acetate (4.14 g, 42.1 mmol), and dioxane (100 mL) were added to a reaction vessel, and the contents were stirred for 30 minutes. Subsequently, tris(dibenzylideneacetone)dipalladium (Pd₂(dba)₃) (0.19 g, 0.21 mmol) and XPhos (0.40 g, 0.84 mmol) were added thereto, and the contents were heated by stirring under reflux for 13 hours. After the reaction was completed, the reaction mixture was cooled to room temperature. Subsequently, the reaction mixture was filtered by using Celite^{™} to filter and separate impurities. The obtained filtrate, from which the solvent was removed under a reduced pressure, was purified by column chromatography to obtain Compound 5 (4.1 g, Yield: 55%).

### Synthesis Example 6: Synthesis of Compound 6

### Synthesis of Intermediate 6-1

Intermediate 6-1 was synthesized according to reaction scheme 6-1.

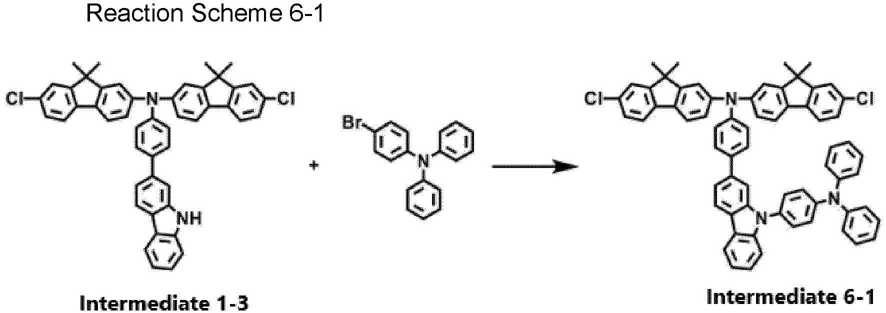

Under an argon atmosphere, Intermediate 1-3 (7.0 g, 9.84 mmol), 4-bromotriphenylamine (3.8 g, 11.8 mmol), tBuONa (1.41 g, 14.7 mmol), and toluene (80 mL) were added to a reaction vessel, and the contents were stirred for 30 minutes. Subsequently, palladium acetate (0.353 g, 1.57 mmol) and XPhos (0.37 g, 0.78 mmol) were added thereto, and the contents were heated by stirring under reflux for 5 hours. The reaction mixture was then cooled to room temperature. Subsequently, the reaction mixture was filtered by using Celite^{™}, and impurities were separated by filtration. The obtained filtrate, from which the solvent was removed under reduced pressure, was purified by column chromatography to obtain 8.45 g (Yield: 90%) of solid Intermediate 6-1.

### Synthesis of Compound 6

Compound 6 was synthesized according to Reaction Scheme 6-2.

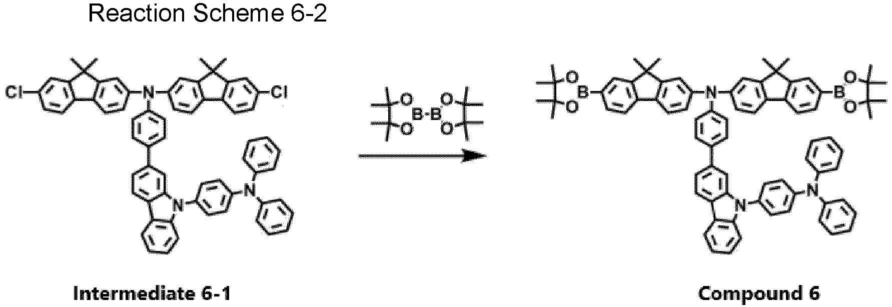

Under an argon atmosphere, Intermediate 6-1 (8.5 g, 8.9 mmol), bispinacolate diboron (11.3 g, 44.5 mmol), potassium acetate (5.2 g, 53.4 mmol), and dioxane (100 mL) were added to a reaction vessel, and the contents were stirred for 30 minutes. Subsequently, tris(dibenzylideneacetone)dipalladium (Pd₂(dba)₃) (0.244 g, 0.267 mmol) and XPhos (0.51 g, 1.07 mmol) were added thereto, and the contents were heated by stirring under reflux for 6 hours. After the reaction was completed, the reaction mixture was cooled to room temperature. Subsequently, the reaction mixture was filtered by using Celite^{™} to filter and separate impurities. The obtained filtrate, from which the solvent was removed under reduced pressure, was purified by column chromatography to obtain Compound 6 (7.52 g, Yield: 74.3%).

### Synthesis Example 7: Synthesis of Compound 7

### Synthesis of Intermediate 7-1

Intermediate 7-1 was synthesized according to the method disclosed in Japanese Patent Application Laid-Open No. 2022-045759.

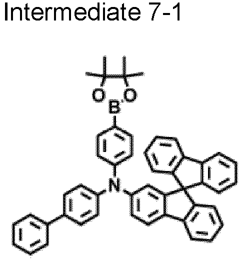

### Synthesis of Intermediate 7-2

Intermediate 7-2 was synthesized according to Reaction Scheme 7-1.

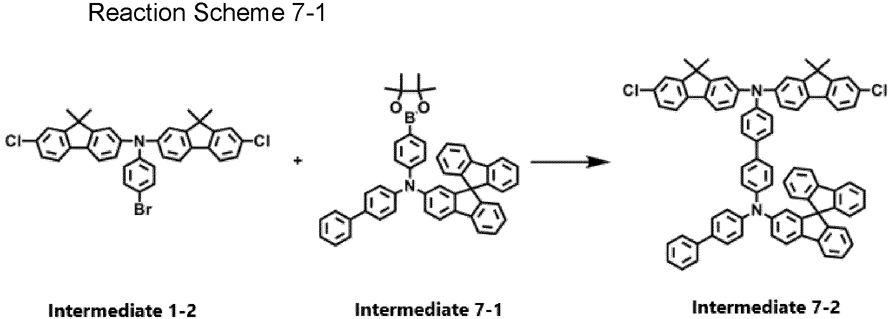

Under an argon atmosphere, Intermediate 1-2 (6.0 g, 8.7 mmol), Intermediate 7-1 (5.4 g, 8.7 mmol), sodium carbonate (1.1 g, 10.5 mmol), toluene (100 mL), and water (50 mL) were added to a reaction vessel, and the contents were stirred for 30 minutes. Subsequently, tetrakis(triphenylphosphine)palladium (0) (Pd[PPh₃]₄) (0.5 g, 0.44 mmol) was added thereto, and the contents were heated by stirring under reflux for 13 hours. When the reaction was completed, the reaction mixture was allowed to cool to room temperature. After separating a solid precipitated therein by filtration, a filtrate therefrom was transferred to a separatory funnel, and extracted with toluene. An organic layer obtained therefrom was dried with MgSO₄, filtered, and concentrated under a reduced pressure. The concentrated residue was washed with methanol to obtain a solid. The obtained solid was combined with the filtered and separated solid and then washed again with methanol to obtain 7.5 g (Yield: 78%) of solid Intermediate 7-2.

### Synthesis of Compound 7

Compound 7 was synthesized according to Reaction Scheme 7-2.

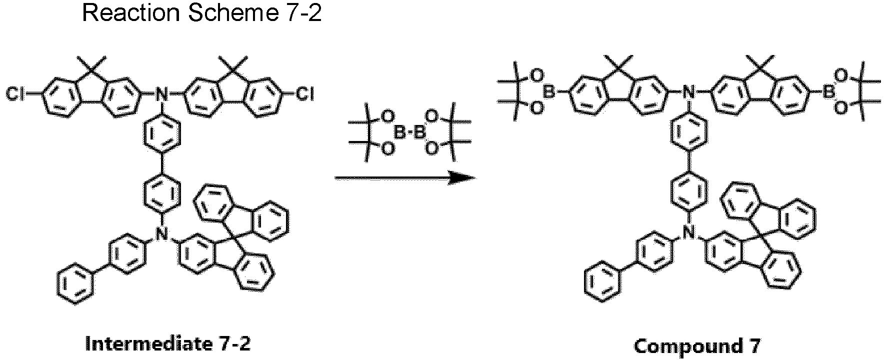

Under an argon atmosphere, Intermediate 7-2 (7.5 g, 6.8 mmol), bispinacolate diboron (8.6 g, 34.1 mmol), potassium acetate (4.0 g, 40.1 mmol), and dioxane (100 mL) were added to a reaction vessel, and the contents were stirred for 30 minutes. Subsequently, tris(dibenzylideneacetone)dipalladium (Pd₂(dba)₃) (0.187 g, 0.205 mmol) and XPhos (0.39 g, 0.818 mmol) were added thereto, and the contents were heated by stirring under reflux for 6 hours. After the reaction was completed, the reaction mixture was cooled to room temperature. Subsequently, the reaction mixture was filtered using Celite^{™} to filter and separate impurities. The obtained filtrate, from which the solvent was removed under reduced pressure, was purified by column chromatography to obtain Compound 7 (5.12 g, Yield: 58.3%).

### Copolymer (polymer compound)

### Synthesis

### Example 1: Synthesis of Copolymer 1

Under an argon atmosphere, Compound 1 (1.967 g) according to Synthesis Example 1, 2,7-dibromo-9,9-di-n-dodecylfluorene (0.963 g), bis[di-tert-butyl(4-dimethylaminophenyl)phosphine]dichloropalladium(II) (Pd(Amphos)₂Cl₂) (11.3 mg), toluene (60 mL), and a 20 mass% tetraethylammonium hydroxide aqueous solution (10.3 g) were added to a reaction vessel, and the contents were heated and stirred under reflux for 6 hours. Subsequently, phenylboronic acid (282.0 mg), bis(triphenylphosphine)palladium(II) dichloride (65.1 mg), and a 20 mass% tetraethylammonium hydroxide aqueous solution (10.3 g) were added thereto, and the contents were heated under reflux for 6 hours. After excluding an aqueous layer, sodium N,N-diethyldithiocarbamate trihydrate (5.9 g) and ion-exchanged water (60 mL) were added thereto, and stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography using silica gel/alumina, and then the solvent was removed under reduced pressure. The obtained liquid was added dropwise to methanol, a solid precipitated therein was filtered and separated, and dried to obtain Copolymer 1 (0.61 g). Copolymer 1 was measured with respect to a weight average molecular weight (Mw) and polydispersity (Mw/Mn), which were measured by using SEC. The weight average molecular weight (Mw) and polydispersity (Mw/Mn) of Copolymer 1 were 81,200 Da and 1.67, respectively.

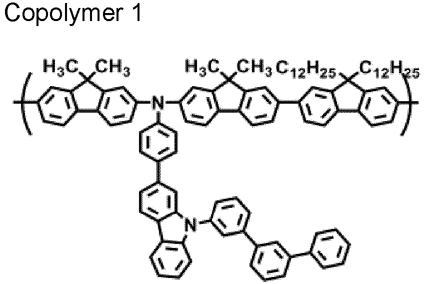

### Example 2: Synthesis of Copolymer 2

Under an argon atmosphere, Compound 1 (1.764 g) synthesized in Synthesis Example 1, 2,7-dibromo-3,6-dimethyl-9,9-di-n-dodecylfluorene (0.984 g), bis[di-tert-butyl(4-dimethylaminophenyl)phosphine]dichloropalladium(II) (Pd(Amphos)₂Cl₂) (12.0 mg), toluene (60 mL), and a 20 mass% tetraethylammonium hydroxide aqueous solution (9.8 g) were added to a reaction vessel, and the contents were heated under reflux with stirring for 6 hours. Subsequently, phenylboronic acid (218.0 mg), bis(triphenylphosphine)palladium(II) dichloride (66.1 mg), and a 20 mass% tetraethylammonium hydroxide aqueous solution (9.8 g) were added thereto, and the contents were heated under reflux with stirring for 6 hours. After removing an aqueous layer, sodium N,N-diethyldithiocarbamate trihydrate (5.50 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified using column chromatography with silica gel/alumina, and the solvent was removed under a reduced pressure. The obtained liquid was added dropwise to methanol. A solid was precipitated therein. The solid was separated by filtration and dried to obtain Copolymer 2 (0.69 g). Copolymer 2 was measured with respect to a weight average molecular weight (Mw) and polydispersity (Mw/Mn), which were measured by using SEC. The weight average molecular weight (Mw) and polydispersity (Mw/Mn) of Copolymer 2 were 42,600 Da and 1.71, respectively.

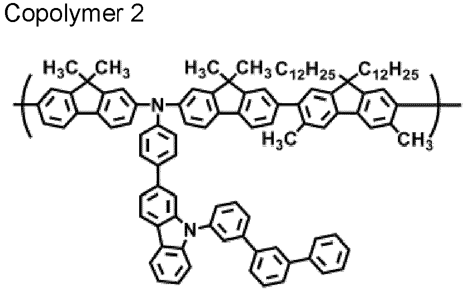

### Example 3: Synthesis of Copolymer 3

Under an argon atmosphere, Compound 2 (1.962 g) synthesized in Synthesis Example 2, 2,7-dibromo-9,9-di-n-octylfluorene (0.871 g), bis[di-tert-butyl(4-dimethylaminophenyl)phosphine]dichloropalladium(II) (Pd(Amphos)₂Cl₂) (14.5 mg), toluene (60 mL), and a 20 mass% tetraethylammonium hydroxide aqueous solution (12.9 g) were added to a reaction vessel, and the contents were heated under reflux with stirring for 6 hours. Subsequently, phenylboronic acid (237.9 mg), bis(triphenylphosphine)palladium(II) dichloride (67.5 mg), and a 20 mass% tetraethylammonium hydroxide aqueous solution (10.6 g) were added thereto, and the contents were heated under reflux with stirring for 6 hours. Subsequently, after removing an aqueous layer, sodium N,N-diethyldithiocarbamate trihydrate (7.0 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under a reduced pressure. The obtained liquid was added dropwise to methanol, and a solid precipitated therein was separated by filtration and dried to obtain Copolymer 3 (0.95 g). Copolymer 3 was measured with respect to a weight average molecular weight (Mw) and polydispersity (Mw/Mn), which were measured with SEC. The weight average molecular weight (Mw) and polydispersity (Mw/Mn) of Copolymer 3 were respectively 64,500 Da and 2.32.

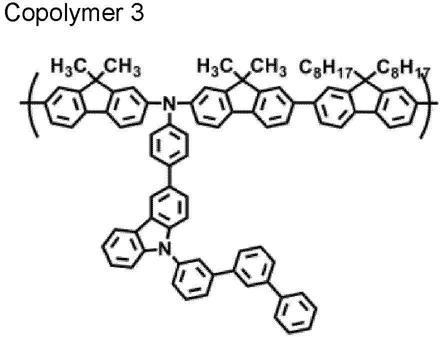

### Example 4: Synthesis of Copolymer 4

Under an argon atmosphere, Compound 2 (2.111 g) synthesized in Synthesis Example 2, 2,7-dibromo-9,9-di-n-hexylfluorene (0.818 g), bis[di-tert-butyl(4-dimethylaminophenyl)phosphine]dichloropalladium(II) (Pd(Amphos)₂Cl₂) (15.8 mg), toluene (60 mL), and a 20 mass% tetraethylammonium hydroxide aqueous solution (10.7 g) were added to a reaction vessel, and the contents were heated under reflux with stirring for 6 hours. Subsequently, phenylboronic acid (284.0 mg), bis(triphenylphosphine)palladium(II) dichloride (76.4 mg), and a 20 mass% tetraethylammonium hydroxide aqueous solution (9.43 g) were added thereto, and the contents were heated under reflux with stirring for 6 hours. Subsequently, after removing an aqueous layer, sodium N,N-diethyldithiocarbamate trihydrate (7.0 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered, and dried to obtain a solid. This solid was dissolved in toluene and purified by column chromatography with silica gel/alumina, and the solvent was removed under reduced pressure. The obtained liquid was added dropwise to methanol, and a solid precipitated therein was separated by filtration and dried to obtain Copolymer 4 (0.74 g). Copolymer 4 was measured with respect to a weight average molecular weight (Mw) and polydispersity (Mw/Mn), which were measured by using SEC. The weight average molecular weight (Mw) and polydispersity (Mw/Mn) of Copolymer 4 were respectively 80,350 Da and 2.03.

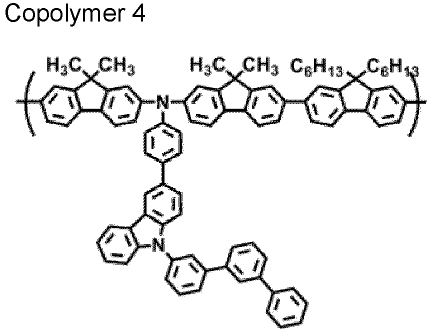

### Example 5: Synthesis of Copolymer 5

Under an argon atmosphere, Compound 1 (2.050 g) synthesized in Synthesis Example 1, 2,7-dibromo-9,9-di-n-decylfluorene (0.919 g), bis[di-tert-butyl(4-dimethylaminophenyl)phosphine]dichloropalladium(II) (Pd(Amphos)₂Cl₂) (11.7 mg), toluene (60 mL), and a 20 mass% tetraethylammonium hydroxide aqueous solution (10.2 g) were added to a reaction vessel, and the contents were heated under reflux for 6 hours. Subsequently, phenylboronic acid (268.4 mg), bis(triphenylphosphine)palladium(II) dichloride (69.3 mg), and a 20 mass% tetraethylammonium hydroxide aqueous solution (10.2 g) were added thereto, and the contents were heated under reflux with stirring for 6 hours. Subsequently, after removing an aqueous layer, sodium N,N-diethyldithiocarbamate trihydrate (7.6 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid precipitated therein was separated by filtration and dried to obtain Copolymer 5 (0.87 g). Copolymer 5 was measured with respect to a weight average molecular weight (Mw) and polydispersity (Mw/Mn), which were measured by using SEC. The weight average molecular weight (Mw) and polydispersity (Mw/Mn) of Copolymer 5 were respectively 87,890 and 1.87.

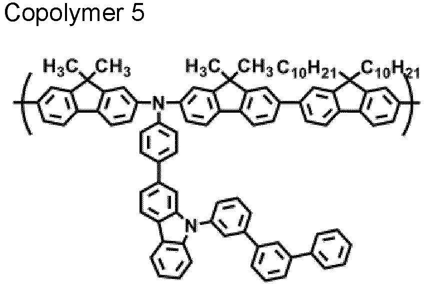

### Example 6: Synthesis of Copolymer 6

Under an argon atmosphere, Compound 1 (2.093 g) synthesized in Synthesis Example 1, 2,7-dibromo-3,6-dimethyl-9,9-di-n-octylfluorene (0.896 g), bis[di-tert-butyl (4-dimethylaminophenyl)phosphine]dichloropalladium(II) (Pd(Amphos)₂Cl₂) (14.0 mg), toluene (60 mL), and a 20 mass% tetraethylammonium hydroxide aqueous solution (11.6 g) were added to a reaction vessel, and the contents were heated at reflux with stirring for 6 hours. Subsequently, 9,9-dimethylfluorene-2-boronic acid (281.8 mg), bis(triphenylphosphine)palladium(II) dichloride (70.5 mg), and a 20 mass% tetraethylammonium hydroxide aqueous solution (11.6 g) were added thereto, and the contents were heated under reflux with stirring for 6 hours. Subsequently, after removing an aqueous layer, sodium N,N-diethyldithiocarbamate trihydrate (8.0 g) and ion-exchanged water (60 mL) were added thereto, and the contents were stirred at 85°C for 2 hours. After separating the organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 6 (0.99 g). Copolymer 6 was measured with respect to a weight average molecular weight (Mw) and polydispersity (Mw/Mn), which were measured by using SEC. The weight average molecular weight (Mw) and polydispersity (Mw/Mn) of Copolymer 6 were respectively 97,000 Da and 2.99.

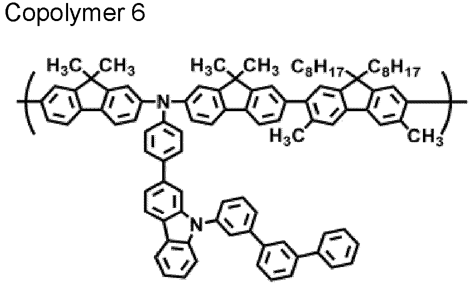

### Example 7: Synthesis of Copolymer 7

Under an argon atmosphere, Compound 3 (1.603 g) synthesized in Synthesis Example 3, 2,7-dibromo-9,9-di-n-dodecylfluorene (0.912 g), palladium acetate (6.3 mg), tris (2-methoxyphenyl)phosphine (64.5 mg), toluene (50 mL), and a 20 mass% tetraethylammonium hydroxide aqueous solution (7.8 g) were added to a reaction vessel, and the contents were heated at reflux with stirring for 6 hours. Subsequently, phenylboronic acid (202.5 mg), bis(triphenylphosphine)palladium(II) dichloride (58.3 mg), and a 20 mass% tetraethylammonium hydroxide an aqueous solution (7.8 g) were added thereto, and the contents were heated under reflux with stirring for 6 hours. Subsequently, after removing an aqueous layer, sodium N,N-diethyldithiocarbamate trihydrate (5.1 g) and ion-exchanged water (54 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 7 (1.18 g). Copolymer 7 was measured with respect to a weight average molecular weight (Mw) and polydispersity (Mw/Mn), which were measured by using SEC. The weight average molecular weight (Mw) and polydispersity (Mw/Mn) of Copolymer 7 were respectively 86,900 Da and 1.86.

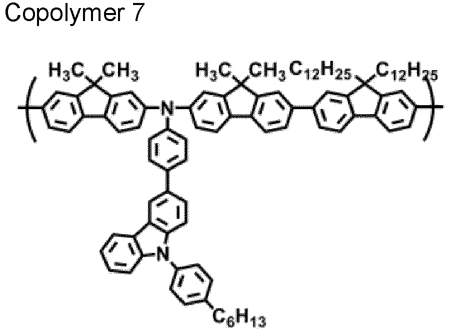

### Example 8: Synthesis of Copolymer 8

Under an argon atmosphere, Compound 3 (1.750 g) synthesized in Synthesis Example 3, 2,7-dibromo-3,6-dimethyl-9,9-di-n-dodecylfluorene (1.034 g), bis[di-tert-butyl (4-dimethylaminophenyl)phosphine]dichloropalladium(II) (Pd(Amphos)₂Cl₂) (14.1 mg), toluene (60 mL), and a 20 mass% tetraethylammonium hydroxide aqueous solution (11.9 g) were added to a reaction vessel, and the contents were heated at reflux with stirring for 6 hours. Subsequently, phenylboronic acid (230.3 mg), bis(triphenylphosphine)palladium(II) dichloride (70.3 mg), and a 20 mass% tetraethylammonium hydroxide aqueous solution (11.9 g) were added thereto, and the contents were heated under reflux with stirring for 6 hours. Subsequently, after removing an aqueous layer, sodium N,N-diethyldithiocarbamate trihydrate (6.4 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 8 (0.78 g). Copolymer 8 was measured with respect to a weight average molecular weight (Mw) and polydispersity (Mw/Mn), which were measured by using SEC. The weight average molecular weight (Mw) and polydispersity (Mw/Mn) of Copolymer 8 were respectively 41,350 Da and 1.70.

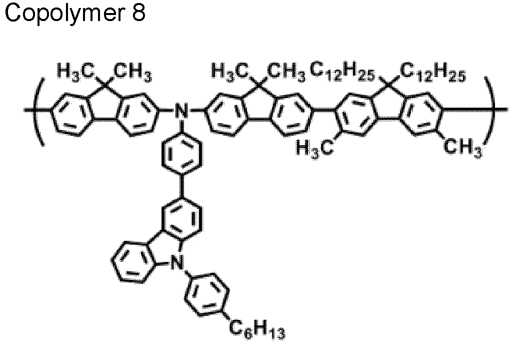

### Example 9: Synthesis of Copolymer 9

Under an argon atmosphere, Compound 4 (1.607 g) synthesized in Synthesis Example 4, 2,7-dibromo-9,9-di-n-hexyl fluorene (0.849 g), palladium acetate (7.7 mg), tris(2-methoxyphenyl)phosphine (80.4 mg), toluene (50 mL), and a 20 mass% tetraethylammonium hydroxide aqueous solution (9.8 g) were added to a reaction vessel, and the contents were heated under reflux with stirring for 6 hours. Subsequently, phenylboronic acid (252.4 mg), bis(triphenylphosphine)palladium(II) dichloride (72.6 mg), and a 20 mass% tetraethylammonium hydroxide an aqueous solution (9.8 g) were added thereto, and the contents were heated under reflux with stirring for 6 hours. Then, after removing an aqueous layer, sodium N,N-diethyldithiocarbamate trihydrate (12.8 g) and ion-exchanged water (48 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 9 (0.89 g). Copolymer 9 was measured with respect to a weight average molecular weight (Mw) and polydispersity (Mw/Mn), which were measured by using SEC. The weight average molecular weight (Mw) and polydispersity (Mw/Mn) of Copolymer 9 were respectively 68,400 Da and 2.01.

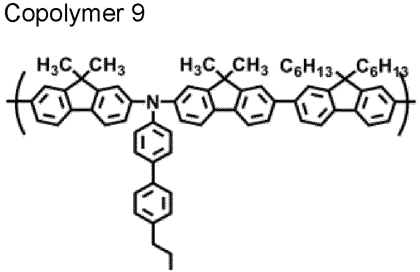

### Example 10: Synthesis of Copolymer 10

Under an argon atmosphere, Compound 4 (1.786 g) synthesized in Synthesis Example 4, 2,7-dibromo-9,9-di-n-decylfluorene (0.931 g), palladium acetate (7.0 mg), tris (2-methoxyphenyl)phosphine (89.3 mg), toluene (54 mL), and a 20 mass% tetraethylammonium hydroxide aqueous solution (10.9 g) were added to a reaction vessel, and the contents were heated under reflux with stirring for 6 hours. Subsequently, phenylboronic acid (350.2 mg), bis(triphenylphosphine)palladium(II) dichloride (65.4 mg), and a 20 mass% tetraethylammonium hydroxide an aqueous solution (10.9 g) were added thereto, and the contents were heated under reflux with stirring for 6 hours. Then, after removing an aqueous layer, sodium N,N-diethyldithiocarbamate trihydrate (7.12 g) and ion-exchanged water (48 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 10 (0.71 g). Copolymer 10 was measured with respect to a weight average molecular weight (Mw) and polydispersity (Mw/Mn), which were measured by using SEC. The weight average molecular weight (Mw) and polydispersity (Mw/Mn) of Copolymer 10 were respectively 145,300 Da and 2.32.

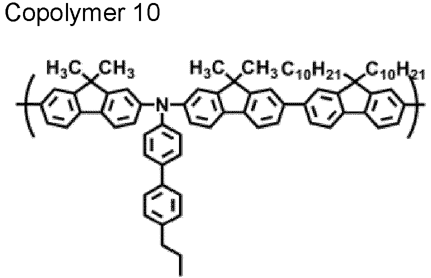

### Example 11: Synthesis of Copolymer 11

Under an argon atmosphere, Compound 4 (2.212 g) synthesized in Synthesis Example 4, 1,4-dibromo-2,5-dihexylbenzene (0.770 g), palladium acetate (8.9 mg), tris (2-methoxyphenyl)phosphine (110.3 mg), toluene (60 mL), and a 20 mass% tetraethylammonium hydroxide aqueous solution (13.4 g) were added to a reaction vessel, and the contents were heated at reflux with stirring for 6 hours. Subsequently, phenylboronic acid (432.5 mg), bis(triphenylphosphine)palladium(II) dichloride (80.2 mg), and a 20 mass% tetraethylammonium hydroxide aqueous solution (13.4 g) were added thereto, and the contents were heated under reflux with stirring for 6 hours. Then, after removing an aqueous layer, sodium N,N-diethyldithiocarbamate trihydrate (8.86 g) and ion-exchanged water (48 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 11 (1.06 g). Copolymer 11 was measured with respect to a weight average molecular weight (Mw) and polydispersity (Mw/Mn), which were measured by using SEC. The weight average molecular weight (Mw) and polydispersity (Mw/Mn) of Copolymer 11 were respectively 54,100 Da and 2.12.

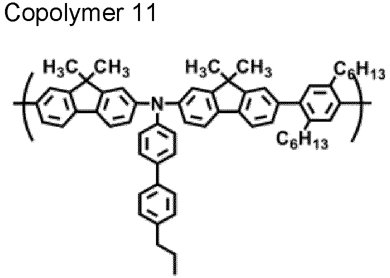

### Example 12: Synthesis of Copolymer 12

Under an argon atmosphere, Compound 1 (1.751 g) synthesized in Synthesis Example 1, 2,7-bis(4-bromophenyl)-3-methyl-9,9-di-n-dodecylfluorene (1.000 g), bis[di-tert-butyl(4-dimethylaminophenyl)phosphine] dichloropalladium(II) (Pd(Amphos)₂Cl₂) (11.5 mg), toluene (60 mL), and a 20 mass% tetraethylammonium hydroxide aqueous solution (10.2 g) were added to a reaction vessel, and the contents were heated under reflux with stirring for 6 hours. Subsequently, 9,9-dimethylfluorene-2-boronic acid (441.3 mg), bis(triphenylphosphine)palladium(II) dichloride (54.8 mg), and a 20 mass% tetraethylammonium hydroxide aqueous solution (10.2 g) were added thereto, and the contents were heated under reflux with stirring for 6 hours. Then, after excluding an aqueous layer, sodium N,N-diethyldithiocarbamate trihydrate (10.0 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 12 (1.00 g). Copolymer 12 was measured with respect to a weight average molecular weight (Mw) and polydispersity (Mw/Mn), which were measured by using SEC. The weight average molecular weight (Mw) and polydispersity (Mw/Mn) of Copolymer 12 were respectively, 55,700 Da and 2.02.

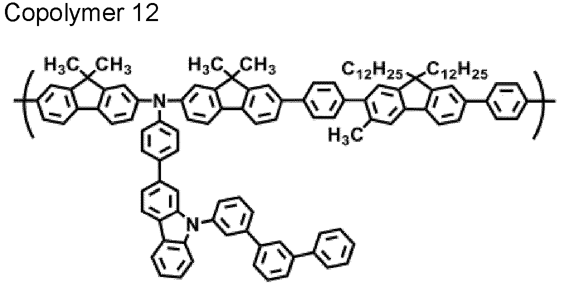

### Example 13: Synthesis of Copolymer 13

Under an argon atmosphere, Compound 5 (2.121 g) synthesized in Synthesis Example 5, 2,7-dibromo-9,9-di-n-octylfluorene (0.920 g), bis[di-tert-butyl (4-dimethylaminophenyl)phosphine]dichloropalladium(II) (Pd(Amphos)₂Cl₂) (13.1 mg), toluene (60 mL), and a 20 mass% tetraethylammonium hydroxide aqueous solution (11.1 g) were added to a reaction vessel, and the contents were heated under reflux with stirring for 6 hours. Subsequently, 9,9-dimethylfluorene-2-boronic acid (525.1 mg), bis(triphenylphosphine)palladium(II) dichloride (74.6 mg), and a 20 mass% tetraethylammonium hydroxide aqueous solution (11.1 g) were added thereto, and the contents were heated under reflux with stirring for 6 hours. Then, after removing an aqueous layer, sodium N,N-diethyldithiocarbamate trihydrate (8.2 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, a solid extracted therefrom was separated by filtration, and dried to obtain Copolymer 13 (0.46 g). Copolymer 13 was measured with respect to a weight average molecular weight (Mw) and polydispersity (Mw/Mn), which were measured by using SEC. The weight average molecular weight (Mw) and polydispersity (Mw/Mn) of Copolymer 13 were respectively 49,100 Da and 1.66.

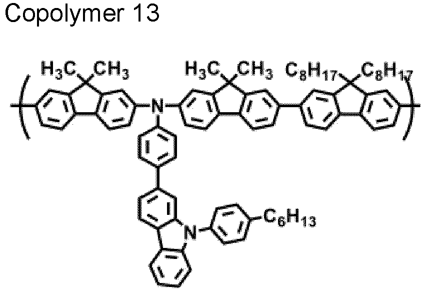

### Example 14: Synthesis of Copolymer 14

Under an argon atmosphere, Compound 5 (1.495 g) synthesized in Synthesis Example 5, 2,7-dibromo-9,9-di-n-decylfluorene (0.919 g), 2,7-dibromo-3,6-dimethyl-9,9-di-n-hexylfluorene (0.675 g), bis[di-tert-butyl(4-dimethylaminophenyl)phosphine]dichloropalladium(II) (Pd(Amphos)₂Cl₂) (12.8 mg), toluene (50 mL), and a 20 mass% tetraethylammonium hydroxide aqueous solution (11.8 g) were added to a reaction vessel, and the contents were heated at reflux with stirring for 6 hours. Subsequently, 9,9-dimethylfluorene-2-boronic acid (371.3 mg), bis(triphenylphosphine)palladium(II) dichloride (54.3 mg), and a 20 mass% tetraethylammonium hydroxide aqueous solution (11.8 g) were added thereto, and the contents were heated under reflux with stirring for 6 hours. Then, after removing an aqueous layer, sodium N,N-diethyldithiocarbamate trihydrate (8.4 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 14 (0.65 g). Copolymer 14 was measured with respect to a weight average molecular weight (Mw) and polydispersity (Mw/Mn), which were measured by using SEC. The weight average molecular weight (Mw) and polydispersity (Mw/Mn) of Copolymer 14 were respectively 32,800 Da and 1.70.

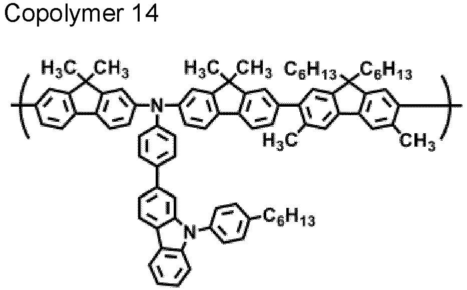

### Example 15: Synthesis of Copolymer 15

Under an argon atmosphere, Compound 6 (2.045 g) synthesized in Synthesis Example 6, 2,7-dibromo-9,9-di-n-decylfluorene (0.909 g), bis[di-tert-butyl (4-dimethylaminophenyl)phosphine]dichloropalladium(II) (Pd(Amphos)₂Cl₂) (13.4 mg), toluene (60 mL), and a 20 mass% tetraethylammonium hydroxide aqueous solution (10.5 g) were added to a reaction vessel, and the contents were heated at reflux with stirring for 6 hours. Subsequently, 9,9-dimethylfluorene-2-boronic acid (515.3 mg), bis(triphenylphosphine)palladium(II) dichloride (66.4 mg), and a 20 mass% tetraethylammonium hydroxide aqueous solution (10.5 g) were added thereto, and the contents were heated under reflux with stirring for 6 hours. Then, after removing an aqueous layer, sodium N,N-diethyldithiocarbamate trihydrate (10.0 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 15 (0.52 g). Copolymer 15 was measured with respect to a weight average molecular weight (Mw) and polydispersity (Mw/Mn), which were measured by using SEC. The weight average molecular weight (Mw) and polydispersity (Mw/Mn) of Copolymer 15 were respectively, 34,900 Da and 1.53.

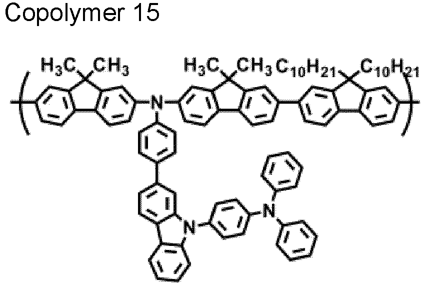

### Example 16: Synthesis of Copolymer 16

Under an argon atmosphere, Compound 6 (2.007 g) synthesized in Synthesis Example 6, 2,7-dibromo-3,6-dimethyl-9,9-di-n-decylfluorene (0.932 g), bis[di-tert-butyl (4-dimethylaminophenyl)phosphine]dichloropalladium(II) (Pd(Amphos)₂Cl₂) (12.4 mg), toluene (60 mL), and a 20 mass% tetraethylammonium hydroxide aqueous solution (10.3 g) were added to a reaction vessel, and the contents were heated at reflux with stirring for 6 hours. Subsequently, 9,9-dimethylfluorene-2-boronic acid (512.8 mg), palladium acetate (19.1 mg), SPhos (2-dicyclohexylphosphino-2',6'-dimethoxybiphenyl) (63.8 mg) and a 20 mass% tetraethylammonium hydroxide aqueous solution (10.3 g) were added thereto, and the contents were heated under reflux with stirring for 6 hours. Then, after removing an aqueous layer, sodium N,N-diethyldithiocarbamate trihydrate (7.0 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 16 (1.1 g). Copolymer 16 was measured with respect to a weight average molecular weight (Mw) and polydispersity (Mw/Mn), which were measured by using SEC. The weight average molecular weight (Mw) and polydispersity (Mw/Mn) of Copolymer 16 were respectively 79,800 Da and 1.90.

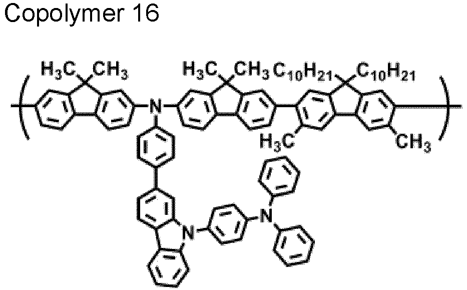

### Example 17: Synthesis of Copolymer 17

Under an argon atmosphere, Compound 6 (1.868 g) synthesized in Synthesis Example 6, 2,7-dibromo-3-methyl-9,9-di-n-decylfluorene (0.929 g), bis[di-tert-butyl (4-dimethylaminophenyl)phosphine]dichloropalladium(II) (Pd(Amphos)₂Cl₂) (11.5 mg), toluene (60 mL), and a 20 mass% tetraethylammonium hydroxide aqueous solution (11.5 g) were added to a reaction vessel, and the contents were heated under reflux with stirring for 6 hours. Subsequently, 9,9-dimethylfluorene-2-boronic acid (192.5 mg), bis(triphenylphosphine)palladium(II) dichloride (67.1 mg), and a 20 mass% tetraethylammonium hydroxide aqueous solution (11.5 g) were added thereto, and the contents were heated under reflux with stirring for 6 hours. Then, after removing an aqueous layer, sodium N,N-diethyldithiocarbamate trihydrate (7.0 g) and ion-exchanged water (60 mL) were added thereto and then, the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 17 (1.06 g). Copolymer 17 was measured with respect to a weight average molecular weight (Mw) and polydispersity (Mw/Mn), which were measured by using SEC. The weight average molecular weight (Mw) and polydispersity (Mw/Mn) of Copolymer 17 were respectively 73,400 Da and 1.84.

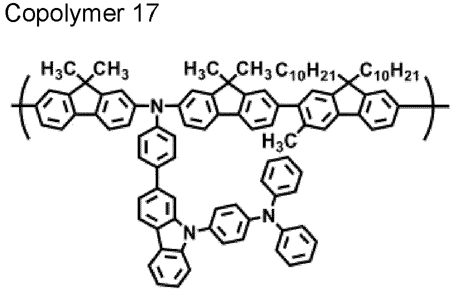

### Example 18: Synthesis of Copolymer 18

Under an argon atmosphere, Compound 7 (1.988 g) synthesized in Synthesis Example 7, 2,7-dibromo-9,9-di-n-octylfluorene (0.771 g), bis[di-tert-butyl (4-dimethylaminophenyl)phosphine]dichloropalladium(II) (Pd(Amphos)₂Cl₂) (12.3 mg), toluene (60 mL), and a 20 mass% tetraethylammonium hydroxide aqueous solution (10.1 g) were added to a reaction vessel, and the contents were heated under reflux with stirring for 6 hours. Subsequently, 9,9-dimethylfluorene-2-boronic acid (405.1 mg), palladium acetate (21.3 mg), SPhos (2-dicyclohexylphosphino-2',6'-dimethoxybiphenyl) (64.6 mg), and a 20 mass% tetraethylammonium hydroxide aqueous solution (10.1 g) were added thereto, and the contents were heated under reflux with stirring for 6 hours. Then, after removing an aqueous layer, sodium N,N-diethyldithiocarbamate trihydrate (7.4 g) and ion-exchanged water (60 mL) were added thereto, and the contents were stirred at 85°C for 2 hours. After separating an organic layer from the aqueous layer, the organic layer was washed with water, a 3 mass% aqueous acetic acid solution, and water. The organic layer was added dropwise to methanol to precipitate a polymer compound, which was then filtered and dried to obtain a solid. This solid was dissolved in toluene and then purified by column chromatography with silica gel/alumina, and the solvent was removed under reduced pressure. The obtained liquid was added dropwise to methanol, and a solid extracted therefrom was separated by filtration and dried to obtain Copolymer 18 (0.96 g). Copolymer 18 was measured with respect to a weight average molecular weight (Mw) and polydispersity (Mw/Mn), which were measured by using SEC. The weight average molecular weight (Mw) and polydispersity (Mw/Mn) of Copolymer 18 were respectively 156,600 Da and 1.94.

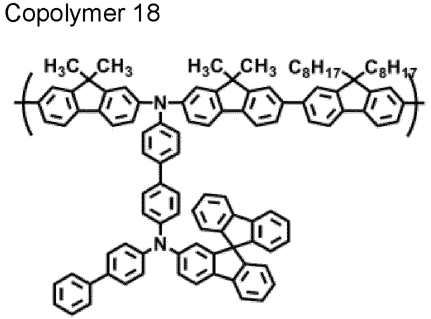

### Comparative Example 1: Synthesis of Comparative Copolymer 1

Comparative Copolymer 1 was synthesized in the same manner as in the same method of synthesizing Polymer Compound P-6 disclosed in Example 6 described in Japanese Patent Laid-Open Publication No. 2021-138915.

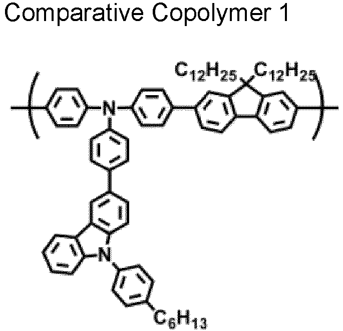

### Solvent resistance (film retention rate)

The copolymers according to the examples and the comparative examples were evaluated with respect to solvent resistance in the following method, and the results are shown in Tables 1 and 2. Each of the copolymers was dissolved at a concentration of 1 mass% in xylene as a solvent to prepare a copolymer coating solution. Subsequently, the copolymer coating solution was spin-coated on a quartz substrate, and dried at 230°C for 30 minutes to form a 25 nm-thick dry film. The formed film (before dipping in a solvent) was measured with respect to an absorption spectrum by using an ultraviolet-visible spectrophotometer (UV-1800, Shimadzu Corp.). In the absorption spectrum, a wavelength of a peak on the longest wavelength side was measured, and used as a reference wavelength.

Subsequently, the same film (before dipping in a solvent) on the quartz substrate was dipped in cyclohexylbenzene (CHB) as the solvent for 20 minutes and taken from the solvent, and dried at 230°C for 30 minutes. The dried film (after dipping in the solvent) was measured with respect to an absorption spectrum by using the same ultraviolet-visible spectrophotometer as above. For this absorption spectrum, a film retention rate (Re.rate) (%) was defined as a ratio of intensity at the reference wavelength of the absorption spectrum of the film after dipping in the solvent to that at the reference wavelength of the absorption spectrum of the film before dipping in the solvent {("intensity at the reference wavelength of the absorption spectrum of the film after dipping in the solvent"/"intensity at the reference wavelength of the absorption spectrum of the film before dipping in the solvent") ×100 (%)}.

**Table 1**

| | **Structural Unit** | | Mw | **Re.rate** (%) |
|---|---|---|---|---|
| **Exa.** 1 | 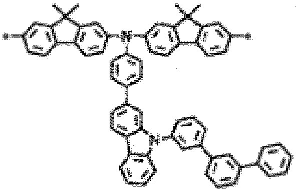 | 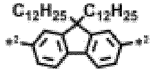 | 81200 | 100 |
| **Exa.** 3 | 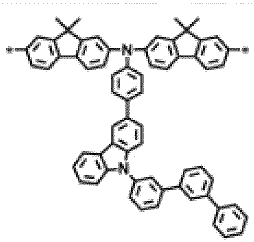 | 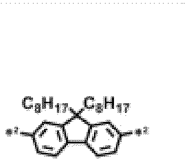 | 64500 | 100 |
| **Exa.** 4 | 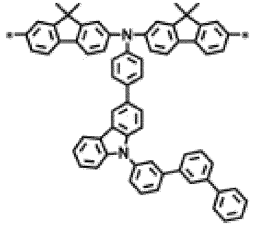 | 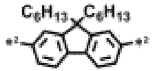 | 80350 | 100 |
| **Exa.** 5 | 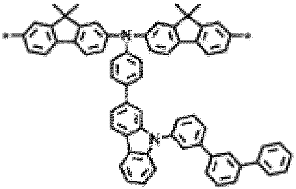 | 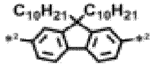 | 87890 | 100 |
| **Exa.** 6 | 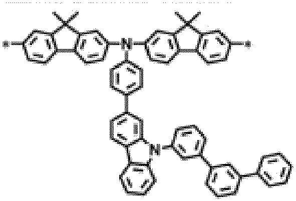 | 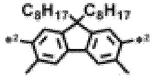 | 97000 | 96 |

**Table 2**

| | | | | |
|---|---|---|---|---|
| **Exa.** 9 | 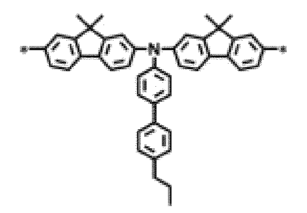 | 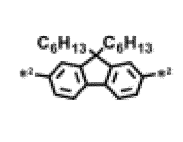 | 68400 | 99 |
| **Exa.** 12 | 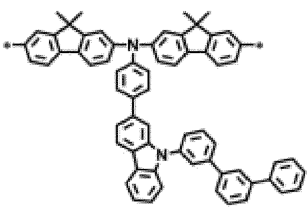 | 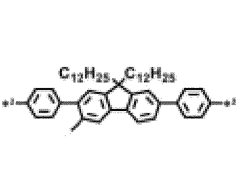 | 55100 | 98 |
| **Exa.** 13 | 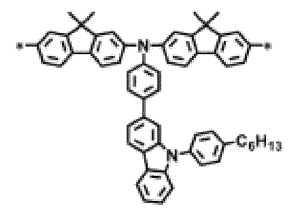 | 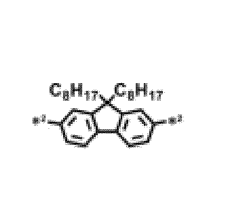 | 49100 | 90 |
| **Exa.** 18 | 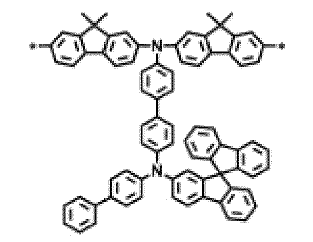 | 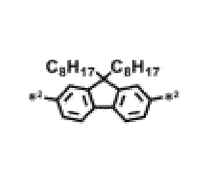 | 15660 0 | 98 |
| **Com. Exa. 1** | 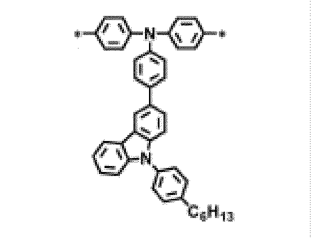 | 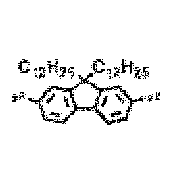 | 15600 0 | 23 |

Each of the copolymers of Examples 1, 3 to 6, 9, 12, 13, and 18 exhibited a high film retention rate. On the other hand, the copolymer of Comparative Example 1, in which two aromatic rings bonded to a nitrogen atom were all benzene rings, exhibited a decrease in the film retention rate despite that the copolymer of Comparative Example 1 has equivalent weight average molecular weight to those of the copolymers of the Examples.

### Measurement of HOMO Levels

Each of the copolymers of Examples 1 to 18, and Comparative Example 1 was dissolved in xylene at a concentration of 1 mass% to prepare coating solutions. Each of the coating solutions was spin-coated on a UV-cleaned ITO-attached glass substrate at a rotation speed of 2000 rpm to form films, and dried on a hot plate at 150 °C for 30 minutes to form samples for measurement. The samples were measured with respect to HOMO levels by using an atmospheric photoelectron spectroscope (AC-3, Riken Keiki Co. Ltd.) in the air. Here, the measurement results were used to calculate a tangent intersection point of the rise, which was used as the HOMO levels (eV). The results are shown in Tables 3 to 6.

### Glass Transition Temperature (Tg)

Each of the copolymers of Examples 1 to 18 and the Comparative Example 1 was heated to 300 °C at 10 °C/min, maintained for 10 minutes, cooled to 25 °C at 10°C/min, maintained for 10 minutes, and then, heated again to 300 °C at 10°C/min to measure a glass transition temperature (Tg) by using a differential scanning calorimeter (DSC) (Tradename: DSC6000, Seiko Instruments, Inc.)

When the measurement was completed, the samples were cooled to room temperature (25°C) at 10°C/min. The results are shown in Tables 3 to 6.

**Table 3**

| | **Structural Unit** | | HOMO (eV) | Tg (°C ) |
|---|---|---|---|---|
| **Exa. 1** | 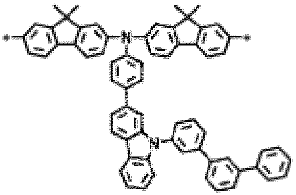 | 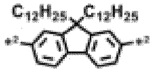 | -5.47 | 139 |
| **Exa. 2** | 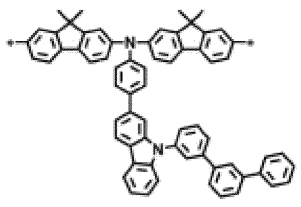 | 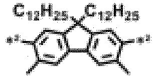 | -5.53 | 135 |
| **Exa. 3** | 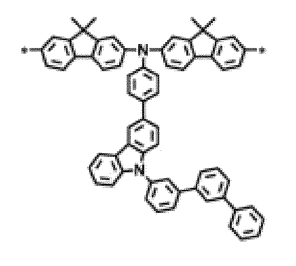 | 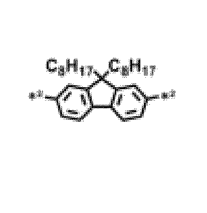 | -5. 41 | 117 |
| **Exa. 4** | 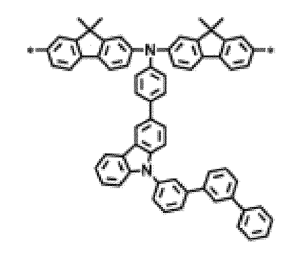 | 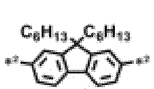 | -5.41 | 201 |
| **Exa. 5** | 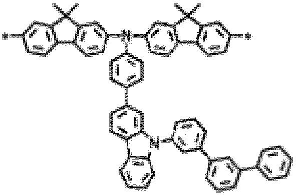 | 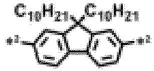 | -5.46 | 158 |

**Table 4**

| | | | | |
|---|---|---|---|---|
| **Exa. 6** | 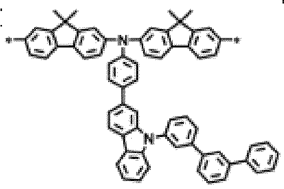 | 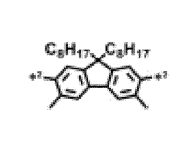 | -5.49 | 190 |
| **Exa. 7** | 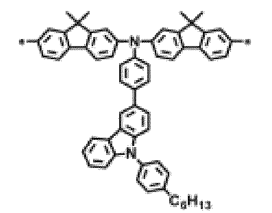 | 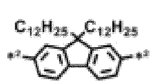 | -5.41 | 127 |
| **Exa. 8** | 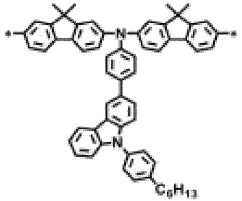 | 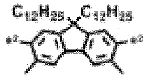 | -5. 42 | 102 |
| **Exa. 9** | 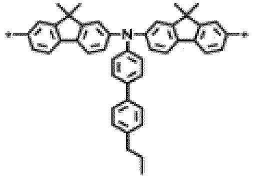 | 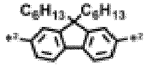 | -5,49 | 214 |
| **Exa. 10** | 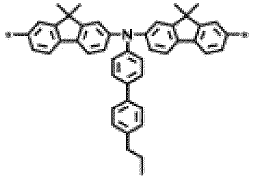 | 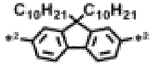 | -5.49 | 161 |
| **Exa. 11** | 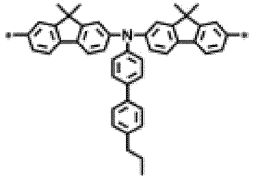 | 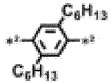 | -5.51 | 163 |

**Table 5**

| | | | | |
|---|---|---|---|---|
| **Exa.12** | 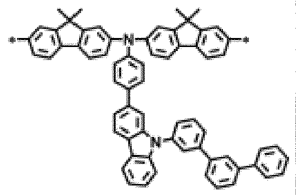 | 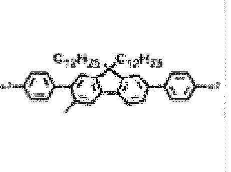 | -5.47 | 161 |
| **Exa. 13** | 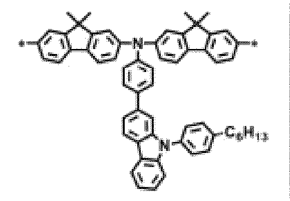 | 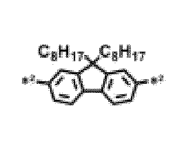 | -5.40 | 166 |
| **Exa.14** | 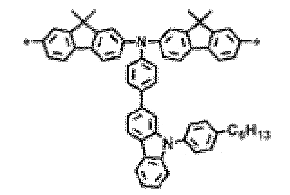 | 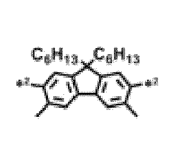 | -5.47 | 199 |
| **Exa. 15** | 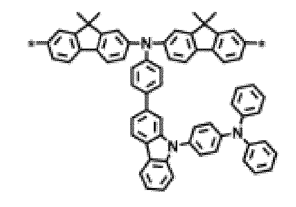 | 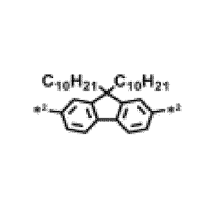 | -5.48 | 183 |
| **Exa. 16** | 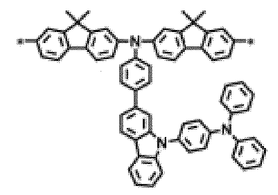 | 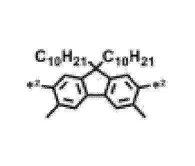 | -5.51 | 193 |
| **Exa. 17** | 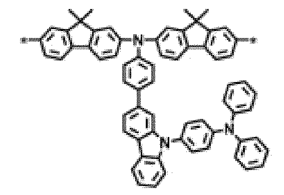 | 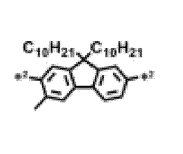 | -5.50 | 174 |

**Table 6**

| | | | | |
|---|---|---|---|---|
| **Exa. 18** | 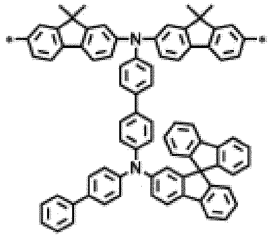 | 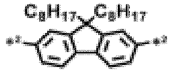 | -5. 43 | 212 |
| **Com. Exa. 1** | 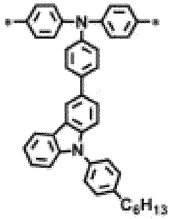 | 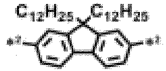 | -5.38 | 112 |

As shown from Tables 3 to 6, each of the copolymers of Examples 1 to 18, compared with the copolymer of Comparative Example 1, was confirmed to exhibit a deep HOMO level. In addition, the copolymers of the examples exhibited satisfactory glass transition temperatures, and thus are thought to have sufficient heat resistance, when formed into films.

### Manufacturing of Electroluminescent Devices

### Manufacture Example 1: Manufacturing of Electroluminescent Device 1

As the first electrode (anode), an ITO-attached glass substrate with the indium tin oxide (ITO) patterned to a film thickness of 150 nm was used. This ITO-attached glass substrate was washed sequentially with a neutral detergent, deionized water, water, and isopropyl alcohol, and then UV-treated. Subsequently, on this ITO-attached glass substrate, poly(3,4-ethylenedioxythiophene)/poly(4-styrenesulfonate) (PEDOT/PSS) (Sigma-Aldrich Co., Ltd.) was spin-coated to have a dry film thickness of 30 nm, and dried. As a result, a hole injection layer (HIL) with a thickness (drying film thickness) of 30 nm was formed on the ITO-attached glass substrate.

Subsequently, Copolymer 1 synthesized in Example 1 (a hole transport material) was dissolved in toluene (solvent) at a concentration of 1 mass% to prepare Coating Solution 1 for forming a hole transport layer (HTL). On the hole injection layer (HIL), Coating Solution 1 for forming a hole transport layer (HTL) was spin-coated to have a (dry film) thickness of 30 nm, and heated at 230 °C for 1 hour to form a hole transport layer (HTL) with a (dry film) thickness of 30 nm.

Subsequently, a quantum dot dispersion was prepared by dispersing blue quantum dots of ZnTeSe/ZnSe/ZnS (core/shell/shell; average diameter = about 10 nm) in cyclohexane at a concentration of 1.0 mass%. Here, the hole transport layer (HTL) (particularly, Copolymer 1) was not dissolved in the cyclohexane. This quantum dot dispersion was spin-coated to have a dry film thickness of 30 nm on the hole transport layer (HTL), and dried. As a result, a quantum dot light emitting layer with the (dry film) thickness of 30 nm was formed on the hole transport layer (HTL). In addition, light emitted by irradiating the quantum dot dispersion with ultraviolet rays had a center wavelength of 462 nm, and a full width at half maximum (FWHM) of 30 nm.

This quantum dot light emitting layer was completely dried. On the quantum dot light emitting layer, lithium quinolate (Liq) and 1,3,5-tris(N-phenylbenzimidazole-2-yl)benzene (TPBI) (Sigma-Aldrich Co., Ltd.) as an electron transport material were co-deposited by using a vacuum deposition device. As a result, an electron transport layer with a thickness of 36 nm was formed on the quantum dot light emitting layer.

On the electron transport layer, (8-quinolinolato)lithium (lithium quinolate) (Liq) was deposited by using the vacuum deposition device. As a result, an electron injection layer with a thickness of 0.5 nm was formed on the electron transport layer.

On the electron injection layer, aluminum (hereinafter, Al) was deposited by using the vacuum deposition device to form a second electrode (a cathode) with a thickness of 100 nm. Accordingly, Electroluminescent Device 1 (Quantum Dot Electroluminescent Device 1) was obtained.

### Manufacture Example 2: Manufacturing of Electroluminescent Device 2

Electroluminescent Device 2 (Quantum Dot Electroluminescent Device 2) was manufactured in the same manner as in Manufacture Example 1 except that Copolymer 2 of Example 2 was used instead of Copolymer 1.

### Manufacture Example 3: Manufacturing of Electroluminescent Device 11

Electroluminescent Device 11 (Quantum Dot Electroluminescent Device 11) was manufactured in the same manner as in Manufacture Example 1 except that Copolymer 11 of Example 11 was used instead of Copolymer 1.

### Manufacture Example 4: Manufacturing of Electroluminescent Device 13

Electroluminescent Device 13 (Quantum Dot Electroluminescent Device 13) was manufactured in the same manner as in Manufacture Example 1 except that Copolymer 13 of Example 13 was used instead of Copolymer 1.

### Comparative Manufacture Example 1: Manufacturing of Electroluminescent Device X1

Comparative Electroluminescent Device X1 (Quantum Dot Electroluminescent Device X1) was manufactured in the same manner as in Manufacture Example 1 except that poly[(9,9-dioctylfluorenyl-2,7-diyl)-co-(4,4'-(N-sec-butylphenyl)diphenylamine)] having the following structural unit (TFB) (Luminescence Technology Corp.) was used instead of Copolymer 1.

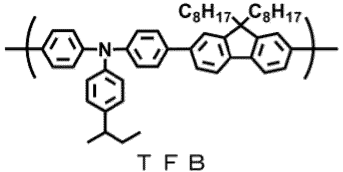

### Evaluation of Electroluminescent Devices

The quantum dot electroluminescent devices according to Manufacture Examples 1 to 4 and Comparative Manufacture Example 1 were evaluated with respect to luminous efficiency (EQE) and durability (LT50) in the following method, and the results are shown in Table 7.

### EQE

Each of the quantum dot electroluminescent devices, to which a voltage was applied and in which a current started to flow at a predetermined voltage, emitted light. While increasing voltage by using a DC constant voltage supply (a source meter, Keyence Corp.), each device was measured with respect to a current at which the device emitted light, and in addition, when it emitted light, its luminance was measured by using a luminance-measuring apparatus (SR-3, Topcom). Here, the measurements were stopped when the luminance started to decrease. After calculating a current value per unit area (current density) from an area of each device, the luminance (cd/m²) was divided by the current density (A/m²) to obtain current efficiency (cd/A).

In addition, assuming Lambertian radiation, a spectral luminance spectrum measured with the luminance-measuring apparatus was used to calculate external quantum efficiency (EQE) (%) at a luminance of 5000 nit (cd/m²), which was used to evaluate luminous efficiency.

### LT50

Each of the quantum dot electroluminescent devices was made to emit light by applying a predetermined voltage thereto with the DC constant voltage supply (a source meter, Keyence Corp.). While luminance of each quantum dot electroluminescent device was measured by using the luminance-measuring apparatus (SR-3, Topcon), after slowly increasing a current, when the luminance reached 650 nit (cd/m²), the device was allowed to stand by keeping the current constant. "LT50(h)" was obtained by measuring time when the luminance measured by the luminance measuring apparatus slowly decreased and became 50% of the initial luminance.

**Table 7**

| **EL Device** | **Structural Unit** | | **Mw** | EQE (%) @5000nit | LT50 (h) @650nit |
|---|---|---|---|---|---|
| 1 | 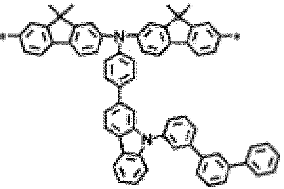 | 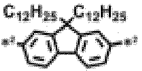 | 81200 | 6.1 | 84 |
| 2 | 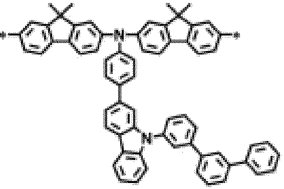 | 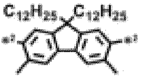 | 42600 | 9.8 | 63 |
| 11 | 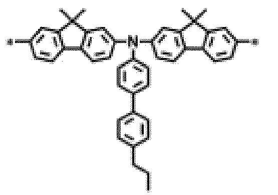 | 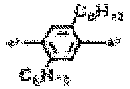 | 54100 | 10.9 | 54 |
| 13 | 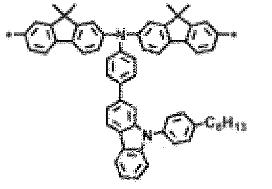 | 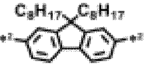 | 49100 | 7.5 | 42 |
| X1 | 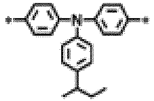 | 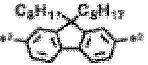 | 359000 | 9.2 | 12 |

As shown in Table 7, each quantum dot electroluminescent device manufactured by respectively using the copolymers of Examples 1, 2, 11, and 13 exhibited sufficient current efficiency and LT50. On the other hand, Comparative Quantum Dot Electroluminescent Device X1 exhibited that LT50 was reduced, compared with each of the quantum dot electroluminescent devices manufactured by using the copolymers of the examples. Electroluminescent devices manufactured by using a copolymer as described herein are expected to exhibit the same results as above.

## Claims

1. A copolymer comprising a structural unit represented by Chemical Formula 1, and a structural unit represented by Chemical Formula 2: 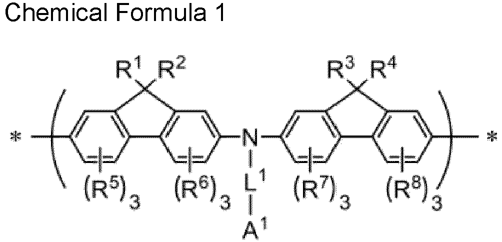 wherein, in Chemical Formula 1,
A¹ is a substituted or unsubstituted aromatic ring group having 6 to 60 ring-forming atoms, a substituted or unsubstituted heteroaromatic ring group having 3 to 60 ring-forming atoms, or a group represented by Chemical Formula 3,
L¹ is a single bond, or a substituted or unsubstituted aromatic ring group having 6 to 60 ring-forming atoms,
R¹ to R⁴ are each independently a substituted or unsubstituted aromatic ring group having 6 to 30 ring-forming atoms, a substituted or unsubstituted alkyl group having 1 to 30 carbon atoms, or a substituted or unsubstituted ethylene glycol group or oligoethylene glycol group having 2 to 30 carbon atoms,
wherein, R¹ and R² are optionally bonded with each other to form a ring, or R³ and R⁴ are optionally bonded with each other to form a ring,
R⁵ to R⁸ are each independently a hydrogen atom, or a substituted or unsubstituted alkyl group having 1 to 30 carbon atoms, and
* is a bonding position with another atom, 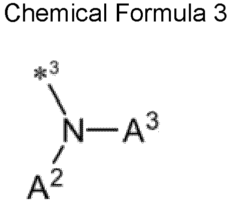
wherein, in Chemical Formula 3,
A² and A³ are each independently a substituted or unsubstituted aromatic ring group having 6 to 30 ring-forming atoms, or a substituted or unsubstituted heteroaromatic ring group having 3 to 30 ring-forming atoms, and
*³ is a bonding position with another atom,
Chemical Formula 2 *² - A⁴ - * ²
wherein, in Chemical Formula 2,
A⁴ is a substituted or unsubstituted aromatic ring group having 6 to 60 ring-forming atoms, or a substituted or unsubstituted heteroaromatic ring group having 3 to 60 ring-forming atoms, and
*² is a bonding position with another atom.

2. The copolymer of claim 1, wherein the copolymer comprises a structural unit represented by Chemical Formula 4: 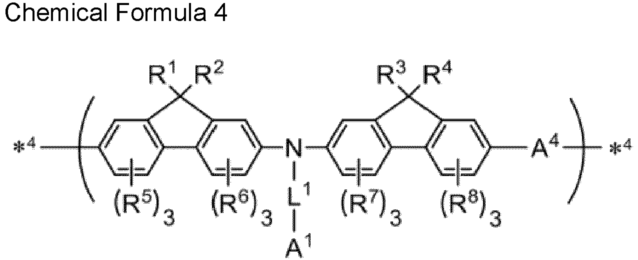 wherein, in Chemical Formula 4,
A¹ is a substituted or unsubstituted aromatic ring group having 6 to 60 ring-forming atoms, a substituted or unsubstituted heteroaromatic ring group having 3 to 60 ring-forming atoms, or a group represented by Chemical Formula 3,
L¹ is a single bond, or a substituted or unsubstituted aromatic ring group having 6 to 60 ring-forming atoms,
R¹ to R⁴ are each independently a substituted or unsubstituted aromatic ring group having 6 to 30 ring-forming atoms, a substituted or unsubstituted alkyl group having 1 to 30 carbon atoms, or a substituted or unsubstituted ethylene glycol group or oligoethylene glycol group having 2 to 30 carbon atoms,
wherein, R¹ and R² are optionally bonded with each other to form a ring, or R³ and R⁴ are optionally bonded with each other to form a ring,
R⁵ to R⁸ are each independently a hydrogen atom, or a substituted or unsubstituted alkyl group having 1 to 30 carbon atoms,
A⁴ is a substituted or unsubstituted aromatic ring group having 6 to 60 ring-forming atoms, or a substituted or unsubstituted heteroaromatic ring group having 3 to 60 ring-forming atoms, and
* is a bonding position with another atom, 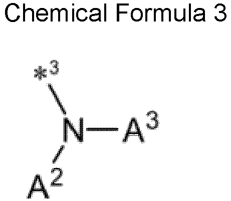
wherein, in Chemical Formula 3,
A² and A³ are each independently a substituted or unsubstituted aromatic ring group having 6 to 30 ring-forming atoms, or a substituted or unsubstituted heteroaromatic ring group having 3 to 30 ring-forming atoms, and
*³ is a bonding position with another atom.

3. The copolymer of claims 1 or 2, wherein L¹ is a group represented by Chemical Formula 5 or Chemical Formula 6: 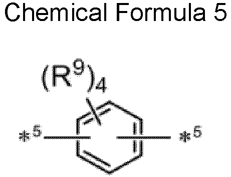 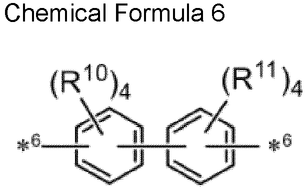 wherein, in Chemical Formula 5 and Chemical Formula 6,
R⁹ to R¹¹ are each independently a hydrogen atom, a substituted or unsubstituted aromatic ring group having 6 to 30 ring-forming atoms, or a substituted or unsubstituted alkyl group having 1 to 30 carbon atoms, and
*⁵ and *⁶ are a bonding position with another atom; or
wherein L¹ is represented by one of Group 2: 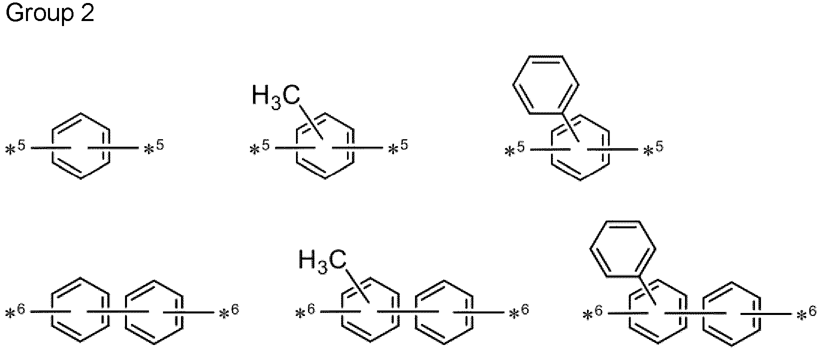
wherein, in Group 2, *⁵ and *⁶ are each a bonding position with another atom.

4. The copolymer of any of claims 1-3, wherein A¹ is a group represented by Chemical Formula 7: 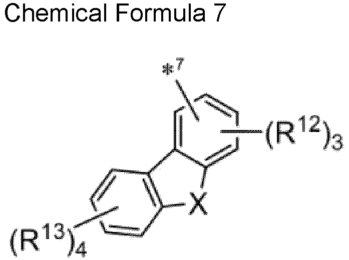 wherein, in Chemical Formula 7,
R¹² and R¹³ are each independently a hydrogen atom, a substituted or unsubstituted aromatic ring group having 6 to 30 ring-forming atoms, or a substituted or unsubstituted alkyl group having 1 to 30 carbon atoms,
X represents *'-C(R¹⁴)(R¹⁵)-*', *'-N(R¹⁶)-*', *'-O-*', or *'-S-*',
wherein R¹⁴ and R¹⁵ are each independently a substituted or unsubstituted aromatic ring group having 6 to 30 carbon atoms, or a substituted or unsubstituted alkyl group having 1 to 30 carbon atoms, or R¹⁴ and R¹⁵ are optionally bonded to each other to form a ring structure,
R¹⁶ is a substituted or unsubstituted aromatic ring group having 6 to 30 ring-forming atoms, or a substituted or unsubstituted alkyl group having 1 to 30 carbon atoms,
*' is a bonding position with another atom, and
^{*7} is a bonding position with another atom; or
wherein A¹ is represented by one of Group 1: 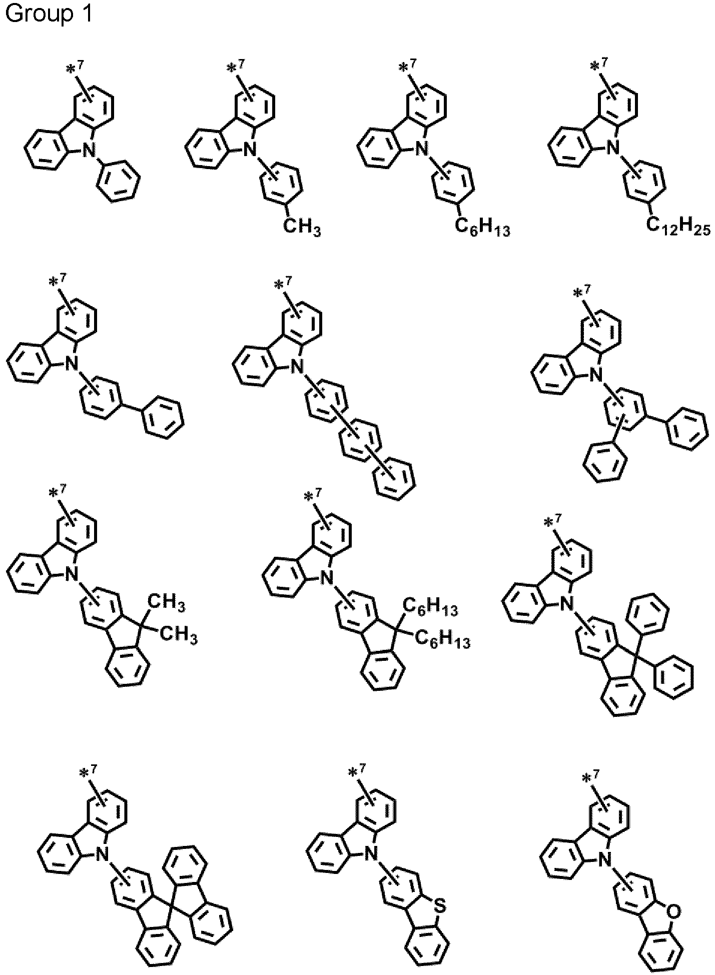 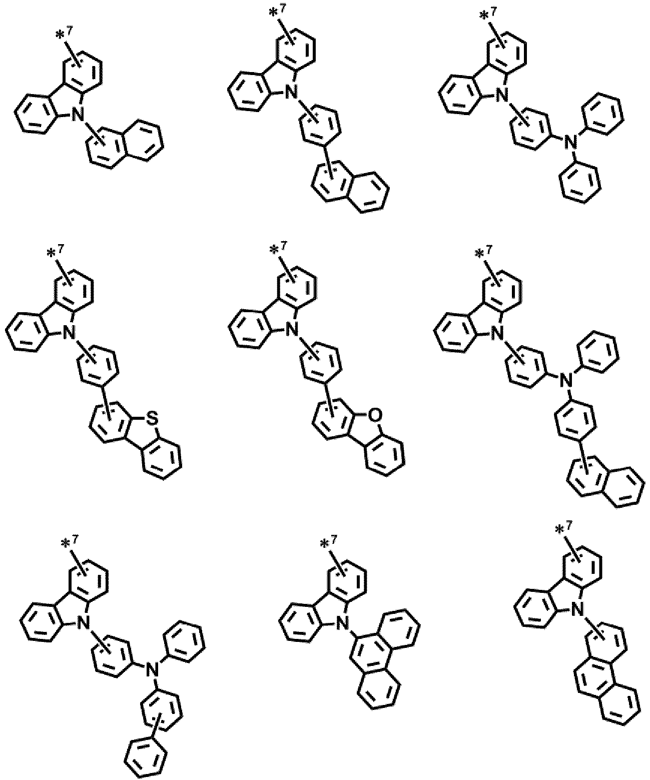
wherein, in Group 1,
^{*7} is a bonding position with L¹ in Chemical Formula 1; or
wherein A¹ is a group represented by Chemical Formula 3.

5. The copolymer of any of claims 1-4, wherein Chemical Formula 2 is represented by one of Group 4: 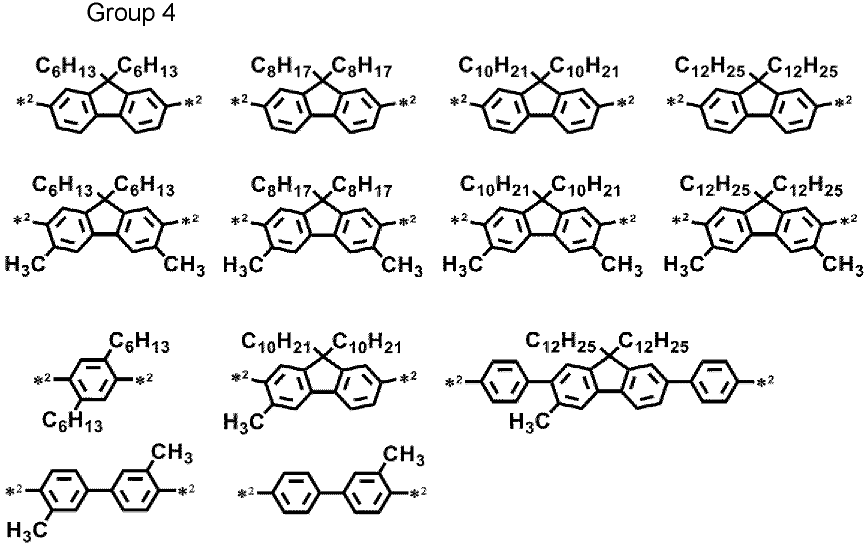 wherein, in Group 4, ^{*2} is a bonding position with another atom.

6. The copolymer of any of claims 1-5, wherein the structural unit represented by Chemical Formula 2 comprises a structural unit represented by Chemical Formula 2': 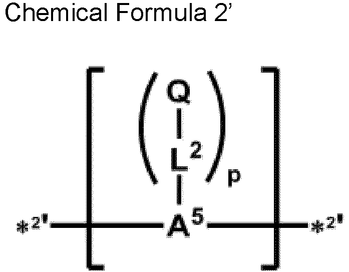 wherein, in Chemical Formula 2',
A⁵ is a substituted or unsubstituted aromatic ring group having 6 to 60 ring-forming atoms, or a substituted or unsubstituted heteroaromatic ring group having 3 to 60 ring-forming atoms,
L² is a single bond, a substituted or unsubstituted alkylene group having 1 to 30 carbon atoms, or a substituted or unsubstituted aromatic ring group having 6 to 30 ring-forming atoms,
Q is a crosslinkable group,
p is an integer of greater than or equal to 1, and
^{*2'} is a bonding position with another atom.

7. The copolymer of claim 6, wherein Chemical Formula 2' comprises a structural unit represented by one of Group 5: 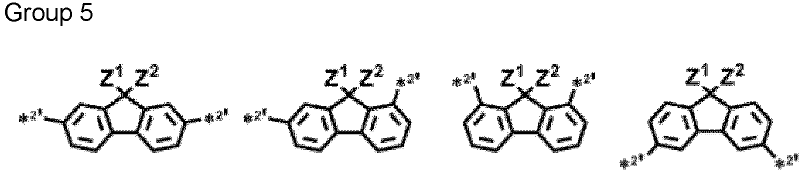 wherein, in Group 5,
Z¹ and Z² are each independently a group represented by ^{*a3}-L²-Q, wherein ^{*a3} is a bonding position with another atom, L² and Q are each the same as defined in Chemical Formula 2', and ^{*2'} is a binding site that forms a main chain; and/or
wherein Q is represented by one of Group 6: 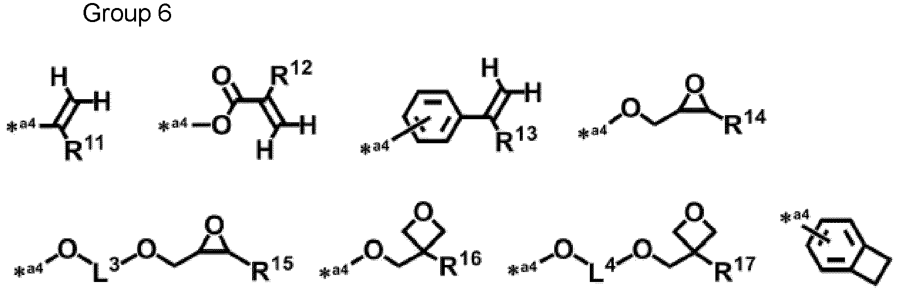
wherein, in Group 6,
R¹¹ to R¹⁷ are each independently a hydrogen atom, or a substituted or unsubstituted alkyl group having 1 to 10 carbon atoms,
L³ and L⁴ each independently represent ^{*a5}-(CH₂)_{q}-^{*a5}, wherein q is an integer of 1 to 10, and ^{*a5} is a bonding position with another atom, and
^{*a4} is a bonding position with another atom.

8. The copolymer of any of claims 1-7, wherein the copolymer comprises at least one structural unit represented by Group 7:

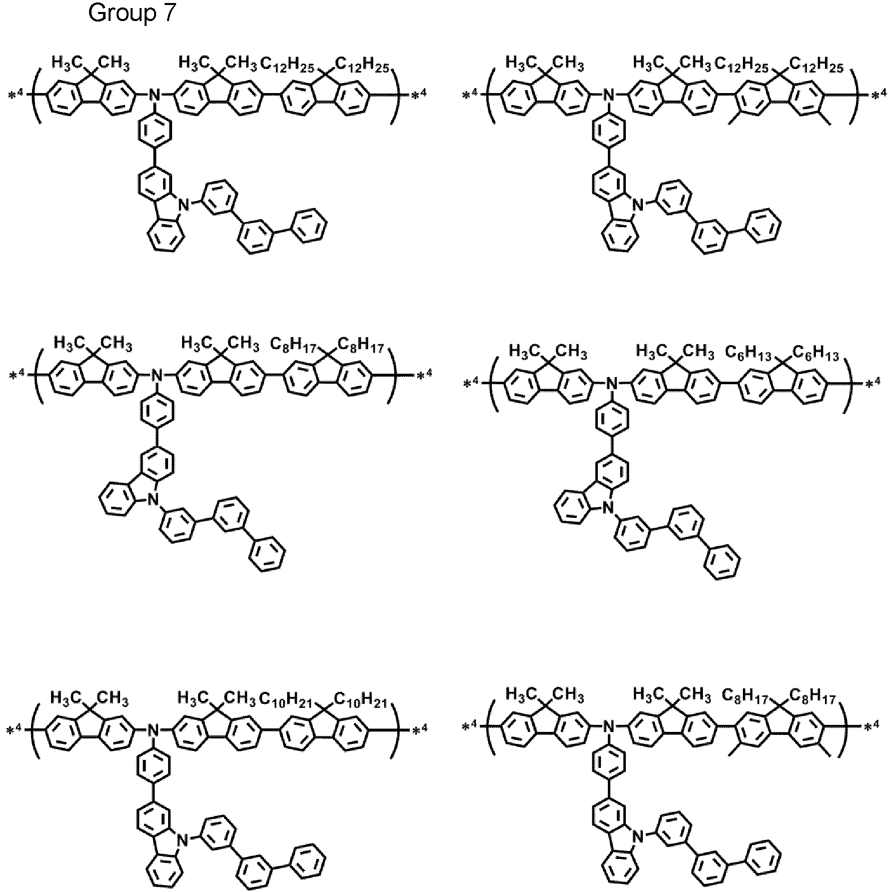

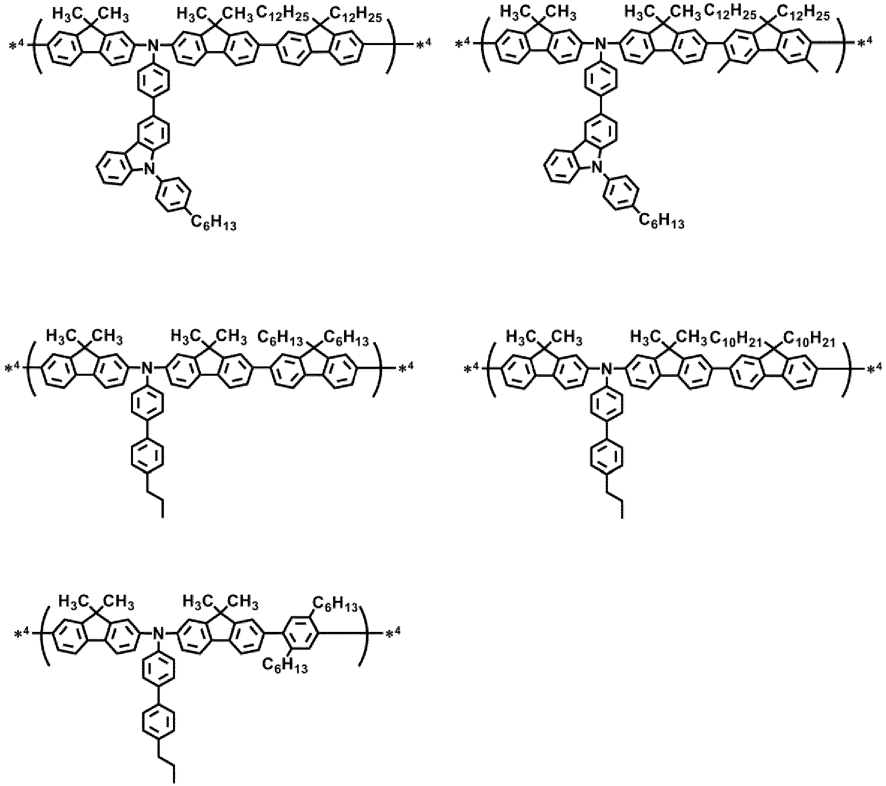

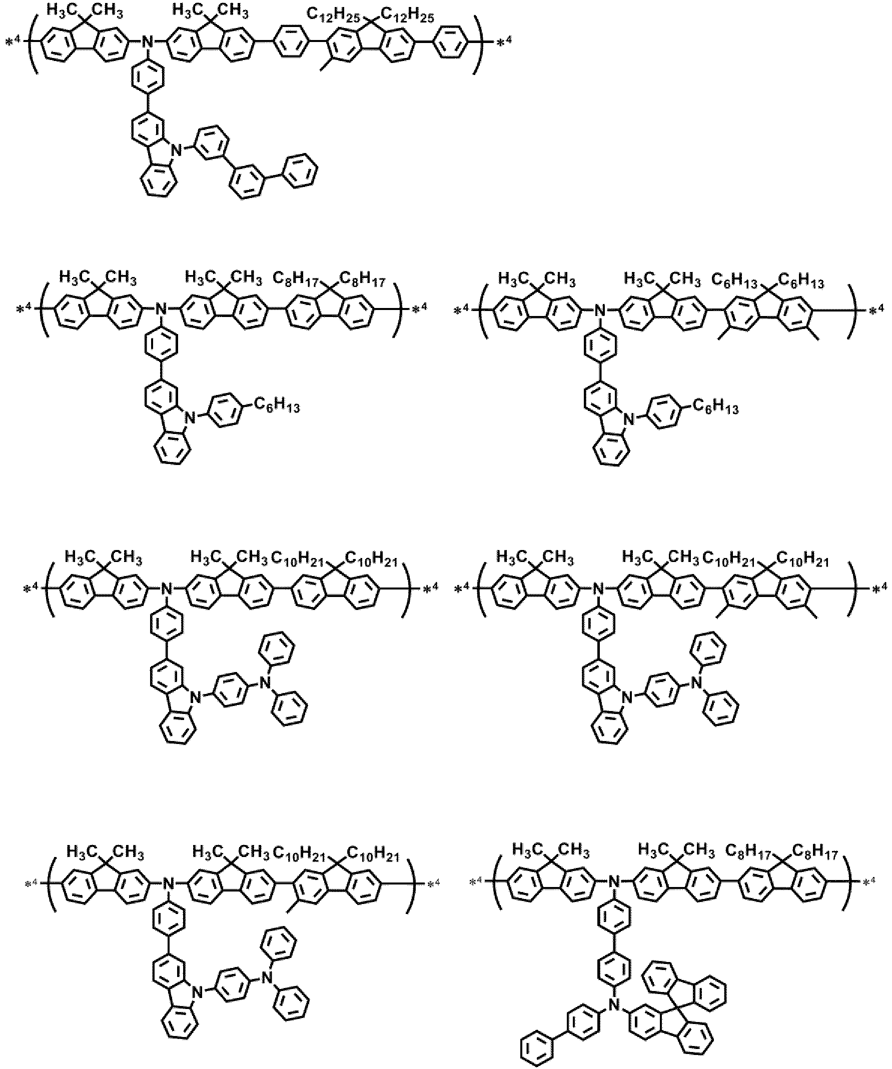

9. A composition comprising the copolymer of any of claims 1-8, and at least one material that is a hole transport material, an electron transport material, or a light emitting material.

10. A composition comprising the copolymer of any of claims 1-8, and at least one solvent.

11. An electroluminescent device comprising a pair of electrodes, and at least one organic layer comprising the copolymer of any of claims 1-8, wherein the at least one organic layer is disposed between the pair of electrodes.

12. An electroluminescent device comprising a pair of electrodes and at least one organic layer comprising the composition of claim 9 disposed between the pair of electrodes.

13. The electroluminescent device of claims 11 or 12, wherein the at least one organic layer comprises a hole transport layer.

14. The electroluminescent device of any of claims 11-13, further comprising a layer comprising a plurality of quantum dots disposed between the pair of electrodes, wherein the plurality of quantum dots comprises an inorganic nanoparticle;
preferably wherein the layer comprising the plurality of quantum dots is a light emitting layer, and the light emitting layer is disposed on the at least one organic layer.

15. The electroluminescent device of any of claims 11-14, wherein the at least one organic layer comprises at least one of Copolymer 1 to Copolymer 18:
